# EUROPEAN PATENT APPLICATION

(11) **EP 4 592 297 A1**
(43) Date of publication of application: **30.07.2025**
(21) Application number: 24153315.7
(22) Date of filing: 23.01.2024
(51) Int. Cl.: C07F 5/02, C07F 7/08, C07F 9/50, C07F 9/6568, C09K 11/06, H10K 50/11

(54) **AN ORGANIC BORON COMPOUND, AN ORGANIC LIGHT EMITTING DIODE COMPRISING THE ORGANIC BORON COMPOUND, A USE OF THE DIODE, AND A CONSUMER PRODUCT**

(71) Applicant: Noctiluca S.A., 81-100 Torun (PL)
(72) Inventor: Bosiak, Mariusz, 87-148 Papowo Torunskie (PL); Zielinska, Alicja, 87-100 Torun (PL)
(74) Representative: Kowalkiewicz, Zuzanna

(57) **Abstract**

The subject of the invention is an organic boron compound, an organic light emitting diode comprising the organic boron compound, a use of the diode, and a consumer product. The organic boron compound can be a compound according to Formula I. Furthermore, the organic light emitting diode (OLED) comprising an anode, cathode, and organic emissive layer, disposed between the anode and cathode, wherein the organic emissive layer includes a phosphorescent sensitizer doped with a TADF emissive dopant, and a host, wherein the phosphorescent sensitizer is an organometallic iridium or platinum complex and the TADF emissive dopant is a compound according to Formula I. The invention belongs to the field of light-emitting diodes/devices.

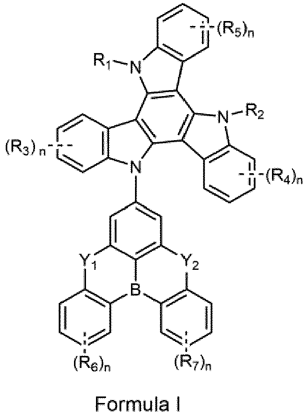

## Description

### FIELD

The present disclosure generally relates to an organic boron compound, an organic light emitting diode comprising the organic boron compound, a use of the diode, and a consumer product. The invention belongs to the field of light-emitting diodes/devices.

### BACKGROUND

Light-emitting devices comprise organic light-emitting diodes (OLED) that are also described as organic light-emitting devices in the state of the art. OLED comprises two electrodes, between which there are organic or organometallic layers, of which at least one is an emissive layer containing at least one chemical compound - an emitter.

Image display technology based on organic light-emitting devices effectively displaces older technologies such as plasma or LCD screens. Current OLED screens generally use fluorescent emitters (the first-generation emitters) for blue emission and phosphorescent (the second-generation emitters) emitters for green, yellow and red. Due to the constraints resulting from the quantum selection rules, only 25% of the excited 1st generation emitter molecules (excitons) have a singlet state and can emit light by returning to the singlet ground state. The remaining 75% of excitons in the triplet state are non-emissive and lose excitation in non-radiative processes. As a result, the first-generation emitters are inefficient. The second-generation emitters (phosphorescent), which are complexes of d-electron metals such as iridium or platinum, thanks to spin-orbit coupling and intersystem crossing can emit radiation from the triplet state and, in theory, emission from 100% excitons is possible. However, they have disadvantages such as the need to use expensive heavy metals, the disposal of which is cumbersome, screen burn-in in places where a static image is displayed for a long time due to the low stability of complex compounds or the lack of a blue light emitter.

Organic compounds operating on the basis of the thermally activated delayed fluorescence (TADF) mechanism, belonging to the third generation of emitters, have many advantages over the emitters currently used in OLED. They can be purely organic compounds, need not contain heavy metals, can be more resistant to the burn-in effect and it is possible to develop an efficient and durable blue emitter. In addition, it is possible to replace the second-generation emitters used today with cheaper TADF emitters in the same production lines.

The TADF emitters can also be used in so-called hyperfluorescent OLED. In that case, they act as assistant hosts to fluorescent or TADF emitters, by the Förster resonance energy transfer (FRET). TADF emitters are usually made of interconnected electron-donating (a donor) and electron-withdrawing (an acceptor) moieties, and their proper matching allows to reduce the energy difference between the singlet and triplet excited states (ΔE_{ST}) of a molecule. The low ΔE_{ST} value allows the intersystem transition of the excited molecule (an exciton) from the triplet to the singlet state (reverse intersystem crossing - RISC) and the emission in the form of prompt and delayed fluorescence up to 100% of the excited emitter molecules. A particular group among TADF emitters are multiresonant TADF (MR-TADF) compounds - fused polycyclic aromatic compounds having electron-donating atom (the donor) and electron-deficient atom (the acceptor) disposed para to each other in a fused planar polycyclic aromatic framework.

One object of the disclosure is to provide an organic boron compound, which is suitable for a use in the diode according to the invention. The subsequent objective of the disclosure is to provide an organic light emitting diode having an increased efficiency and operational lifetime as well as a use of this diode. Yet another aim of the disclosure is to provide a consumer product containing the diode described herein.

### SUMMARY OF THE INVENTION

There is disclosed an organic boron compound according to Formula I: 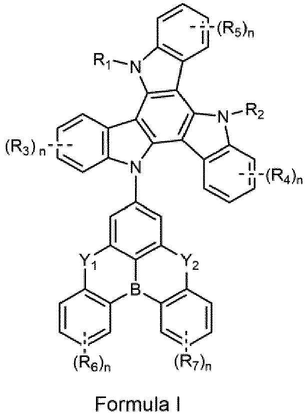 wherein:
R₁ and R₂ are together C₁-C₂₀ alkyl, C₂-C₂₀ alkenyl, C₂-C₂₀ alkynyl groups or their deuterated analogues;
R₃-R₅, together or independently, are hydrogen, deuterium, halogen, cyano, nitro, hydrazine, hydrazone, C₁-C₆₀ alkyl, C₂-C₆₀ alkenyl, C₂-C₆₀ alkynyl, C₁-C₆₀ alkoxy group, C₃-C₆₀ cycloalkyl, C₃-C₆₀ cycloalkenyl, C₁-C₆₀ heterocycloalkyl, C₁-C₆₀ heterocycloalkenyl group, C₃-C₆₀ cycloalkynyl group, C₁-C₆₀ heterocycloalkynyl group, hydroxyl, C₆-C₆₀ aryl, C₁-C₆₀ heteroaryl group, C₅-C₆₀ aryloxy, C₁-C₆₀ heteroaryloxy group, C₂-C₆₀ ether group, C₆-C₆₀ thioaryl, C₁-C₆₀ heterothioaryl, C₁-C₆₀ amino, C₁-C₆₀ alkylamino, C₁-C₆₀ dialkylamino, C₆-C₆₀ arylamino, C₆-C₆₀ diarylamino, C₆-C₆₀ heteroarylamino group, C₆-C₆₀ heterodiarylamino group, C₄-C₆₀ non-aromatic fused polycyclic group, C₁-C₆₀ non-aromatic fused heteropolycyclic group or deuterated analogues thereof;
R₆-R₇, together or independently, are hydrogen, deuterium, halogen, hydroxyl, cyano, nitro, hydrazine, hydrazone, C₁-C₆₀ alkyl, C₂-C₆₀ alkenyl, C₂-C₆₀ alkynyl, C₃-C₆₀ cycloalkyl, C₃-C₆₀ cycloalkenyl, C₁-C₆₀ heterocycloalkyl, C₁-C₆₀ heterocycloalkenyl, C₃-C₆₀ cycloalkynyl group, C₁-C₆₀ heterocycloalkynyl group, C₆-C₆₀ aryl, C₁-C₆₀ heteroaryl group, C₁-C₆₀ alkoxy group, C₅-C₆₀ aryloxy, C₁-C₆₀ heteroaryloxy group, C₂-C₆₀ ether group, C₆-C₆₀ thioaryl, C₁-C₆₀ heterothioaryl, C₁-C₆₀ amino, C₁-C₆₀ alkylamino, C₁-C₆₀ dialkylamino, C₆-C₆₀ arylamino, C₆-C₆₀ diarylamino, C₆-C₆₀ heteroarylamino group, C₆-C₆₀ heterodiarylamino group, C₄-C₆₀ non-aromatic fused polycyclic group, C₁-C₆₀ non-aromatic fused heteropolycyclic group or deuterated analogues thereof;
Y₁ and Y₂, together or independently, are O or N(Rs);
R₈ is hydrogen, deuterium, C₆-C₆₀ aryl group, C₁-C₆₀ heteroaryl group, C₅-C₆₀ aryloxy, C₁-C₆₀ heteroaryloxy group, C₆-C₆₀ arylamino, C₆-C₆₀ heteroarylamino, C₆-C₆₀ diarylamino, C₆-C₆₀ heteroarylamino group, C₆-C₆₀ heterodiarylamino group, C₆-C₆₀ thioaryl group, C₁-C₆₀ heterothioaryl or deuterated analogues thereof;
an index n ranging from 0-4 indicates how many R₃, R₄, R₅, R₆, R₇ may be attached to a particular ring.

In a preferred embodiment of the invention, the compound according to Formula I is selected from the compounds/structures 1-373 and deuterated analogues thereof.

In a preferred embodiment of the invention, R₁ and R₂ are together C₆-C₁₀ alkyl, C₆-C₁₀ alkenyl, C₆-C₁₀ alkynyl groups or their deuterated analogues.

Although the TADF compounds can be used as efficient emission materials themselves or in combination with fluorescent emitters to achieve so-called hiperfluorescence, they can also be used in combination with phosphorescent emitters (most often iridium or platinum complex), which acts as their sensitizers. This approach, called phosphor-sensitized TADF (PST) or phosphor-sensitized fluorescence (PSF), increases the efficiency and operational lifetime of the OLED devices. In this case, the emissive layer is composed of a host, a phosphorescent sensitizer (PS), and doped with a TADF or MR-TADF emissive dopant (also known as a guest). This approach allows for the reduction of the loss in triplet excitons on the TADF emitter.

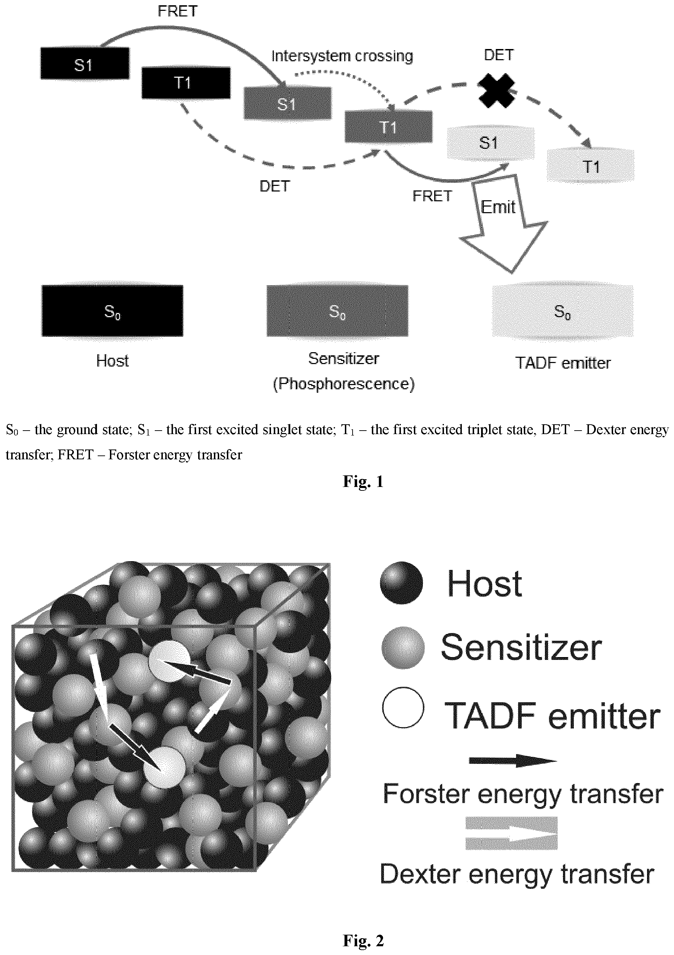

In the PST-based OLEDs, the electron-hole recombination excites the host, forming excitons, and then cascade energy transfer from the host to the PS and then to the TADF dopant occurs (Fig. 1). Also, the directly generated triplet excitons of the PS may transfer their energy to the singlet excited state of TADF by Forster energy transfer (FRET) or to the triplet excited state of TADF by Dexter energy transfer (DET). Although this first process can significantly improve the emission efficiency, the latter is rather undesirable because it may lead to triplet-triplet exciton quenching and the loss of efficiency and operational lifetime of the OLED devices. The final PS to TADF energy transfer process will be regulated by the FRET process rather than the DET process if the PS and the TADF emitter are spatially isolated from each other. The isolation of the sensitizer and TADF emitter favours the FRET and the singlet TADF exciton generation as a major process.

Unexpectedly, an OLED comprising a TADF emissive dopant according to Formula I and the phosphorescent sensitizer characterizes an increased efficiency and operational lifetime in comparison to the known in the art diodes operating basis on the same phenomena. It was noted that the introduction of the compound, according to Formula I, to the emission layer of the OLED diode, comprising also a host and the PS, increases its external quantum efficiency (EQE) and operational lifetime. Moreover, it was noticed that the operational lifetime of the diode containing the compound according to Formula I rises with the length increase in alkyl, alkenyl, and alkynyl carbon chains constituting the substituent R₁ and R₂. The presence of the chains having from 1 atom to 5 atoms as these substituents in the compound of Formula I results in the statistically significant increase of diodes' EQE and operational lifetime in comparison to diodes devoid of the compound according to Formula I. The increase in these parameters reaches the maximum for the chains having from 6 to 10 carbon atoms being the substituent R₁ and R₂ in the compound according to Formula I. If the diodes comprise the compound according to Formula I, whereof the substituent R₁ and R₂ consist of the chains having from 11 to 20 carbon atoms, the statistically significant increase in the same diode parameters' is noted in comparison to diodes devoid of the compound according to Formula I.

This phenomenon can be attributed to the arrangement of molecules relative to each other in the emission layer. The FRET and DET processes depend strongly on distance, and DET occurs at much shorter distances than FRET (Fig. 2). Increasing the distance between PS and TADF reduces the frequency of DET occurrence and, consequently, reduces the density of triplet excitons at the TADF emitter, which translates into its shorter time spent in the excited state and, hence, slower degradation. Undoubtedly, the longer alkyl, alkenyl, and alkynyl chains of R₁ and R₂ on the donor part of Formula I have a repulsive effect on the PS and host molecules, ensuring a sufficient distance for FRET to occur efficiently but not DET. The introduction of chains longer than C₂₀ seems to be cumbersome, because they start to twist and fold and also reduce glass transition temperature of the substance. Consequently, the reduction of glass transition temperature leads to decreasing of diodes' parameters (e.g., EQE, operational lifetime).
An organic light emitting diode (OLED) according to the invention comprises an anode, cathode, and organic emissive layer, disposed between the anode and cathode, wherein the organic emissive layer includes a phosphorescent sensitizer doped with a TADF emissive dopant, and a host, wherein the phosphorescent sensitizer is an organometallic iridium or platinum complex and the TADF emissive dopant is a compound according to Formula I or the compounds/structures 1-373 and deuterated analogues thereof.

In a preferred embodiment of the invention, the organometallic iridium or platinum complex is a compound according to Formula II or Formula III, or a compound is selected from MC-1 to MC-10 and deuterated analogues thereof.

In a preferred embodiment of the invention, the organometallic iridium or platinum complex is selected from the compounds/structures Ir-1-Ir-151 or Pt-1-Pt-228 and deuterated analogues thereof.

In a preferred embodiment of the invention, the diode comprises at least one auxiliary phosphorescent sensitizer. The more preferably the auxiliary phosphorescent sensitizer is selected from a compound according to Formula II, Formula III, or the compounds structures Ir-1 to Ir-151, Pt-1 to Pt-228, MC-1 to MC-10, and deuterated analogues thereof.

In a preferred embodiment of the invention, the diode comprises at least one auxiliary host. The more preferably the auxiliary host is selected from the compounds/structures H-1 to H-164 and deuterated analogues thereof.

In a preferred embodiment of the invention, the diode comprises at least one auxiliary TADF emissive dopand. The more preferably the auxiliary TADF emissive dopand is selected from the compounds/structures E-1-E-60 and deuterated analogues thereof.

In a preferred embodiment of the invention, the diode comprises at least one fluorescence compound. The more preferably the fluorescence compound is selected from: tris(8-hydroxyquinolinato)aluminum (Alq3), bis(2-methyl-8-quinolinato)(4-phenylphenoxy)aluminum(BAlq),bis(2-methyl-8-quinolinato)-4-(phenylphenolato)aluminum (BAlq(PPh2Me)), rubrene (5,6,11,12-tetraphenylnaphthacene), mtCzTrz (9,9'-(5-(4-(3-(3-(tert-butyl)-6-isopropyl-9H-carbazol-9-yl)-5-(3,6-diisopropyl-9H-carbazol-9-yl)phenyl)-6-(4-methoxyphenyl)-1,3,5-triazin-2-yl)-1,3-phenylene)bis(3,6-di-tert-butyl-9H-carbazole)), M1 (4-(2-(4-(diphenylamino)phenyl)-4,5-diphenyl-1H-imidazol-1-yl)phenyl acetate), C-A-C (9,10-bis(3,5-bis(3,6-di-tert-butylcarbazol-9-yl)-phenyl) anthracene), m-ACSO2 (10,10'-(sulfonylbis(3,1-phenylene))bis(9,9-dimethyl-9,10-dihydroacridine)), TXO-TPA (2-[4-(diphenylamino) phenyl]-10, 10-dioxide-9H-thioxanthen-9-one), N-BDAVBi-C6 (4,4'-(1E,1'E)-2,2'-(Naphthalene-2,6-diyl)bis(ethene-2,1-diyl)bis(N,N-bis(4-hexylphenyl)aniline)), PXZPDO (1,3-bis(4-(10H-phenoxazin-10-yl)phenyl)-3-hydroxyprop-2-en-1-one), TPA (9,10-bis[phenyl(m-tolyl)-amino]anthracene), TTPA (9,10-bis[N,N-di-(p-tolyl)-amino]anthracene), 3phCN-ICz (5'-(5-phenylindolo[3,2-a]carbazol-12(SH)-yl)-[1,1':3',1"-terphenyl]-2'-carbonitrile), mCDtCBPy (3,3",6,6"-tetra-tert-butyl-9'-(6-(3-(3,3",6,6"-tetra-tert-butyl-9'H-[9,3':6',9"-tercarbazol]-9'-yl)-phenyl)pyridine-2-yl)-9'H-9,3':6',9"-tercarbazole), DDMACPy (2,6-bis(3-(9,9-dimethylacridin-10(9H)-yl)phenyl)pyridine), BICz (5,5'-(4-(2,12-Di-tert-butyl-5,9-dioxa-13b-boranaphtho[3,2,1-de]anthracen-7-yl)-1,3-phenylene)bis(7,7-dimethyl-5,7-dihydroindeno[2,1-b]carbazole)), BAnF8Pye (1-(7-(9,9'-bianthracen-10-yl)-9,9-dioctyl-9H-fluoren-2-yl)pyrene), BDAF (2-[9,9-di(4-methylphenyl)-fluoren-2-yl]-9,9-di(4-methylphenyl)fluorene), TDAF (2,7-bis[9,9-di(4-methylphenyl)-fluoren-2-yl]-9,9-di(4-methylphenyl)fluorene), 9,10-diphenylanthracene, 3P-T2T (2,4,6-tris[3-(1H-pyrazol-1-yl)phenyl]-1,3,5-triazine), mCBP-CN (3,3'-di(carbazol-9-yl)-5-cyano-1,1'-biphenyl), 9,9'-(((1E,1'E)-(2,5-dimethyl-1,4-phenylene)bis(ethene-2,1-diyl))bis(4,1-phenylene))bis(9H-carbazole), 9,9'-(((1E,1'E)-(2,5 -dimethoxy-1,4-phenylene)bis(ethene-2,1-diyl))bis(4,1 - phenylene))bis(9H-carbazole), 9,9'-(((1E,1'E)-(9,9-dimethyl-9H-fluorene-2,7-diyl)bis(ethene-2,1-diyl))bis(4,1-phenylene))bis(9H-carbazole), 10-(3-(9H-carbazol-9-yl)phenyl)-9,9-dimethyl-9,10-dihydroacridine, 2FPPICz (2-(4-(9H-carbazol-9-yl)phenyl)-1-(3,5-difluorophenyl)-1H-phenanthro[9,10-d]imidazole), CzPVSBF (2,7-bis((E)-4-(9H-carbazol-9-yl)styryl)-9,9'-spirobi[fluorene]), CN-TPB-TPA (4"'-(diphenylamino)-2',5'-diphenyl-[1,1':4',1":4",1‴-quaterphenyl]-4-carbonitrile), BCzTPM (9,9'-bis(4-tritylphenyl)-9H,9'H-3,3'-bicarbazole), PIM-TRZ (2-(3-(4,6-Diphenyl-1,3,5-triazin-2-yl)phenyl)-1-phenyl-1H-benzo[d]imidazole), mCP-t-Bu (1,3-bis(3,6-di-tert-butyl-9H-carbazol-9-yl)benzene), SiCblTrz (9-(4-phenyl-6-(3-(triphenylsilyl)phenyl)-1,3,5-triazin-2-yl)-9H-pyrido[2,3-b]indole), m-BPDBT (3,3'-bis(dibenzo[b,d]thiophen-4-yl)-1,1'-biphenyl), DBTSiDBT (bis(4-(dibenzo[b,d]thiophen-4-yl)phenyl)diphenylsilane), DBFSiDBF (bis(4-(dibenzo[b,d]furan-4-yl)phenyl)diphenylsilane), DBTSF4 (4-(9,9'-spirobi[fluoren]-4-yl)dibenzo[b,d]thiophene), CCP (9-phenyl-3,9'-bi-9H-carbazole), PIAnCN (4-(10-(4-(1-phenyl-1H-phenanthro[9,10-d]imidazol-2-yl)phenyl) anthracen-9-yl)benzonitrile), PIAnTAZ (2-(4-(10-(4-(4,6-diphenyl-1,3,5 -triazin-2-yl)phenyl)anthracen-9-yl)phenyl)-1-phenyl-1H-phenanthro[9,10-d]imidazole), MAD-1N (2-methyl-9,10-di(naphthalen-1-yl)anthracene), SSTF (10-phenyl-2'-(triphenylsilyl)-10H-spiro[acridine-9,9'-fluorene]), BUBH-3 (4,4'-di[10-(naphthalen-1-yl)anthracen-9-yl]biphenyl), 4P-NPB (N,N'-di-(1-naphthalenyl)-N,N' -diphenyl-[1,1':4',1":4",1"'-quaterphenyl]-4,4"'-diamine), BANE (10,10'-di(biphenyl-4-yl)-9,9'-bianthracene), TPyPA (tris[4-(pyrenyl)-phenyl]amine), m-Bpye (1,3-di(pyren-1-yl)benzene), BSBF (2-(9,9-spirobifluoren-2-yl)-9,9-spirobifluorene), BH-9PA (9-(10-phenylanthracen-9-yl)spiro-[benzo[c]fluorene-7,9'-fluorene]), 9-(naphthalen-1-yl)-10-(naphthalen-2-yl)anthracene, pDPFB (1,4-bis(9-phenyl-9H-fluoren-9-yl)benzene), SF34 (3-(9,9'-spirofluorenyl-4-yl)-9,9'-spirofluorene), TCPZ (2,4,6-tris(3-(9H-carbazol-9-yl)phenyl)-1,3,5-triazine), POPH ((5-terphenyl-1,3-phenylene)bis(diphenylphosphine oxide)), DPTPCz (3-(4,6-Diphenyl-1,3,5-triazin-2-yl)-9-phenyl-9H-carbazole), BCz-Si (9-phenyl-9'-(triphenylsilyl)-9H,9'H-3,3'-bicarbazole), 3CzPFP (3-[3-(9H-carbazol-9-yl)phenyl]furo[2,3-b:5,4-b']dipyridine), 4ICDPy (5,12-dihydro-6,7-dimethyl-5,12-di-4-pyridinyl-indolo[3,2-a]carbazole), POSTF (2'-(diphenylphosphoryl)-10-phenyl-10H-spiro[acridine-9,9'-fluorene]), SF3PO (bis(9,9-spirobifluorene-3-yl)-phenylphosphane oxide), CPPyC (9-(5-(3-(9H-carbazol-9-yl)phenyl)pyridin-3-yl)-9H-carbazole), Znq2 (bis(8-hydroxyquinoline) zinc), DBP (dibenzo{[f,f']-4,4',7,7'-tetraphenyl}diindeno[1,2,3-cd:1',2',3'-lm]perylene), DMPPP (1,1'-(2,5-dimethyl-1,4-phenylene)dipyrene), DBPenta (6,13-di-biphenyl-4-yl-pentacene), Spiro-Pye (2,7-dipyrenyl-9,9-spirobifluorene), TPBA (9,9',10,10'-Tetraphenyl-2,2'-bianthracene), BPPF (9,9-bis[4-(pyrenyl)phenyl]-9H-fluorene), TPB3 (1,3,5-tri(pyren-1-yl)benzene), 2,2'-Spiro-Pye (2,2'-dipyrenyl-9,9-spirobifluorene), TSBF (2,7-bis(9,9-spirobifluoren-2-yl)-9,9-spirobifluorene), MADN (2-methyl-9,10-bis(naphthalen-2-yl)anthracene), p-DMDPVBi (1-[2,2-Bis(4-methylphenyl)ethenyl]-4-[4-[2,2-bis(4-methylphenyl)ethenyl]phenyl]benzene), DPVBi (4,4'-bis(2,2-diphenylethenyl)-1,1'-biphenyl), TBADN (2-tert-butyl-9,10-di(naphth-2-yl)anthracene), DCM ((E)-2-(2-(4-(dimethylamino)styryl)-6-methyl-4H-pyran-4-ylidene)malononitrile), DCM2 (4-(dicyanomethylene)-2-methyl-6-julolidyl-9-enyl-4H-pyran), DCMB ((E)-2-(2-(4-(dimethylamino)styryl)-6-tertbutyl-4H-pyran-4-ylidene)malononitrile), (BA-NPB)N10,N10'-diphenyl-N10,N10'-dinaphthalenyl-9,9'-bianthracene-10,10'-diamine.

In a preferred embodiment of the invention, the diode comprises at least one of layer between the anode and cathode selected from: a hole injection layer; hole transport layer; electron transport layer; emission auxiliary layer; electron blocking layer; hole blocking layer; electron injection layer; or a combination thereof.

In a preferred embodiment of the invention, the diode comprises a matrix, preferably the matrix is passive or active.

In a preferred embodiment of the invention, the diode emits light with a maximum wavelength of 350 nm to 2 500 nm. The more preferably with a maximum wavelength of 400 nm to 750 nm.

The addition to the diode of at least one auxiliary TADF is desired as the subsequent emitter(s) if there is a need to obtain a diode emitting white light, or a secondary or tertiary colours, etc. The addition to the diode of at least one fluorescence compound is desired as the subsequent emitter(s) if there is a need to obtain a diode emitting white light, or a secondary or tertiary colours, etc. The addition to the diode of at least one auxiliary host is desired to achieve exciplex hosts - the hosts comprise p-type host + n-host types. The diodes containing exciplex hosts have a lower efficiency roll-off, and a broader recombination zone compared to a single host system. Moreover, the excitons generated in the exciplex hosts are more easily transferred to both the singlet state of the TADF emitter or PS through Förster energy transfer.

An organic light emitting diode according to the invention, wherein the host or a mixture of the host and the auxiliary host(s), constitutes from 60.0% (w./w.) to 99.9% (w./w.) of the emissive layer. More preferably the host or a mixture of the host and the auxiliary host(s), constitutes from 65.0% (w./w.) to 95.0% (w./w.) of the emissive layer. The most preferably the host or a mixture of the host and the auxiliary host(s), constitutes from 87.5% (w./w.) to 92.5% (w./w.) of the emissive layer.

An organic light emitting diode according to the invention, wherein the TADF emissive dopant or a mixture of the TADF emissive dopant and the auxiliary TADF emissive dopant(s), constitutes from 0.01% (w./w.) to 10.00% (w./w.) of the emissive layer. More preferably the TADF emissive dopant or a mixture of the TADF emissive dopant and the auxiliary TADF emissive dopant(s), constitutes from 0.5% (w./w.) to 3.00% (w./w.) of the emissive layer. The most preferably the TADF emissive dopant or a mixture of the TADF emissive dopant and the auxiliary TADF emissive dopant(s), constitutes from 1.5% (w./w.) to 2.5% (w./w.) of the emissive layer.

An organic light emitting diode according to the invention, wherein the phosphorescent sensitizer or a mixture of the phosphorescent sensitizers and the auxiliary phosphorescent sensitizer(s), constitutes from 0.05% (w./w.) to 40.00% (w./w.) of the emissive layer. More preferably the phosphorescent sensitizer or a mixture of the phosphorescent sensitizers and the auxiliary phosphorescent sensitizer(s), constitutes from 1.00% (w./w.) to 30.00% (w./w.) of the emissive layer. The most preferably the phosphorescent sensitizer or a mixture of the phosphorescent sensitizers and the auxiliary phosphorescent sensitizer(s), constitutes from 7.5% (w./w.) to 12.5% (w./w.) of the emissive layer.

The mixture host and the auxiliary host(s) instead of a host is beneficial, because the subsequent (auxiliary) hosts can be needed for sensitization of subsequent (auxiliary) phosphorescent sensitizers in diodes emitting white light, or a secondary or tertiary colours, etc. The mixture of the phosphorescent sensitizers and the auxiliary phosphorescent sensitizer(s) instead of a phosphorescent sensitizer is beneficial, because the subsequent (auxiliary) phosphorescent sensitizers can be needed for sensitization of subsequent (auxiliary) TADFs in diodes that emit white light, or a secondary or tertiary colours, etc.

The content of host or a mixture host and the auxiliary host(s) in the range from 60.0% (w./w.) to 99.9% (w./w.) of the emissive layer, leads to the increase in EQE and simultaneously the decrease in roll-off. The reason for that is the move of the emitter molecules away from each other reduces their mutual extinction. The maximum effect is observed when the host is above 70.0% (w./w.) of the emissive layer.

The content of TADF emissive dopand or a mixture of the TADF emissive dopant and the auxiliary TADF emissive dopant(s) in the range from 0.01% (w./w.) to 10.00 (w./w.) of the emissive layer, leads to the increase in EQE and simultaneously the decrease in roll-off. The reason for that is the move of the emitter molecules away from each other reduces their mutual extinction. The maximum effect is observed when the host is above 2.0% (w./w.) of the emissive layer.

The content of the phosphorescent sensitizer or a mixture of the phosphorescent sensitizers and the auxiliary phosphorescent sensitizer(s) in the range from 0.05% (w./w.) to 40.00 (w./w.) of the emissive layer, leads to the increase in EQE and simultaneously the decrease in roll-off. The reason for that is the move of the PS molecules away from each other reduces their mutual extinction. The maximum effect is observed when the PS concentration is below 20.0% (w./w.) of the emissive layer.

Use of the diode according to the invention as a display screen or illumination device, an electroluminescent display device, an organic photovoltaic device, or a sensing device.

A consumer product comprises the diode according to the invention, wherein the product is selected from a flat panel display, a computer monitor, a medical monitor, a television, a billboard, a light for interior or exterior illumination/signalling, a heads-up display, a fully or partially transparent display, a flexible display, a laser printer, a telephone, a cell phone, tablet, a phablet, a personal digital assistant, a wearable device, a laptop computer, a watch, a backlight, a digital camera, a camcorder, a 3-D display, a virtual reality or augmented reality display, a vehicle, a video walls comprising multiple displays tiled together, a theatre, stadium screen, and a sign.

### General definition of terms and substituents

As used herein, the terms "or" and "and/or" include any and all combinations of one or more of the associated listed items. The term "or" is not an exclusive term, e.g., A or B means: A, B, or A and B. The expression "at least one" comprises at least one, two, three, four, five and more mentioned elements (etc.).

It should be understood that the terms "comprises," "comprising," "includes," "including," "has", "have," "having," "contains," "containing," and the like are intended to specify the presence of stated features, integers, steps, operations, elements, components, or combinations thereof in the disclosure, but do not preclude the presence or addition of one or more other features, integers, steps, operations, elements, components, or combinations thereof.

Certain chemical compound can have one or more hydrogen atoms of the compound replaced by one or more deuterium atoms including perdeuterated analogues. Further, it should be noted that the term "deuterated analog" as used herein refers to compounds where at least one hydrogen atom has been replaced by a deuterium atom. The term "deuterated" as used herein alone or as part of a group, means substituted deuterium atoms. When a particular position is designated as holding deuterium (stated as "D" or "deuterium"), it is understood that the abundance of deuterium at that position is substantially greater than the natural abundance of deuterium, which is 0.015% (i.e., at least 50.1% incorporation of deuterium). The deuterated analog of the present disclosure may be a fully or partially deuterium substituted derivative. For example, the deuterium substituted compound of the present disclosure can hold a fully or partially deuterium substituted alkyl, aryl or heteroaryl group. In one embodiment, the deuterium substituted compound of the present disclosure holds a fully or partially deuterium substituted alkyl group, e.g., -CD₃, CD₂, CD₃, -CD₂, and the like. In another embodiment, the deuterium substituted compound of the present disclosure holds a fully or partially deuterium substituted aryl, such as phenyl, e.g., CeDs or a fully or partially deuterium substituted heteroaryl, e.g., pyridyl-d₃, and the like.

The term "Ph" used herein refers to a phenyl group, the term "Me" used herein refers to a methyl group, the term "Et" used herein refers to an ethyl group, the term "Bu" as used herein refers to a butyl group and the term "*tert*-Bu" or "t-Bu" as used herein refers to a *tert*-butyl group, the term "Pr" used herein refers to a propyl group, the term "iPr" used herein refers to an isopropyl group, the term "TMS" used herein refers to a trimethylsilyl group, and the term "OMe" used herein refers to a methoxy group, the term "DMF" used herein refers to dimethylformamide, the term "AcOEt" used herein refers to ethyl acetate, the term "MeOH" used herein refers to methanol, the term "t-BuONa" used herein refers to sodium *tert*-butoxide.

Organic groups include both substituted and unsubstituted forms of such groups unless otherwise denoted. The term "substituted" refers to at least one hydrogen replaced by deuterium, halogen, C₁-C₆₀ alkyl, C₂-C₆₀ alkenyl, C₂-C₆₀ alkynyl, C₁-C₆₀ alkoxy group, C₃-C₆₀ cycloalkyl, C₃-C₆₀ cycloalkenyl, C₁-C₆₀ heterocycloalkyl, C₁-C₆₀ heterocycloalkenyl, C₃-C₆₀ cycloalkynyl group, C₁-C₆₀ heterocycloalkynyl group, hydroxyl, C₂-C₆₀ ether group, C₅-C₆₀ aryloxy, C₆-C₆₀ thioaryl, C₁-C₆₀ heterothioaryl, C₁-C₆₀ amino, C₁-C₆₀ alkylamino, C₁-C₆₀ dialkylamino, C₆-C₆₀ arylamino, cyano, nitro, hydrazine, hydrazone, C₆-C₆₀ diarylamino, C₆-C₆₀ heteroarylamino group, C₆-C₆₀ heterodiarylamino group, C₆-C₆₀ aryl, C₁-C₆₀ heteroaryl group, C₁-C₆₀ heteroaryloxy group, C₄-C₆₀ non-aromatic fused polycyclic group, C₁-C₆₀ non-aromatic fused heteropolycyclic group, or deuterated analogues thereof.

The term "a mixture of the host and the auxiliary host(s)" as used herein refers to a mixture of one, two, three or more auxiliary hosts. The term "a mixture of the TADF emissive dopant and the auxiliary TADF emissive dopant(s)" as used herein refers to a mixture of one, two, three or more auxiliary TADF emissive dopants. The term "a mixture of the phosphorescent sensitizers and the auxiliary phosphorescent sensitizer(s)" as used herein refers to a mixture of one, two, three or more auxiliary phosphorescent sensitizers.

The term "C₁-C₆₀ alkyl group" as used herein refers to a linear or branched aliphatic saturated hydrocarbon group having 1 to 60 carbon atoms, and examples thereof include methyl group, an ethyl group, a propyl group, an isopropyl group, a butyl group, an isobutyl group, a sec-butyl group, a *tert*-butyl group, a pentyl group, an isoamyl group, a neopentyl group, a hexyl group, 2-methylpentyl group, a 3-methylpentyl group, a heptyl group, a 4-methylhexyl group, a 2,2-dimethylpentyl group, an octyl group, a 3-methylheptyl group, a nonyl group, a 4-methyloctyl group, a 3-ethylheptyl group, a decyl group, a 2-methylnonyl group, a 3,3-dimethyloctyl group, an undecyl group, a dodecyl group, a tridecyl group, a tetradecyl group, a pentadecyl group, a hexadecyl group, a heptadecyl group, an octadecyl group, a nonadecyl group, an eicosyl group, a heneicosyl group, a docosyl group, a tricosyl group, a tetracosyl group, a pentacosyl group, a hexacosyl group, a heptacosyl group, an octacosyl group, a nonacosyl group, a triacontyl group, a hentriacontyl group, a dotriacontyl group, a tritriacontyl group,a tetratriacontyl group, a pentatriacontyl group, a hexatriacontyl group, a heptatriacontyl group, an octatriacontyl group, a nonatriacontyl group, a tetracontyl group, a hentetracontyl group,a dotetracontyl group, a tritetracontyl group, a tetratetracontyl group, a pentatetracontyl group, a hexatetracontyl group, a heptatetracontyl group, an octatetracontyl group, a nonatetracontyl group, a pentacontyl group, a hentapentacontyl group, a dotriacontyl group, a tritriacontyl group, a tetratetracontyl group, a pentapentacontyl group, a hexapentacontyl group,a heptapentacontyl group, a octapentacontyl group, a nonapentacontyl group, a hexacontyl group and others.

The term "C₁-C₂₀ alkyl group" as used herein refers to a linear or branched aliphatic saturated hydrocarbon group having 1 to 20 carbon atoms. The term "C₆-C₁₀ alkyl group" as used herein refers to a linear or branched saturated hydrocarbon group having 6 to 10 carbon atoms.

The term "C₂-C₆₀ alkenyl group" as used herein refers to a linear or branched aliphatic unsaturated hydrocarbon group having at least one carbon-carbon double bond in the middle or at the terminus of the C₂-C₆₀ alkyl group, and examples thereof include an ethenyl group, a propenyl group, a isopropenyl group, a butenyl group, a 2-methyl-1-propenyl group, a 2-methyl-2-butenyl group, a 3-methyl-2-butenyl group, a pentenyl group, a 4-methyl-2-butenyl group, a hexenyl group, a 2,3-dimethyl-2-butenyl group, a 4,4-dimethyl-1-butenyl group, a heptenyl group, a 3,4-dimethyl-3-butenyl group, an octenyl group, a 2,3-dimethyl-2-hexenyl group, a nonenyl group, a 2-methyl-3-heptenyl group, a decenyl group, a 4-ethyl-4-octenyl group, an undecenyl group, a dodecenyl group, a tridecenyl group, a tetradecenyl group, a pentadecenyl group, a hexadecenyl group, a heptadecenyl group, an octadecenyl group, a nonadecenyl group, an eicosenyl group, a heneicosenyl group, a docosenyl group, a tricosenyl group, a tetracosenyl group, a pentacosenyl group, a hexacosenyl group, a heptacosenyl group, an octacosenyl group, a nonacosenyl group, a triacontenyl group, a hentriacontenyl group, a dotriacontenyl group, a tritriacontenyl group, a tetratriacontenyl group, a pentatriacontenyl group, a hexatriacontenyl group, a heptatriacontenyl group, an octatriacontenyl group, a nonatriacontenyl group, a tetracontenyl group, a hentetracontenyl group, a dotetracontenyl group, a tritetracontenyl group, a tetratetracontenyl group, a pentatetracontenyl group, a hexatetracontenyl group, a heptatetracontenyl group, an octatetracontenyl group, a nonatetracontenyl group, a pentacontenyl group, a hentapentacontenyl group, a dotriacontenyl group, a tritriacontenyl group, a tetratetracontenyl group, a pentapentacontenyl group, a hexapentacontenyl group, a heptapentacontenyl group, an octapentacontenyl group, a nonapentacontenyl group, a hexacontenyl group and others.

The term "C₂-C₂₀ alkenyl group" as used herein refers to a linear or branched aliphatic unsaturated hydrocarbon group having 2 to 20 carbon atoms, wherein at least one carbon-carbon double bond is in the middle or at the terminus of the C₂-C₂₀ alkyl group. The term "C₆-C₁₀ alkenyl group" as used herein refers to a linear or branched aliphatic unsaturated hydrocarbon group having 6 to 10 carbon atoms, wherein at least one carbon-carbon double bond is in the middle or at the terminus of the C₂-C₁₀ alkyl group.

The term "C₂-C₆₀ alkynyl group" as used herein refers to a linear or branched aliphatic unsaturated hydrocarbon group having at least one carbon-carbon triple bond in the middle or at the terminus of the C₂-C₆₀ alkyl group, and examples thereof include an ethynyl group, and a propynyl group, a butynyl group, a 2-methyl-2-propynyl group, a pentynyl group, a 3-ethyl-2-butynyl group, a hexynyl group, a 3,3-dimethyl-1-butynyl group, a heptynyl group, a 3-propyl-3-pentynyl group, an octynyl group, a 2,3-dimethyl-2-hexynyl group, a nonynyl group, a 3,4-dimethyl-3-heptynyl group, a decynyl group, a 2-ethyl-2-octynyl group, an undecynyl group, a dodecynyl group, a tridecynyl group, a tetradecynyl group, a pentadecynyl group, a hexadecynyl group, a heptadecynyl group, an octadecynyl group, a nonadecynyl group, an eicosynyl group, a heneicosynyl group, a docosynyl group, a tricosynyl group, a tetracosynyl group, a pentacosynyl group, a hexacosynyl group, a heptacosynyl group, an octacosynyl group, a nonacosynyl group, a triacontynyl group, a hentriacontynyl group, a dotriacontynyl group, a tritriacontynyl group, a tetratriacontynyl group, a pentatriacontynyl group, a hexatriacontynyl group, a heptatriacontynyl group, an octatriacontynyl group, a nonatriacontynyl group, a tetracontynyl group, a hentetracontynyl group, a dotetracontynyl group, a tritetracontynyl group, a tetratetracontynyl group, a pentatetracontynyl group, a hexatetracontynyl group, a heptatetracontynyl group, an octatetracontynyl group, a nonatetracontynyl group, a pentacontynyl group, a hentapentacontynyl group, a dotriacontynyl group, a tritriacontynyl group, a tetratetracontynyl group, a pentapentacontynyl group, a hexapentacontynyl group, a heptapentacontynyl group, an octapentacontynyl group, a nonapentacontynyl group, a hexacontynyl group, and others.

The term "C₂-C₂₀ alkynyl group" as used herein refers to a linear or branched aliphatic unsaturated hydrocarbon group having 2 to 20 carbon atoms, wherein at least one carbon-carbon triple bond is in the middle or at the terminus of the C₂-C₂₀ alkynyl group. The term "C₆-C₁₀ alkynyl group" as used herein refers to a linear or branched aliphatic unsaturated hydrocarbon group having 6 to 10 carbon atoms, wherein at least one carbon-carbon triple bond is in the middle or at the terminus of the C₂-C₁₀ alkynyl group.

The term "C₃-C₆₀ cycloalkyl group" as used herein refers to a monocyclic or polycyclic and non-aromatic saturated group that has 3 to 60 carbon atoms. When the C₃-C₆₀ cycloalkyl group includes two or more rings, the rings may be fused to each other. The examples thereof include a cyclopropyl group, a cyclobutyl group, a cyclopentyl group, a cyclohexyl group, and a cycloheptyl group, a cyclooctyl group, a cyclononyl group, a cyclodecyl group, a cycloundecyl group, a cyclododecyl group, a cyclotridecyl group, a cyclotetradecyl group, a cyclopentadecyl group, a cyclohexadecyl group, a cycloheptadecyl group, a cyclooctadecyl group, a cyclononadecyl group, a cycloeicosyl group, a cycloheneicosyl group, a cyclodoecosyl group, a cyclotricosyl group, a cyclotetracosyl group, a cyclopentacosyl group, a cyclohexacosyl group, a cycloheptacosyl group, a cyclooctacosyl group, a cyclononacosyl group, a cyclotriacontyl group, a cyclohentriacontyl group, a cyclodotriacontyl group, a cyclotritriacontyl group, a cyclotetratriacontyl group, a cyclopentatriacontyl group, a cyclohexatriacontyl group, a cycloheptatriacontyl group, a cyclooctatriacontyl group, a cyclononatriacontyl group, a cyclo tetracontyl group, a cyclohentetracontyl group, a cyclodotetracontyl group, a cyclotritetracontyl group, a cyclotetratetracontyl group, a cyclopentatetracontyl group, a cyclohexatetracontyl group, a cycloheptatetracontyl group, a cyclooctatetracontyl group, a cyclononatetracontyl group, a cyclopentacontyl group, a cyclohentapentacontyl group, a cyclodotriacontyl group, a cyclotritriacontyl group, a cyclotetratetracontyl group, a cyclopentapentacontyl group, a cyclohexapentacontyl group, a cycloheptapentacontyl group, a cyclooctapentacontyl group, a cyclononapentacontyl group, a cyclohexacontyl group, and others.

The term "C₁-C₆₀ heterocycloalkyl group" as used herein refers to a cycloalkyl group having at least one heteroatom selected from N, O, Si, P, and S as a ring-forming atom and 1 to 60 carbon atoms. When C₁-C₆₀ heterocycloalkyl group includes two or more rings, the rings may be fused to each other. The examples thereof include 1,2,3,4-oxatriazolidinyl group, a tetrahydrofuranyl group, and a tetrahydrothiophenyl group, a pyrrolidinyl group, an oxetanyl group, a thiiranyl group, a piperidinyl group, an azetidinyl group, a silacyclopropyl group, a furan group, a pyridinyl group, a dithianyl group, a phospholanyl group, a thiazolyl group, a siloxanyl group, a morpholinyl group, an oxazolyl group, a thiophenyl group, and an aziridinyl group, tetrahydropyranyl group, a silacyclohexyl group, a phosphabicycloheptyl group, and others.

The term "C₃-C₆₀ cycloalkenyl group" used herein refers to a monocyclic or polycyclic and non-aromatic unsaturated group that has 3 to 60 carbon atoms and at least one carbon-carbon double bond in the ring thereof. When the C₃-C₆₀ cycloalkenyl group includes two or more rings, the rings may be fused to each other. The examples thereof include a cyclopropenyl group, a cyclobutenyl group, a cyclopentenyl group, a cyclohexenyl group, a cycloheptenyl group, a cyclooctenyl group, a cyclononenyl group, a cyclodecenyl group, a cycloundecenyl group, a cyclododecenyl group, a cyclotridecenyl group, a cyclohexadecenyl group, a cyclooctadecenyl group, a cyclotetradecenyl group, a cyclotriacosenyl group, a cyclotetracontenyl group, a cyclopentacontenyl group, a cyclohexacontenyl group and others.

The term "C₁-C₆₀ heterocycloalkenyl group" as used herein refers to a cycloalkenyl group that has at least one heteroatom selected from N, O, Si, P, and S as a ring-forming atom, having 1 to 60 carbon atoms, and at least one double bond in its ring. When the C₁-C₆₀ heterocycloalkenyl group includes two or more rings, the rings may be fused to each other. The examples of thereof include a 4,5-dihydro-1,2,3,4-oxatriazolyl group, a 2,3-dihydrofuranyl group, a 2,3-dihydrothiophenyl group, a pyrrolenyl group, a furanyl group, a thiophenyl group, a pyrrolopyridenyl group, an oxetanyl group, an azetidinyl group, a dioxasilolanyl group, a phospholanyl group, a pyrrolizidinyl group, an oxepinyl group, a thiepinyl group, a silacyclohexenyl group, a piperidinylidene group, an oxocyclooctenyl group, an azononacyclohexenyl group and others.

The term "C₃-C₆₀ cycloalkynyl group" used herein refers to a monocyclic or polycyclic and non-aromatic unsaturated group that has 3 to 60 carbon atoms and at least one carbon-carbon triple bond in the ring thereof. When the C₃-C₆₀ cycloalkynyl group includes two or more rings, the rings may be fused to each other. The examples thereof include a cyclopropynyl group, a cyclobutynyl group, a cyclopentynyl group, a cyclohexynyl group, a cycloheptynyl group, a cyclooctynyl group, a cyclononylyl group, a cyclodecynyl group, a cycloundecynyl group, a cyclododecynyl group, a cyclotridecynyl group, a cyclotetradecynyl group, a cyclopentadecynyl group, a cyclohexadecynyl group, a cycloheptadecynyl group, a cyclooctadecynyl group, a cyclononadecynyl group, a cyclotriacontynyl group, a cyclotriacosynyl group, a cyclotetracontynyl group, a cyclopentacontynyl group, a cyclohexacontynyl group.

The term "C₁-C₆₀ heterocycloalkynyl group" as used herein refers to a cycloalkynyl group that has at least one heteroatom selected from N, O, Si, P, and S as a ring-forming atom, having 1 to 60 carbon atoms, and at least one triple bond in its ring. When the C₁-C₆₀ heterocycloalkynyl group includes two or more rings, the rings may be fused to each other. The examples thereof include a pyridinylcyclopropynyl group, an oxazolylcyclobutynyl group, a thiophenylcyclopentynyl group, a silylcyclohexynyl group, a phosphacycloheptynyl group, a pyrazinylcyclooctynyl group, an oxacyclononynyl group, a thiasilacyclodecynyl group, an isoxazolylcycloheptenyl group, a pyrimidinylcyclopentadienyl group, a triazinylcyclohexadienyl group, a phosphoranylpyridinylcycloheptenyl group, an oxathiacyclononadienyl group, a silylpyrazinylcyclooctadienyl group, a pyridazinylcyclooctatrienyl group, an isothiazolylsilylcyclononatrienyl group, a thiophenylphosphacyclodecatrienyl group, a pyrimidinylsilylcycloheptadienyl group, an oxazinylphosphoranylcyclodecadienyl group, a silylthiasilacyclohexatrienyl group

The term "C₆-C₆₀ aryl group" as used herein refers to a carbocyclic aromatic group having 6 to 60 carbon atoms. When the C₆-C₆₀ aryl group includes two or more rings, the rings may be fused to each other. The examples thereof include a phenyl group, a naphthyl group, an anthracenyl group, a phenanthrenyl group, a pyrenyl group, a chrysenyl group, a biphenyl group, a triphenylenyl group, a fluorenyl group, a perylenyl group, a coronene-ovalenyl group, a dibenzo[a,e]pentalenyl group, a tetrabenzo[a,c,f,h]pentaphenyl group, a hexabenzo[a,c,f,h,k,n]pentadecaphenyl group, an octabenzo[a,c,f,h,k,n,q,u]icosaphenyl group, a toluyl group, a xylyl group, a diphenylmethyl group, a terphenyl group and others.

The term "C₁-C₆₀ heteroaryl group" as used herein refers to an aryl group having a at least one heteroatom selected from N, O, Si, P, and S as a ring-forming atom, and having 1 to 60 carbon atoms. When the C₁-C₆₀ heteroaryl group includes two or more rings, the rings may be fused with each other. The examples thereof include a pyrimidinyl group, a pyrazinyl group, a pyridazinyl group, a triazinyl group, a quinolinyl group, an isoquinolinyl group, a furan-2-yl group, a thiophen-3-yl group, an imidazol-4-yl group, a thiazol-2-yl group, an oxazol-5-yl group, a pyrrole-2-yl group, an indol-3-yl group, a benzofuran-4-yl group, a benzothiophen-2-yl group, a benzimidazol-1-yl group, a benzothiazol-4-yl group, an isoxazol-3-yl group, a pyridin-4-ylmethyl group, a quinoxalin-2-yl group, a naphtho[1,2-d]imidazol-4-yl group, a tetrazol-1-yl group, a 1,2,3-triazol-4-yl group, a pyridin-2-ylmethoxy group, a thieno[2,3-c]pyridin-4-yl group, a 3,4-dihydro-2H-pyran-2-yl group, a 1,3-dioxol-2-yl group, a pyrazolo[1,5-a]pyridin-3-yl group, a benzofuran-2-ylmethyl group, a carbazole group, an indolocarbazole group, a phenoxazine group, a phenothiazine group, a benzimidazoquinazoline group, a pyridocarbazole group, a pyrrolopyrazine group, a quinoxaline-2,3-dione group, an isoxazole-3,5-dione group, an indole-3-carboxylic acid group, a dibenzofuranone group, a pyrroloquinoxaline group, an imidazo[1,2-a]pyrimidine group, a thiazolo[4,5-d]pyrimidine group, a benzothiazole-5-sulfonamide group, a 1H-pyrazolo[3,4-b]quinolin-3-amine group, a furo[3,2-c]pyridin-4(5H)-one group, a 1,3-dihydro-2H-indol-2-one group, a 2H-indazole-3-carboxylic acid group, a pyrazolo[1,5-a]pyrimidin-3-amine group, a 3H-indole-4-carbonitrile group, a benzoxazin-3-one group, a benzothiophene-2-carboxylic acid group, an isothiazole-3-carboxylic acid group, a pyrido[2,3-b]pyrazin-7-one group, a 3H-quinazolin-4-one group, a benzofurazan-5-amine group, a 1,2,4-triazolo[4,3-a]pyridine group, a 1,3,4-oxadiazole-2(3H)-thione group, a 2H-thiopyran-4,6-dione group, a pyrrolo[1,2-a]quinoxaline-4,7-dione group, a silylpyridine group, a phosphorylpyrazole group, an oxiranylpyrimidine group, a thioxanthyl group, a siloxazinyl group, a phosphonaphthyl group, a dioxaphenanthrenyl group, a thiophenylsiloxane group, an oxatriazinyl group, a silylpyrrole-2-carboxylic acid group, a phosphinophenoxazine group, a silathiazolyl group, an oxadithienyl group, a phosphabenzimidazole group, a silaquinolinyl group, an oxepino[2,3-b]pyridinyl group, a dioxaphenanthrenylpyrazinyl group, a phosphorothiazolidinyl group, a silaisoxazolyl group, an oxazolidinylpyridyl group and others.

The term "C₁-C₆₀ alkoxy group" as used herein refers to an alkyl group which is singularly bonded to oxygen forming thus R-O-. The examples thereof include a methoxy group, an ethoxy group, and an isopropyloxy group, a propoxy group, a butoxy group, a *tert-*butoxy group, a sec-butoxy group, an iso-butoxy group, a pentoxy group, an iso-amyloxy group, a neo-pentoxy group, a hexoxy group, a heptoxy group, an octoxy group, a nonoxy group, a decoxy group, an undecoxy group, a dodecoxy group, a pentadecoxy group, an eicosoxy group, a pentacosoxy group, a triacontoxy group, a pentatriacontoxy group, a tetracontoxy group, a pentatetracontoxy group, a pentacontoxy group, a pentapentacontoxy group, and a hexacontoxy group and others.

The term "C₅-C₆₀ aryloxy group" as used herein refers to an aryl which is singularly bonded to oxygen forming thus Ar-O-. The examples thereof include include a methoxyphenyl group, an ethoxyphenyl group, a propoxyphenyl group, an isopropoxyphenyl group, a butoxyphenyl group, a pentoxyphenyl group, a hexoxyphenyl group, a heptoxyphenyl group, an octoxyphenyl group, a nonoxyphenyl group, a decoxyphenyl group, a dodecoxyphenyl group, a hexadecoxyphenyl group, a triacontaoxyphenyl group, a hexacontaoxyphenyl group, a phenylmethoxy group, a naphthoxy group, a biphenyloxy group, an anisoyloxy group, a toluoyloxy group, a xylyloxy group, a benzoyloxy group, a napththoyloxy group, an anthryloxy group, a perylenyloxy group, a fluorenyloxy group, a triphenyloxy group, a phenoxyphenyl group, a naphthoxyphenyl group, a pyrenyloxy group and others.

The term "C₁-C₆₀ heteroaryloxy group" as used herein refers to an aryloxy group having a at least one heteroatom selected from N, O, Si, P, and S as a ring-forming atom, and having 1 to 60 carbon atoms. The examples thereof include a pyridinyloxy group, a furanoyloxy group, a thiophenoyloxy group, a siloxanoyloxy group, a phosphinoyloxy group, a pyrimidinyloxy group, a pyrazinyloxy group, a thiazolinyloxy group, an isoxazolinyloxy group, a benzoxazinoyloxy group, a benzothiazolinyloxy group, an imidazolinyloxy group, a pyridazinyloxy group, a silathiazolinyloxy group, an isothiazolinyloxy group, an oxazolinyloxy group, a silabenzoxazinoyloxy group, a phosphabenzothiazolinyloxy group, a dibenzofuranyloxy group, a silaisoxazolinyloxy group. and others.

The term "C₂-C₆₀ ether group" as used herein refers to a group containing an ether group - an oxygen atom connected to two selected from: alkyl, alkenyl, alkynyl, and aryl group, where the ether group having 2 to 60 carbon atoms. The examples thereof include: a methyl ether group, an ethyl ether group, an isopropyl ether group, a *tert*-butyl ether group, a phenyl ether group, an anisyl ether group, a benzyl ether group, an allyl ether group, a methoxyethyl ether group, an ethoxyethyl ether group, a methylphenyl ether group, an ethylphenyl ether group, an isobutyl ether group, a cyclohexyl ether group, a methoxymethyl ether group, an ethoxymethyl ether group, a propyl ether group, a butyl ether group, a pentyl ether group, a hexyl ether group, a methoxypropyl ether group, an ethoxypropyl ether group, a dimethyl ether group, a diethyl ether group, a dipropyl ether group, a dibutyl ether group, a dipentyl ether group, a methoxyisopropyl ether group, an ethoxyisopropyl ether group, a methoxy*tert*-butyl ether group, a methoxyphenyl ether group, an ethoxyphenyl ether group, a p-tolyl ether group, an o-anisyl ether group, a naphthyl ether group, a biphenyl ether group, a 2-methylphenyl ether group, a 4-ethylphenyl ether group, a 3-methoxyphenyl ether group, a 2,4-dimethylphenyl ether group, a 3,5-diethylphenyl ether group, a 2,4,6-trimethylphenyl ether group, a 2,3-dimethoxyphenyl ether group, a 2,4-diethylphenyl ether group, a 4-methoxynaphthyl ether group, a 3,4-diphenylnaphthyl ether group and others.

The term "C₆-C₆₀ thioaryl group" as used herein refers to a group derived from a thioether with R as an aryl group. The group has 6 to 60 carbon atoms. When the C₆-C₆₀ thioaryl group includes two or more rings, the rings may be fused to each other. The examples thereof include a thiophenyl group, a thionaphthyl group, a thioanthryl group, a thiophenanthryl group, a thiopyryl group, a thiobenzofuranyl group, a thioindolyl group, a thioquinolyl group, a thiopyridazinyl group, a thionaphthoquinolyl group, a thiopyrimidinyl group, a thiochromenyl group, a thioacridinyl group, a thiodibenzothiophenyl group, a thiotriphenylmethyl group and others.

The term "C₁-C₆₀ heterothioaryl" as used herein refers to a thioaryl group having 1 to 60 carbon atoms, where two or more rings fused to each other, at least one heteroatom selected from N, O, Si, P, and S, other than carbon atoms, as a ring-forming atom. Examples of the thereof include a pyrimidothioaryl group, a thieno[2,3-b][1,4]dioxinyl group, a pyrazinothioaryl group, a benzothiazolyl group, a dibenzothiophenyl group, a thiopheno[3,4-b]pyrrolyl group, an isothiazolylthioaryl group, a naphthothiophenyl group, a thianthrenyl group, an indolizinothioaryl group, a dithiolo[3,4-b]pyrrolyl group, a selenopheno[2,3-b]pyridinyl group, a pyrrolo[2,3-b]thiophenyl group, an oxazolo[2,3-b]pyridinylthioaryl group, a pyrrolizinothioaryl group and others.

The term "C₁-C₆₀ amino group" as used herein refers to an organic compound comprises -N(R)₂, where R is, together or independently, selected from: hydrogen, deuterium, alkyl, alkenyl, alkynyl, aryl group, and heteroarylo group. The amino group has 1 to 60 carbon atoms. The term "C₁-C₆₀ alkylamino" as used herein refers amino group wherein R is an alkyl group. The term "C₁-C₆₀ dialkylamino" as used herein refers amino group wherein both R are alkyl groups. The term "C₆-C₆₀ arylamino group" as used herein refers amino group wherein R is an aryl group. The term "C₆-C₆₀ diarylamino group" as used herein refers amino group wherein both R are aryl groups. The term "C₆-C₆₀ heteroarylamino group" as used herein refers amino group wherein R is a heteroaryl group. The term "C₆-C₆₀ heterodiarylamino group" as used herein refers amino group wherein both R are heteroaryl groups. The examples of the amino group includes a methylamino group, a phenylamino group, a diphenylamino group, a naphthylamino group, a 9-methyl-anthracenylamino group, an ammonium group, a dimethylamino group, a diethylamino group, a methylanilino group, an ethylanilino group, an ethylphenylamino group, a diethylphenylamino group, a methoxymethylamino group, a methylbenzylamino group, an anilino group, a phenanthryl amino group, an ethoxyethylamino group, a pyridinylamino group, a quinolinylamino group, an isoquinolinylamino group, an imidazolylamino group, a benzimidazolylamino group, a triazolylamino group, a pyrazinylamino group, a pyrimidinylamino group, a thiazolylamino group, an oxazolylamino group, an isoxazolylamino group, an indolylamino group, a quinoxalinylamino group, a benzothiazolylamino group, a benzoxazolylamino group, a carbamoyl group, a thiocarbamoyl group, a sulfonylamino group, a sulfamoyl group, an amidoaryl group, a hydrazinyl group, a hydrazinoaryl group, a guanidinyl group, a guanidinoaryl group, an amidinyl group, an amidinoaryl group, a thiosemicarbazidyl group, a triazolethioamide group and others.

The term "C₁-C₆₀ amidino group" as used herein refers to an organic compound comprises at least one -RC(NR)NR₂ group, where R is, together or independently, selected from: hydrogen, deuterium, alkyl, alkenyl, alkynyl, and aryl group, where the amidino group has 1 to 60 carbon atoms. The examples thereof include: a methylamidino group, an ethylamidino group, a propylamidino group, a butylamidino group, a vinylamidino group, an allylamidino group, a phenylamidino group, a benzylamidino group, a tolylamidino group, a naphthylamidino group, a cyclopropylamidino group, a cyclohexylamidino group, an ethynylamidino group, a propynylamidino group, a 2-ethylbutylamidino group, an isopropylamidino group, an octylamidino group, a 2-methoxyethylamidino group, a 4-phenylbutylamidino group, a 3,4-dimethylcyclohexylamidino group, a 1,8-diazabicyclo[5.4.0]undec-7-enyl group, a diminazenyl group, a benzamidino group, a pentamidino group and others.

The term "a cyano group" as used herein refers to a -C=N functional group.

The term "a nitro group" as used herein refers to a -NO₂ functional group.

The term "a halogen" as used herein refers to fluorine, chlorine, bromine, or iodine.

The term "C₄-C₆₀ non-aromatic fused polycyclic group" as used herein refers to a group, having 4 to 60 carbon atoms, where two or more rings fused with each other, only carbon atoms as ring-forming atoms, and no aromaticity in its entire molecular structure. The examples thereof include a fluorenyl group, a cyclobutylcyclopentyl group, a cyclopentylcyclohexyl group, a decalinyl group, a bicyclo[3.2.1]octanyl group, a dicyclo[4.4.0]decanyl group, a spiro[4.4]nonanyl group, a tetracyclo[5.3.0.0²,⁶.0³,⁵]decanyl group, a pentacyclo[6.4.0.0²,⁶.0³,¹⁰.0⁵,⁹]dodecanyl group, a tricyclo[3.2.1.0²,⁴]octanyl group, a bicyclo[4.3.1]decanyl group, a tetradecahydrophenanthrenyl group, a tricyclo[5.3.1.0²,⁶]dodecanyl group, a dicyclo[6.4.0]tetradecanyl group, a pentacyclo[7.3.1.0²,⁷.0³,⁶]tetradecanyl group, a tetracyclo[8.3.1.0²,⁸.0³,¹⁰.0⁶,⁹]hexadecanyl group, a hexacyclo[9.3.1.0²,⁹.0³,¹¹.0⁶,¹⁰]octadecanyl group and others.

The term "C₁-C₆₀ non-aromatic fused heteropolycyclic group" as used herein refers to a group, having 1 to 60 carbon atoms, where two or more rings fused to each other, at least one heteroatom selected from N, O, Si, P, and S, other than carbon atoms, as a ring-forming atom, and no aromaticity in its entire molecular structure. The examples thereof include an oxazolidinyl group, a silathiophenyl group, a pyrrolidinyl group, a phosphaseleninyl group, a dithiiranyl group, an oxathianyl group, a silaoxazinyl group, a thiaselenopyryl group, a phosphaoxazepinyl group, a pyrimidothiopyranyl group, a siladihydrothiazepinyl group, a pyrazinothiadiazinyl group, a phosphoazepinothiazinyl group, a triazolothiadiazinyl group, a sulfinylpyrazolopyridinyl group, an isoxazinothiopyranyl group, a thiadiazinylthiophenyl group, a dioxasilolanyl group, an oxatriazolothiopyridinyl group and others.

The term "organic ligand" as used herein refers to an organic compound bonded with at least one coordinate bond to a coordination center. Examples of the organic ligand include diketone (e.g., acetylacetonate, 2,6-dimethylheptane-3,5-dionato, 2,8-dimethylnonane-4,6-dionato, 2,2,6,6-tetramethylheptane-3,5-dionate), a carboxylic acid (e.g., picolinate), -C(=O), isonitrile, an oxalate, benzoate, acetonitrile, pyridine, ethylendiamine, 2,2'-bipiridine, 1,10-phenanthroline, bis-N,N'-(phenyl)pentane-2,4-diketiminato, triphenylphosphine, alkenes, alkynes, alkyls, hydride, diethylenetriamine, ethylenediaminetetraacetic acid, tetrakis(1-pyrazolyl)borate, pyrazine and others.

The term "inorganic ligand" as used herein refers to an inorganic compound bonded with at least one coordinate bond to a coordination center. Examples of the inorganic ligand include iodide, bromide, sulfide, thiocyanate, chloride, nitrate, azide, fluoride, hydroxide, water, nitrite, isothiocyanate, ammonia, cyanide, phosphorus trifluoride, hexafluorophosphate and others.

### BRIEF DESCRIPTION OF THE FIGURES

**Fig. 1****.** The energy transfer mechanism in the emission layer of PST-based OLED
   The abbreviations used in Fig. 1: S₀ - the ground state; S₁ - the first excited singlet state; T₁ - the first excited triplet state, DET - Dexter energy transfer; FRET - Forster energy transfer.
**Fig. 2****.** The composition and energy transfer scheme in the emitting layer of the PST-based OLED.

### DETAILED DESCRIPTION OF THE INVENTION

The present invention is illustrated by the following examples in detail.

### Example 1: Organic boron compounds

The organic boron compound can be a compound according to Formula I. 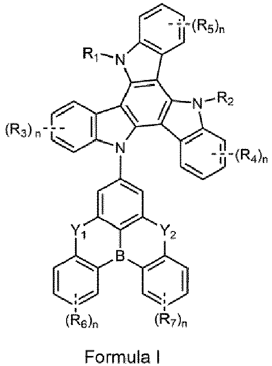 wherein:
R₁ and R₂ may be together C₁-C₂₀ alkyl, C₂-C₂₀ alkenyl, C₂-C₂₀ alkynyl groups or their deuterated analogues;
R₃-R₅, together or independently, may be hydrogen, deuterium, halogen, cyano, nitro, hydrazine, hydrazone, C₁-C₆₀ alkyl, C₂-C₆₀ alkenyl, C₂-C₆₀ alkynyl, C₁-C₆₀ alkoxy group, C₃-C₆₀ cycloalkyl, C₃-C₆₀ cycloalkenyl, C₁-C₆₀ heterocycloalkyl, C₁-C₆₀ heterocycloalkenyl group, C₃-C₆₀ cycloalkynyl group, C₁-C₆₀ heterocycloalkynyl group, hydroxyl, C₆-C₆₀ aryl, C₁-C₆₀ heteroaryl group, C₅-C₆₀ aryloxy, C₁-C₆₀ heteroaryloxy group, C₂-C₆₀ ether group, C₆-C₆₀ thioaryl, C₁-C₆₀ heterothioaryl, C₁-C₆₀ amino, C₁-C₆₀ alkylamino, C₁-C₆₀ dialkylamino, C₆-C₆₀ arylamino, C₆-C₆₀ diarylamino, C₆-C₆₀ heteroarylamino group, C₆-C₆₀ heterodiarylamino group, C₄-C₆₀ non-aromatic fused polycyclic group, C₁-C₆₀ non-aromatic fused heteropolycyclic group or deuterated analogues thereof;
R₆-R₇, together or independently, may be hydrogen, deuterium, halogen, hydroxyl, cyano, nitro, hydrazine, hydrazone, C₁-C₆₀ alkyl, C₂-C₆₀ alkenyl, C₂-C₆₀ alkynyl, C₃-C₆₀ cycloalkyl, C₃-C₆₀ cycloalkenyl, C₁-C₆₀ heterocycloalkyl, C₁-C₆₀ heterocycloalkenyl, C₃-C₆₀ cycloalkynyl group, C₁-C₆₀ heterocycloalkynyl group, C₆-C₆₀ aryl, C₁-C₆₀ heteroaryl group, C₁-C₆₀ alkoxy group, C₅-C₆₀ aryloxy, C₁-C₆₀ heteroaryloxy group, C₂-C₆₀ ether group, C₆-C₆₀ thioaryl, C₁-C₆₀ heterothioaryl, C₁-C₆₀ amino, C₁-C₆₀ alkylamino, C₁-C₆₀ dialkylamino, C₆-C₆₀ arylamino, C₆-C₆₀ diarylamino, C₆-C₆₀ heteroarylamino group, C₆-C₆₀ heterodiarylamino group, C₄-C₆₀ non-aromatic fused polycyclic group, C₁-C₆₀ non-aromatic fused heteropolycyclic group or deuterated analogues thereof;
Y₁ and Y₂, together or independently, may be O or N(Rs);
R₈ may be hydrogen, deuterium, C₆-C₆₀ aryl group, C₁-C₆₀ heteroaryl group, C₅-C₆₀ aryloxy, C₁-C₆₀ heteroaryloxy group, C₆-C₆₀ arylamino, C₆-C₆₀ heteroarylamino, C₆-C₆₀ diarylamino, C₆-C₆₀ heteroarylamino group, C₆-C₆₀ heterodiarylamino group, C₆-C₆₀ thioaryl group, C₁-C₆₀ heterothioaryl or deuterated analogues thereof;
an index n ranging from 0-4 indicates how many R₃, R₄, R₅, R₆, R₇ may be attached to a particular ring.

For example, R₁ and R₂ may also be together C₆-C₁₀ alkyl, C₆-C₁₀ alkenyl, C₆-C₁₀ alkynyl groups or their deuterated analogues. For example, R₁ and R₂ may also be together C₁ alkyl, C₂ alkyl, C₃ alkyl, C₄ alkyl, C₅ alkyl, C₆ alkyl, C₇ alkyl, C₈ alkyl, C₉ alkyl, C₁₀ alkyl, C₁₁ alkyl, C₁₂ alkyl, C₁₃ alkyl, C₁₄ alkyl, C₁₅ alkyl, C₁₆ alkyl, C₁₇ alkyl, C₁₈ alkyl, C₁₉ alkyl group or their deuterated analogues. For example, R₁ and R₂ may also be together C₂ alkenyl, C₃ alkenyl, C₄ alkenyl, C₅ alkenyl, C₆ alkenyl, C₇ alkenyl, C₈ alkenyl, C₉ alkenyl, C₁₀ alkenyl, C₁₁ alkenyl, C₁₂ alkenyl, C₁₃ alkenyl, C₁₄ alkenyl, C₁₅ alkenyl, C₁₆ alkenyl, C₁₇ alkenyl, C₁₈ alkenyl, C₁₉ alkenyl, C₂₀ alkenyl group or their deuterated analogues. For example, R₁ and R₂ may also be together C₂ alkynyl, C₃ alkynyl, C₄ alkynyl, C₅ alkynyl, C₆ alkynyl, C₇ alkynyl, C₈ alkynyl, C₉ alkynyl, C₁₀ alkynyl, C₁₁ alkynyl, C₁₂ alkynyl, C₁₃ alkynyl, C₁₄ alkynyl, C₁₅ alkynyl, C₁₆ alkynyl, C₁₇ alkynyl, C₁₈ alkynyl, C₁₉ alkynyl, C₂₀ alkynyl group or their deuterated analogues. Examples of organic boron chemical compounds that are included in the compounds described according to Formula I and do not limit the scope of protection of this application. The compound according to Formula I may be selected from: 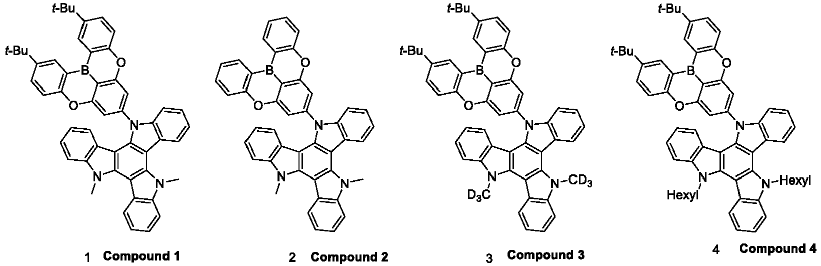 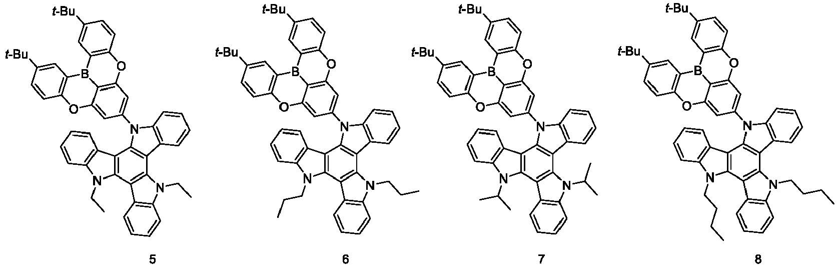 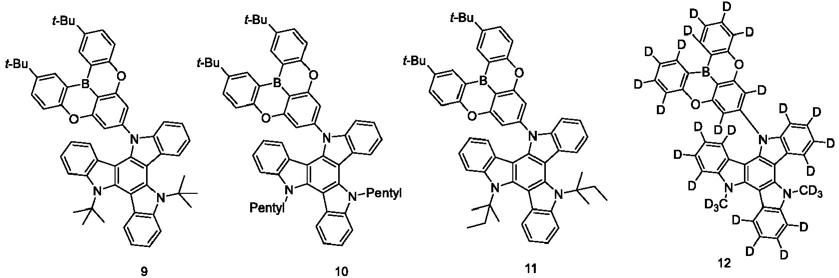 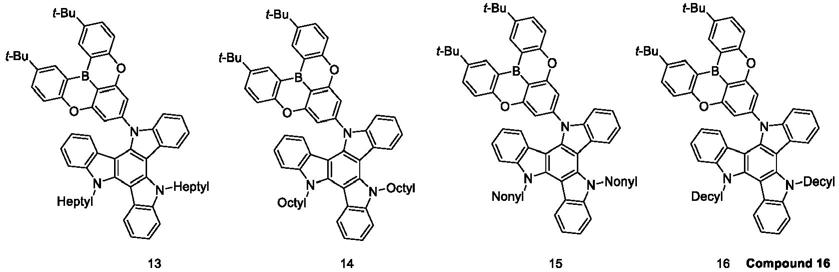 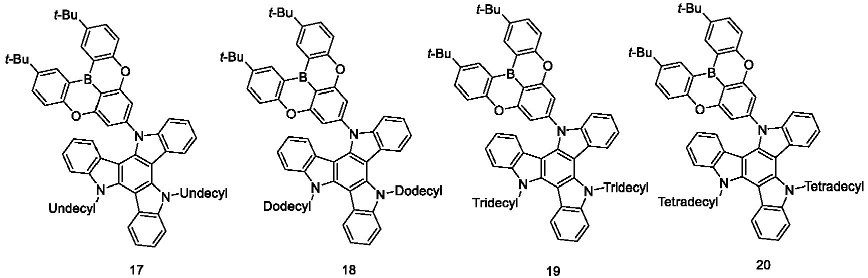 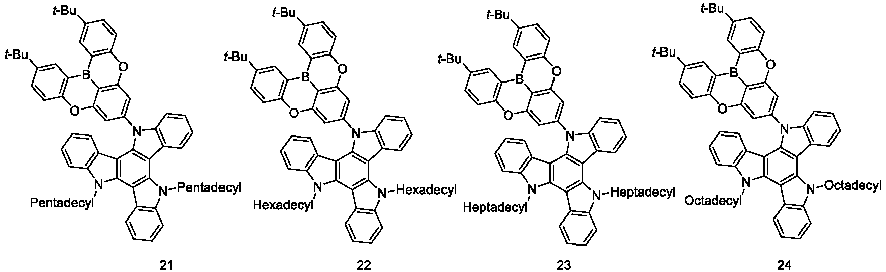 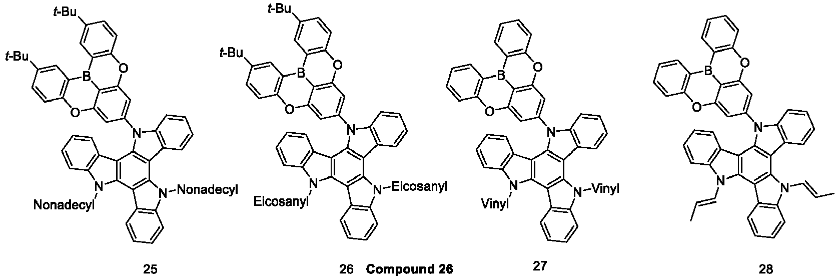 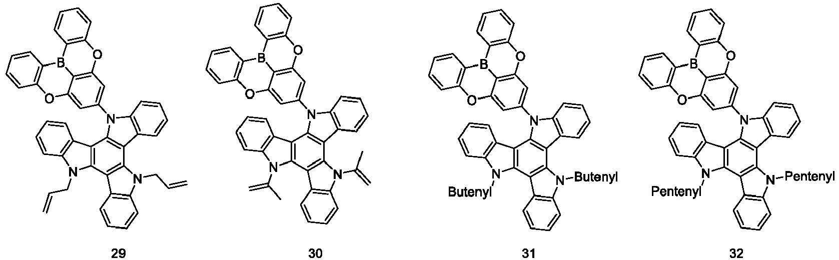 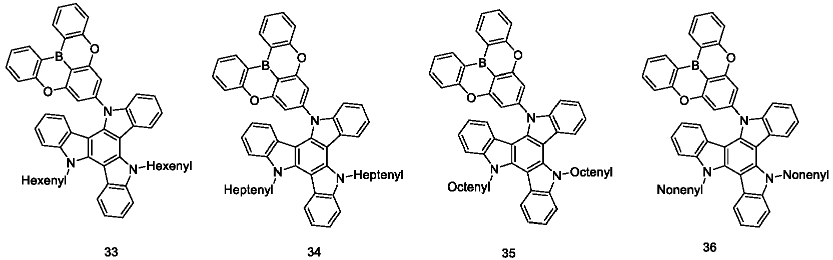 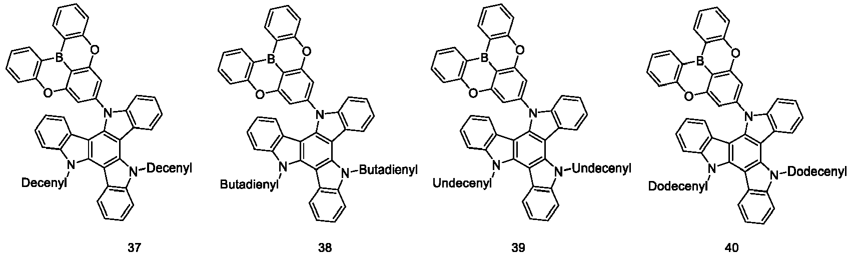 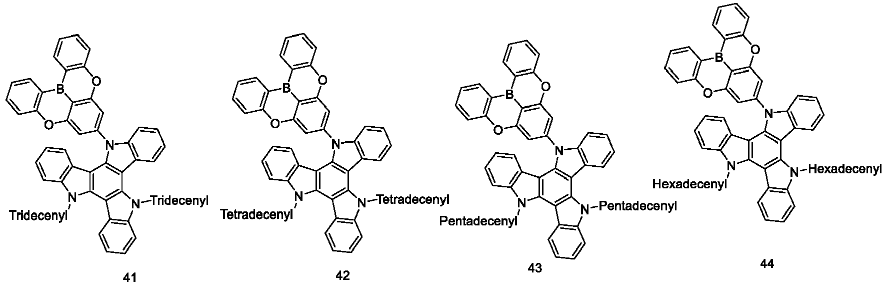 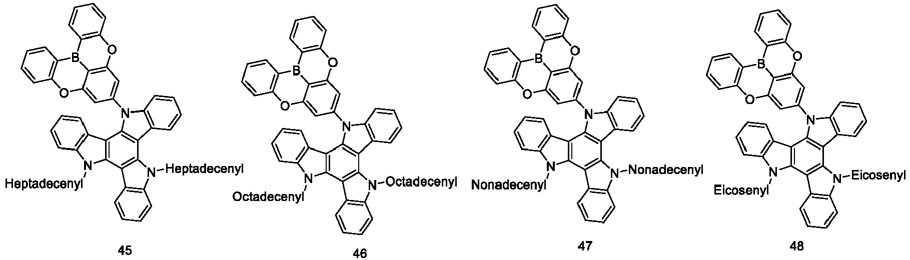 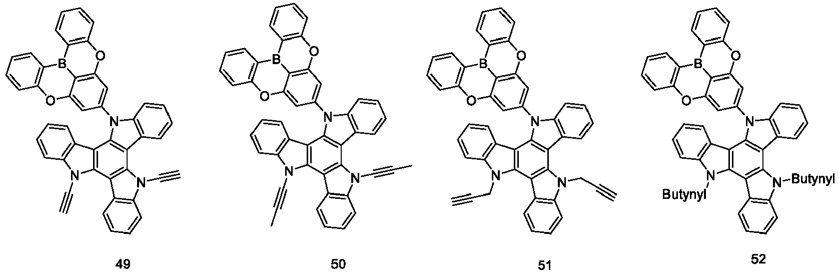 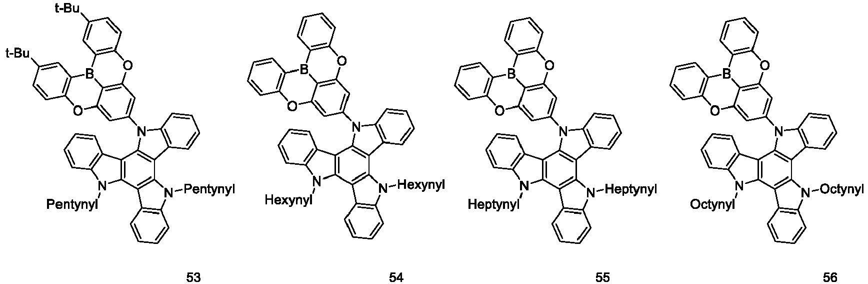 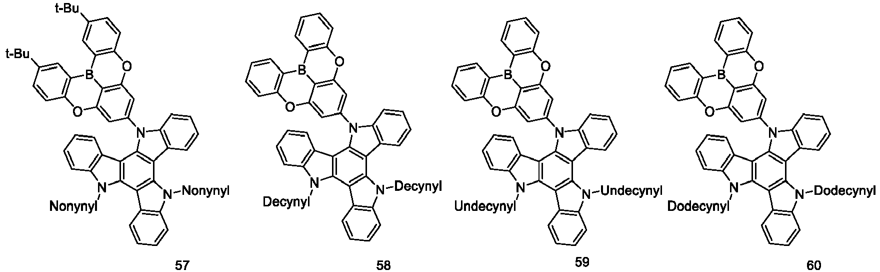 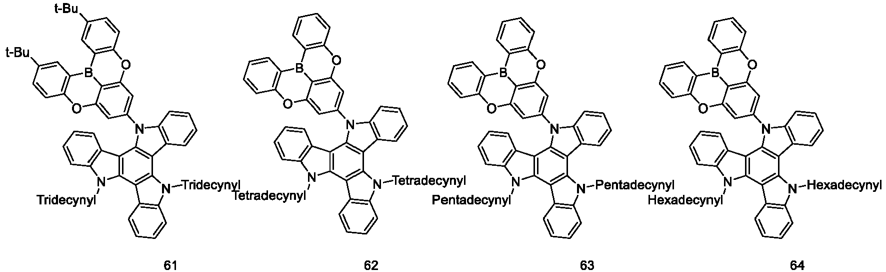 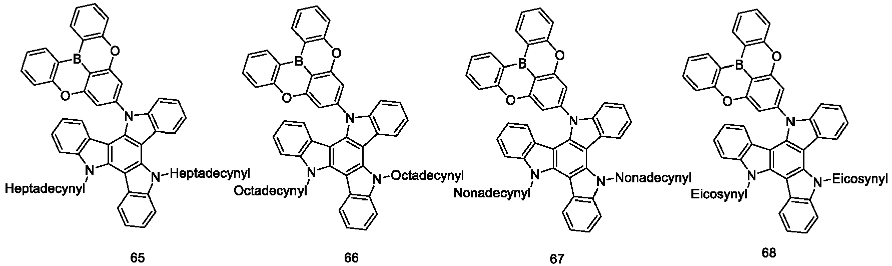 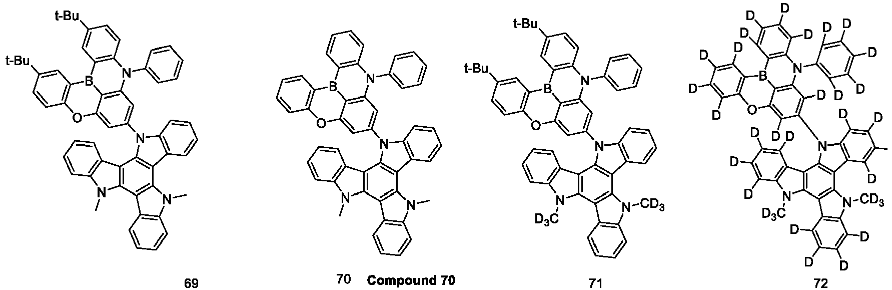 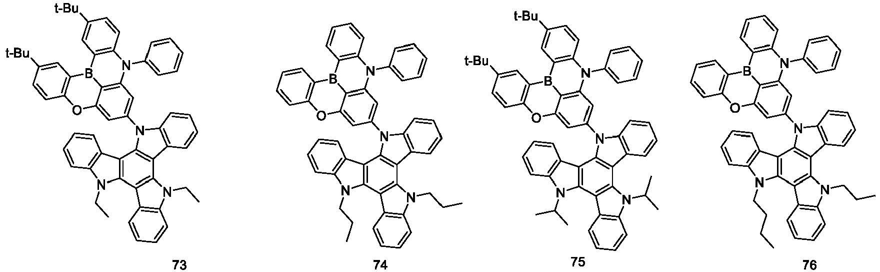 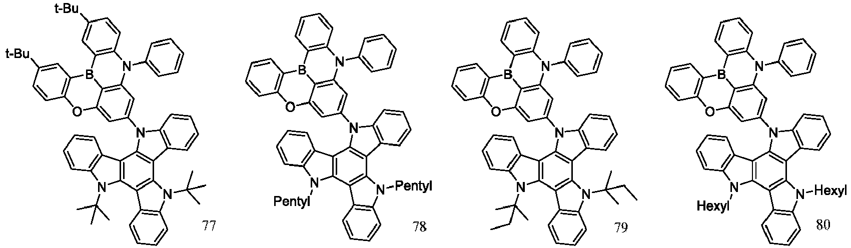 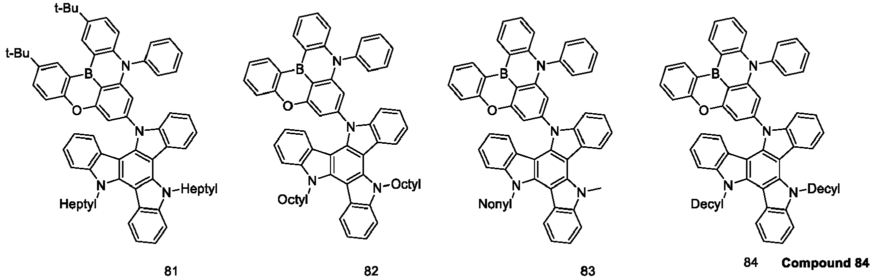 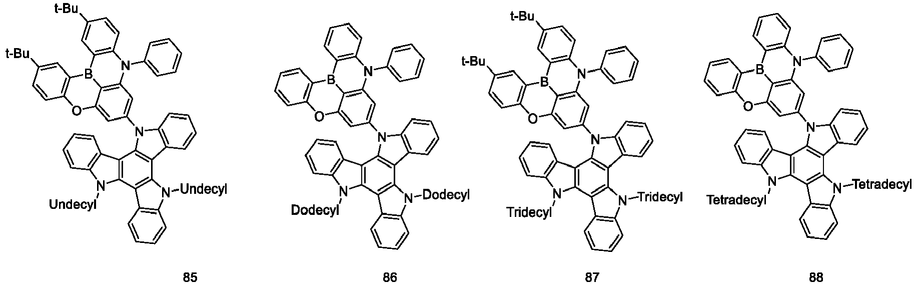 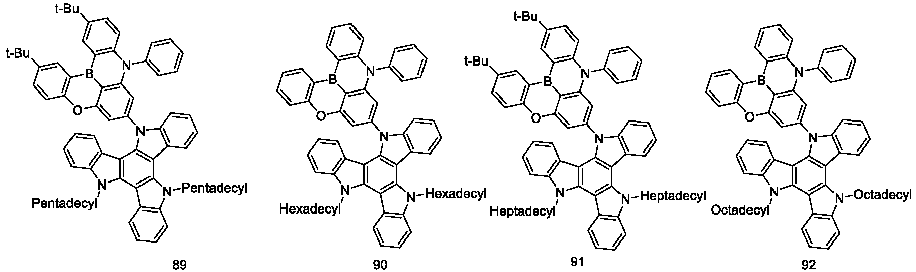 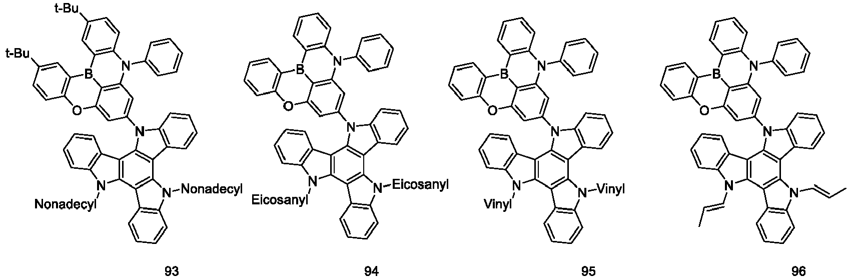 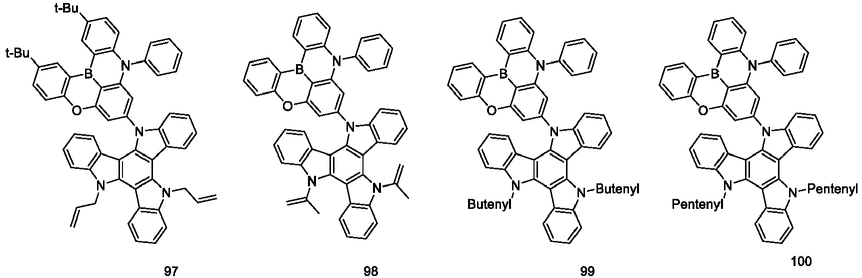 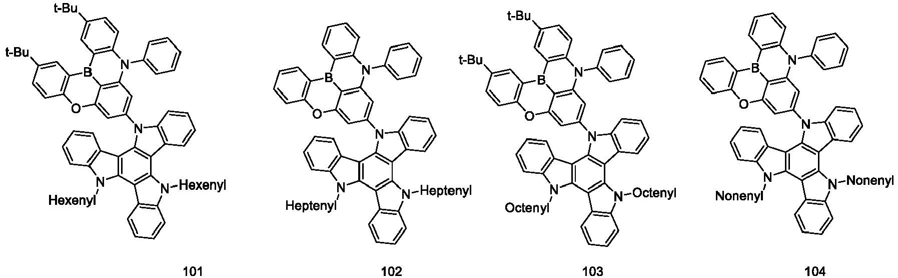 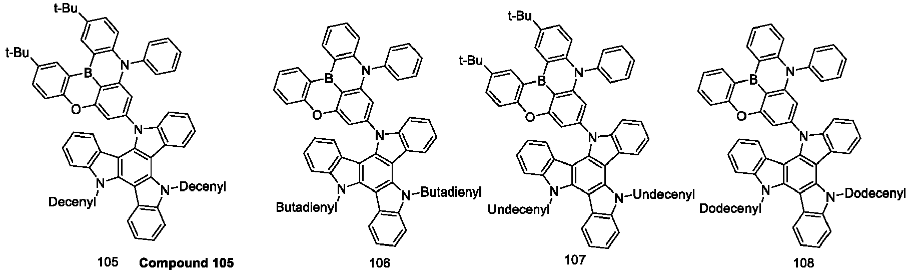 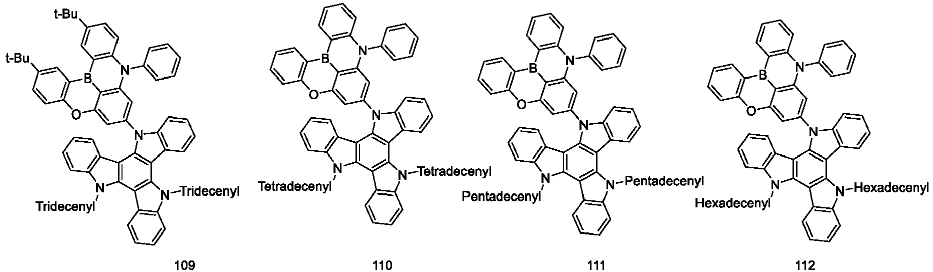 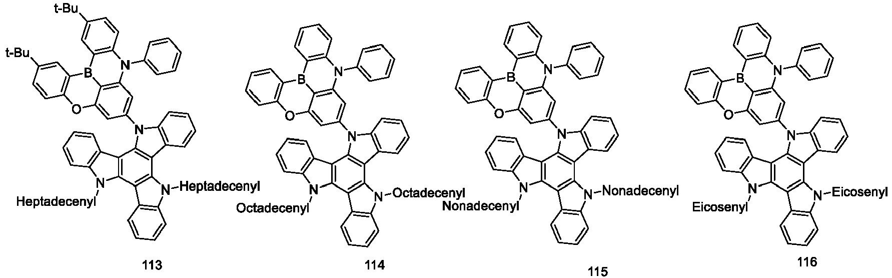 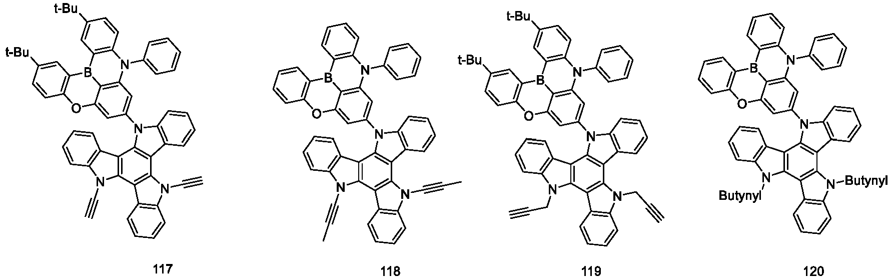 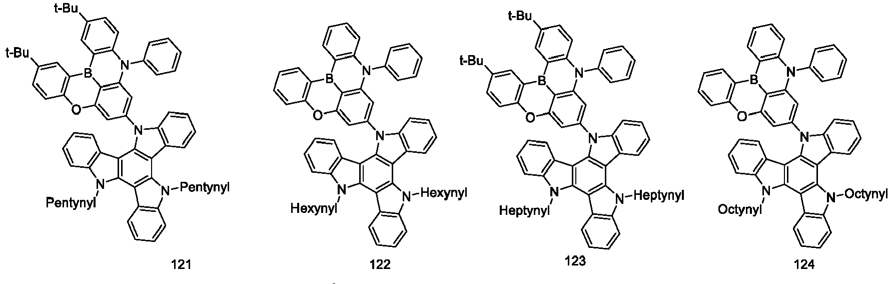 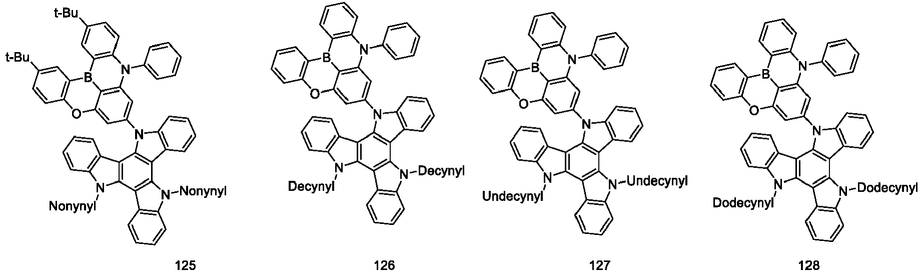 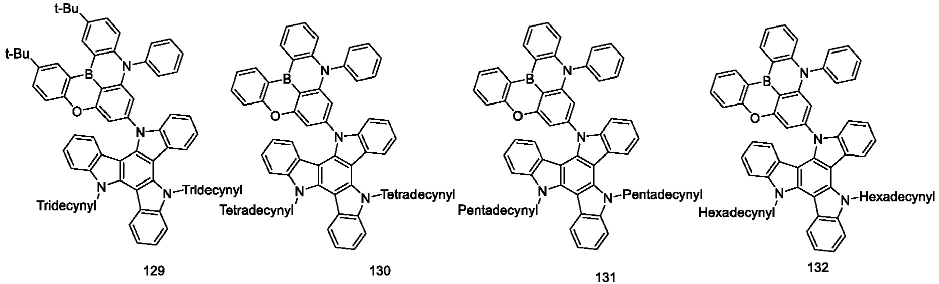 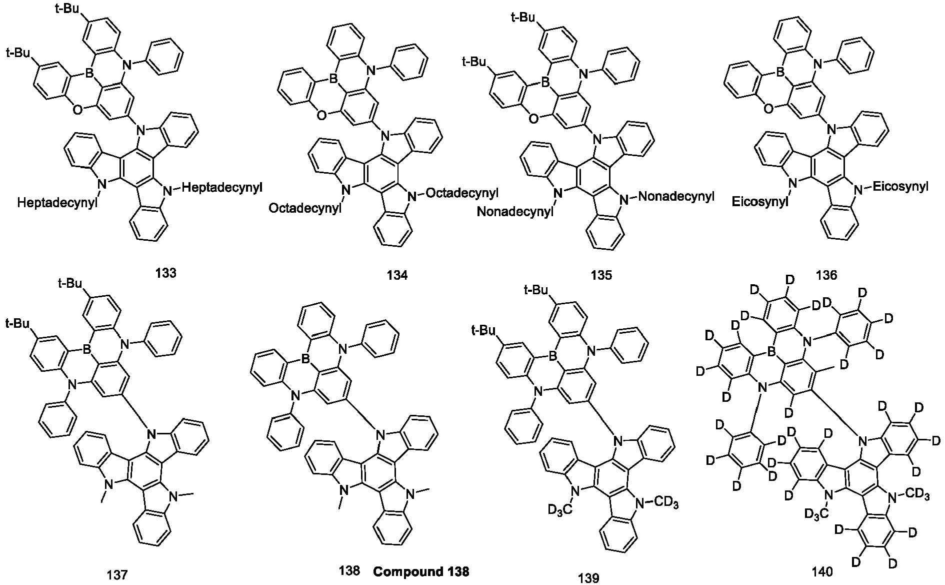 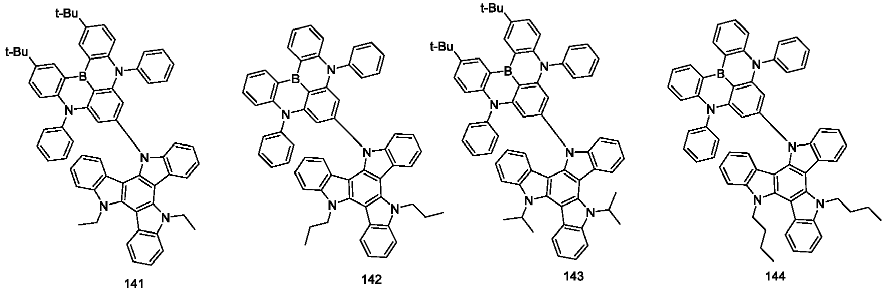 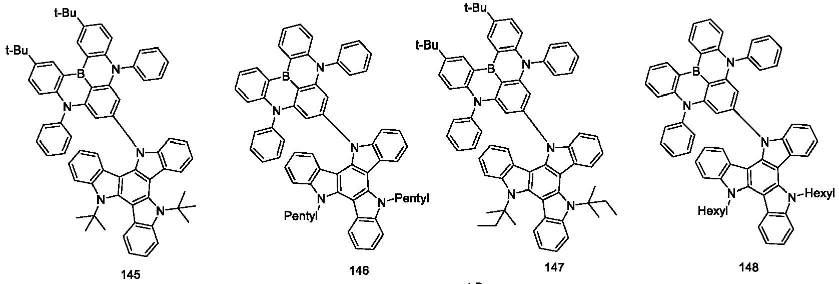 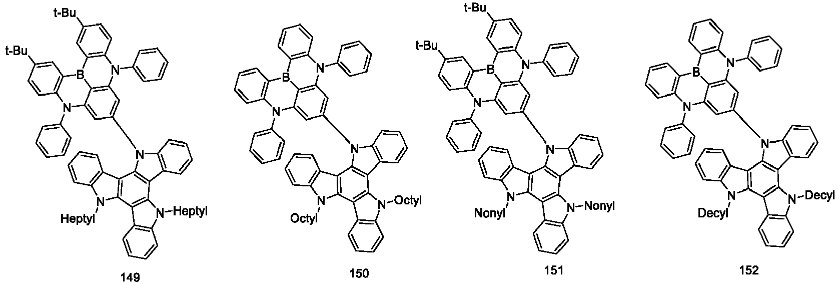 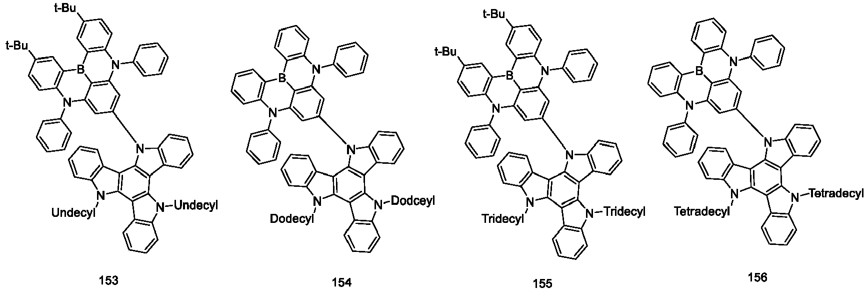 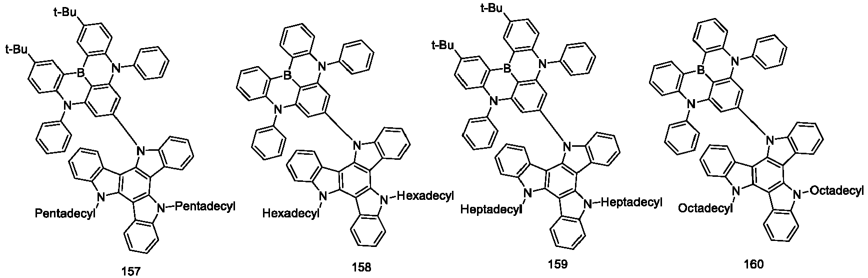 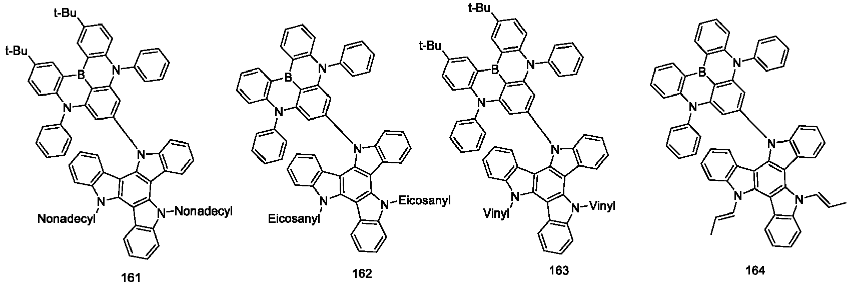 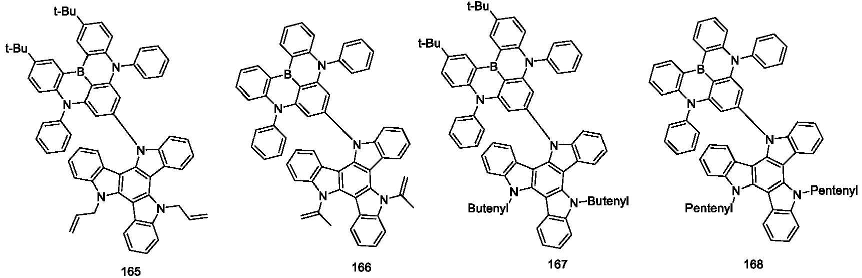 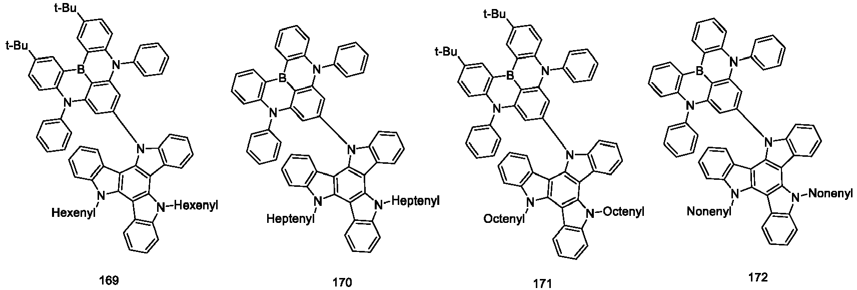 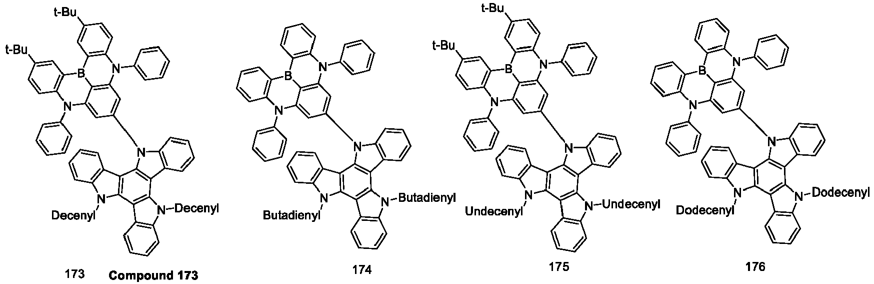 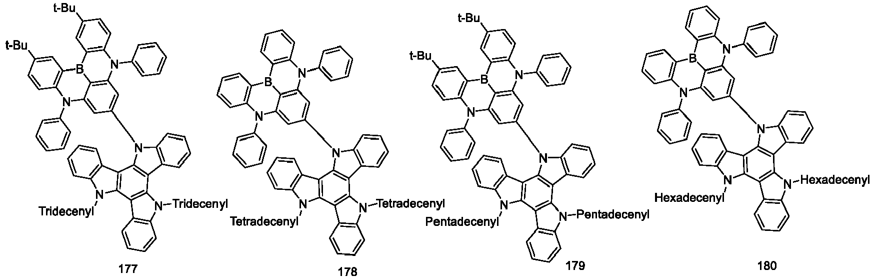 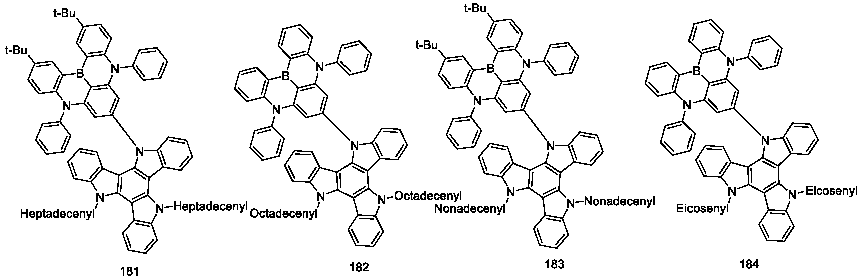 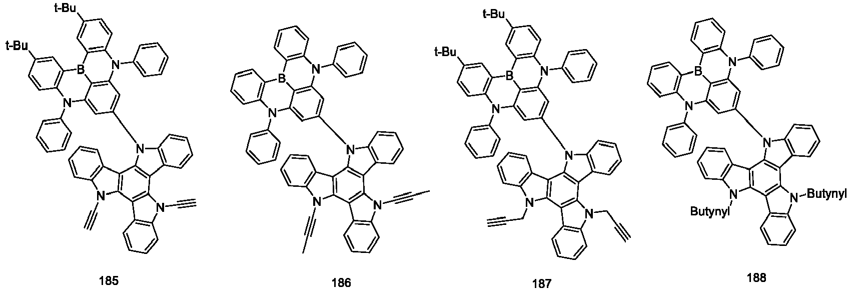 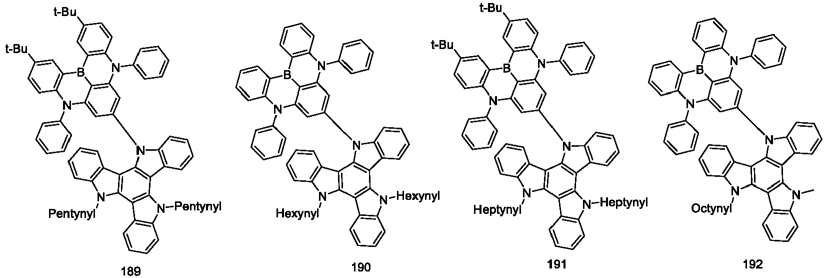 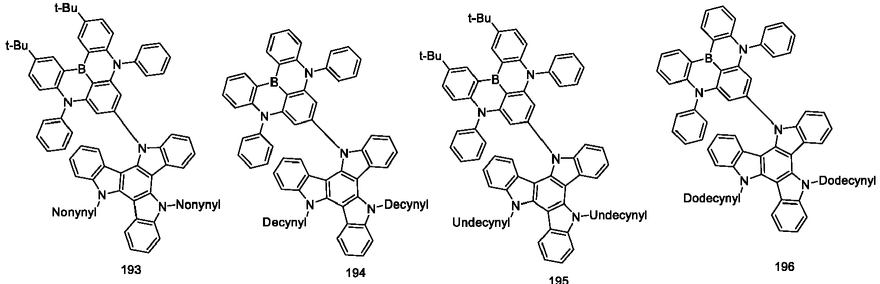 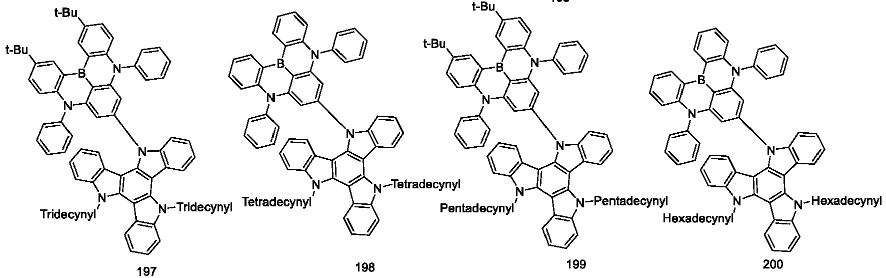 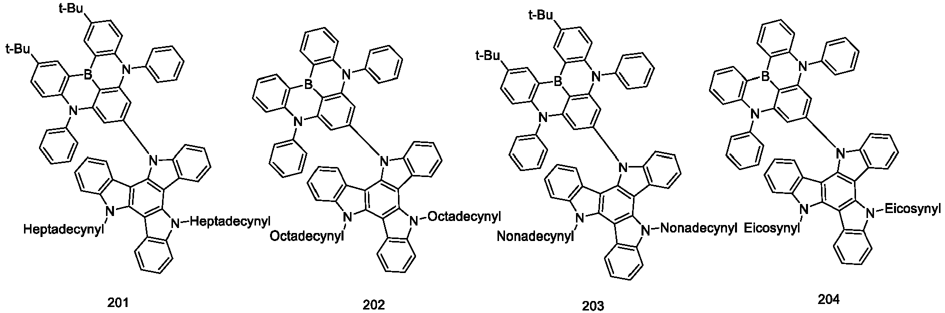 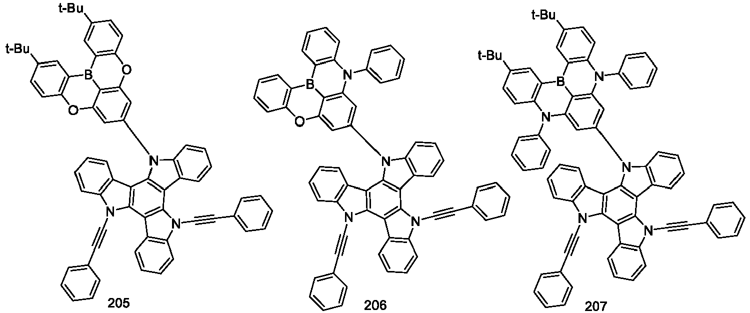 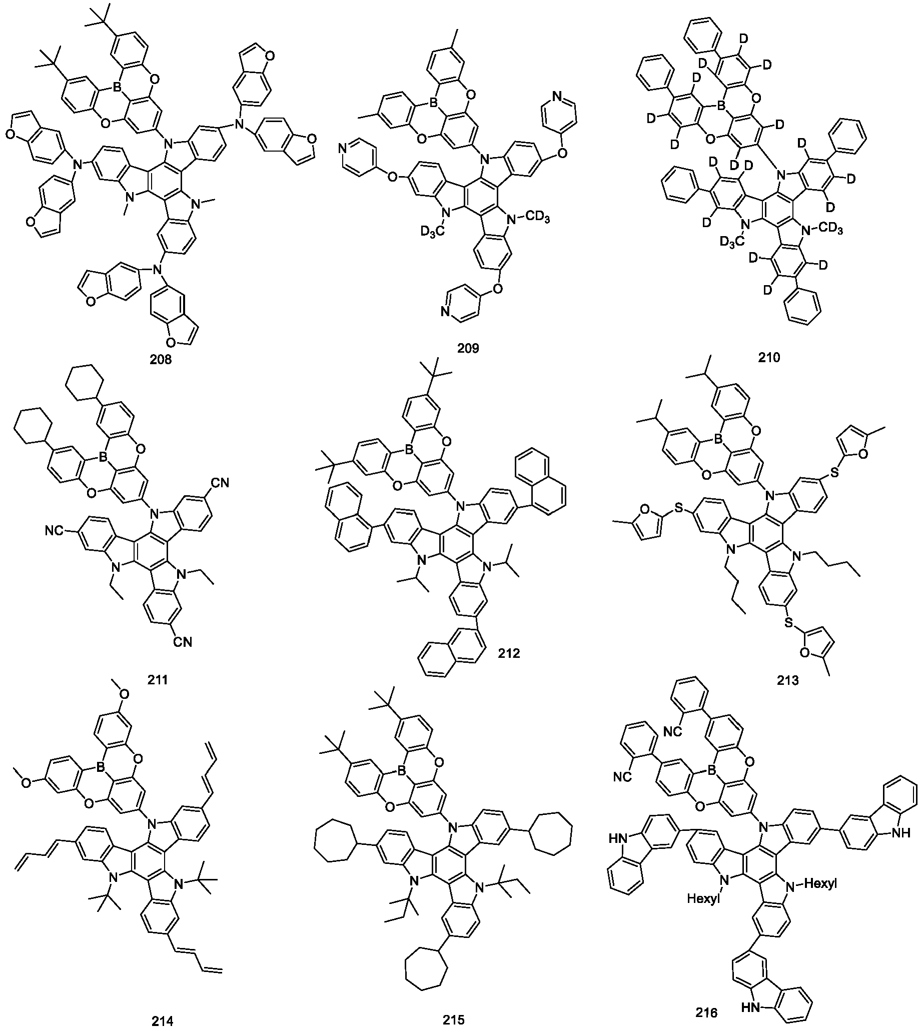 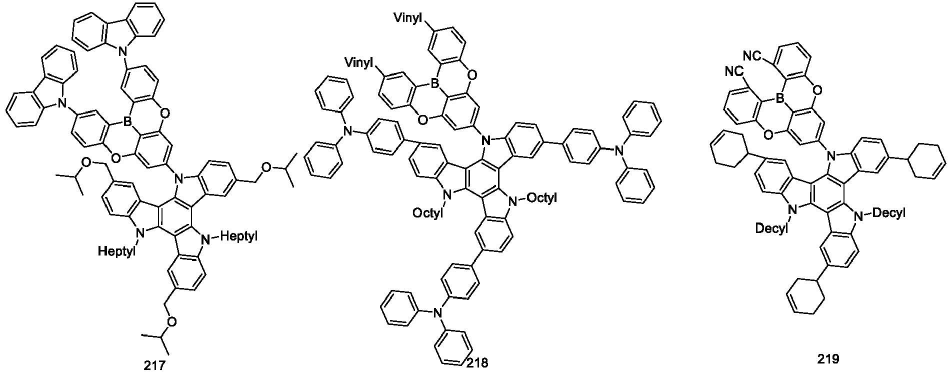 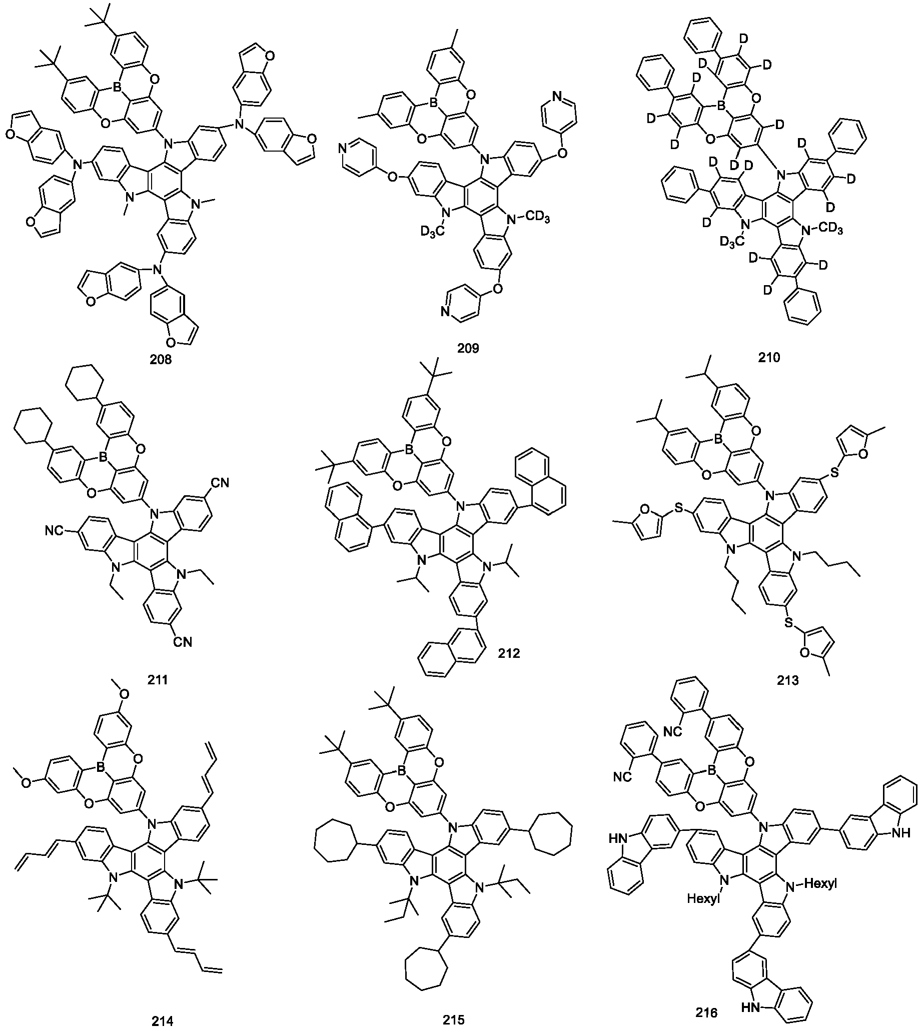 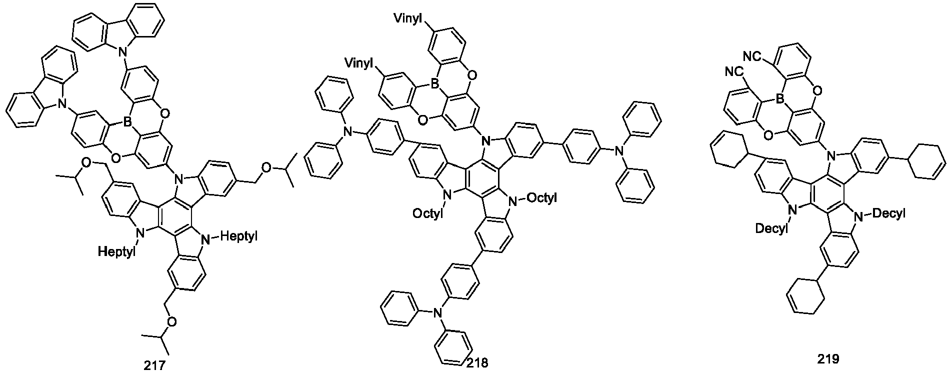 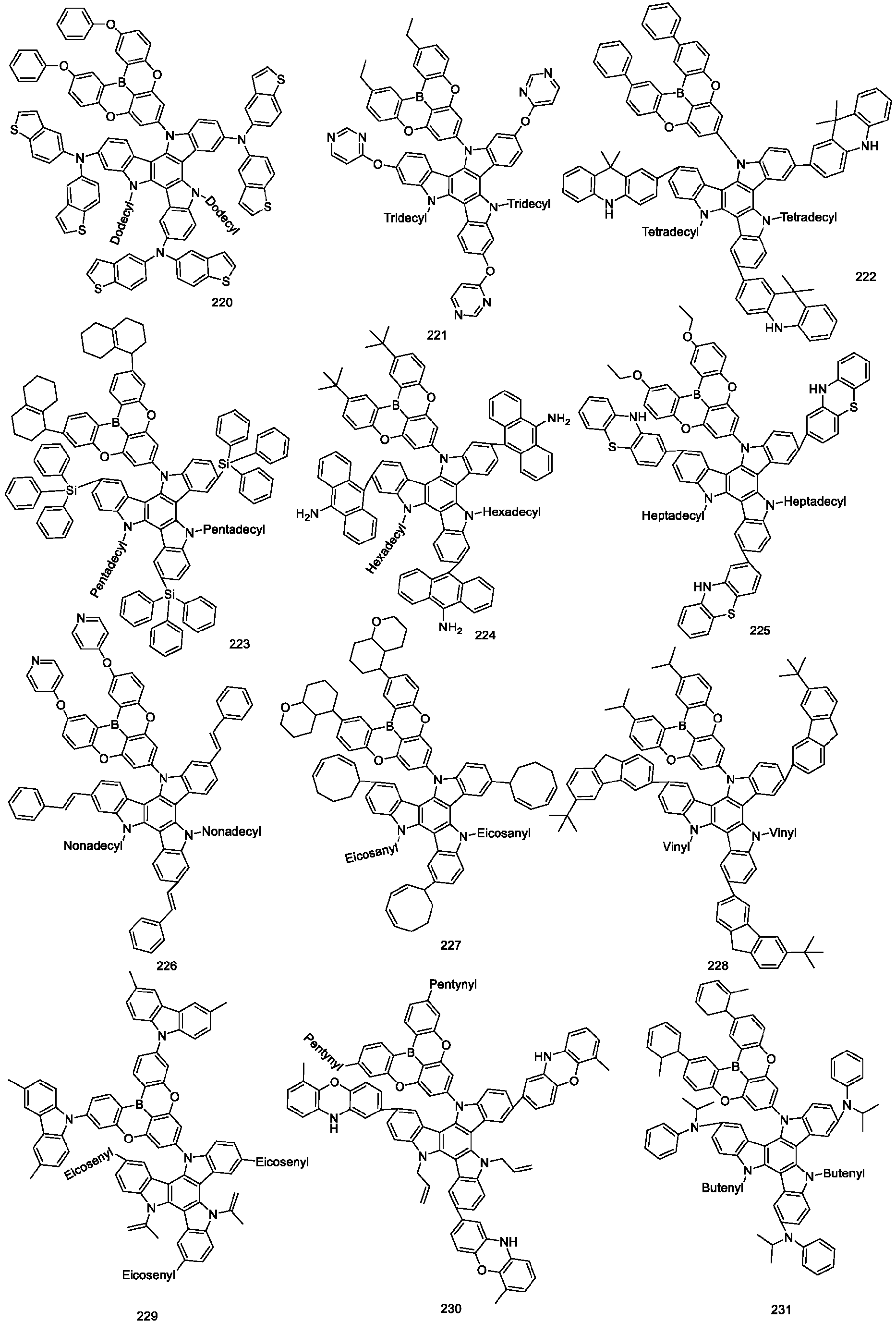 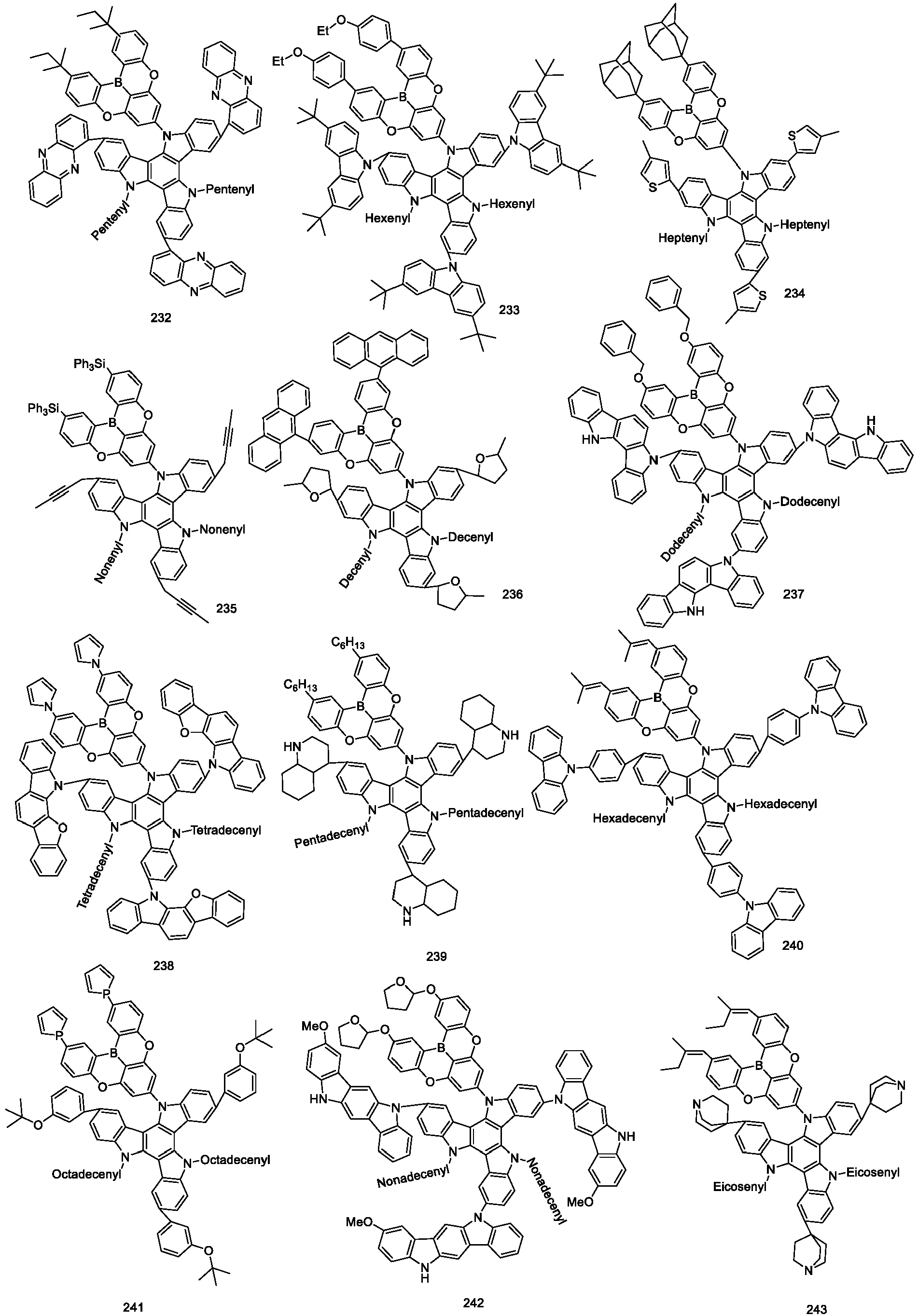 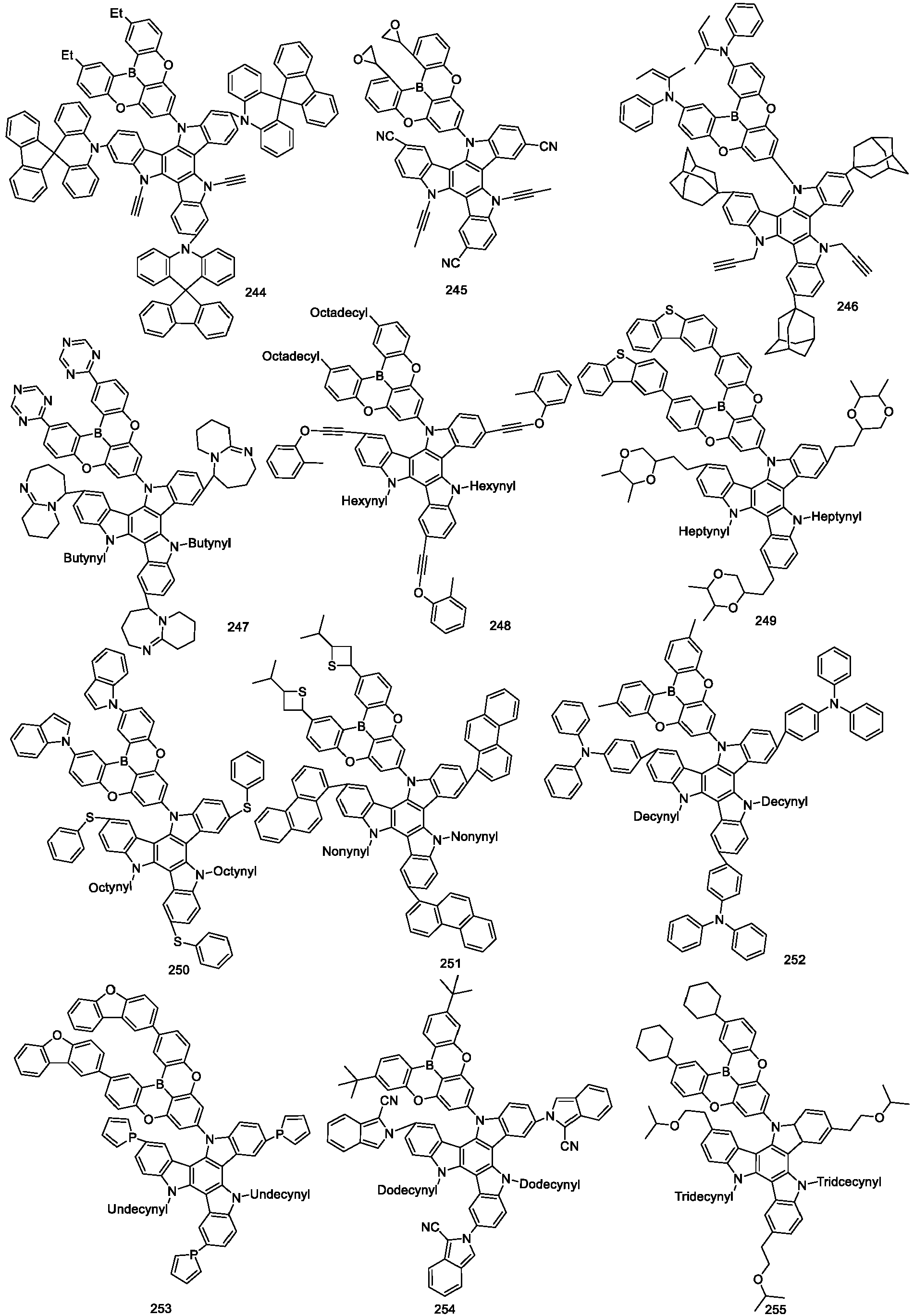 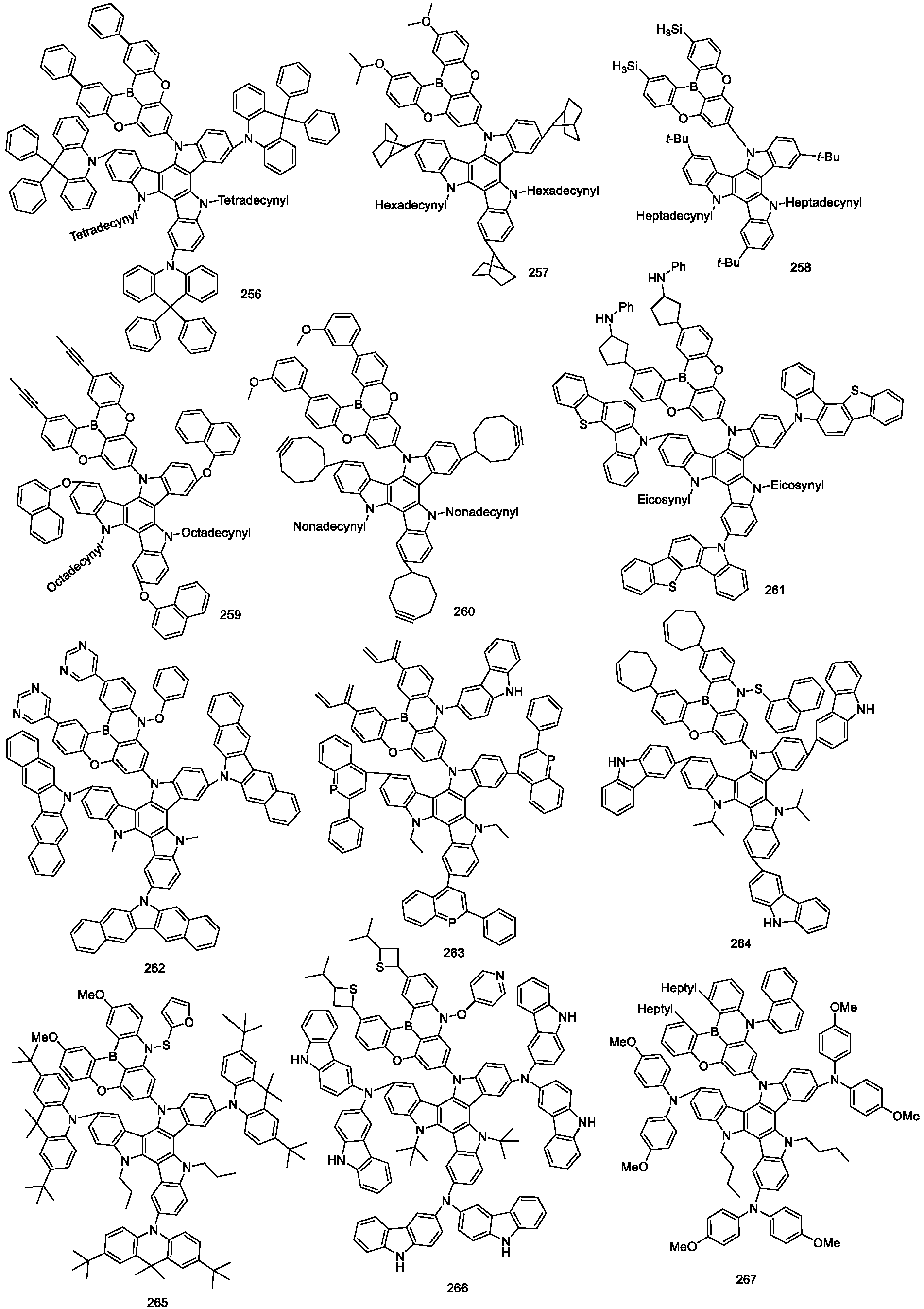 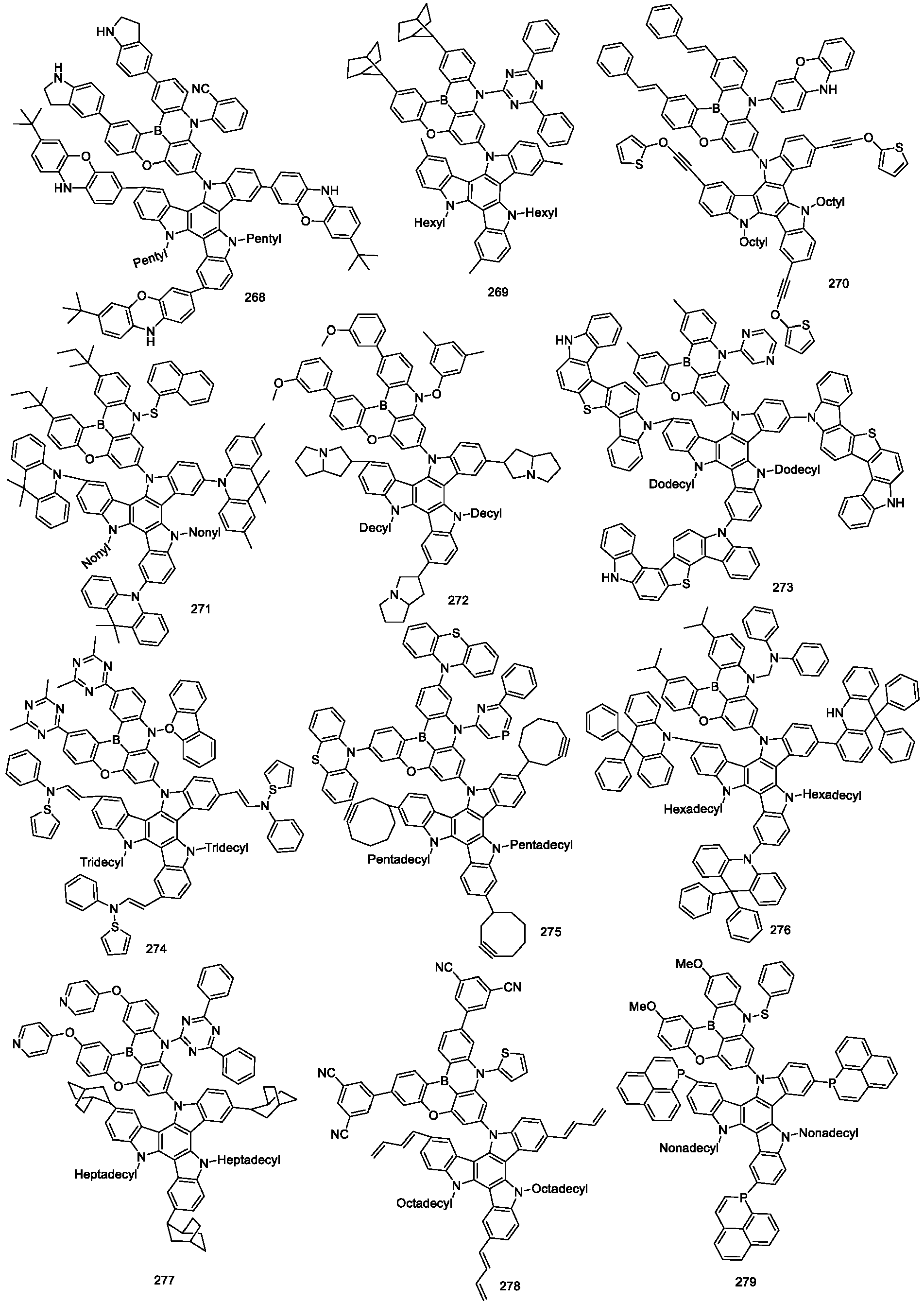 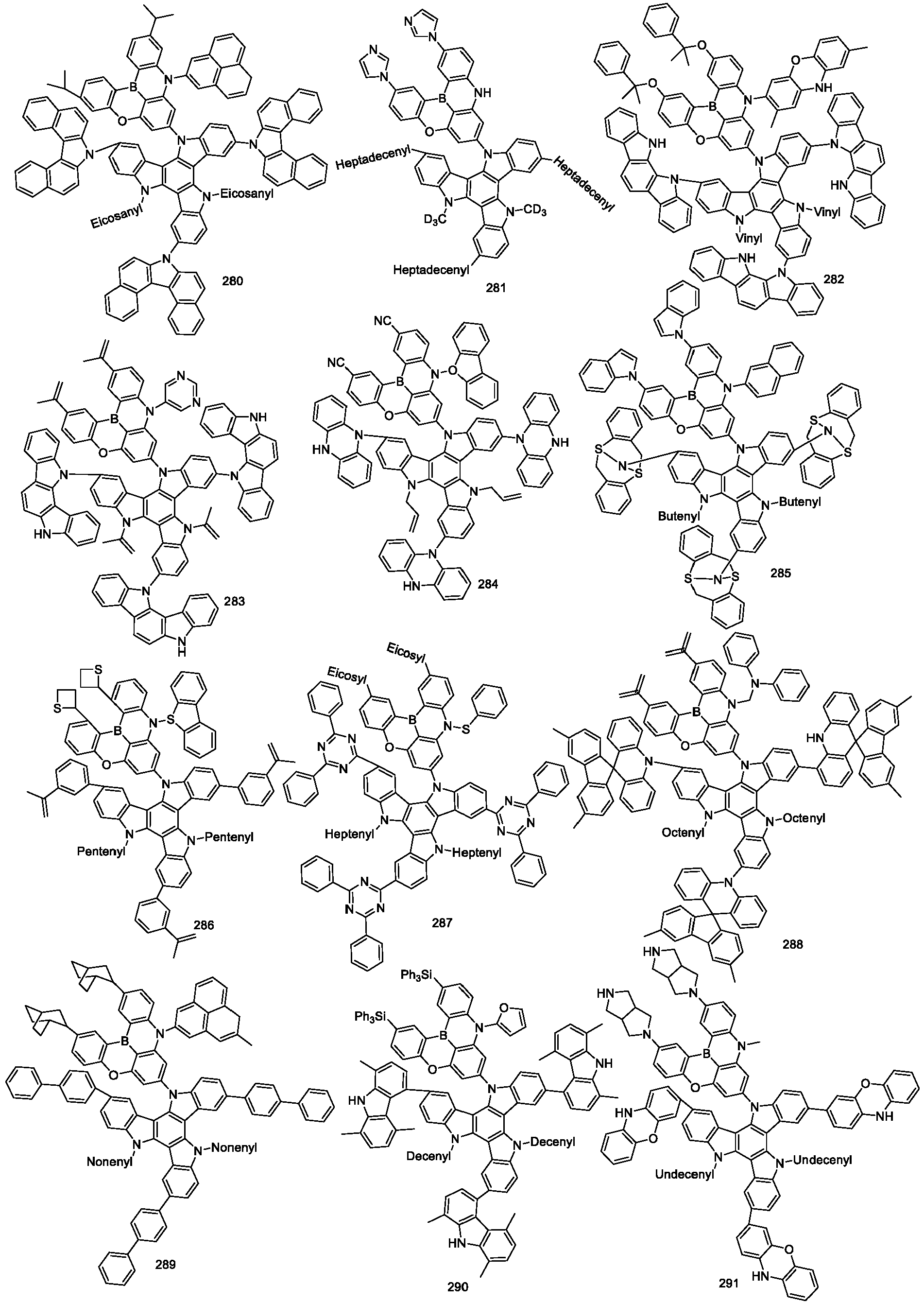 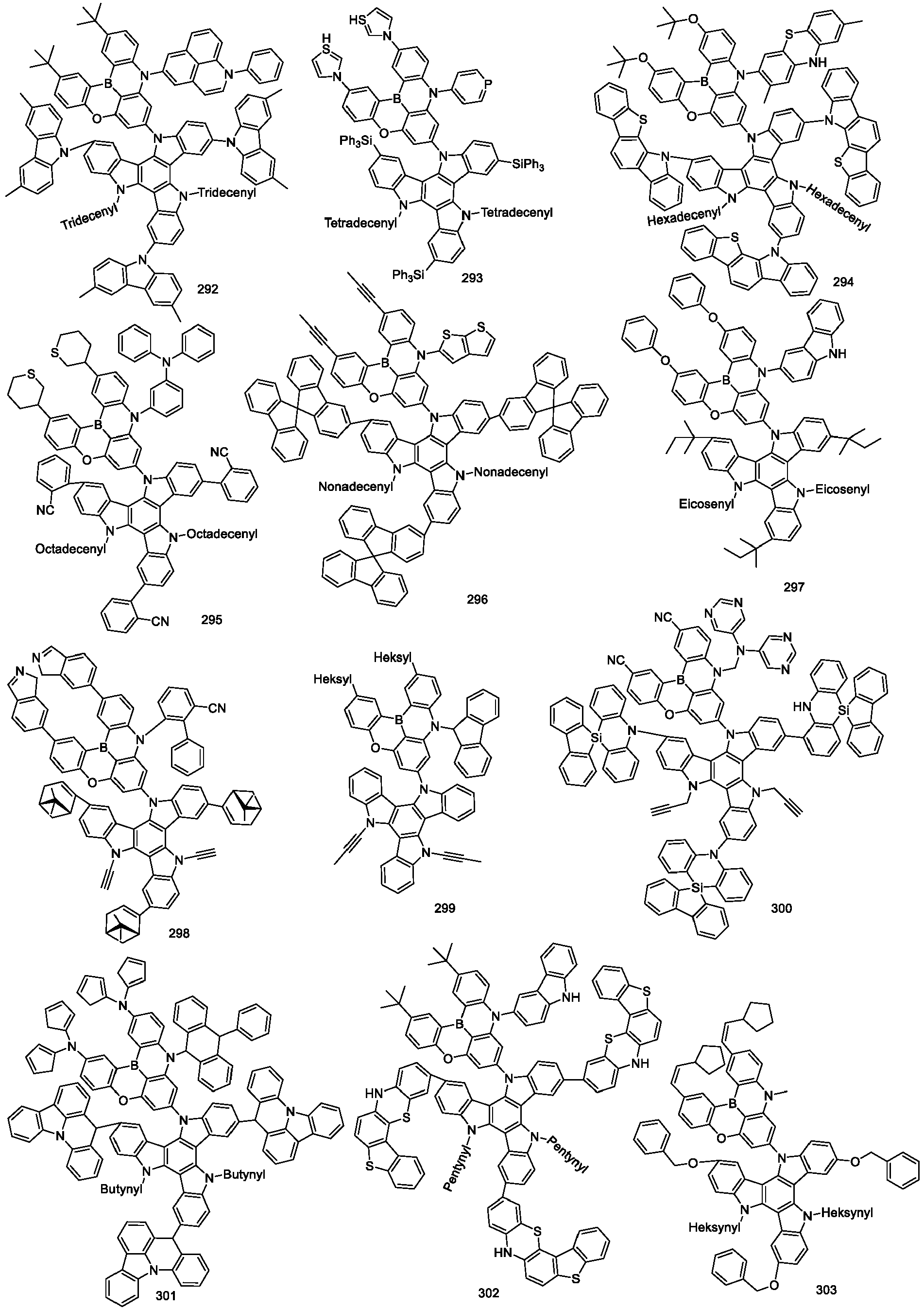 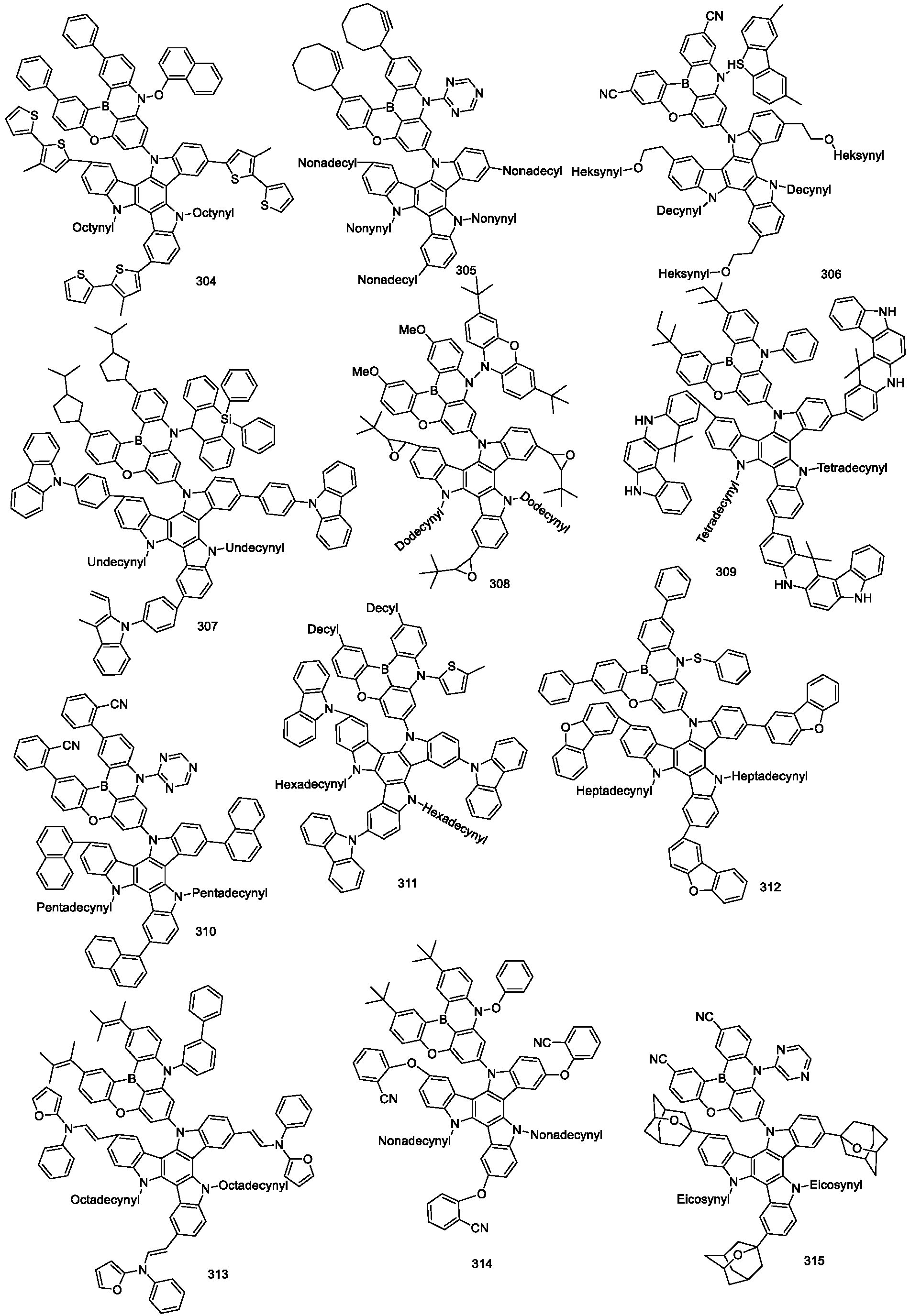 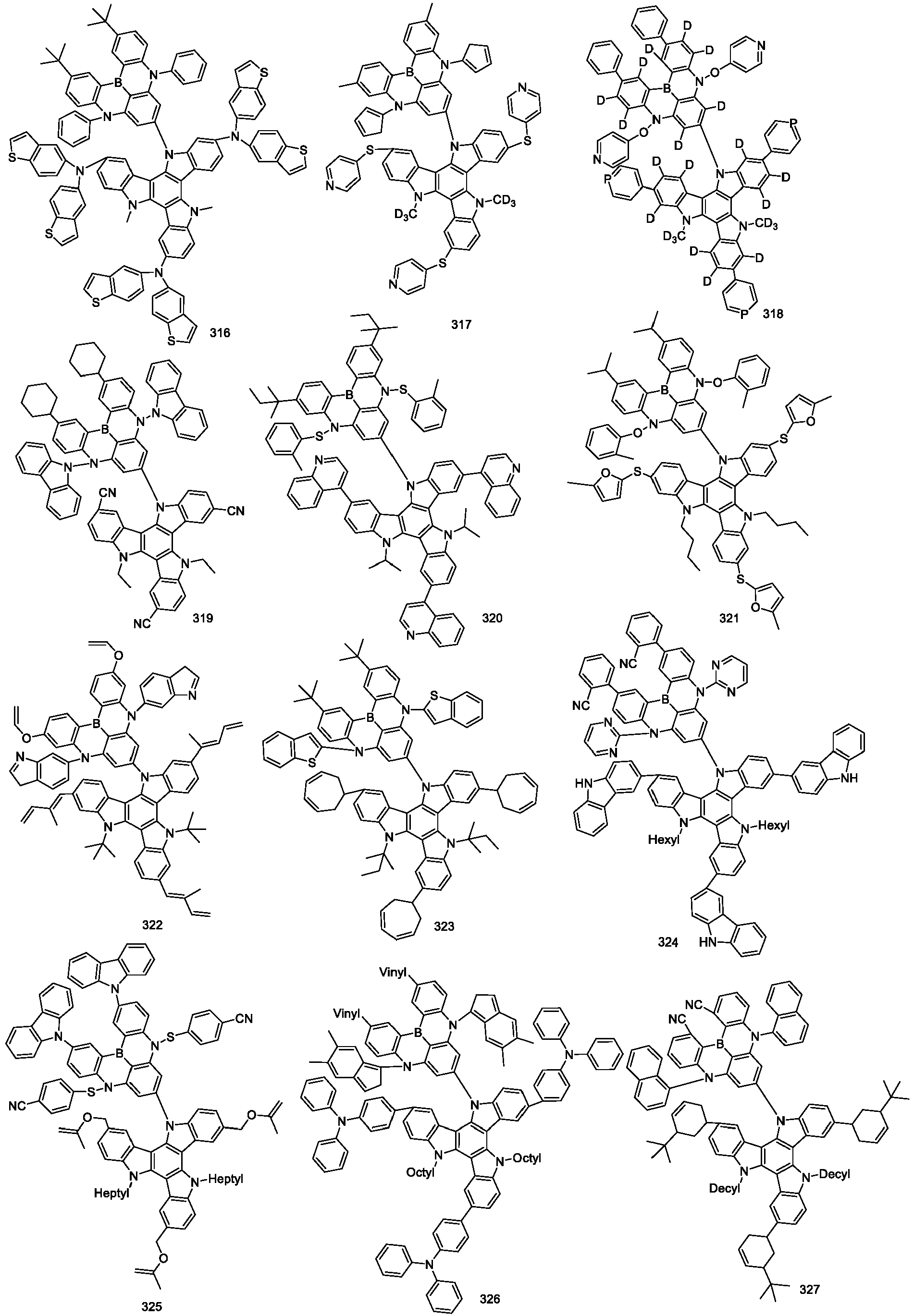 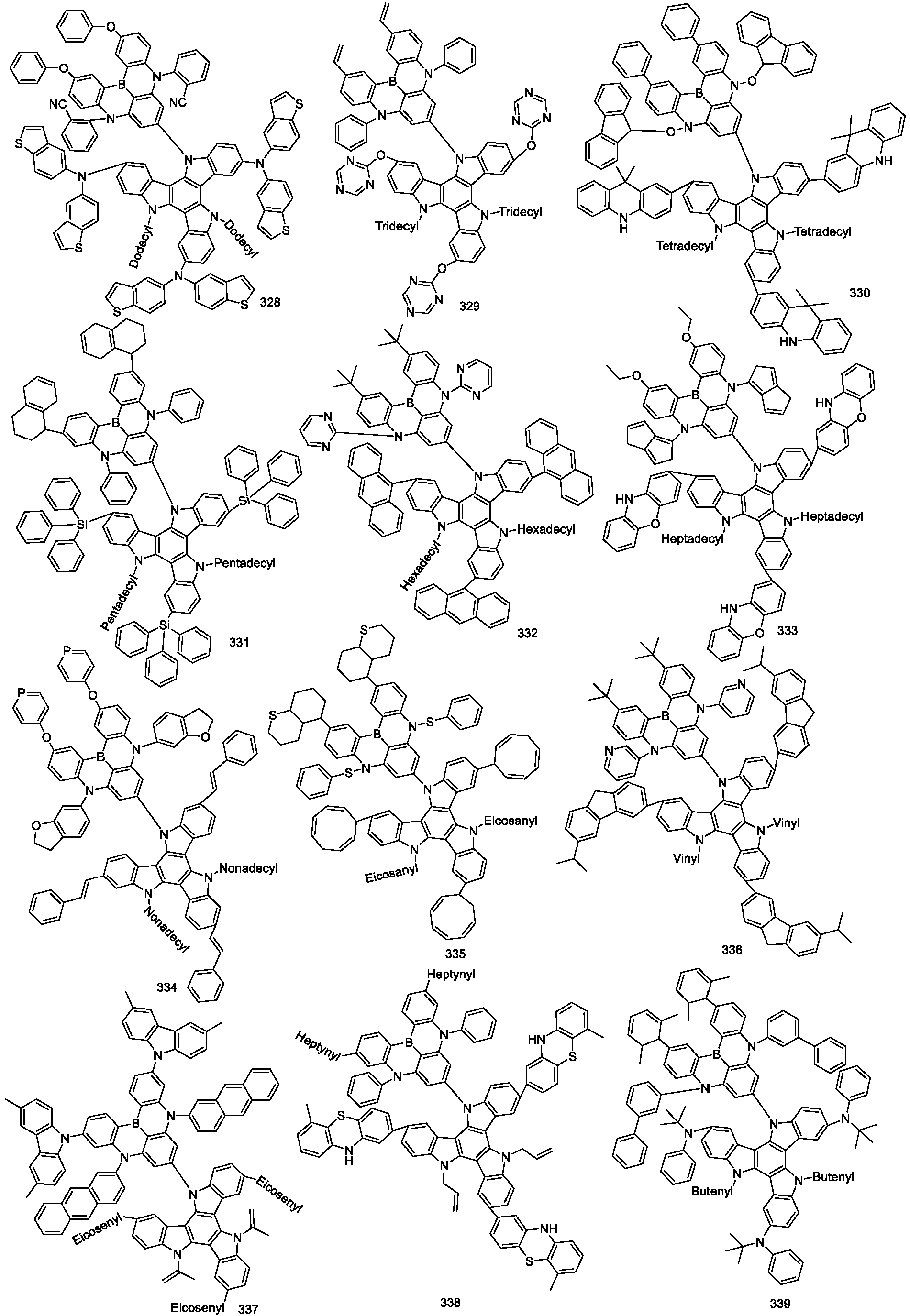 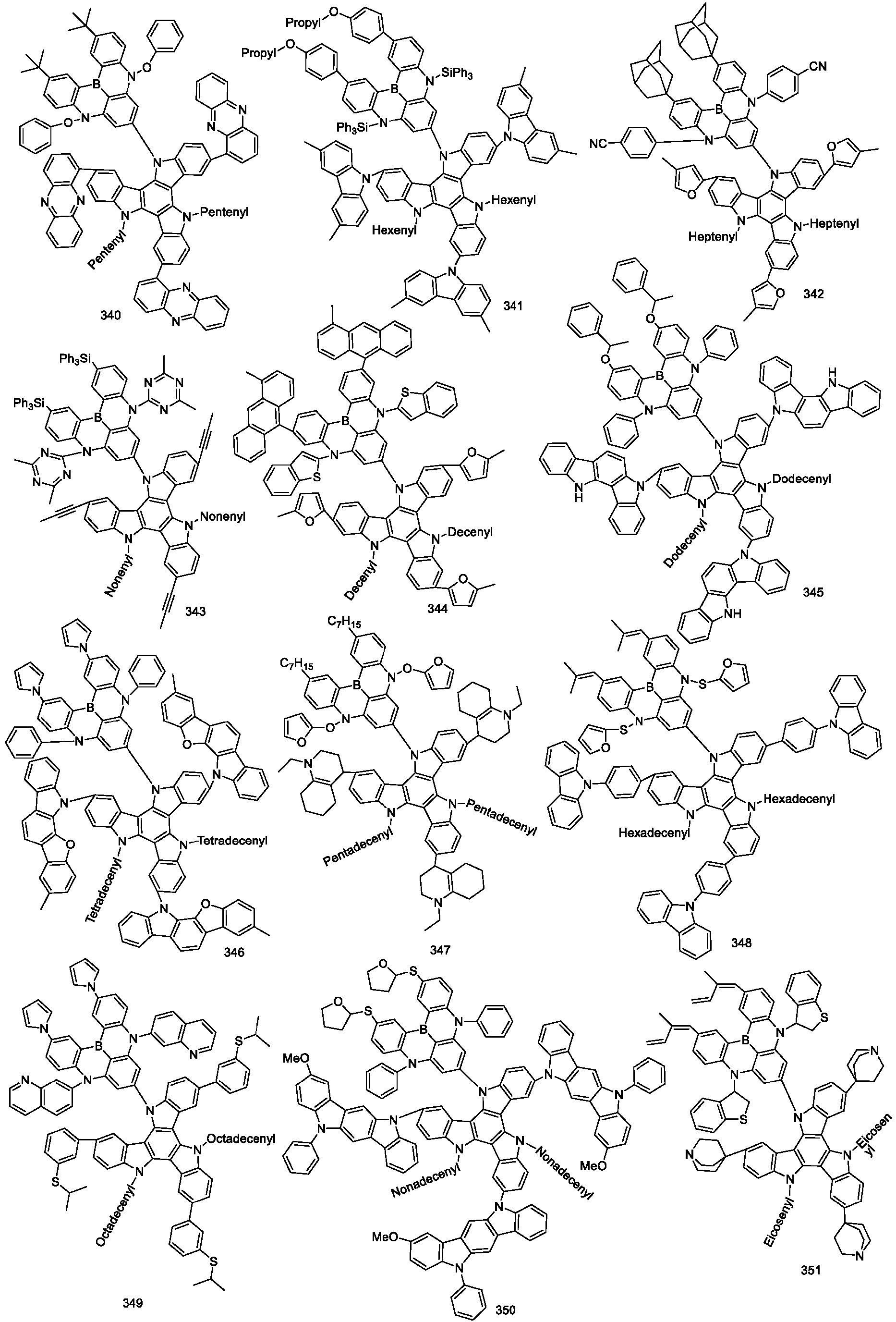 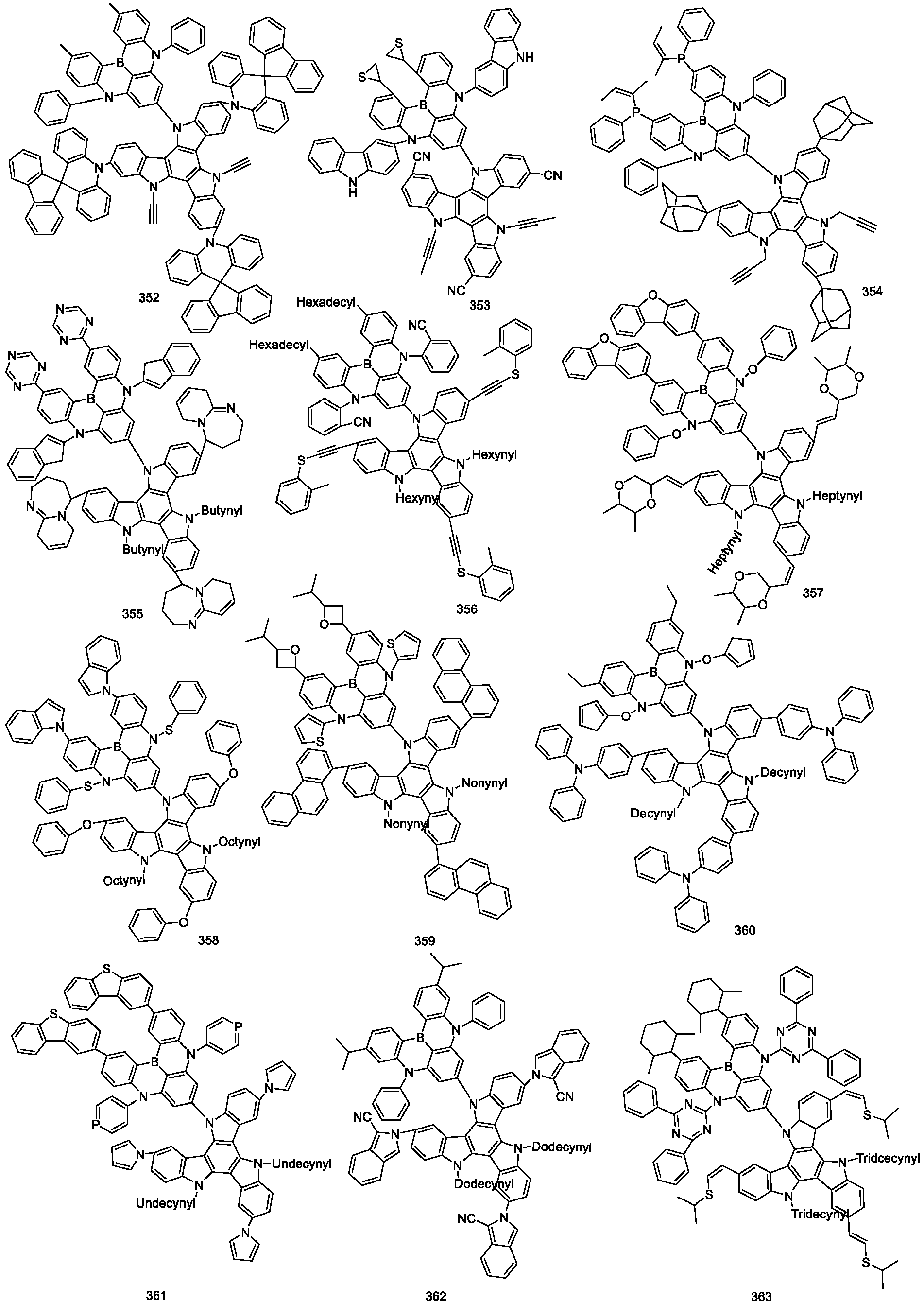 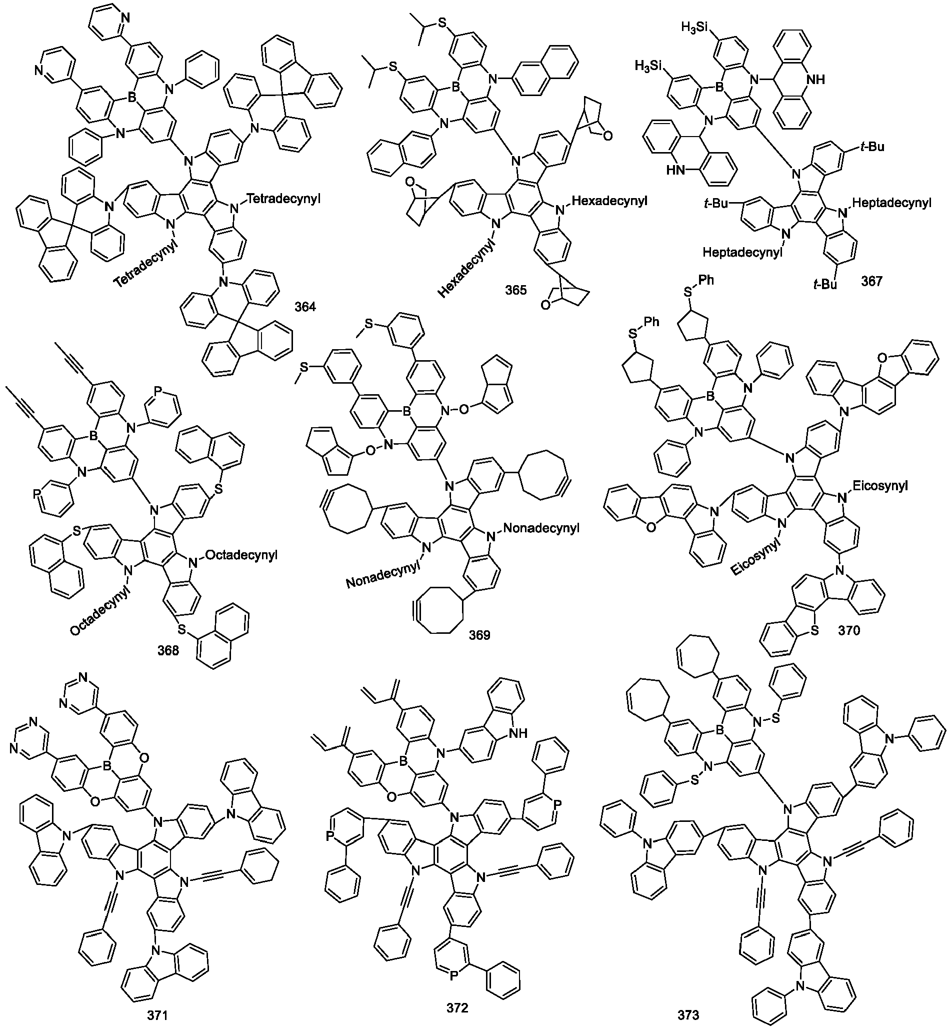 and deuterated analogues thereof.

### Example 2: Process for obtaining compounds with the structure according to Formula I

The process of obtaining compounds with the structure represented by Formula I is presented in the following examples, which do not limit its scope of protection. The process of synthesizing the compounds of the embodiment will be exemplified through descriptions of processes for synthesizing Compounds **1, 2, 3, 4, 5, 6, 16, 26, 84, 105,** and **173**. The preferred alkyl phosphine used in the process is tri-*tert*-butylphosphine or tri-*tert*-butylphosphonium tetrafluoroborate, the preferred alkyl-aromatic phosphine used in the process are the Buchwald type alkyl-aromatic phosphines SPhos, XPhos and *t*-BuXPhos.

### 2.1 Process for the preparation of Compound 1 of the invention by a two-step synthesis

### a. 5,10-Dimethyl-10,15-dihydro-5H-diindolo[3,2-a:3',2'-c]carbazole

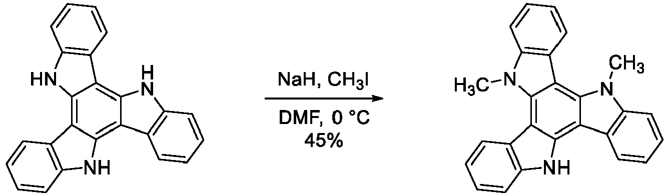

NaH (60% in mineral oil, 0.720g, 30 mmol) was weighed into a two-necked flask and dry DMF (100 ml) was added under inert gas. Stirred at room temperature (RT) for 5 min. After this time, diindolocarbazole (3.45g, 10 mmol) was added in one portion, cooled to 0 °C and stirred for 30 min. A solution of CH₃I (2.84 g, 20 mmol) in dry DMF (100 mol) was then slowly added dropwise. The reaction was stirred overnight with spontaneously warming to RT. Water (250 ml) was added and the mixture was extracted with AcOEt (3×100 ml). The combined organic layers were washed with water (100 ml) and brine (150 ml), dried with anhydrous MgSO₄, the solvents were evaporated to give 4.2 g of a solid. Purified twice by flash chromatography in 40% dichloromethane (DCM)/petroleum ether (PE) with 3%(v/v) triethylamine to give 1.66 g of solid (45%). ¹H NMR (benzene-*d₆*, 400 MHz) δ [ppm]: 8.26 (d, *J* = 7.8 Hz, 2H), 8.22 (d, *J* = 7.8 Hz, 2H), 7.95 (s, 1H), 7.52 (d, *J* = 7.5 Hz, 1H), 7.45-7.37 (m, 3H), 7.35-7.25 (m, 4H), 7.16-7.10 (m, 2H), 4.58 (s, 3H), 4.52 (s, 3H). Other methods of purification of the reaction product known in the art are possible (e.g., crystallization).

### b. 5-(2,12-Di-tert-butyl-5,9-dioxa-13b-boranaphtho[3,2,1-de]anthracen-7-yl)-10,15-dimethyl-10,15-dihydro-5H-diindolo[3,2-a:3',2'-c]carbazole - Compound 1

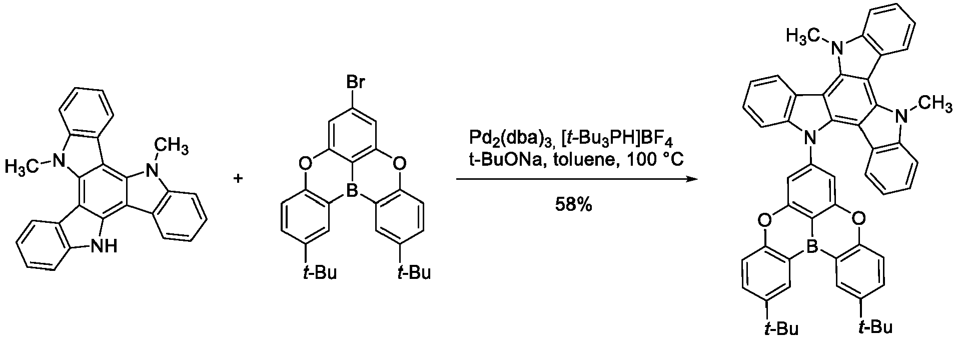

In a Schlenk tube 5,10-dimethyl-10,15-dihydro-5*H*-diindolo[3,2-a:3',2'-c]carbazole (448 mg, 1.2 mmol), 7-bromo-2,12-di-*tert*-butyl-5,9-dioxa-13b-boranaphtho[3,2,1-*de*]anthracene (461 mg, 1 mmol), t-BuONa (192 mg, 2 mmol) were mixed in dry toluene (25 ml) under inert gas and the mixture was stirred at RT for 5 minutes. Then Pd₂(dba)₃ (46 mg, 0.05 mmol, 5 mol%) was added in one portion followed by [*t*-Bu₃PH]BF₄ (29 mg, 0.10 mmol, 10 mol%). The reaction was stirred overnight at 100 °C, cooled to RT, poured into MeOH (150 ml) and water (10 ml) was added. The resulting precipitate was filtered off, washed several times with a small amount of MeOH and dried to give 526 mg of a yellow solid. The precipitate was transferred to a flask, acetone (10 ml) was added and heated at 65 °C for 5 min. It was cooled to RT and the resulting precipitate was filtered off. After drying, 441 mg of a yellow solid (58%) were obtained. ¹H NMR (THF-*d₈*, 400 MHz) δ [ppm]: 8.89 (d, *J* = 2.5 Hz, 2H), 8.65-8.61 (m, 2H), 7.89 (dd, *J* = 8.8 Hz, 2.6 Hz, 2H) 7.78-7.72 (m, 2H), 7.52-7.46 (m, 6H), 7.39-7.33 (m, 3H), 7.10-7.06 (m, 1H), 6.50-6.45 (m, 1H), 6.23 (d, *J* = 7.9Hz, 1H), 4.58 (s, 3H), 4.51 (s, 3H), 1.54 (s, 18H).

### 2.2 7-(10,15-Dimethyl-10,15-dihydro-5H-diindolo[3,2-a:3',2'-c]carbazol-5-yl)-9-phenyl-9H-5-oxa-9-aza-13b-boranaphtho[3,2,1-de]anthracene - Compound 70

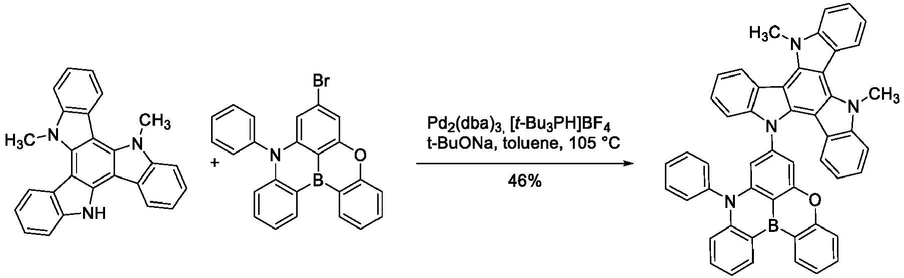

In a Schlenk tube 5,10-dimethyl-10,15-dihydro-5*H*-diindolo[3,2-a:3',2'-c]carbazole (448 mg, 1.2 mmol), 7-bromo-9-phenyl-9*H*-5-oxa-9-aza-13b-boranaphtho[3,2,1-*de*]anthracene (424 mg, 1 mmol), *t*-BuONa (192 mg, 2 mmol) were mixed in dry toluene (25 ml) under inert gas and the mixture was stirred at RT for 5 minutes. Then Pd₂(dba)₃ (46 mg, 0.05 mmol, 5 mol%) was added in one portion followed by [*t*-Bu₃PH]BF₄ (29 mg, 0.10 mmol, 10 mol%). The reaction was stirred overnight at 105 °C, cooled to RT, poured into MeOH (150 ml) and water (10 ml) was added. The resulting precipitate was filtered off, washed several times with a small amount of MeOH, and dried to give 420 mg of a yellow solid. The precipitate was transferred to a flask, acetone (10 ml) was added and heated at reflux for 5 min. It was cooled to RT and the resulting precipitate was filtered off and purified by chromatography (AcOEt 10%). After drying, 330 mg of a yellow solid (46%) were obtained. ¹H NMR (THF-*d₈*, 400 MHz) δ [ppm]: 8.81- 8.78 (m, 2H), 8.63-8.59 (m, 2H), 7.89-7.87 (m, 2H), 7.74-7.68 (m, 2H), 7.54-7.40 (m, 8H), 7.39-7.19 (m, 7H), 7.05-7.01 (m, 2H), 6.50-6.45 (m, 2H), 4.58 (s, 3H), 4.60 (s, 3H).

### 2.3 5-(5,9-Diphenyl-5,9-dihydro-5,9-diaza-13b-boranaphtho[3,2,1-de]anthracen-7-yl)-10,15-dimethyl-10,15-dihydro-5H-diindolo[3,2-a:3',2'-c]carbazole- Compound 138

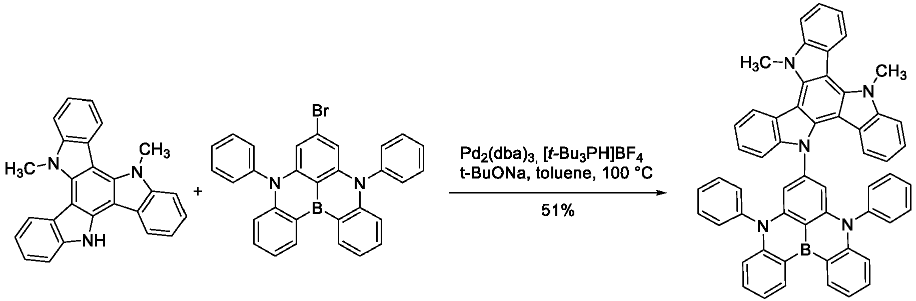

In a Schlenk tube 5,10-dimethyl-10,15-dihydro-5*H*-diindolo[3,2-a:3',2'-c]carbazole (448 mg, 1.2 mmol), 7-bromo-5,9-diphenyl-5,9-dihydro-5,9-diaza-13b-boranaphtho[3,2,1-de]anthracene (500 mg, 1 mmol), *t*-BuONa (192 mg, 2 mmol) were mixed in dry toluene (25 ml) under inert gas and the mixture was stirred at RT for 5 minutes. Then Pd₂(dba)₃ (46 mg, 0.05 mmol, 5 mol%) was added in one portion followed by [*t*-Bu₃PH]BF₄ (29 mg, 0.10 mmol, 10 mol%). The reaction was stirred overnight at 100 °C, cooled to RT, poured into MeOH (150 ml), and water (10 ml) was added. The resulting precipitate was filtered off, washed several times with a small amount of MeOH, and dried to give a yellow solid. The precipitate was transferred to a flask, acetone (10 ml) was added and heated at reflux for 5 min. It was cooled to RT and the resulting precipitate was filtered off and purified by chromatography (AcOEt, 15%). After drying, 400 mg of a yellow solid (46%) were obtained. ¹H NMR (THF-*d₈*, 400 MHz) δ [ppm]: 8.86-8.84 (m, 2H), 8.65-8.61 (m, 2H), 7.90-7.88 (m, 2H), 7.75-7.68 (m, 2H), 7.57-7.15 (m, 20H), 7.05-7.01 (m, 2H), 6.55-6.51 (m, 2H), 4.64 (s, 6H).

### 2.4 Process for obtaining Compound 2 of the invention by synthesis 5-(5,9-dioxa-13b-boranaphtho[3,2,1-de]anthracen-7-yl)-10,15-dimethyl-10,15-dihydro-5H-diindolo[3,2-a:3',2'-clcarbazole

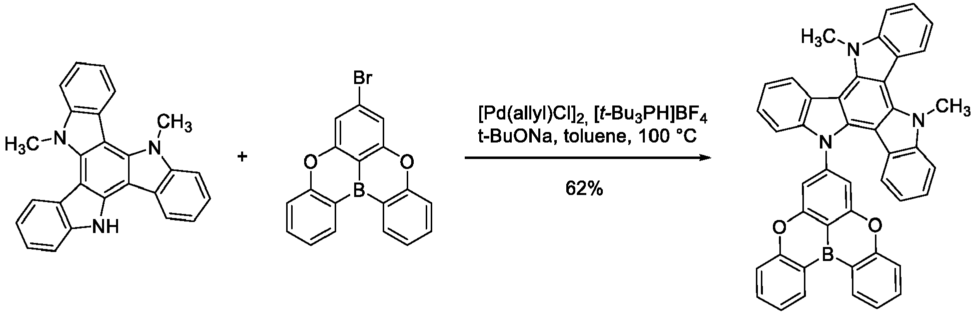

In a Schlenk tube 5,10-dimethyl-10,15-dihydr o-5*H*-diindolo[3,2-*a*:3',2'-*c*]carbazole (671 mg, 1.8 mmol), 7-bromo-2,12-di-*tert*-butyl-5,9-dioxa-13b-boranaphtho[3,2,1-*de*]anthracene (524 mg, 1.5 mmol), *t*-BuONa (288 mg, 3 mmol) were mixed in dry toluene (50 mL) under inert gas and the mixture was stirred at RT for 5 minutes. Then [Pd(allyl)Cl]₂ (27 mg, 0.075 mmol, 5 mol%) was added in one portion followed by [*t*-Bu₃PH]BF₄ (44 mg, 0.15 mmol, 10 mol%). The reaction was stirred overnight at 100 °C, cooled to RT, poured into MeOH (150 ml) and water (10 ml) was added. The resulting precipitate was filtered off, washed several times with a small amount of MeOH and dried to give 730 mg of precipitate. The precipitate was transferred to a flask, acetone (10 ml) was added and heated at 65 °C for 5 min. It was cooled and the resulting precipitate was filtered off. After drying, 600 mg of a yellow solid (58%) were obtained. Anal. Calcd. for C₄₄H₂₈BN₃O₂: C, 82.38; H, 4.40; N, 6.55. Found: C, 82.52; H, 4.38; N, 6.53.

### 2.5 Process for obtaining Compound 3 of the invention by synthesis

### a) Synthesis of 5,10-bis(methyl-d₃)-10,15-dihydro-5H-diindolo[3,2-a:3',2'-c]carbazole

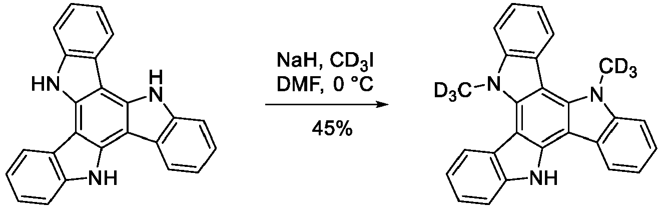

In a two-necked flask NaH (60% in mineral oil, 0.209 g, 8.7 mmol) was dispersed in dry DMF (30 mL) under inert gas and the mixture was stirred at RT for 5 min. It was cooled to 0 °C, diindolocarbazole (1.00 g, 2.9 mmol) was added in one portion, and the mixture was stirred for 30 min. A solution of CD₃I (0.861 g, 5.8 mmol) in dry DMF (30 mol) was slowly added dropwise and the reaction was stirred overnight with spontaneous warming to RT. Water (100 ml) was added and the mixture was extracted with ethyl acetate (3×50 ml). The combined organic layers were washed with water (50 ml) and brine (50 ml), dried with anhydrous MgSO₄, and the solvents were evaporated to give 2.2 g of a solid. Purified twice by flash chromatography, 40% DCM/PE with 3%(v/v) triethylamine, to give 0.495 g of solid (45%). ¹H NMR (benzene-*d₆*, 400 MHz) δ [ppm]: 8.26 (d, *J* = 7.8 Hz, 2H), 8.22 (d, *J* = 7.8 Hz, 2H), 7.95 (s, 1H), 7.52 (d, *J* = 7.5 Hz, 1H), 7.45-7.37 (m, 3H), 7.35-7.25 (m, 4H), 7.16-7.10 (m, 2H). Other methods of purification of the reaction product known in the art are possible (e.g., crystallization).

### b) Synthesis of Compound 3 - 5-(2,12-di-tert-butyl-5,9-dioxa-13b-boranaphtho[3,2,1-de]anthracen-7-yl)-10,15-bis(methyl-d₃)-10,15-dihydro-5H-diindolo[3,2-a:3',2'-c]carbazole

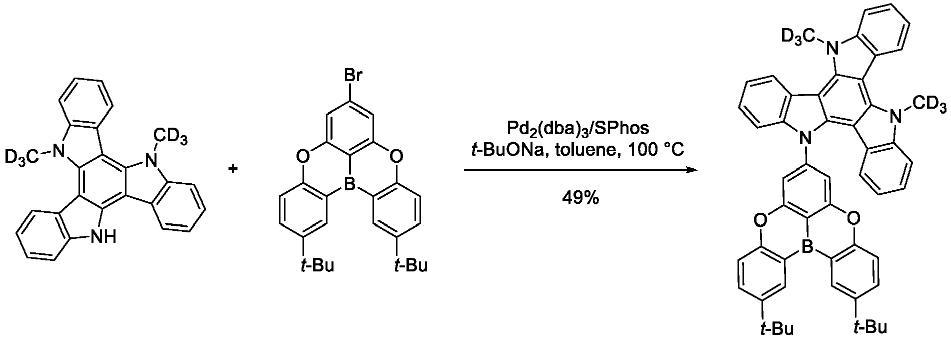

In a Schlenk tube 5,10-bis(methyl-*d₃*)-10,15-dihydro-5*H*-diindolo[3,2-*a*:3',2'-*c*]carbazole (379 mg, 1.0 mmol), 7-bromo-2,12-di-*tert*-butyl-5,9-dioxa-13b-boranaphtho[3,2,1-*de*]anthracene (384 mg, 0.83 mmol) and *t*-BuONa (159 mg, 1.66 mmol) were mixed in dry toluene (15 ml) under inert gas and the mixture was stirred at RT for 5 minutes. Then Pd₂(dba)₃ (38 mg, 0.04 mmol, 5 mol%) was added in one portion followed by SPhos (33 mg, 0.08 mmol, 10 mol%). The reaction was stirred overnight at 100 °C, cooled to RT, poured into MeOH (50 ml). The resulting precipitate was filtered off, washed several times with a small amount of MeOH and dried to give 409 mg of a gray solid. The precipitate was transferred to a flask, MeOH (25 ml) and acetone (10 ml) were added and heated at 65 °C for 1 h. It was cooled and the resulting precipitate was filtered off and dried in air to achieve 310 mg of a yellow solid (49%). ¹H NMR (benzene-*d₆*, 400 MHz) δ [ppm]: 8.96 (d, *J* = 2.4 Hz, 2H), 8.44-8.37 (m, 2H), 7.78 (d, *J* = 8.0, 2H), 7.53-7.35 (m, 6H), 7.34-7.29 (m, 4H), 7.03-6.92 (m, 3H), 6.63 (d, *J* = 3.6 Hz, 2H), 1.39 (s, 18H).

### 2.6 Process for obtaining Compound 4 of the invention by synthesis

### a. 5,10-dihexyl-10,15-dihydro-5H-diindolo[3,2-a:3',2'-c]carbazole

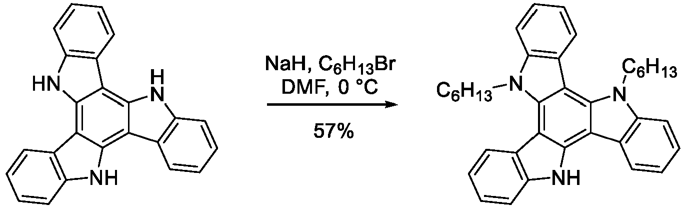

In a two-necked flask NaH (60% in mineral oil, 0.104 g, 4.35 mmol) was dispersed in dry DMF (10 mL) under inert gas and the mixture was stirred at RT for 5 min. It was cooled to 0 °C, diindolocarbazole (0.50g, 1.45 mmol) was added in one portion, and the mixture was stirred for 30 min. A solution of 1-bromohexane (0.479 g, 2.9 mmol) in dry DMF (5 mol) was slowly added dropwise and the reaction was stirred overnight with spontaneous warming to RT. Water (50 ml) was added and the mixture was extracted with ethyl acetate (3×20 ml). The combined organic layers were washed with water (50 ml) and brine (50 ml), dried with anhydrous MgSO₄, and the solvents were evaporated to give 1.2 g of a solid. Purified by flash column chromatography using DCM/PE gradient system with 3%(v/v) triethylamine to give 0.421 g of a solid (57%). ¹H NMR (benzene-*d₆*, 400 MHz) δ [ppm]: 8.46-8.29 (m, 3H), 7.70 (d, *J* = 7.5, 1H), 7.50-7.33 (m, 9H), 4.68-4.51 (m, 4H), 1.91-1.77 (m, 4H), 1.19-0.95 (m, 12H), 0.76-0.67 (m, 6H). Other methods of purification of the reaction product known in the art are possible (e.g., crystallization).

### b. Synthesis of Compound 4 -5-(2,12-di-tert-butyl-5,9-dioxa-13b-boranaphtho[3,2,1-de]anthracen-7-yl)-10,15-dihexyl-10,15-dihydro-5H-diindolo[3,2-a:3',2'-c]carbazole

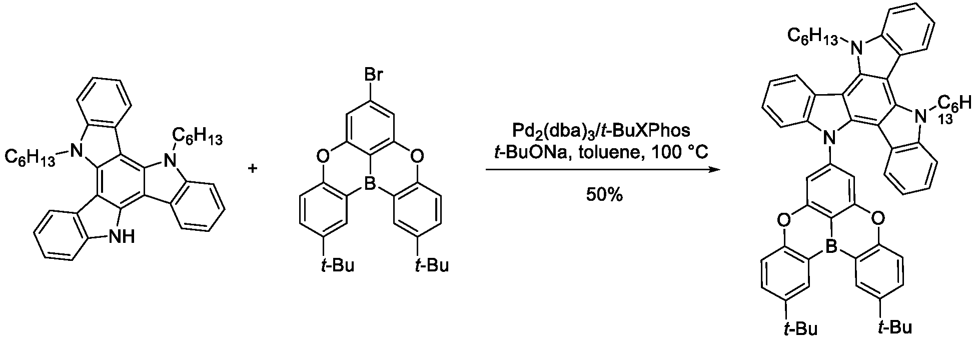

In a Schlenk tube 5,10-dihexyl-10,15-dihydro-5H-diindolo[3,2-a:3',2'-c]carbazoles (617 mg, 1.2 mmol), 7-bromo-2,12-di-*tert*-butyl-5,9-dioxa-13b-boranaphtho[3,2,1-*de*]anthracene (461 mg, 1.00 mmol) and t-BuONa (192 mg, 2.00 mmol) were mixed in dry toluene (10 ml) under inert gas and the mixture was stirred at RT for 5 minutes. Then Pd₂(dba)₃ (46 mg, 0.05 mmol, 5 mol%) was added in one portion followed by *t*-BuXPhos (43 mg, 0.10 mmol, 10 mol%). The reaction was stirred overnight at 100 °C, cooled to RT, poured into MeOH (50 ml). The resulting precipitate was filtered off, washed several times with a small amount of MeOH and dried to give 903 mg of a gray solid. The precipitate was transferred to a flask, MeOH (50 ml) and acetone (20 ml) were added and heated at 65 °C for 1 h. It was cooled and the resulting precipitate was filtered off and dried in air to achieve 450 mg of a yellow solid (50%). ¹H NMR (benzene-*d₆*, 400 MHz) δ [ppm]: 8.94 (d, *J* = 2.4 Hz, 2H), 8.52-8.42 (m, 2H), 7.80 (d, *J* = 8.4, 1H), 7.59-7.55 (m, 1H), 7.53-7.42 (m, 7H), 7.34-7.30 (m, 3H), 7.25 (d, *J* = 8.3 Hz, 1H), 7.00 (td, *J* = 7.6 Hz, 1.0 Hz, 1H), 6.74 (d, *J* = 8.1 Hz, 2H), 6.64 (td, *J* = 7.6 Hz, 0.9Hz, 1H), 4.79 (t, *J* = 8.1 Hz, 2H), 4.67 (t, *J* = 8.0 Hz, 2H), 1.90-1.71 (m, 4H), 1.38 (s, 18H), 1.11 - 0.92 (m, 12H), 0.76-0.65 (m, 6H).

### 2.7 Process for obtaining exemplary compounds of the invention

Synthesis of Compounds **16** and **26** was performed by substantially the same method as the synthesis of Compound **4**, except that 1-bromodecane and 1-bromoeicosane were used for synthesis of 5,10-didecyl-10,15-dihydro-5H-diindolo[3,2-a:3',2'-c]carbazole and 5,10-diicosyl-10,15-dihydro-5H-diindolo[3,2-a:3',2'-c]carbazole to obtain desired products in 51% and 46% respectively. Their coupling with 7-bromo-2,12-di-*tert*-butyl-5,9-dioxa-13b-boranaphtho[3,2,1-de]anthracene allowed to achieve desired products in 41% and 36% yield respectively. The structures of both compounds were confirmed by ¹H NMR.

Synthesis of Compounds **84** and **105** was performed by substantially the same method as the synthesis of Compound **70**, except that 1-bromodecane and (*E*)-5-decenylbromid were used for synthesis of 5,10-didecyl-10,15-dihydro-5H-diindolo[3,2-a:3',2'-c]carbazole and 5,10-di((E)-dec-5-en-1-yl)-10,15-dihydro-SH-diindolo[3,2-a:3',2'-c]carbazole to obtain desired products in 51% and 53% respectively. Their coupling with 7-bromo-9-phenyl-9H-5-oxa-9-aza-13b-boranaphtho[3,2,1-de]anthracene and 7-bromo-2,12-di-*tert*-butyl-9-phenyl-9H-5-oxa-9-aza-13b-boranaphtho[3,2,1-de]anthracene respectively allowed to achieve desired Compounds **84** and **105** in 36% and 31% yield respectively. The structures of both compounds were confirmed by ¹H NMR.

Synthesis of Compound **173** was performed by substantially the same method as the synthesis of Compound **138** except that 5,10-di((E)-dec-5-en-1-yl)-10,15-dihydro-5H-diindolo[3,2-a:3',2'-c]carbazole was used for coupling with 7-bromo-2,12-di-*tert*-butyl-5,9-diphenyl-5,9-dihydro-5,9-diaza-13b-boranaphtho[3,2,1-de]anthracene to give the desired 5,10-di((E)-dec-5-en-1-yl)-15-(2,12-di-*tert*-butyl-5,9-diphenyl-5,9-dihydro-5,9-diaza-13b-boranaphtho[3,2,1-de]anthracen-7-yl)-10,15-dihydro-5H-diindolo[3,2-a:3',2'-c]carbazole (Compound **173**) in 40% yield. The structures of both compounds were confirmed by 1H NMR.

### Example 3: The emissive layer of diode and an exemplary diode

The organic light emitting diode (OLED) comprising an anode, cathode, and organic emissive layer. The emissive layer is disposed between the anode and cathode. The emissive layer can comprise a phosphorescent sensitizer doped with a TADF emissive dopant, and a host. The TADF emissive dopant can be a compound according to Formula I or a compound/structure selected from 1 - 373 or their deuterated analogues (as presented in the Example 1). The phosphorescent sensitizer can be an organometallic iridium or platinum complex. The phosphorescent sensitizer can be a compound be an organometallic iridium complex according to Formula II or an organometallic iridium complex is selected from Ir-1 to Ir-151 and their deuterated analogues. The phosphorescent sensitizer can be an organometallic platinum complex according to Formula III or an organometallic platinum complex is selected from Pt-1 to Pt-228 and their deuterated analogues. The phosphorescent sensitizer can be an organometallic iridium or platinum complex is selected from MC-1 to MC-10. The compounds according to Formula I are suitable for a use in the diode according to the invention. The diode can comprise at least one auxiliary phosphorescent sensitizer, wherein the auxiliary phosphorescent sensitizer(s) can be a compound according to Formula II, Formula III, or the organometallic iridium complex is selected from Ir-1 to Ir-151 or the organometallic platinum complex is selected from Pt-1 to Pt-228 or the complex is selected from MC-1 to MC-10. The diode can comprise at least one auxiliary TADF emissive dopand. The auxiliary TADF emissive dopand(s) can be selected from compounds from E-1 to E60. The diode can comprise at least one auxiliary host. The auxiliary host(s) can be selected from a compound from H-1 to H-164. The diode according to invention can comprise at least one fluorescence compound. The fluorescence compound can be selected from:
tris(8-hydroxyquinolinato)aluminum (Alq3), bis(2-methyl-8-quinolinato)(4-phenylphenoxy)aluminum (BAlq), bis(2-methyl-8-quinolinato)-4-(phenylphenolato)aluminum (BAlq(PPh2Me)), rubrene (5,6,11,12-tetraphenylnaphthacene), mtCzTrz (9,9'-(5-(4-(3-(3-(*tert*-butyl)-6-isopropyl-9H-carbazol-9-yl)-5-(3,6-diisopropyl-9H-carbazol-9-yl)phenyl)-6-(4-methoxyphenyl)-1,3,5-triazin-2-yl)-1,3-phenylene)bis(3,6-di-*tert*-butyl-9H-carbazole)), M1 (4-(2-(4-(diphenylamino)phenyl)-4,5-diphenyl-1H-imidazol-1-yl)phenyl acetate), C-A-C (9,10-bis(3,5-bis(3,6-di-*tert*-butylcarbazol-9-yl)-phenyl) anthracene), m-ACSO2 (10,10'-(sulfonylbis(3,1-phenylene))bis(9,9-dimethyl-9,10-dihydroacridine)), TXO-TPA (2-[4-(diphenylamino) phenyl]-10, 10-dioxide-9H-thioxanthen-9-one), N-BDAVBi-C6 (4,4'-(1E,1'E)-2,2'-(Naphthalene-2,6-diyl)bis(ethene-2,1-diyl)bis(N,N-bis(4-hexylphenyl)aniline)), PXZPDO (1,3-bis(4-(10H-phenoxazin-10-yl)phenyl)-3-hydroxyprop-2-en-1-one), TPA (9,10-bis[phenyl(m-tolyl)-amino]anthracene), TTPA (9,10-bis[N,N-di-(p-tolyl)-amino]anthracene), 3phCN-ICz (5'-(5-phenylindolo[3,2-a]carbazol-12(SH)-yl)-[1,1':3',1"-terphenyl]-2'-carbonitrile), mCDtCBPy (3,3",6,6"-tetra-*tert*-butyl-9'-(6-(3-(3,3",6,6"-tetra-tert-butyl-9'H-[9,3':6',9"-tercarbazol]-9'-yl)-phenyl)pyridine-2-yl)-9'H-9,3':6',9"-tercarbazole), DDMACPy (2,6-bis(3-(9,9-dimethylacridin-10(9H)-yl)phenyl)pyridine), BICz (5,5'-(4-(2,12-di-*tert*-butyl-5,9-dioxa-13b-boranaphtho[3,2,1-de]anthracen-7-yl)-1,3-phenylene)bis(7,7-dimethyl-5,7-dihydroindeno[2,1-b]carbazole)), BAnF8Pye (1-(7-(9,9'-bianthracen-10-yl)-9,9-dioctyl-9H-fluoren-2-yl)pyrene), BDAF (2-[9,9-di(4-methylphenyl)-fluoren-2-yl]-9,9-di(4-methylphenyl)fluorene), TDAF (2,7-bis[9,9-di(4-methylphenyl)-fluoren-2-yl]-9,9-di(4-methylphenyl)fluorene), 9,10-diphenylanthracene, 3P-T2T (2,4,6-tris[3-(1H-pyrazol-1-yl)phenyl]-1,3,5-triazine), mCBP-CN (3,3'-di(carbazol-9-yl)-5-cyano-1,1'-biphenyl), 9,9'-(((1E,1'E)-(2,5-dimethyl-1,4-phenylene)bis(ethene-2,1-diyl))bis(4,1-phenylene))bis(9H-carbazole), 9,9'-(((1E,1'E)-(2,5 -dimethoxy-1,4-phenylene)bis(ethene-2,1-diyl))bis(4,1 - phenylene))bis(9H-carbazole), 9,9'-(((1E,1'E)-(9,9-dimethyl-9H-fluorene-2,7-diyl)bis(ethene-2,1-diyl))bis(4,1-phenylene))bis(9H-carbazole), 10-(3-(9H-carbazol-9-yl)phenyl)-9,9-dimethyl-9,10-dihydroacridine, 2FPPICz (2-(4-(9H-carbazol-9-yl)phenyl)-1-(3,5-difluorophenyl)-1H-phenanthro[9,10-d]imidazole), CzPVSBF (2,7-bis((E)-4-(9H-carbazol-9-yl)styryl)-9,9'-spirobi[fluorene]), CN-TPB-TPA (4"'-(diphenylamino)-2',5'-diphenyl-[1,1':4',1":4",1‴-quaterphenyl]-4-carbonitrile), BCzTPM (9,9'-bis(4-tritylphenyl)-9H,9'H-3,3'-bicarbazole), PIM-TRZ (2-(3-(4,6-Diphenyl-1,3,5-triazin-2-yl)phenyl)-1-phenyl-1H-benzo[d]imidazole), mCP-t-Bu (1,3-bis(3,6-di-*tert*-butyl-9H-carbazol-9-yl)benzene), SiCblTrz (9-(4-phenyl-6-(3-(triphenylsilyl)phenyl)-1,3,5-triazin-2-yl)-9H-pyrido[2,3-b]indole), m-BPDBT (3,3'-bis(dibenzo[b,d]thiophen-4-yl)-1,1'-biphenyl), DBTSiDBT (bis(4-(dibenzo[b,d]thiophen-4-yl)phenyl)diphenylsilane), DBFSiDBF (bis(4-(dibenzo[b,d]furan-4-yl)phenyl)diphenylsilane), DBTSF4 (4-(9,9'-spirobi[fluoren]-4-yl)dibenzo[b,d]thiophene), CCP (9-phenyl-3,9'-bi-9H-carbazole), PIAnCN (4-(10-(4-(1-phenyl-1H-phenanthro[9,10-d]imidazol-2-yl)phenyl) anthracen-9-yl)benzonitrile), PIAnTAZ (2-(4-(10-(4-(4,6-diphenyl-1,3,5 -triazin-2-yl)phenyl)anthracen-9-yl)phenyl)-1-phenyl-1H-phenanthro[9,10-d]imidazole), MAD-1N (2-methyl-9,10-di(naphthalen-1-yl)anthracene), SSTF (10-phenyl-2'-(triphenylsilyl)-10H-spiro[acridine-9,9'-fluorene]), BUBH-3 (4,4'-di[10-(naphthalen-1-yl)anthracen-9-yl]biphenyl), 4P-NPB (N,N'-di-(1-naphthalenyl)-N,N' -diphenyl-[1,1':4',1":4",1"'-quaterphenyl]-4,4"'-diamine), BANE (10,10'-di(biphenyl-4-yl)-9,9'-bianthracene), TPyPA (tris[4-(pyrenyl)-phenyl]amine), m-Bpye (1,3-di(pyren-1-yl)benzene), BSBF (2-(9,9-spirobifluoren-2-yl)-9,9-spirobifluorene), BH-9PA (9-(10-phenylanthracen-9-yl)spiro-[benzo[c]fluorene-7,9'-fluorene]), 9-(naphthalen-1-yl)-10-(naphthalen-2-yl)anthracene, pDPFB (1,4-bis(9-phenyl-9H-fluoren-9-yl)benzene), SF34 (3-(9,9'-spirofluorenyl-4-yl)-9,9'-spirofluorene), TCPZ (2,4,6-tris(3-(9H-carbazol-9-yl)phenyl)-1,3,5-triazine), POPH ((5-terphenyl-1,3-phenylene)bis(diphenylphosphine oxide)), DPTPCz (3-(4,6-Diphenyl-1,3,5-triazin-2-yl)-9-phenyl-9H-carbazole), BCz-Si (9-phenyl-9'-(triphenylsilyl)-9H,9'H-3,3'-bicarbazole), 3CzPFP (3-[3-(9H-carbazol-9-yl)phenyl]furo[2,3-b:5,4-b']dipyridine), 4ICDPy (5,12-dihydro-6,7-dimethyl-5,12-di-4-pyridinyl-indolo[3,2-a]carbazole), POSTF (2'-(diphenylphosphoryl)-10-phenyl-10H-spiro[acridine-9,9'-fluorene]), SF3PO (bis(9,9-spirobifluorene-3-yl)-phenylphosphane oxide), CPPyC (9-(5-(3-(9H-carbazol-9-yl)phenyl)pyridin-3-yl)-9H-carbazole), Znq2 (bis(8-hydroxyquinoline) zinc), DBP (dibenzo{[f,f']-4,4',7,7'-tetraphenyl}diindeno[1,2,3-cd:1',2',3'-lm]perylene), DMPPP (1,1'-(2,5-dimethyl-1,4-phenylene)dipyrene), DBPenta (6,13-di-biphenyl-4-yl-pentacene), Spiro-Pye (2,7-dipyrenyl-9,9-spirobifluorene), TPBA (9,9',10,10'-Tetraphenyl-2,2'-bianthracene), BPPF (9,9-bis[4-(pyrenyl)phenyl]-9H-fluorene), TPB3 (1,3,5-tri(pyren-1-yl)benzene), 2,2'-Spiro-Pye (2,2'-dipyrenyl-9,9-spirobifluorene), TSBF (2,7-bis(9,9-spirobifluoren-2-yl)-9,9-spirobifluorene), MADN (2-methyl-9,10-bis(naphthalen-2-yl)anthracene), p-DMDPVBi (1-[2,2-Bis(4-methylphenyl)ethenyl]-4-[4-[2,2-bis(4-methylphenyl)ethenyl]phenyl]benzene), DPVBi (4,4'-bis(2,2-diphenylethenyl)-1,1'-biphenyl), TBADN (2-*tert*-butyl-9,10-di(naphth-2-yl)anthracene), DCM ((E)-2-(2-(4-(dimethylamino)styryl)-6-methyl-4H-pyran-4-ylidene)malononitrile), DCM2 (4-(dicyanomethylene)-2-methyl-6-julolidyl-9-enyl-4H-pyran), DCMB ((E)-2-(2-(4-(dimethylamino)styryl)-6-*tert*butyl-4H-pyran-4-ylidene)malononitrile), (BA-NPB) N10,N10'-diphenyl-N10,N10'-dinaphthalenyl-9,9'-bianthracene-10,10'-diamine.

The diode can comprise at least one of layer between the anode and cathode selected from: a hole injection layer; a hole transport layer; an electron transport layer; an emission auxiliary layer; an electron blocking layer; a hole blocking layer; an electron injection layer; or a combination thereof. The hole transport layer can function as an electron blocking layer and the electron transport layer can function as a hole blocking layer. The diode can be made by thermal evaporation in high vacuum (PVD) or by solution methods, e.g. spin-coating, ink-jet printing. Exemplary structures of hole injection compounds in the hole injection layer comprise the following:

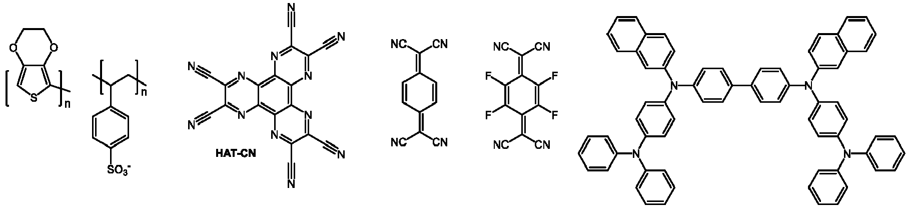

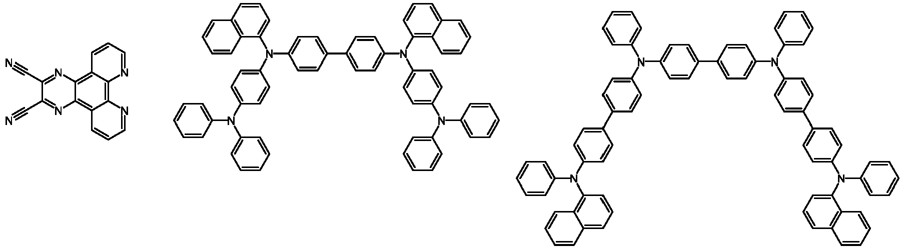

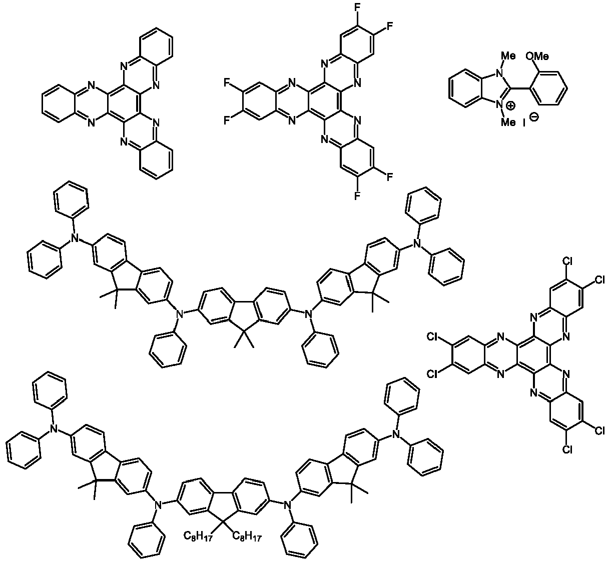

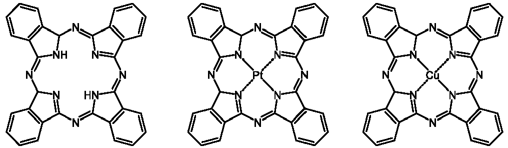

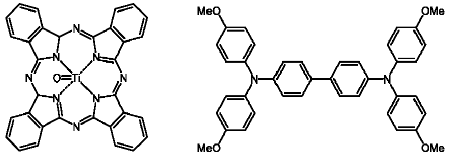

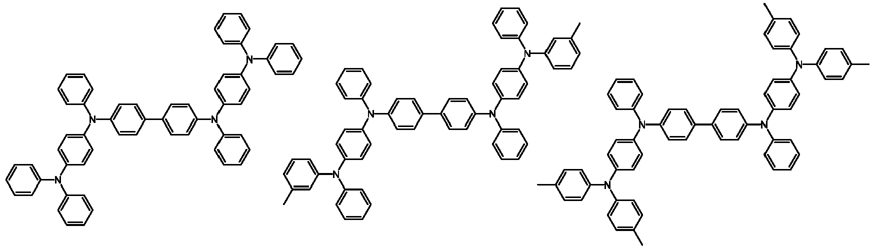

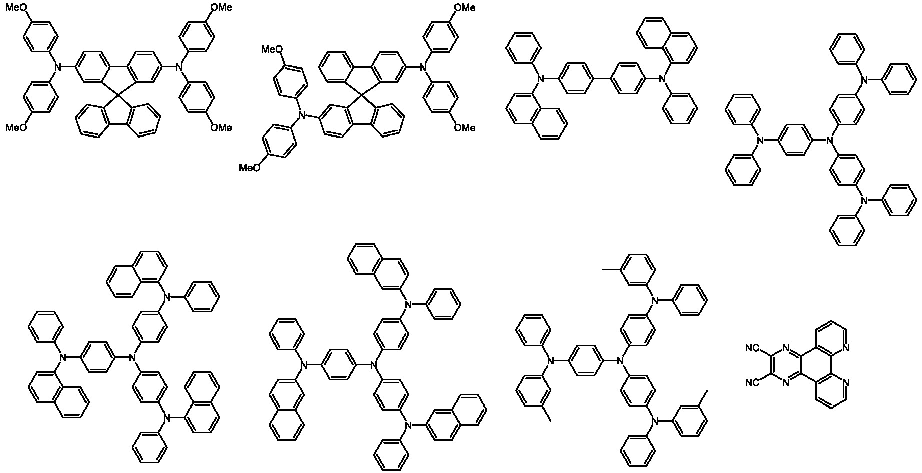

Exemplary structures of compounds of the hole transport layer:

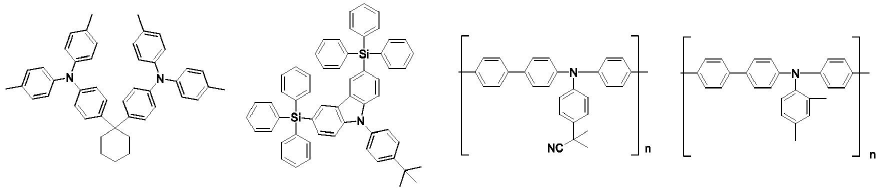

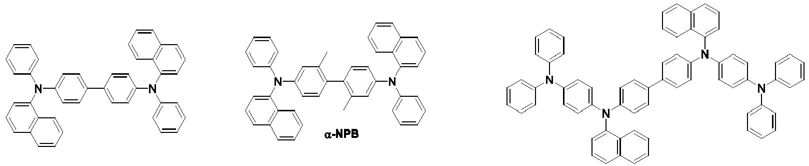

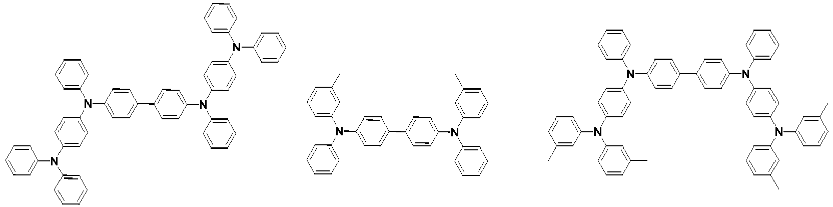

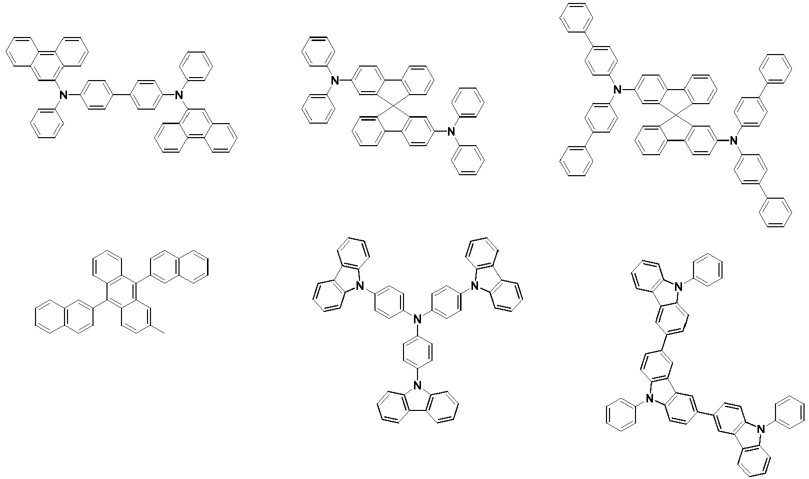

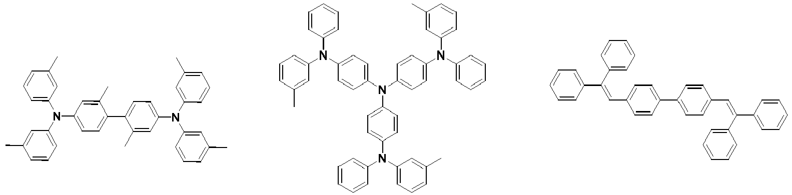

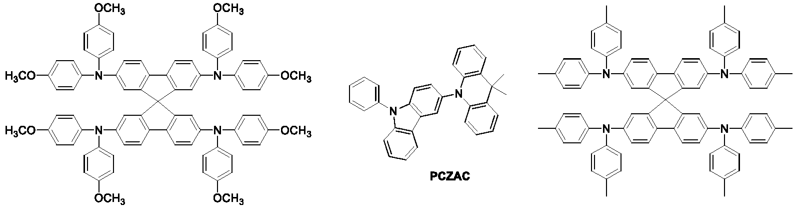

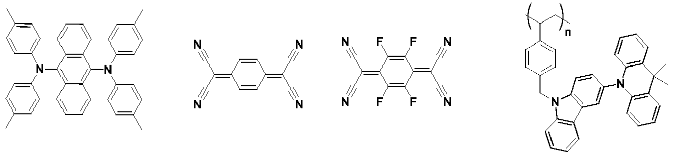

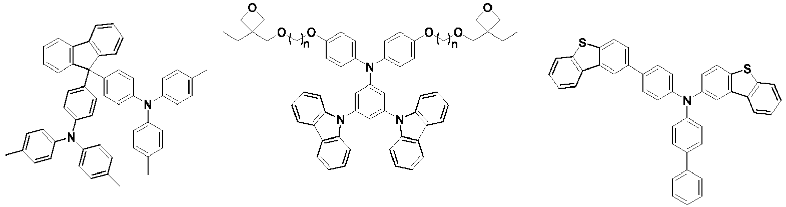

Exemplary structures of electron transporting compounds in the electron transport layer:

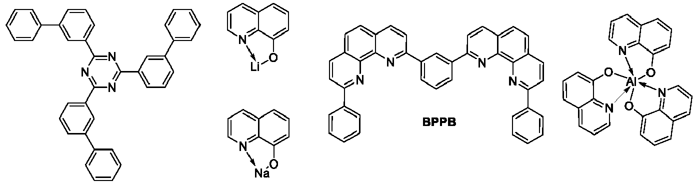

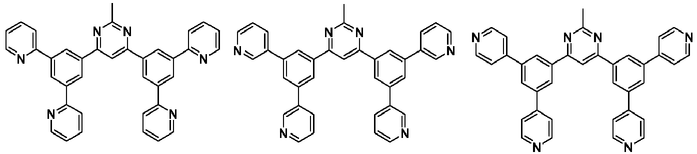

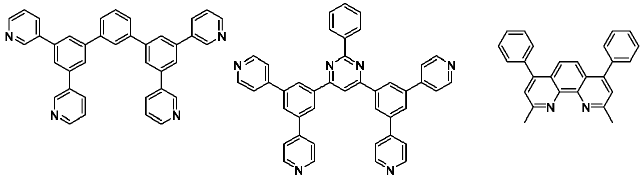

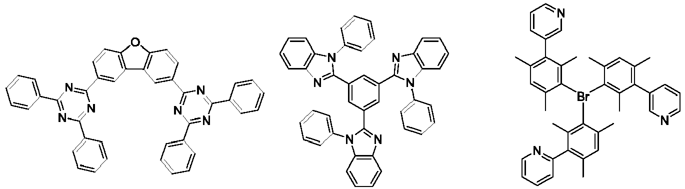

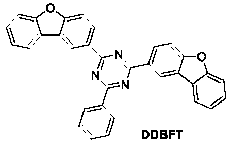

Exemplary structures of electron-injecting materials in the electron injection layer:

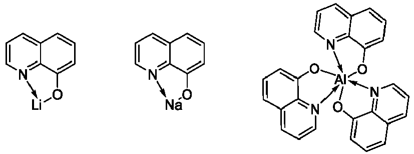

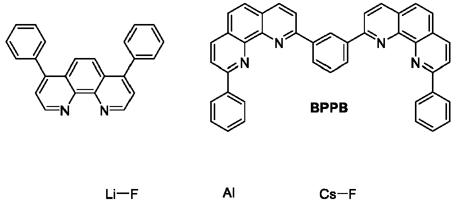

The diode according to invention can comprise the host or a mixture of the host and the auxiliary host(s). The content of the host or a mixture of the host and the auxiliary host(s) can constitute from 60.0% (w./w.) to 99.9% (w./w.) of the emissive layer. The content of the host or a mixture of the host and the auxiliary host(s), can constitute from 62.5%, 65.0%, 70.0%, 75.0%, 80.0%, 85.0%, 87.5%, 90.0%, 92.5%, 95.0% (w./w.) to 99.0% (w./w.) of the emissive layer.

The diode according to invention can comprise the TADF emissive dopant or TADF emissive dopant and the auxiliary TADF emissive dopand. The content of the TADF emissive dopant or TADF emissive dopant and the auxiliary TADF emissive dopand can be from 0.01% (w./w.) to 10.0% (w./w.) of the emissive layer. The content of the TADF emissive dopant or a mixture of the TADF emissive dopant and the auxiliary TADF emissive dopant(s) can be from 0.05%, 0.1%, 1.0%, 1.5%, 2,0%, 2.5%, 3.0%, 5.0%, 7.0%, 8.0%, 9.0% (w./w.) to 9.5% (w./w.) of the emissive layer.

The diode according to invention can comprise the phosphorescent sensitizer or a mixture of the phosphorescent sensitizers and the auxiliary phosphorescent sensitizer(s). The content of the constitutes the phosphorescent sensitizer or a mixture of the phosphorescent sensitizers and the auxiliary phosphorescent sensitizer(s) can be from 0.01% (w./w.) to 40.0% (w./w.) of the emissive layer. The content of the phosphorescent sensitizer or a mixture of the phosphorescent sensitizers and the auxiliary phosphorescent sensitizer(s) can be from 0.05%, 0.1%, 5.0%, 7.5%, 10.0%, 12.5%, 15.0%, 20.0%, 25.0%, 30.0% (w./w.) to 35.0% (w./w.) of the emissive layer.

The diode according to the invention can comprise a matrix. The matrix can be passive or active. The diode according to invention can emit light with a maximum wavelength of 350 nm to 2 500 nm. The diode according to invention can emit light with a maximum wavelength of 400, 450, 500, 550, 600, 650, 700, 750, 800, 900 nm to 1000 nm.

The examples of the host can be: 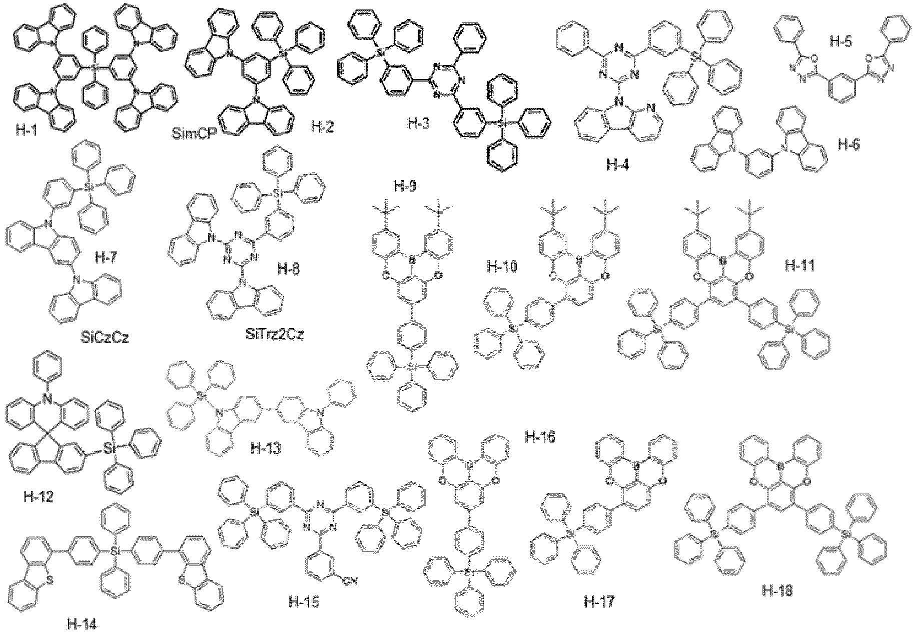 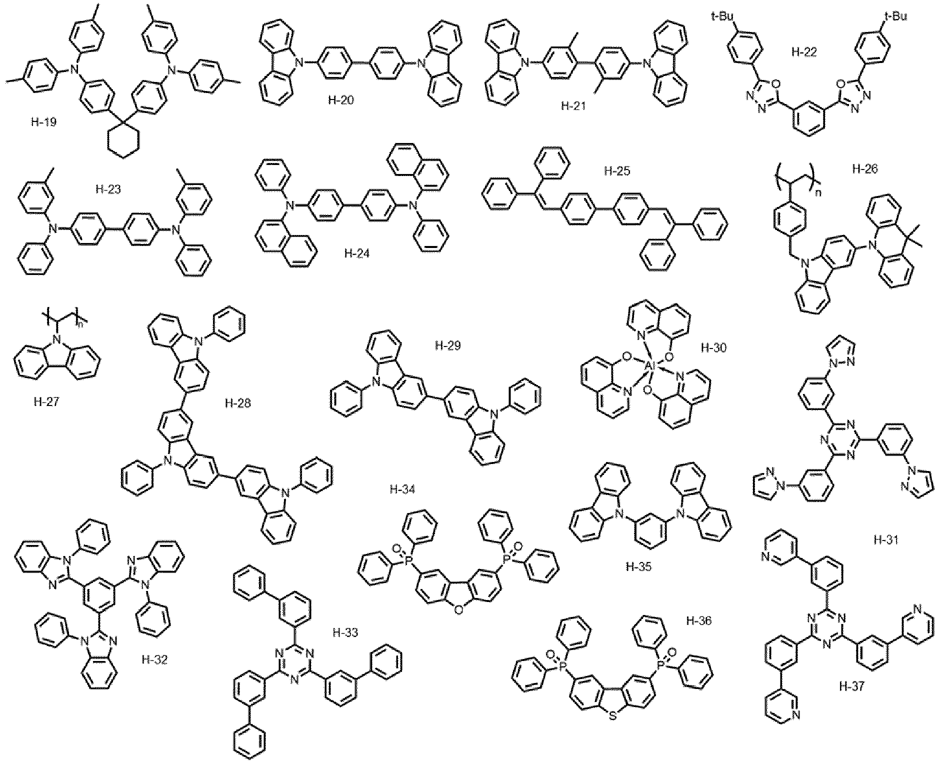 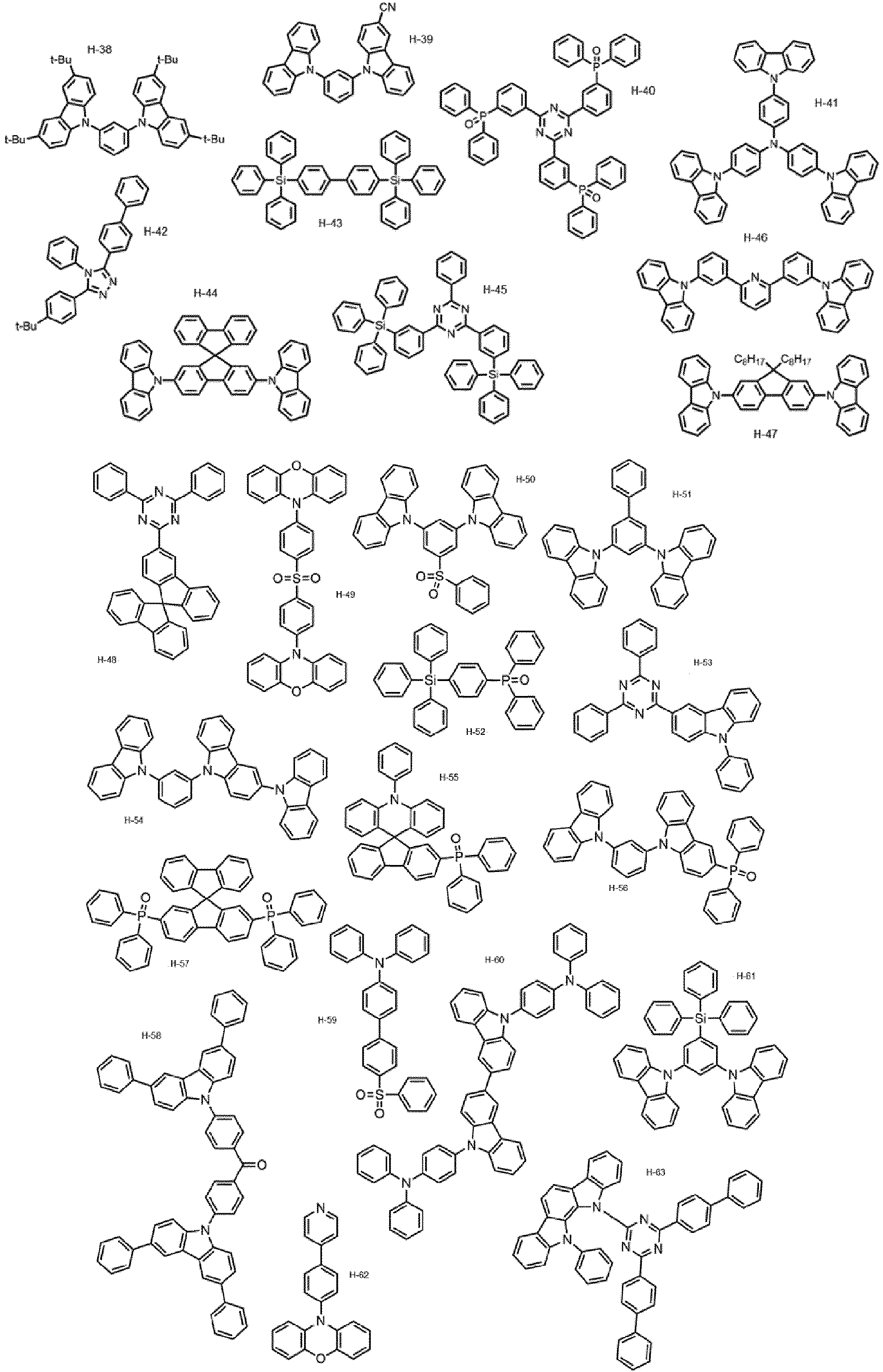 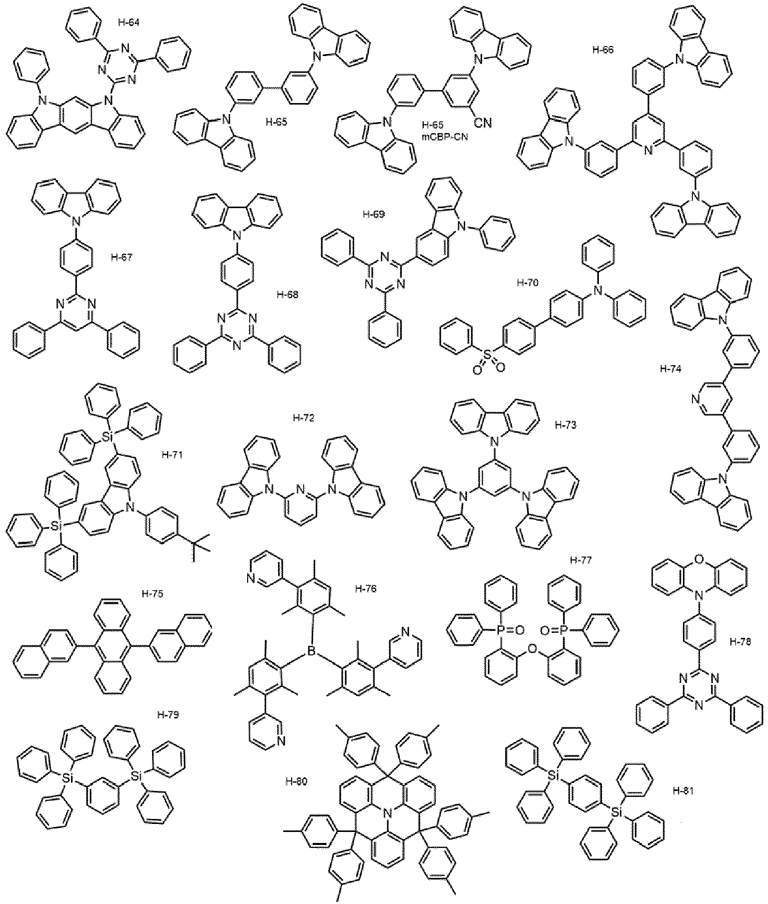 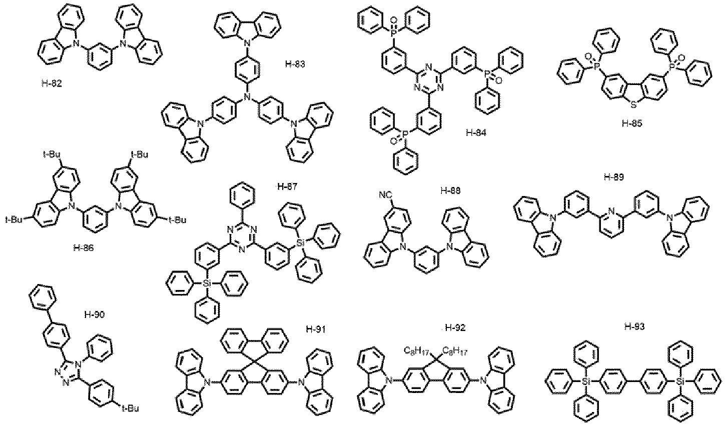 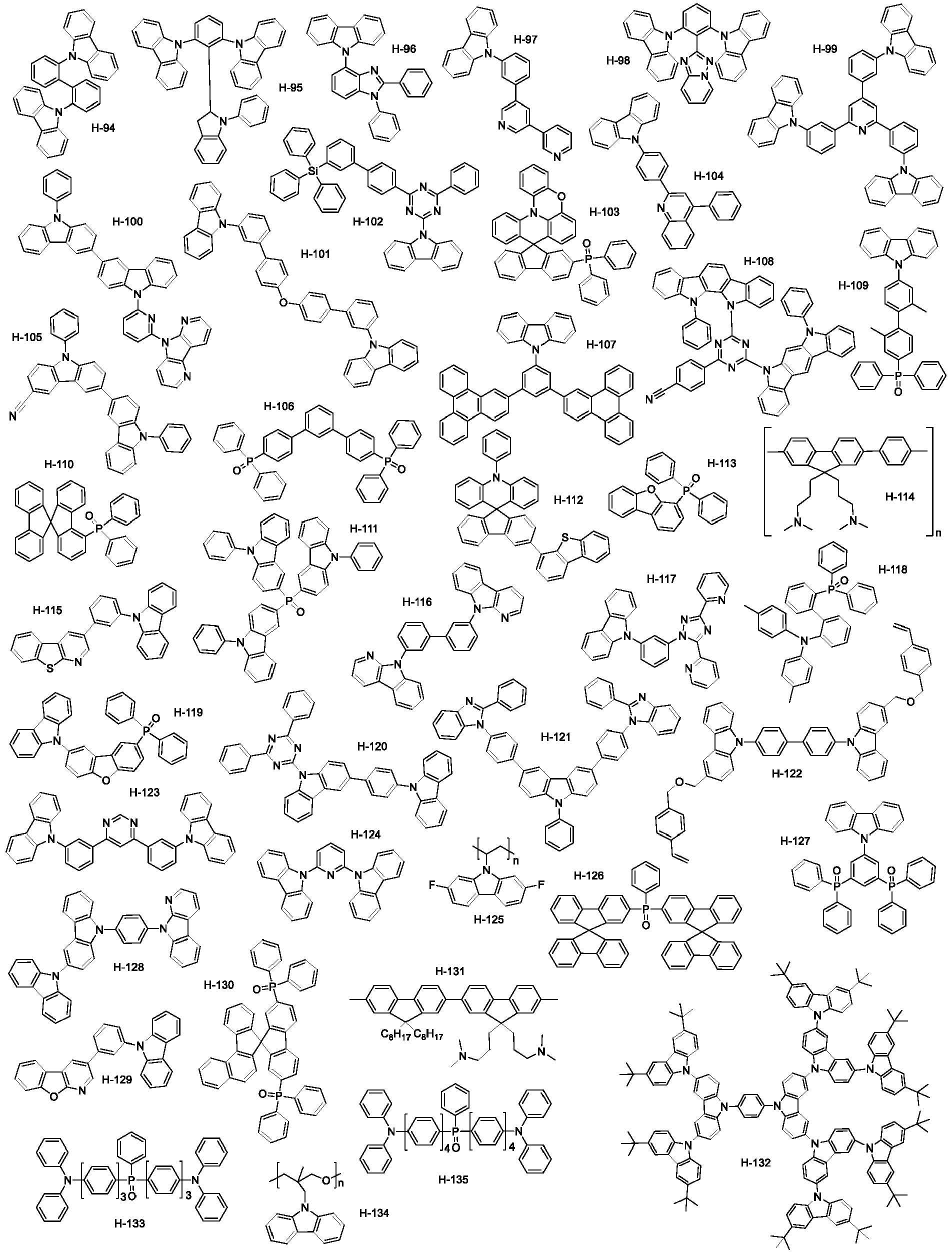 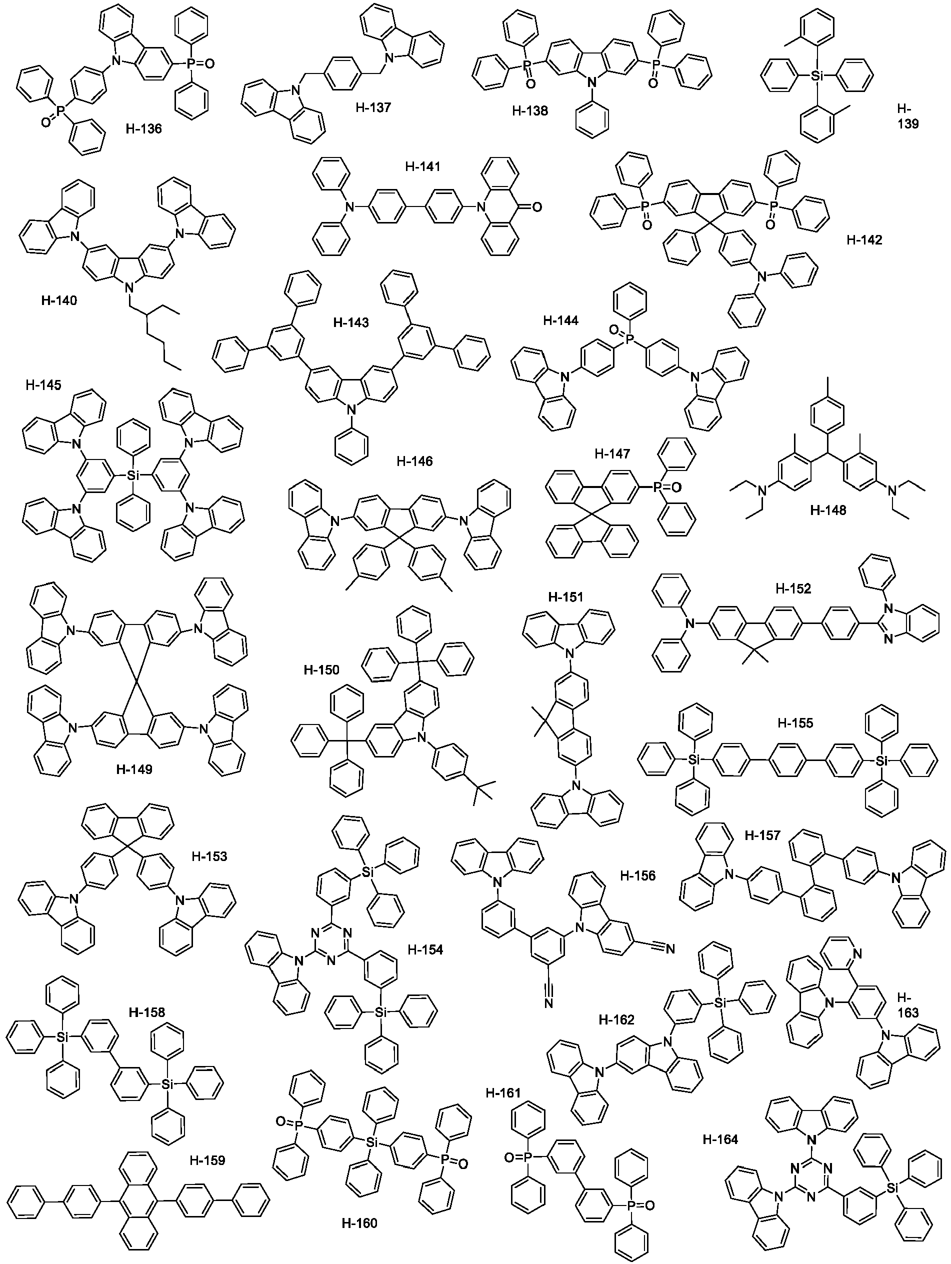 and deuterated analogues thereof.

The examples of the phosphorescent sensitizers can be an organometallic iridium complex according to Formula II: 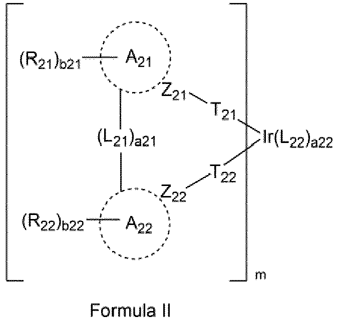 wherein:
m may be an integer from 1 to 3;
a21 may be an integer from 0 to 3;
a22 may be an integer from 0 to 2;
b21, and b22 may each independently be an integer from 1 to 8;
L₂₂ may each independently be selected from an organic ligand, inorganic ligand, a halogen or deuterated analogues thereof;
T₂₁ and T₂₂ may each independently be selected from a single bond, *-O-*', and *-S-*';* and *' each indicate a binding site to an adjacent atom;
Z₂₁, and Z₂₂ may each independently be N or C;
A₂₁ and A₂₂ may each independently be selected from a C₆-C₆₀ aryl group, C₁-C₆₀ heteroaryl group and deuterated analogues thereof;
L₂₁ may each independently be selected from a single bond, *-O-*', *-S-*', *-C(R₂₅)(R₂₆)-*', *-C(R₂₅)=*', *=C(R₂₅)-*', *-C(R₂₅)=C(R₂₅)-*', *-C(=O)-*', *-C(=S)-*', *-C≡C-*', *-B(R₂₅)-*', *-N(R₂₅)-*', *-P(R₂₅)-*', *-Si(R₂₅)(R₂₆)-*', *-P(R₂₅)(R₂₆)-*', and *-Ge(R₂₅)(R₂₆)-*'; * and *' each indicate as denoted above;
R₂₁ and R₂₂ may each independently be selected from hydrogen, deuterium, halogen, a hydroxyl group, a cyano group, a nitro group, an C₁-C₆₀ amidino group, a hydrazino group, a hydrazono group, C₁-C₆₀ alkyl group, C₁-C₆₀ alkoxy group, C₅-C₆₀ aryloxy, C₃-C₆₀ cycloalkyl group, C₁-C₆₀ heterocycloalkyl group, C₃-C₆₀ cycloalkenyl group, C₁-C₆₀ heterocycloalkenyl group, C₃-C₆₀ cycloalkynyl group, C₁-C₆₀ heterocycloalkynyl group, C₆-C₆₀ aryl group, C₆-C₆₀ thioaryl group, C₁-C₆₀ heterothioaryl, C₁-C₆₀ heteroaryl group, a C₄-C₆₀ non-aromatic fused polycyclic group, C₁-C₆₀ non-aromatic fused heteropolycyclic group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂);
Q₂₁ to Q₂₃ and R₂₅ to R₂₆ may each independently be selected from hydrogen, deuterium, halogen, a hydroxyl group, a cyano group, a nitro group, an C₁-C₆₀ amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, C₅-C₆₀ aryloxy, a C₃-C₆₀ cycloalkyl group, a C₁-C₆₀ heterocycloalkyl group, a C₃-C₆₀ cycloalkenyl group, a C₁-C₆₀ heterocycloalkenyl group, C₃-C₆₀ cycloalkynyl group, C₁-C₆₀ heterocycloalkynyl group, a C₆-C₆₀ aryl group, a C₆-C₆₀ thioaryl group, a C₁-C₆₀ heteroaryl group, a C₁-C₆₀ heteroaryloxy group, a C₁-C₆₀ heterothioaryl group, a C₄-C₆₀ non-aromatic fused polycyclic group, a C₁-C₆₀ non-aromatic fused heteropolycyclic group, and deuterated analogues thereof.

The bond between Y₂₁ and T₂₁ or a bond between Y₂₁ and Ir may each be a covalent bond or a coordinate bond. The bond between Y₂₂ and T₂₂ or a bond between Y₂₂ and Ir may each be a covalent bond or a coordinate bond. The bond between Z₂₁ and T₂₁ or a bond between Z₂₁ and Ir may each be a covalent bond or a coordinate bond. The bond between Z₂₂ and T₂₂ or a bond between Z₂₂ and Ir may each be a covalent bond or a coordinate bond.

The examples of phosphorescent sensitizers can be an organometallic platinum complex according to Formula III: 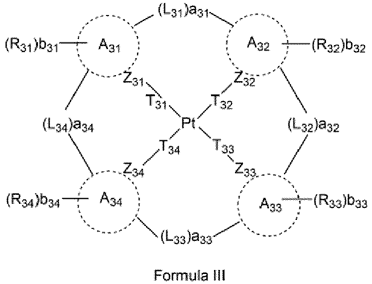 wherein:
a31 to a34 may be an integer from 0 to 3;
b31 to b34 may be an integer from 1 to 8;
A₃₁ to A₃₄ may each independently be selected from a C₆-C₆₀ aryl group, C₁-C₆₀ heteroaryl group, and deuterated analogues thereof;
Z₃₁ to Z₃₄ may each independently be N or C,
L₃₁ to L₃₄ may each independently be selected from a single bond, *-O-*', *—S— *', *-C(R₃₅)(R₃₆)-*', *-C(R₃₅)=*', *=C(R₃₅)-*', *-C(35)=C(R₃₅)-*', *-C(=O)-*', *-C(=S)-*', *-C≡C-*', *-B(R₃₅)-*', *-N(R₃₅)-*', *-P(R₃₅)-*', *-Si(R₃₅)(R₃₆)-*', *-P(R₃₅)(R₃₆)-*', and *-Ge(R₃₅)(R₃₆)-*'; * and *' are the same as defined in Formula II;
T₃₁ to T₃₄, may each independently be selected from a single bond, *-O-*', and *-S-*', *-C(R₃₅)(R₃₆)-*', *-C(R₃₅)=*', *=C(R₃₅)-*', *-C(R₃₅)=C(R₃₅)-*', *-C(=O)-*', *-C(=S)-*', *-C=C-*', *-B(R₃₅)-*', *-N(R₃₅)-*', *-P(R₃₅)-*', *-Si(R₃₅)(R₃₆)-*', *-P(R₃₅)(R₃₆)-*', and *-Ge(R₃₅)(R₃₆)-*'.,
R₃₁ to R₃₆ may each independently be selected from hydrogen, deuterium, halogen, a hydroxyl group, a cyano group, a nitro group, an C₁-C₆₀ amidino group, a hydrazino group, a hydrazono group, C₁-C₆₀ alkyl group, C₁-C₆₀ alkoxy group, C₃-C₆₀ cycloalkyl group, C₁-C₆₀ heterocycloalkyl group, C₃-C₆₀ cycloalkenyl group, C₁-C₆₀ heterocycloalkenyl group, C₃-C₆₀ cycloalkynyl group, C₁-C₆₀ heterocycloalkynyl group, C₆-C₆₀ aryl group, C₅-C₆₀ aryloxy group, C₆-C₆₀ thioaryl group, C₁-C₆₀ heterothioaryl, C₁-C₆₀ heteroaryl group, a C₄-C₆₀ non-aromatic fused polycyclic group, C₁-C₆₀ non-aromatic fused heteropolycyclic group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁),-P(=O)(Q₃₁)(Q₃₂), and deuterated analogues thereof;
Q₃₁ to Q₃₃ may each independently be selected from hydrogen, deuterium, halogen, a hydroxyl group, a cyano group, a nitro group, an C₁-C₆₀ amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₆₀ cycloalkyl group, a C₁-C₆₀ heterocycloalkyl group, a C₃-C₆₀ cycloalkenyl group, a C₁-C₆₀ heterocycloalkenyl group, C₃-C₆₀ cycloalkynyl group, C₁-C₆₀ heterocycloalkynyl group, a C₆-C₆₀ aryl group, a C₅-C₆₀ aryloxy group, a C₆-C₆₀ thioaryl group, a C₁-C₆₀ heteroaryl group, a C₁-C₆₀, heteroaryloxy group, a C₁-C₆₀ heterothioaryl group, a C₄-C₆₀ non-aromatic fused polycyclic group, a C₁-C₆₀ non-aromatic fused heteropolycyclic group, and deuterated analogues thereof.
T₃₁ to T₃₄ may each be a single bond, T₃₁ may be selected from O and S, and T₃₂ to T₃₄ may each be a single bond, T₃₂ may be selected from O and, and T₃₁, T₃₃, and T₃₄ may each be a single bond, T₃₃ may be selected from O and S, and T₃₁, T₃₂, and T₃₄ may each be a single bond, or T₃₄ may be selected from O and S, and T₃₁, T₃₂, and T₃₃ may each be a single bond.

The examples of the phosphorescent sensitizers can be: 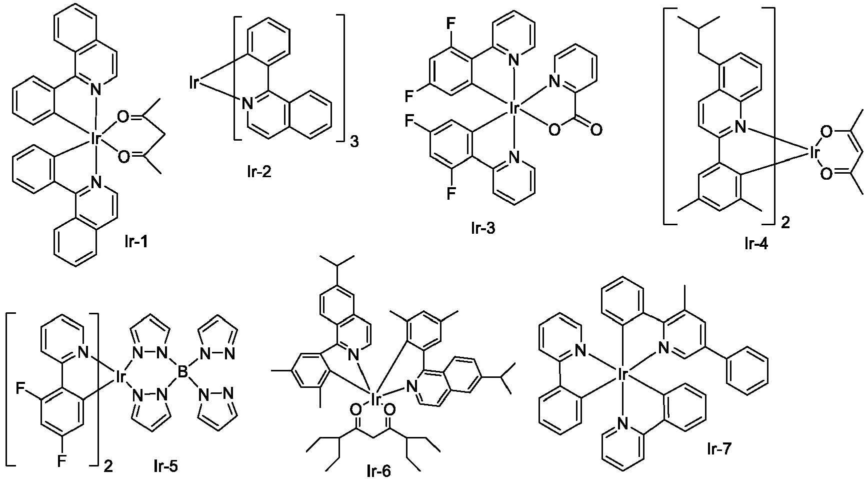 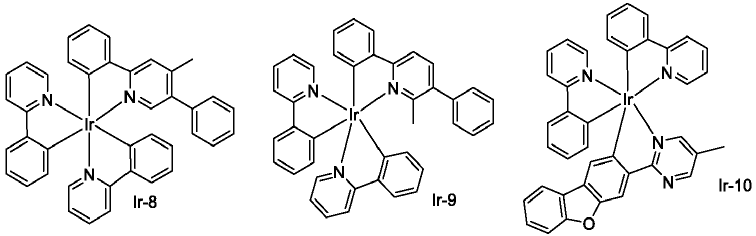 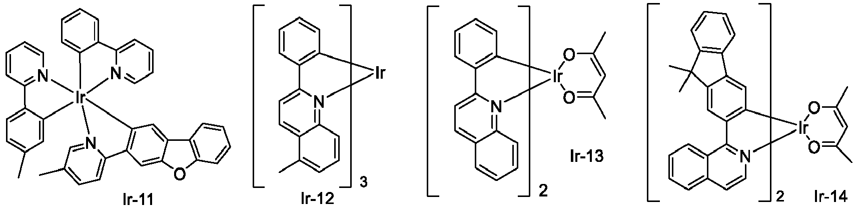 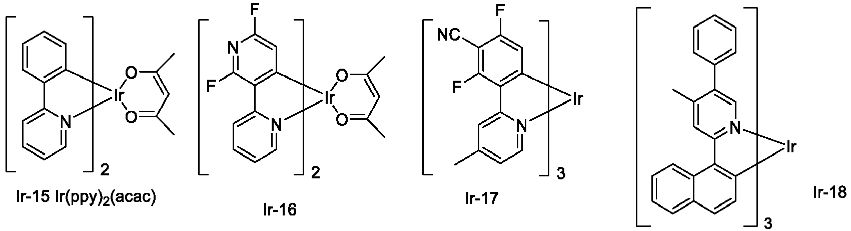 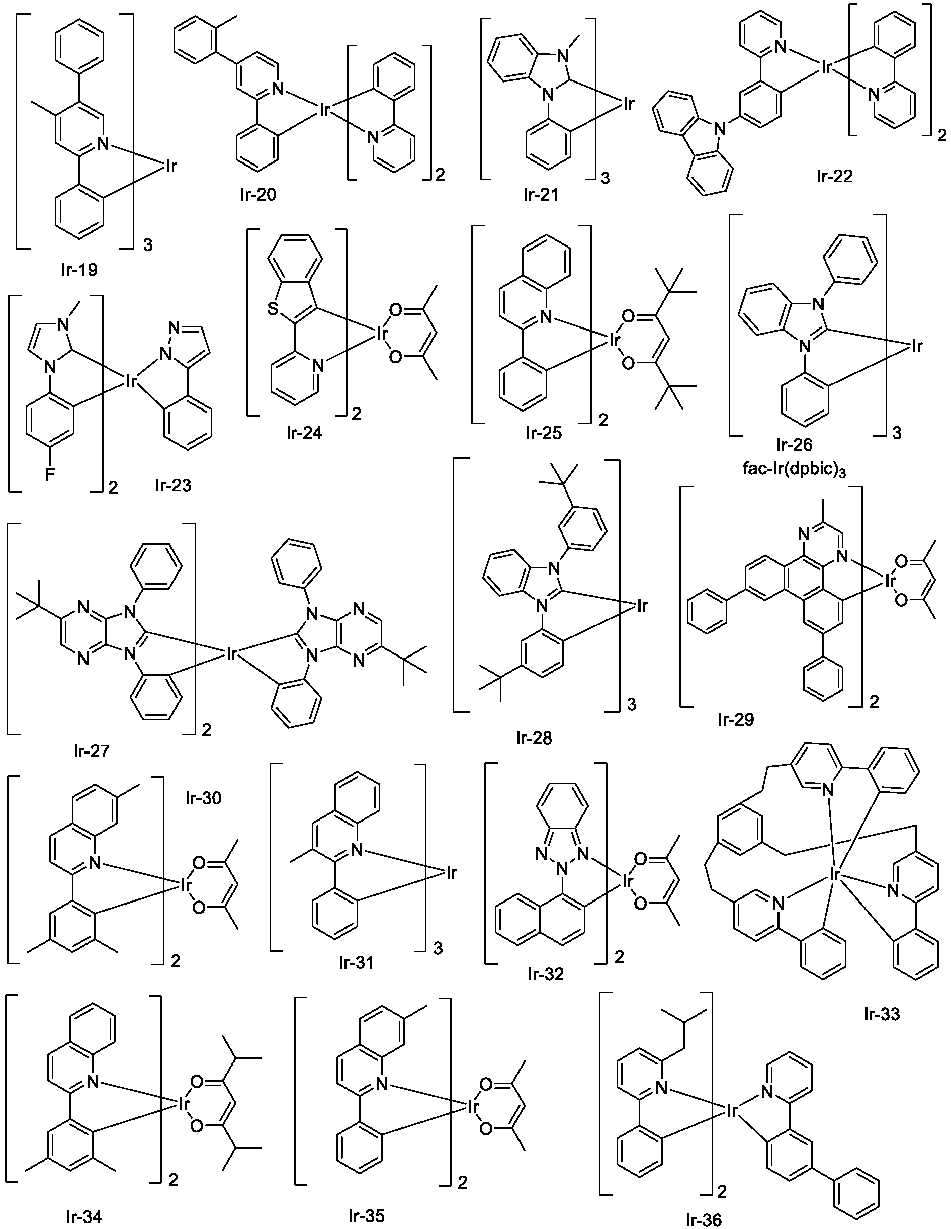 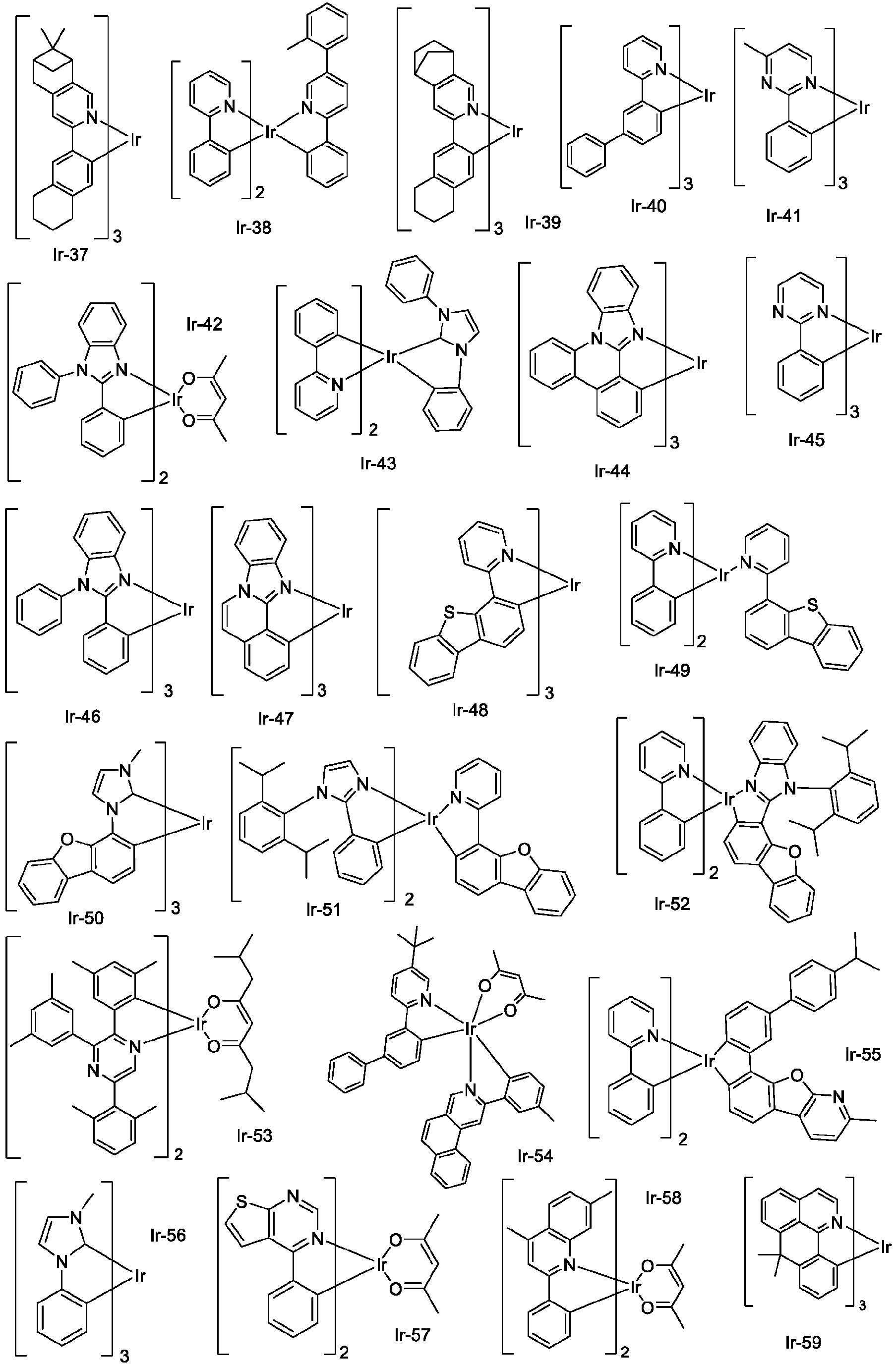 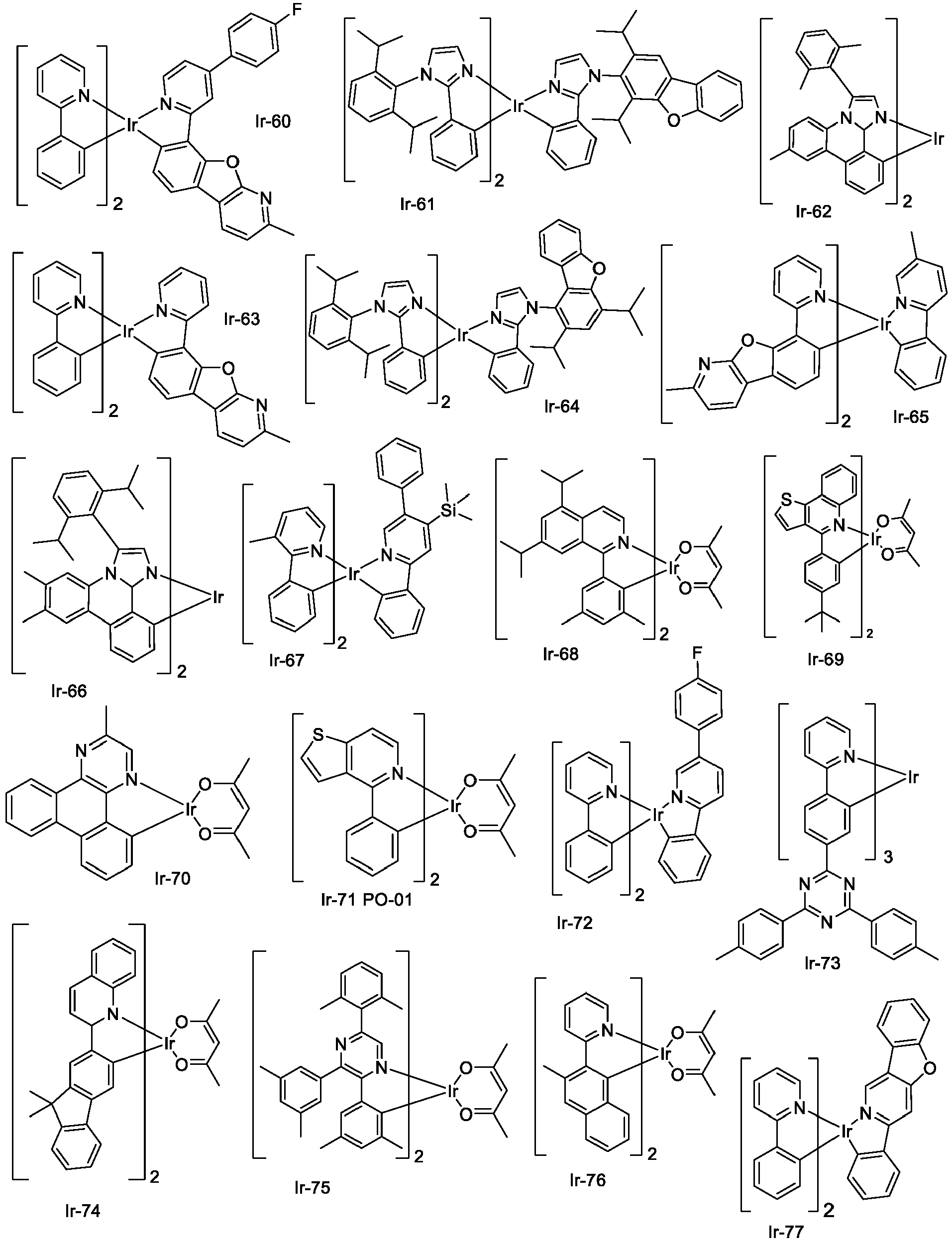 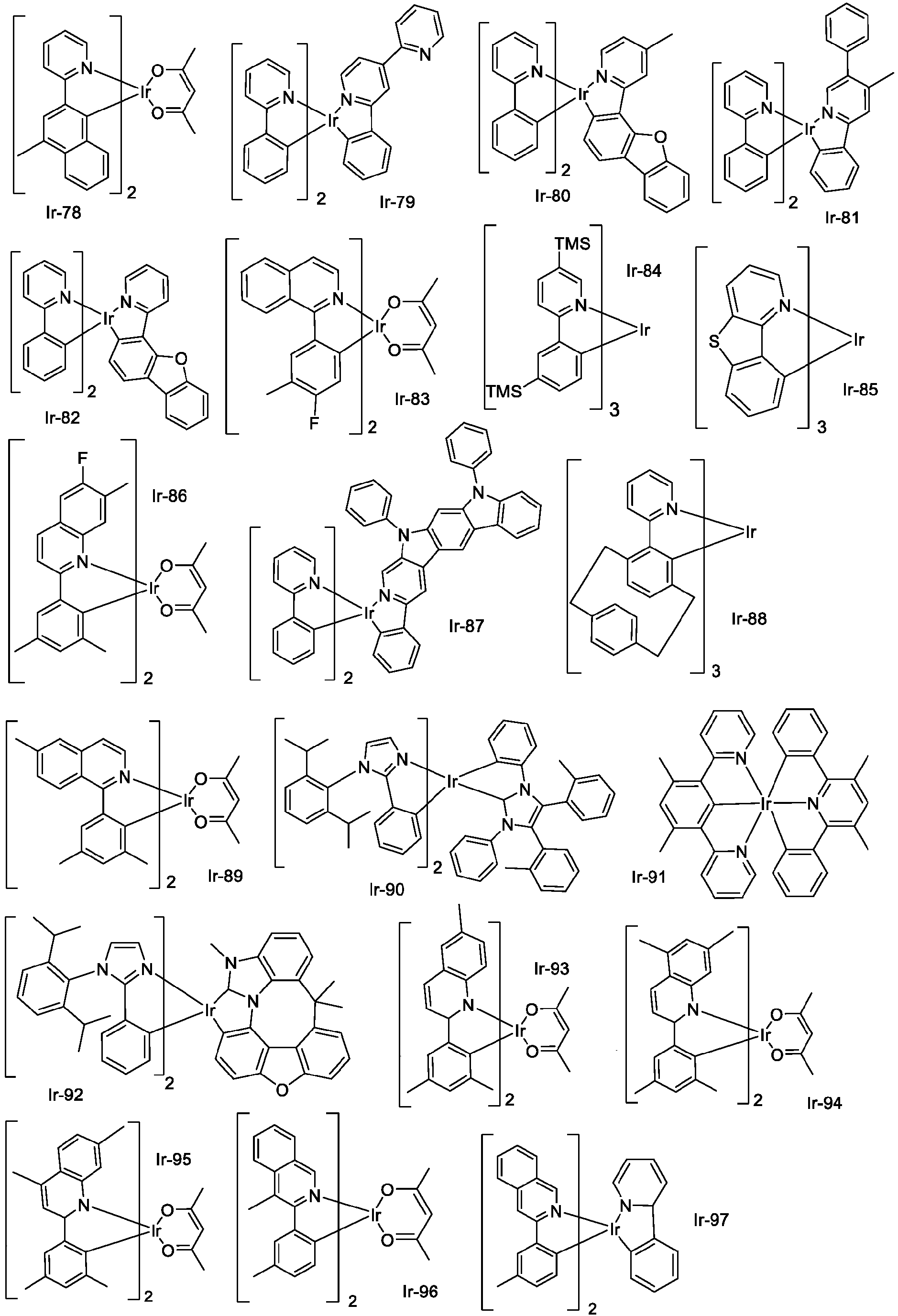 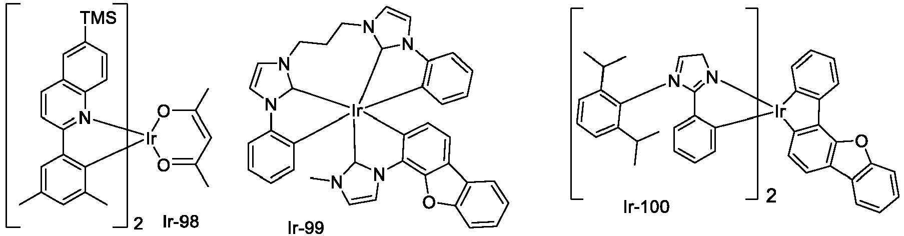 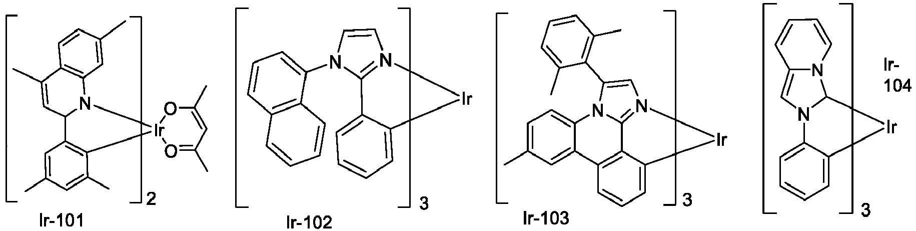 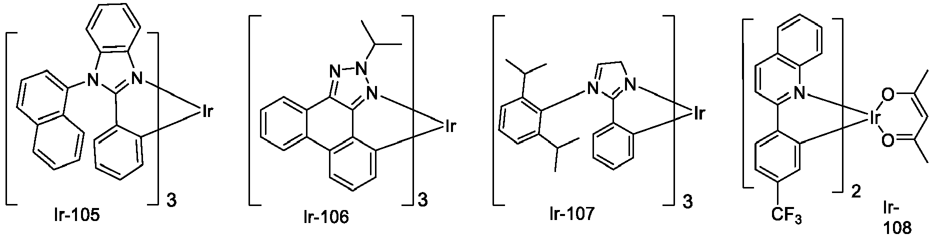 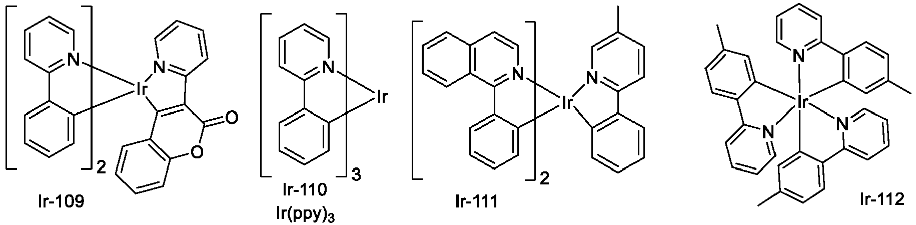 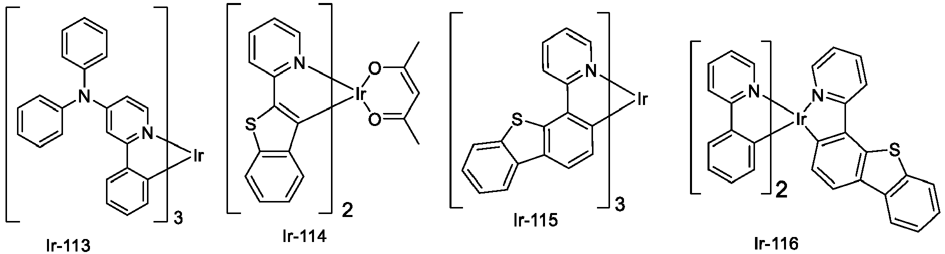 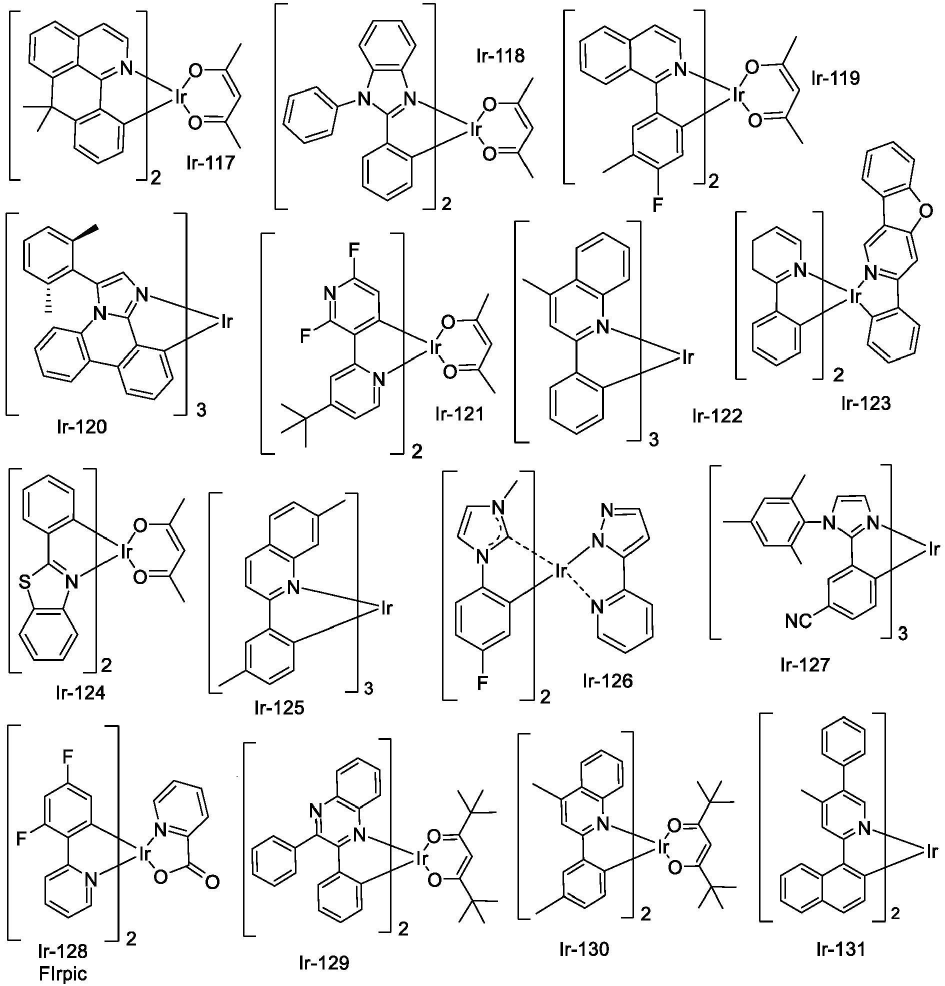 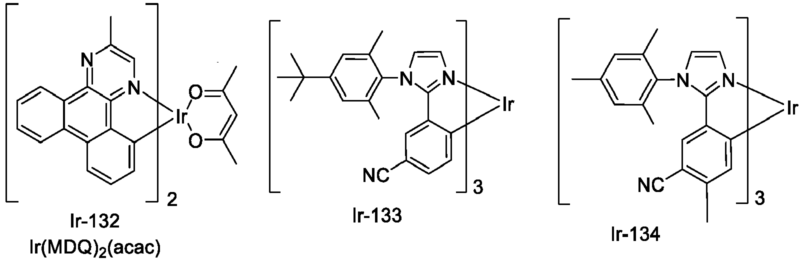 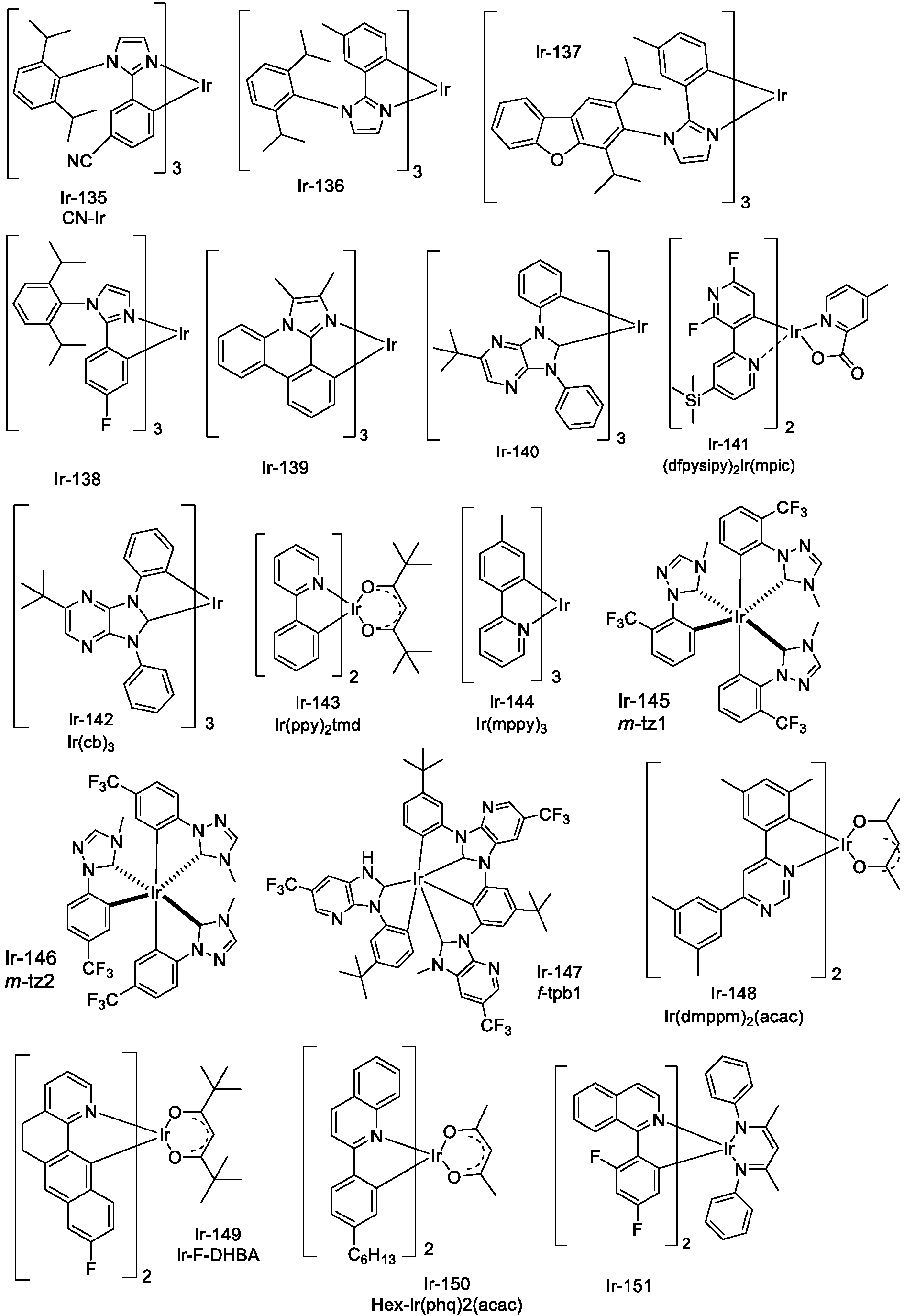 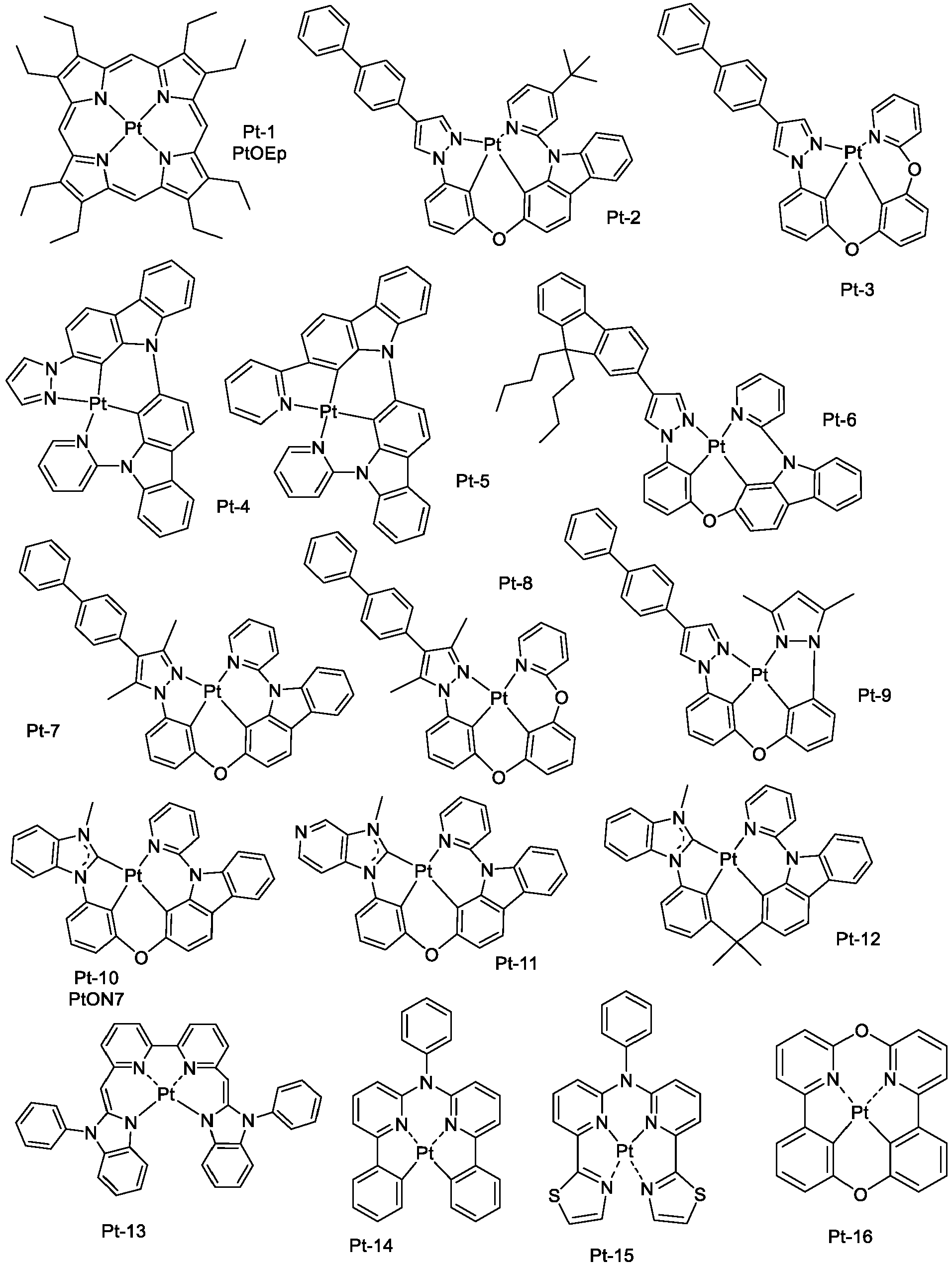 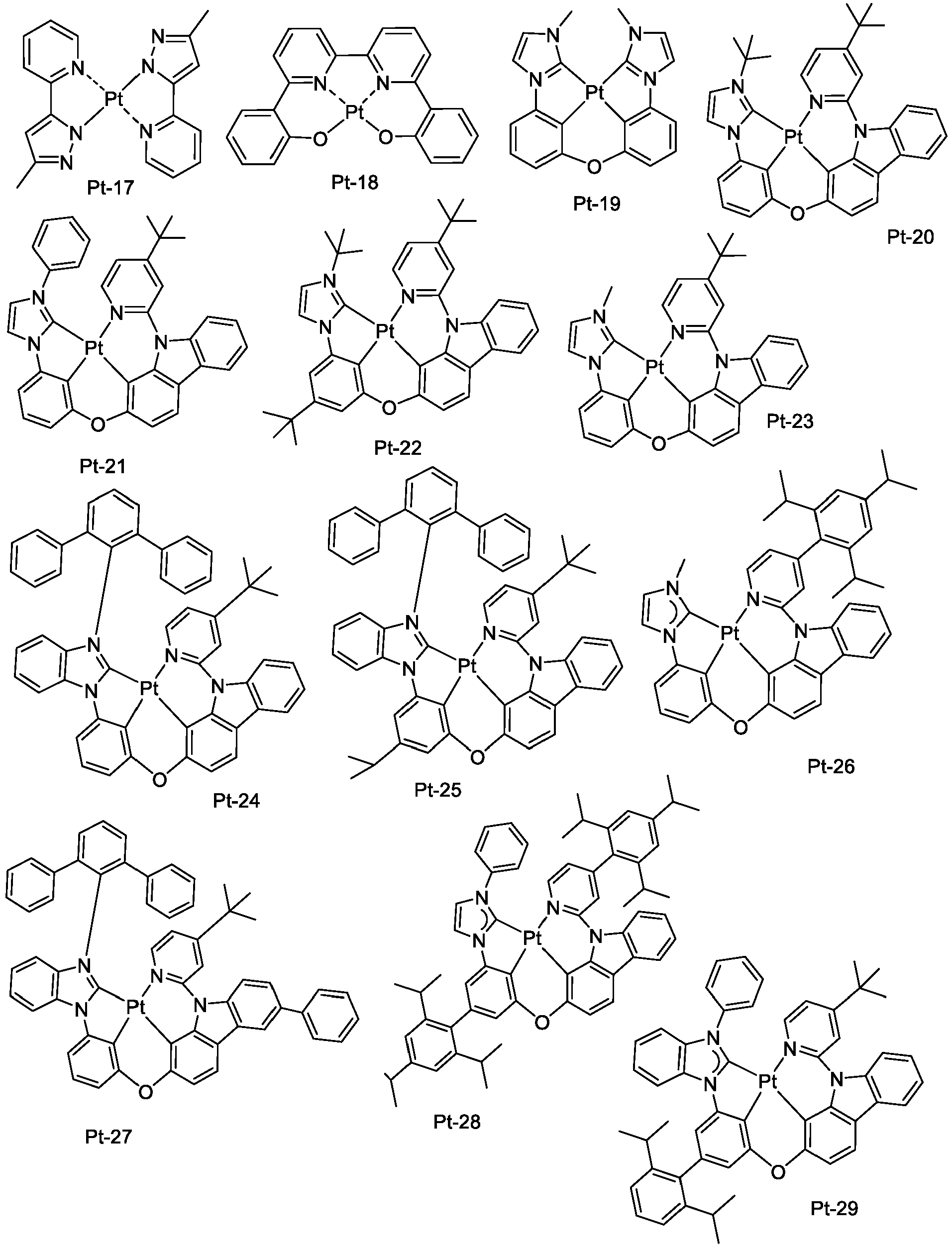 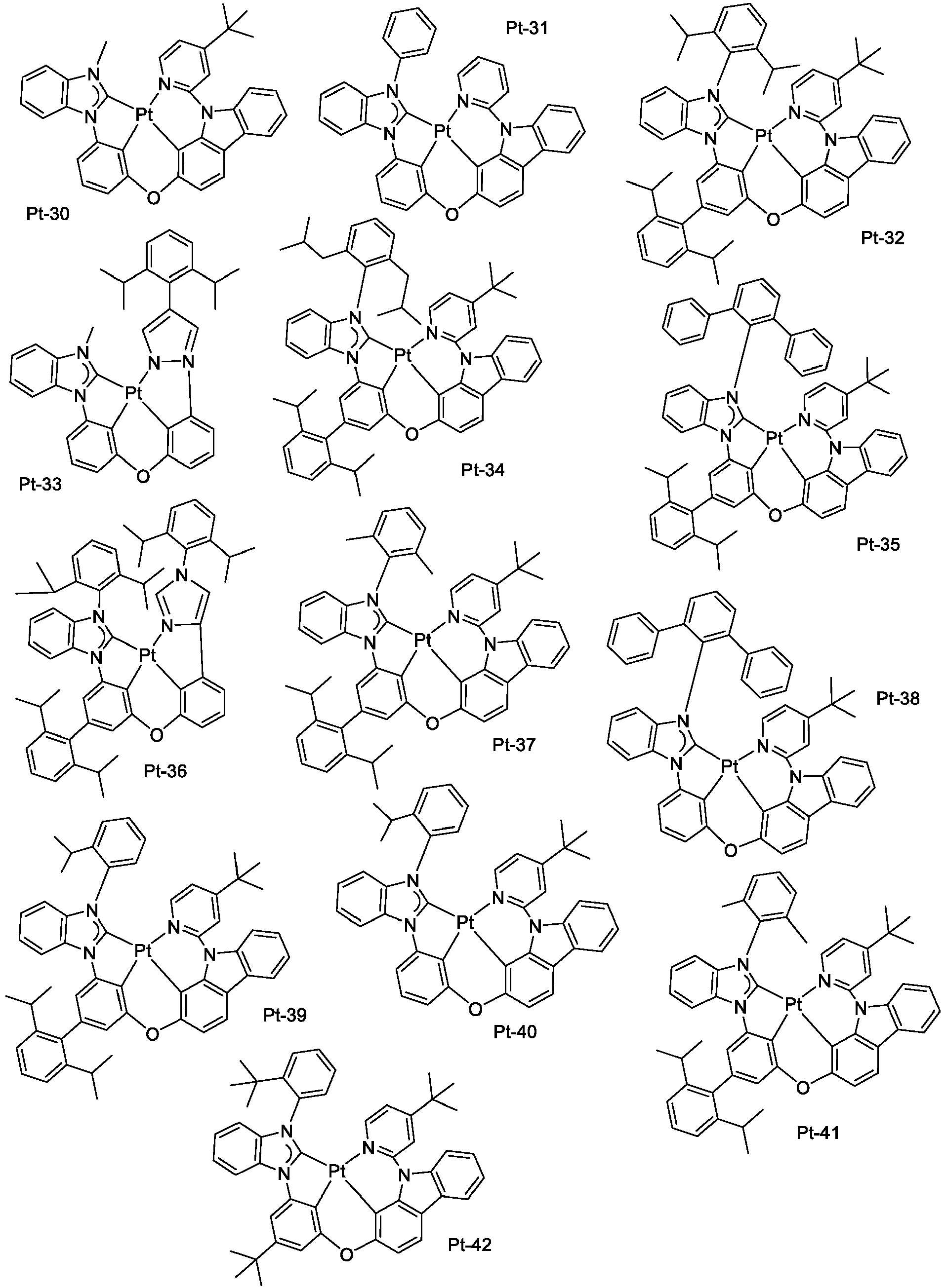 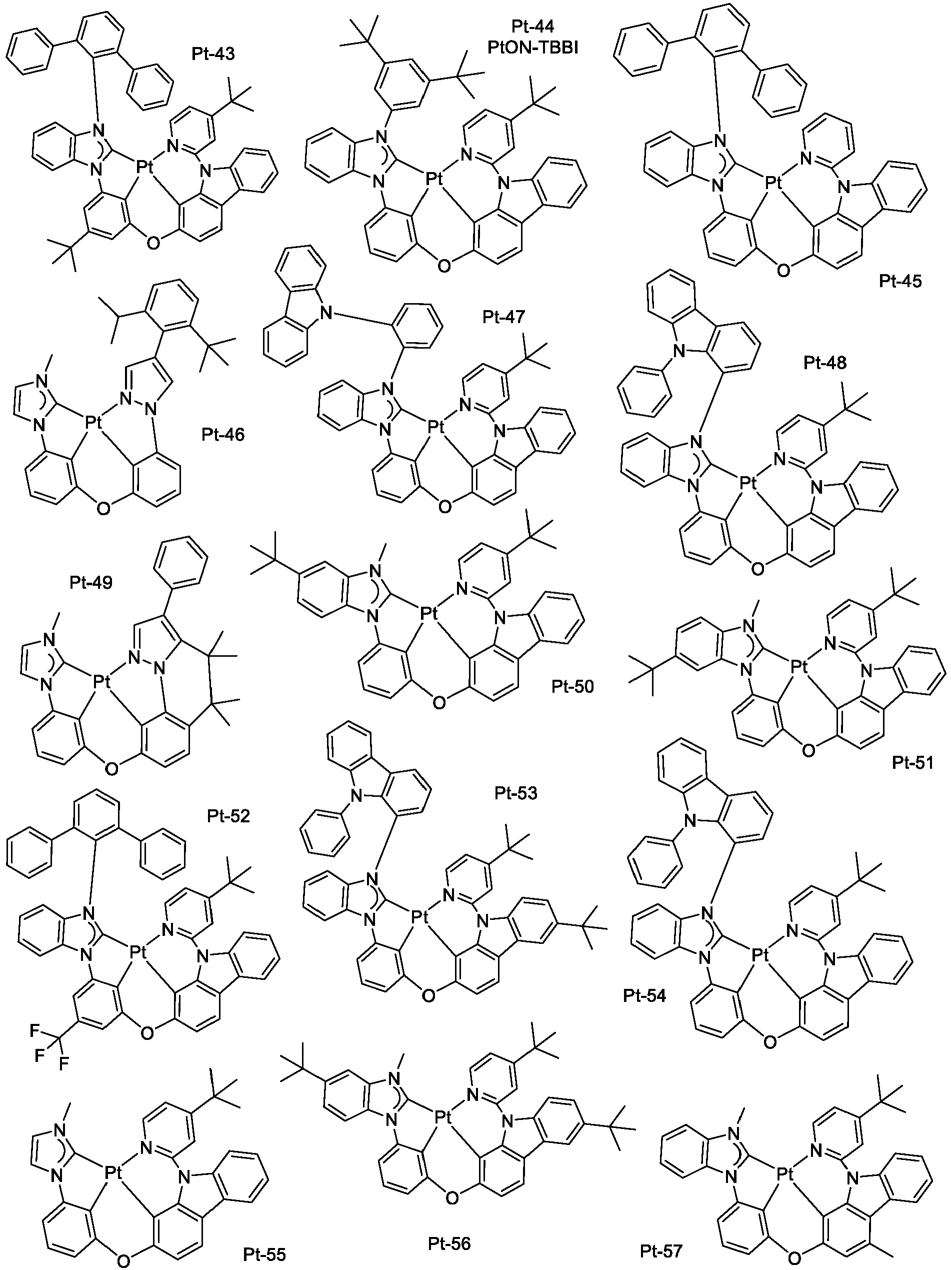 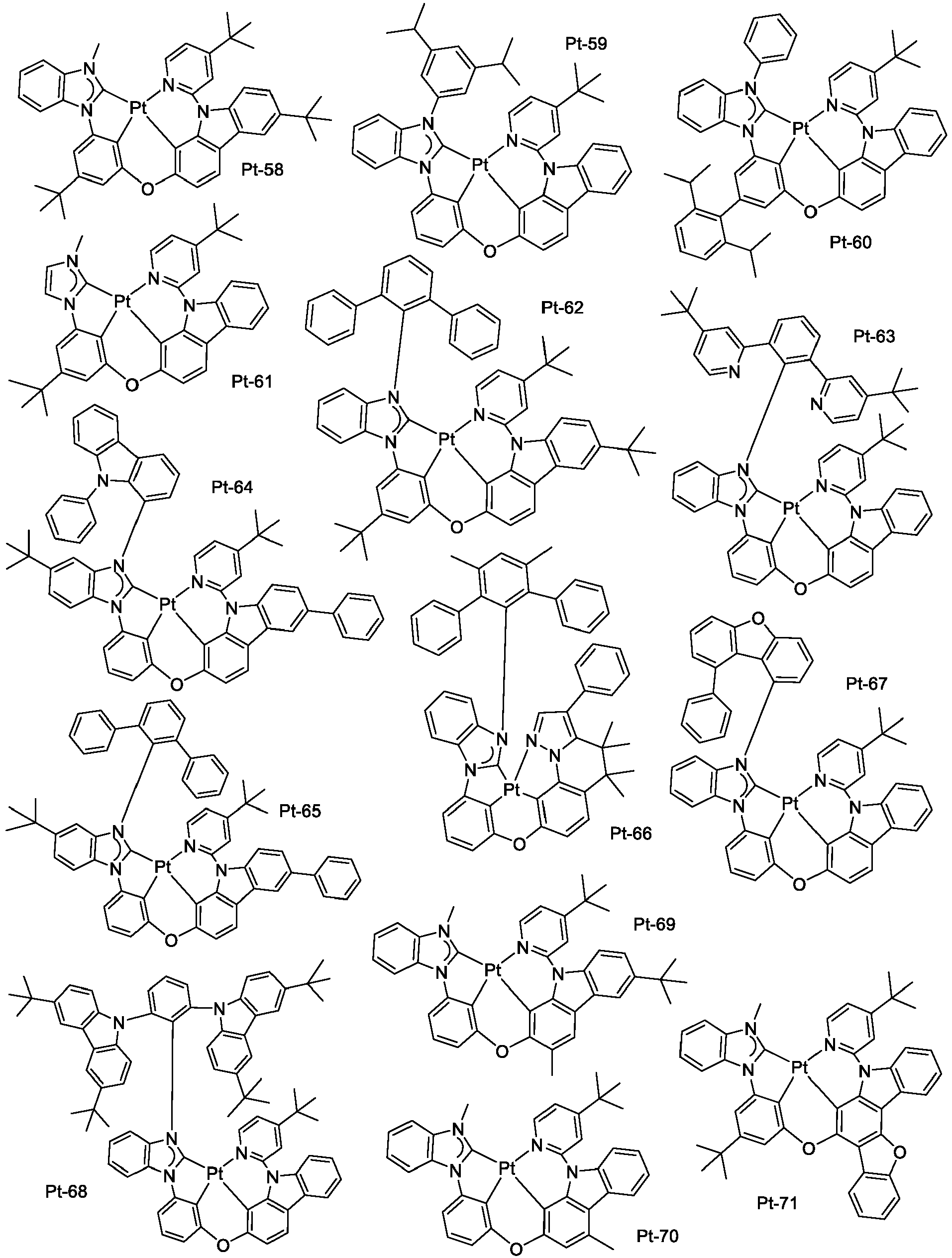 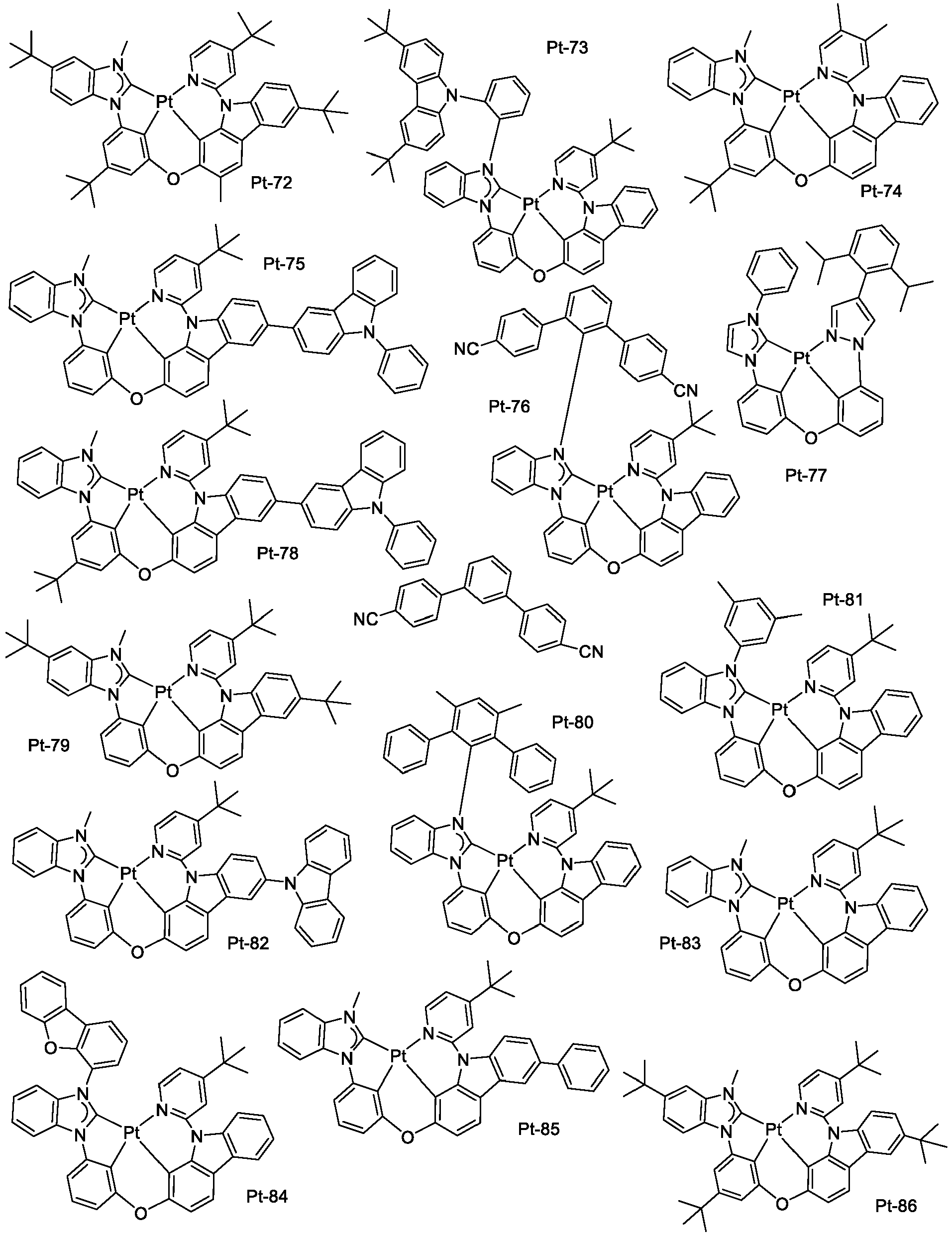 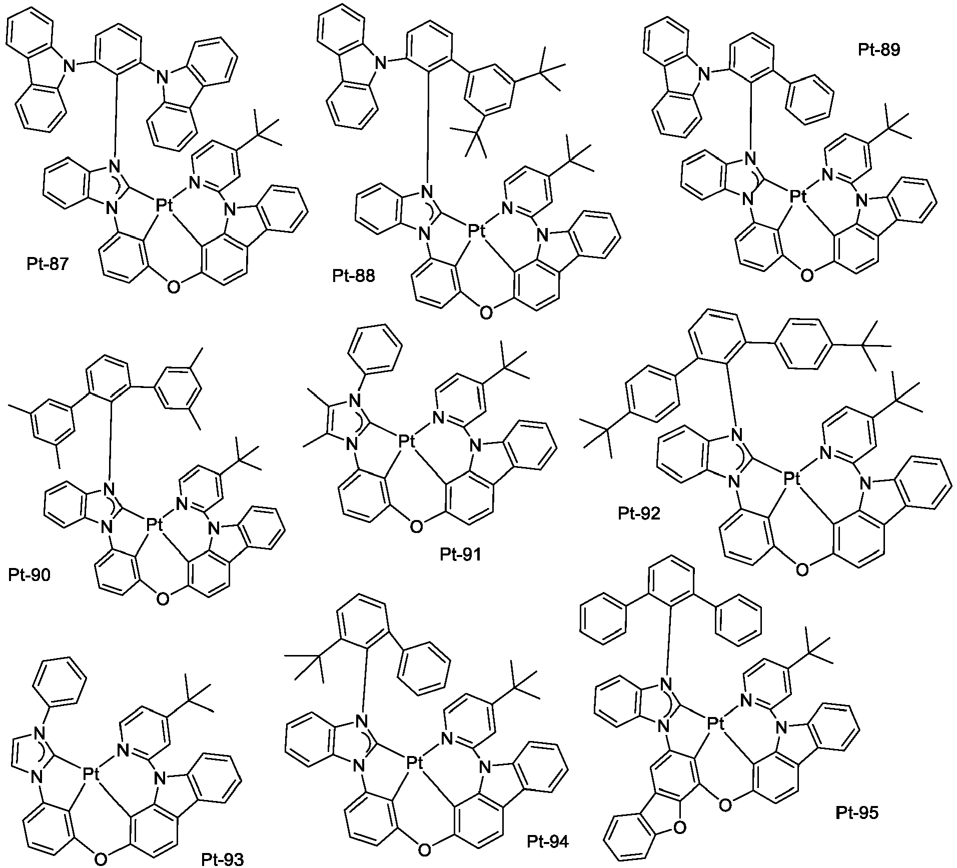 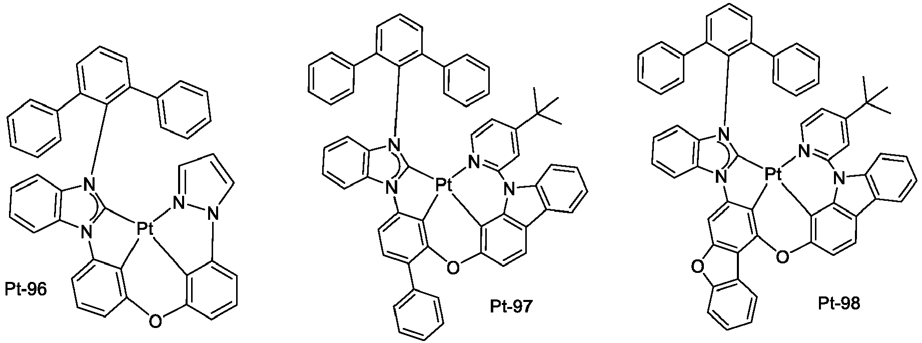 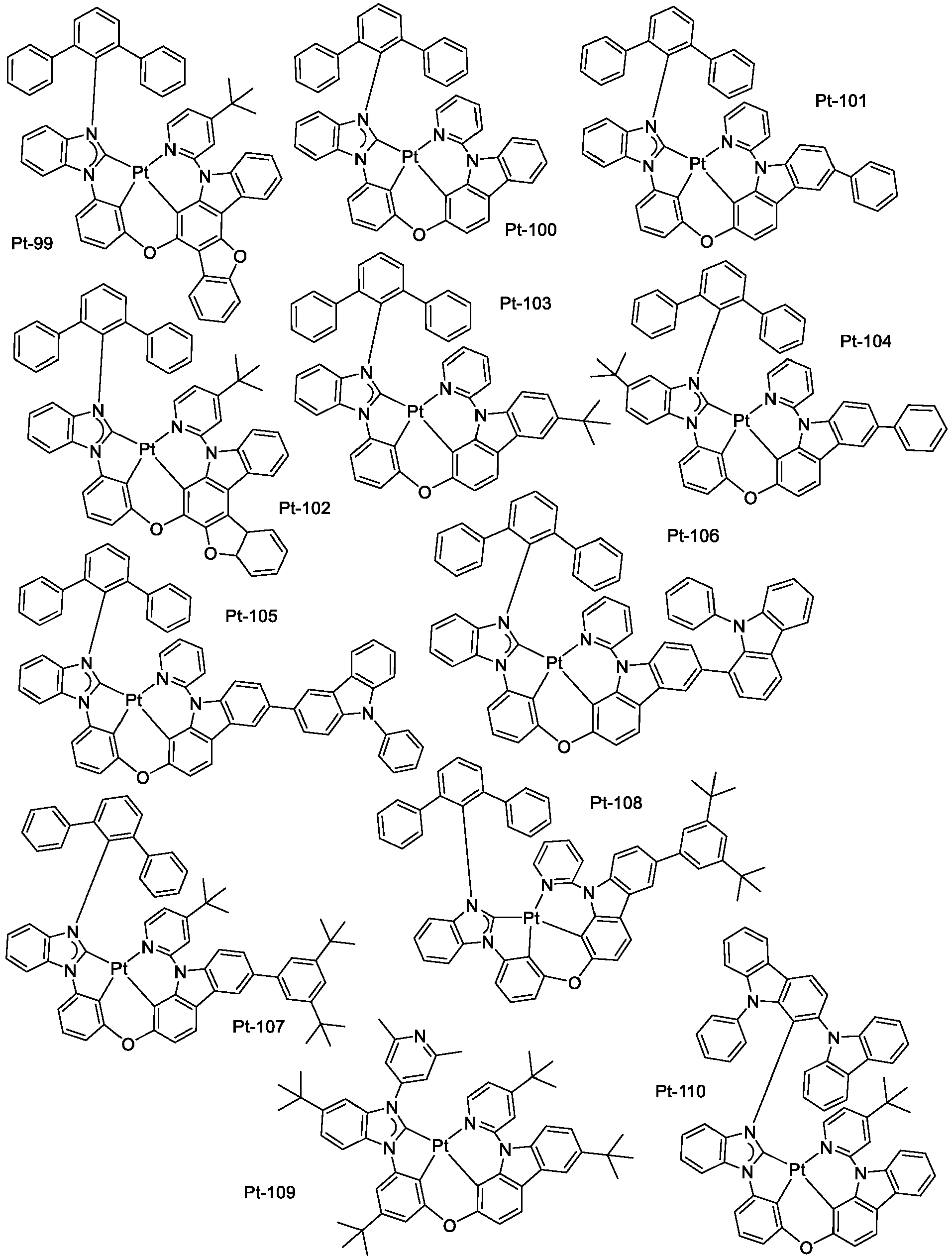 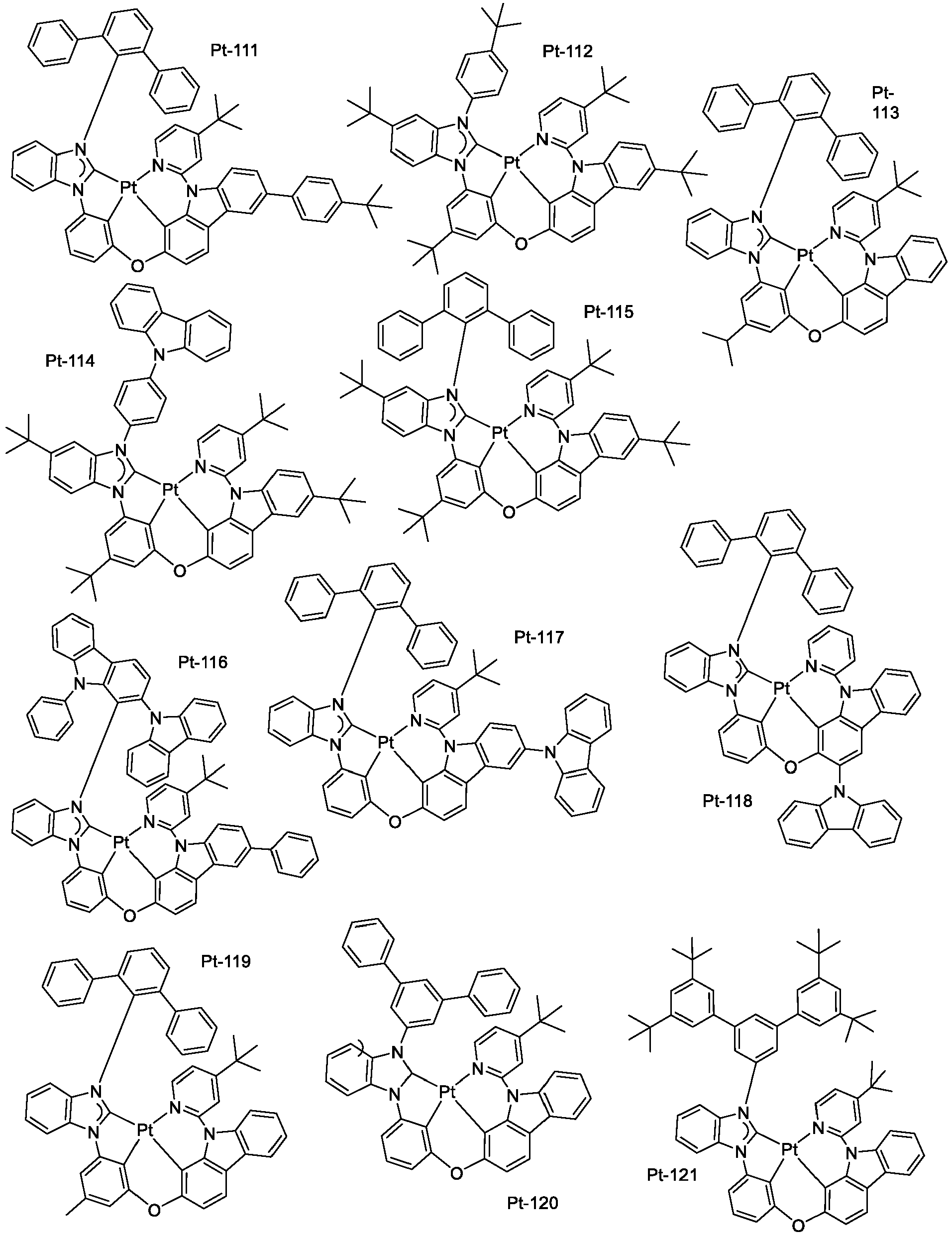 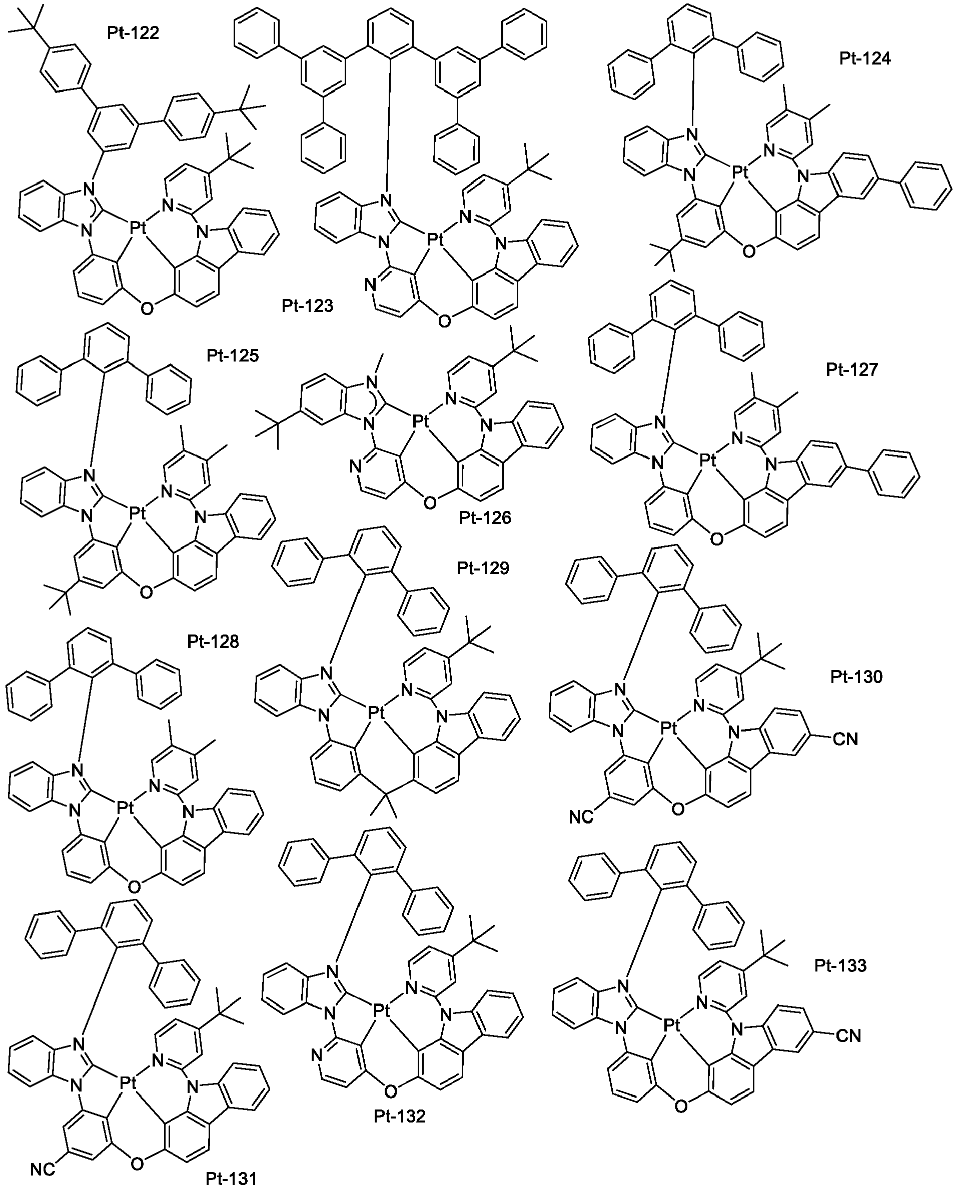 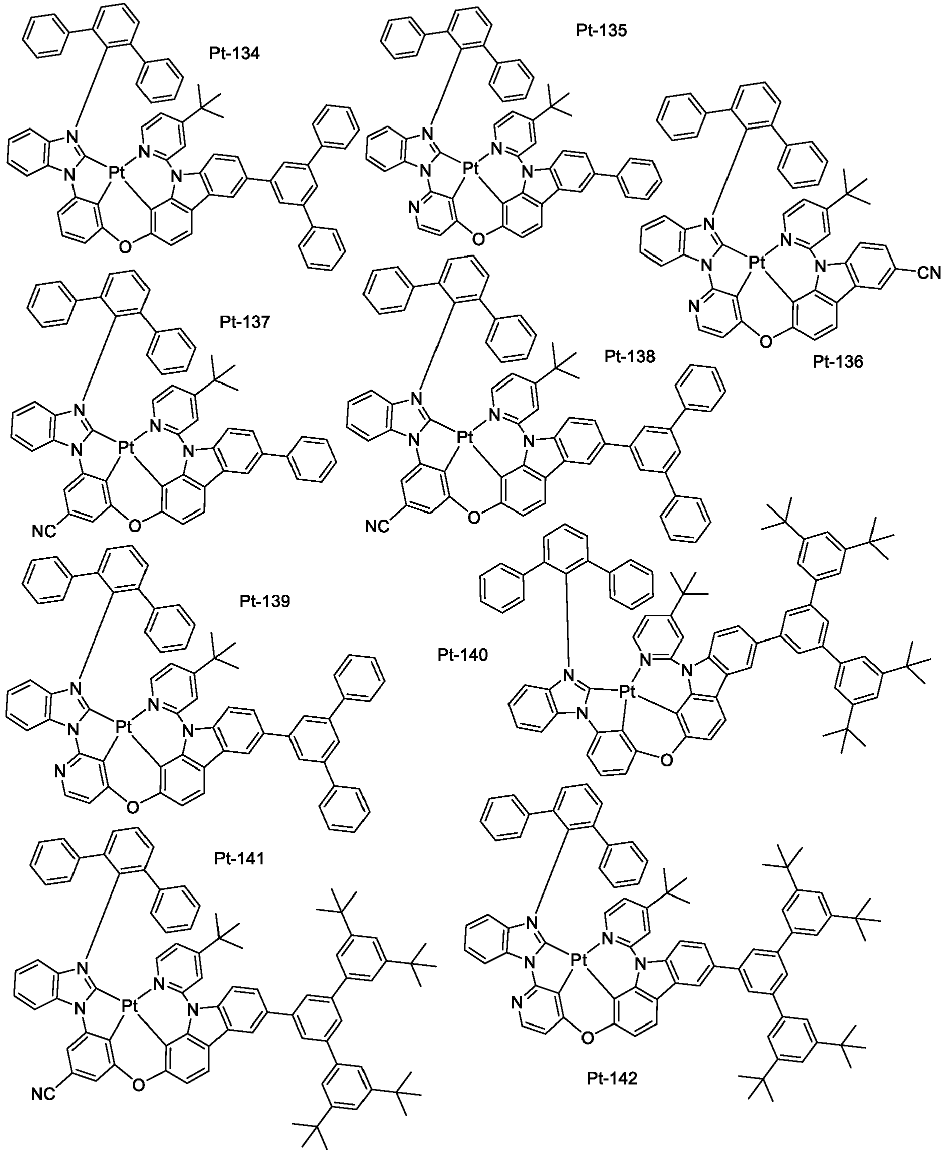 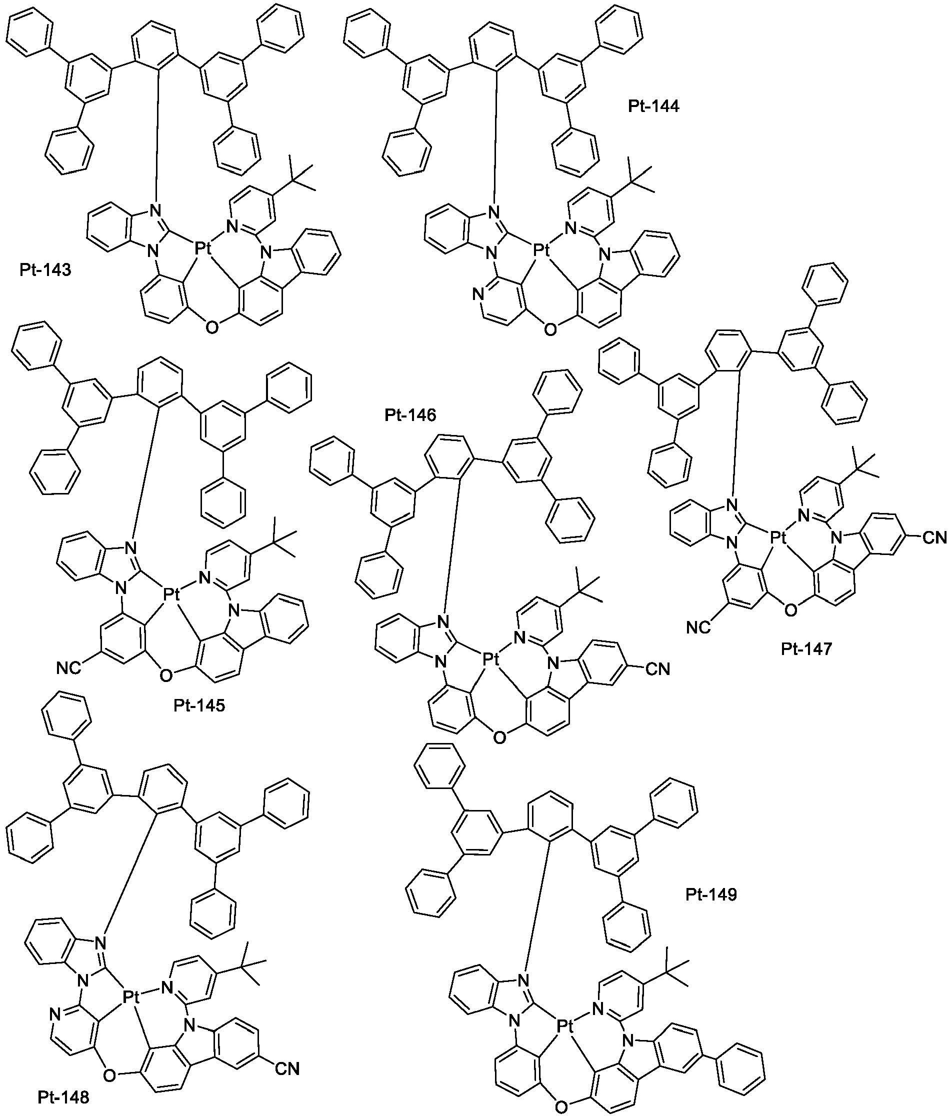 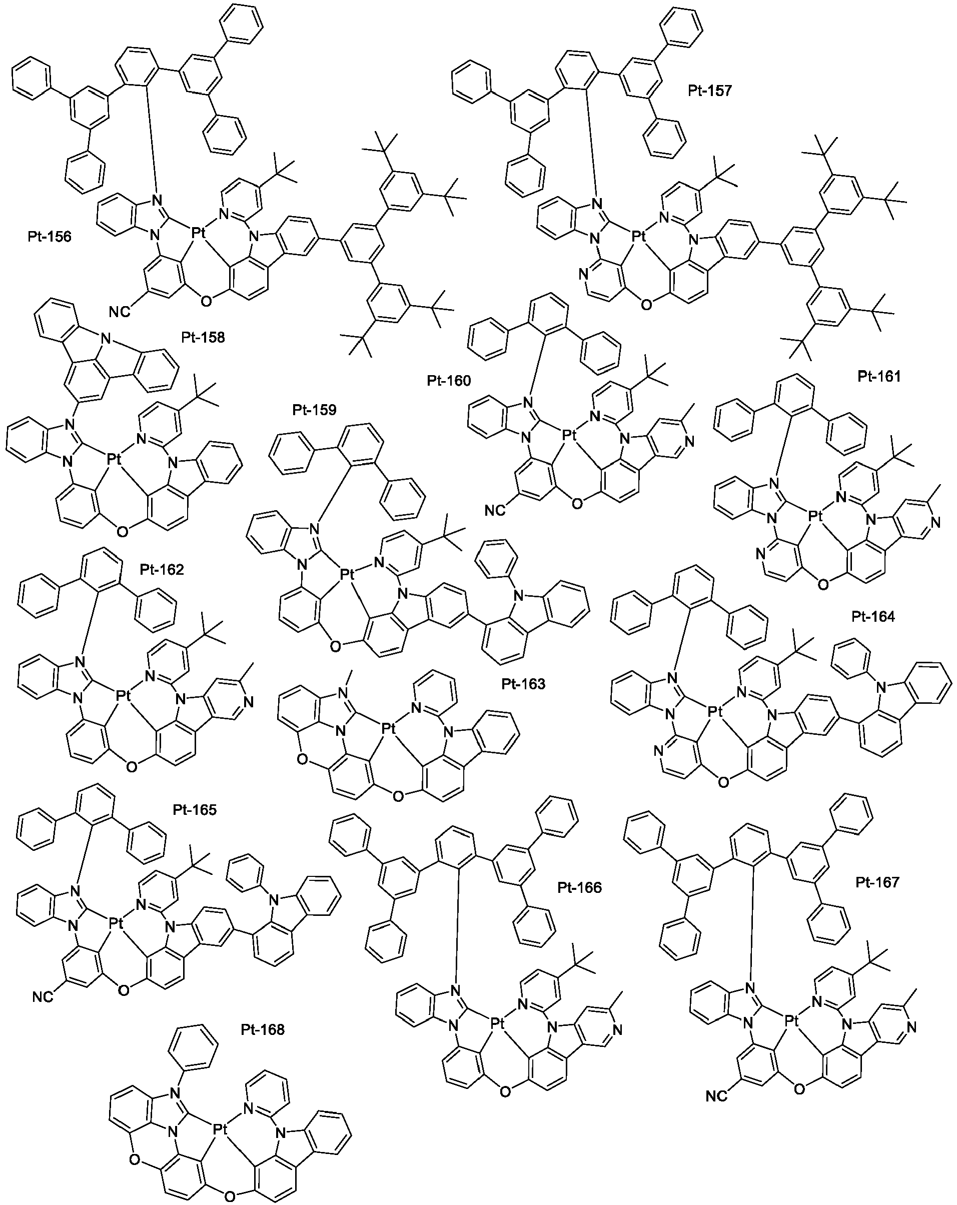 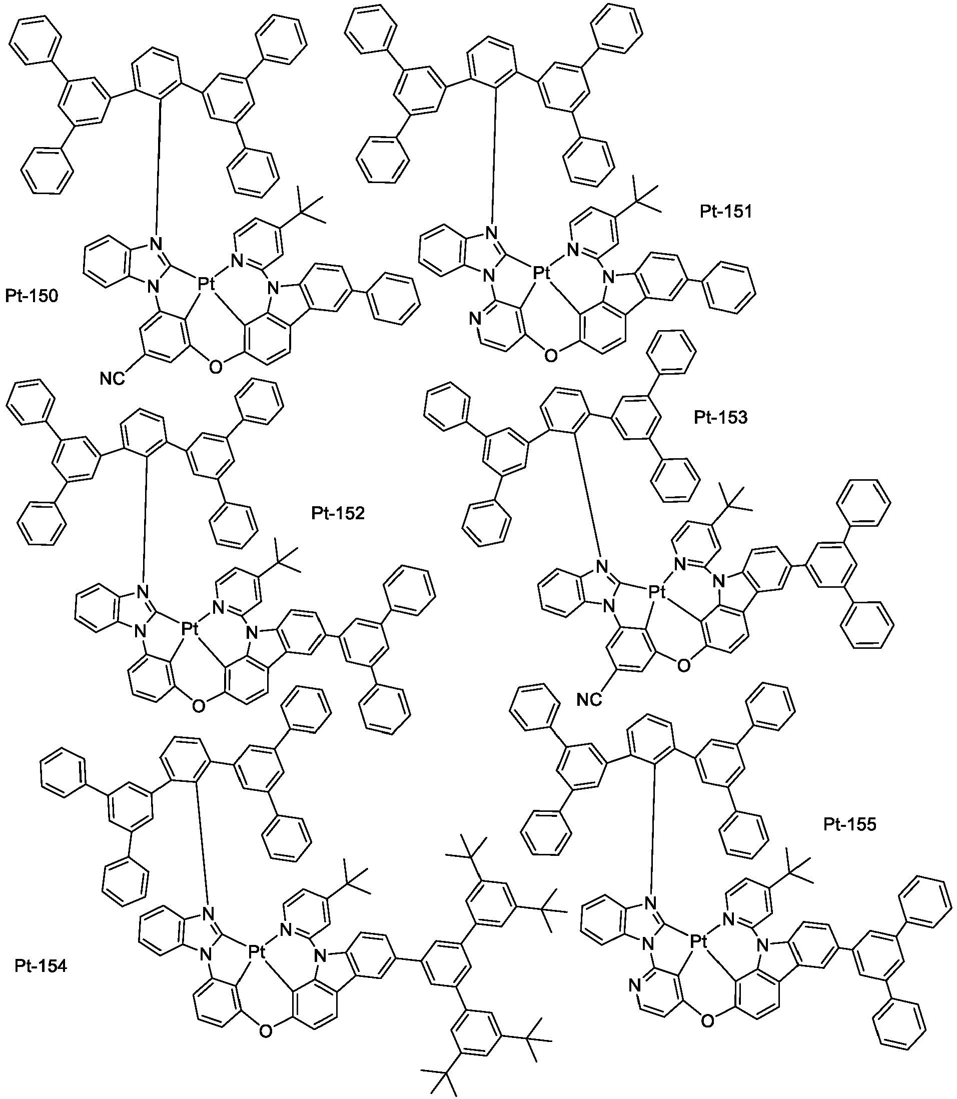 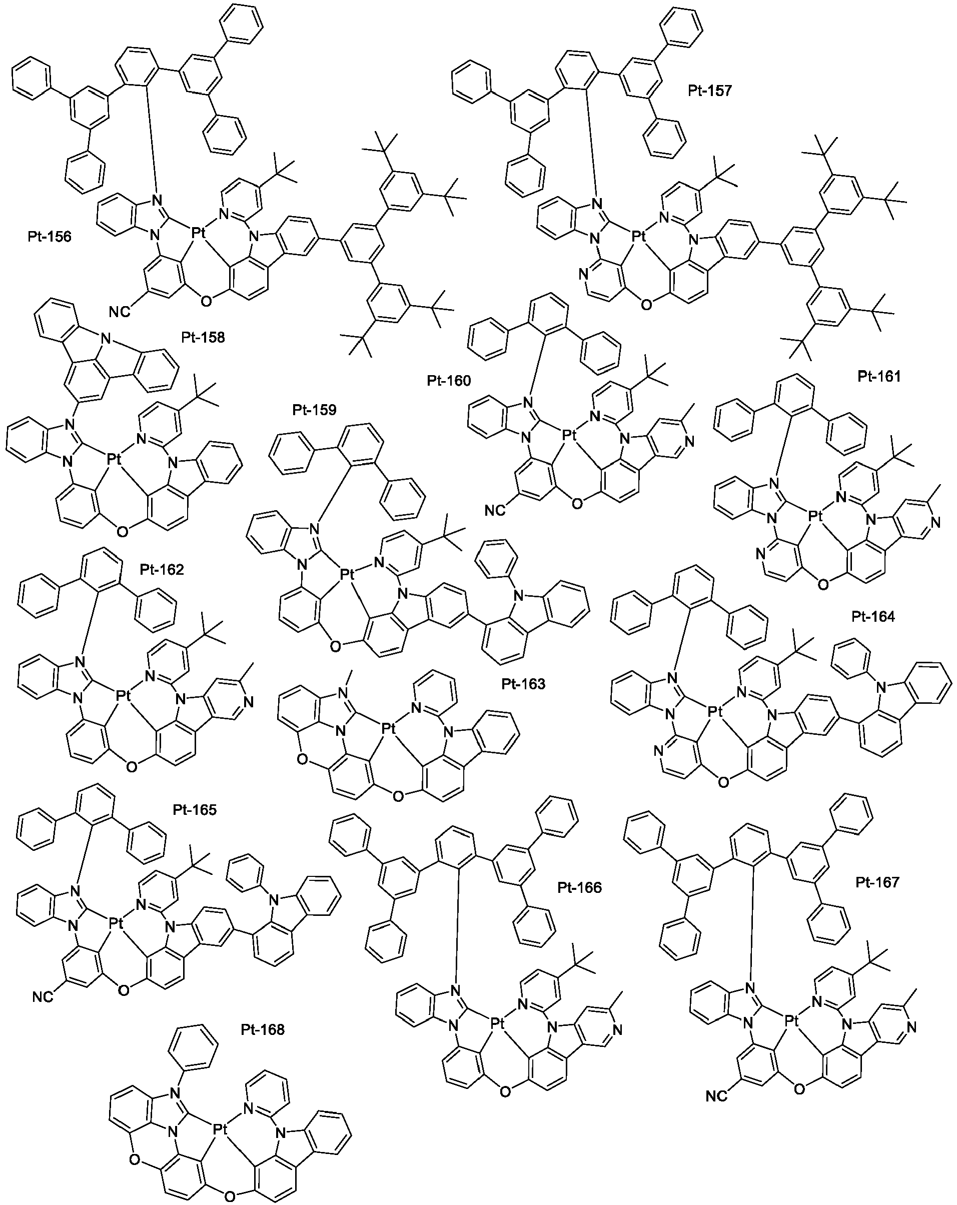 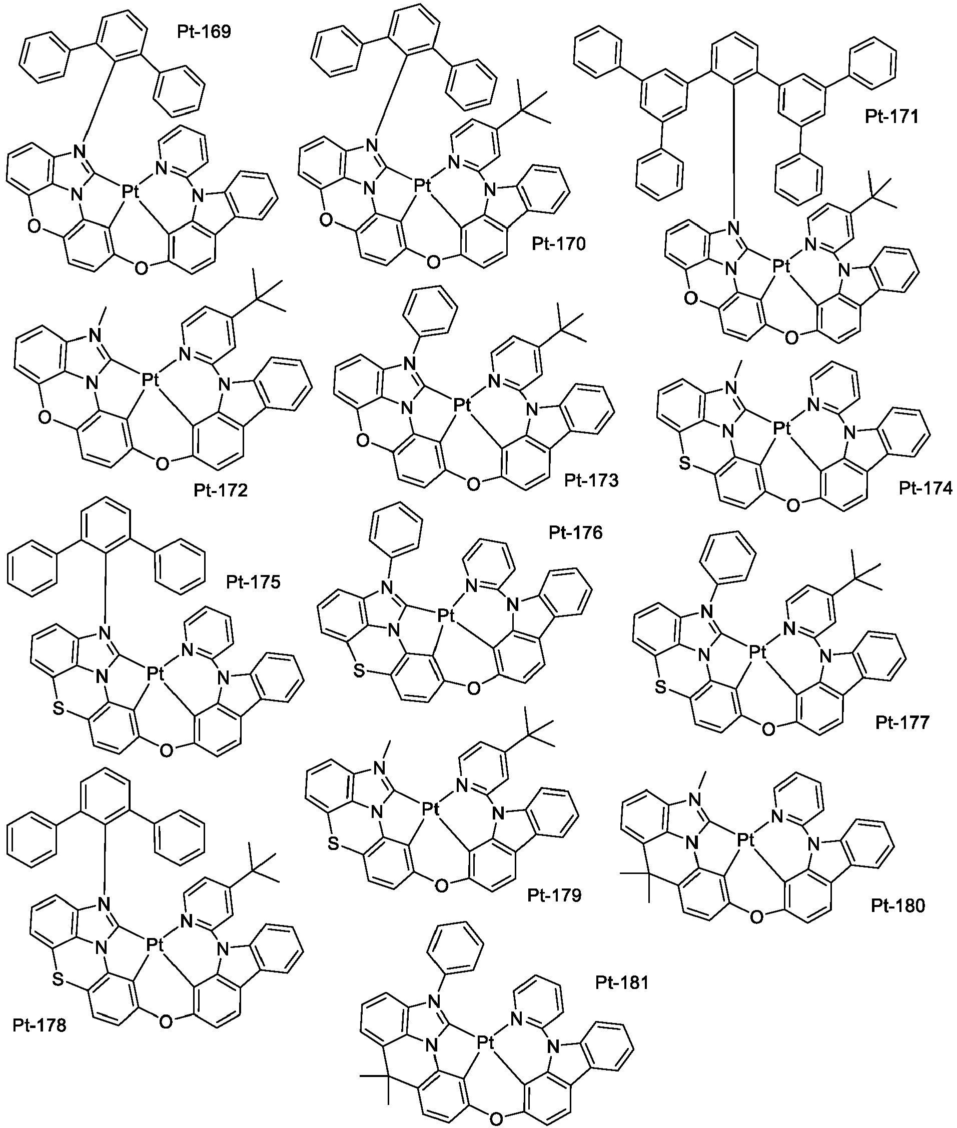 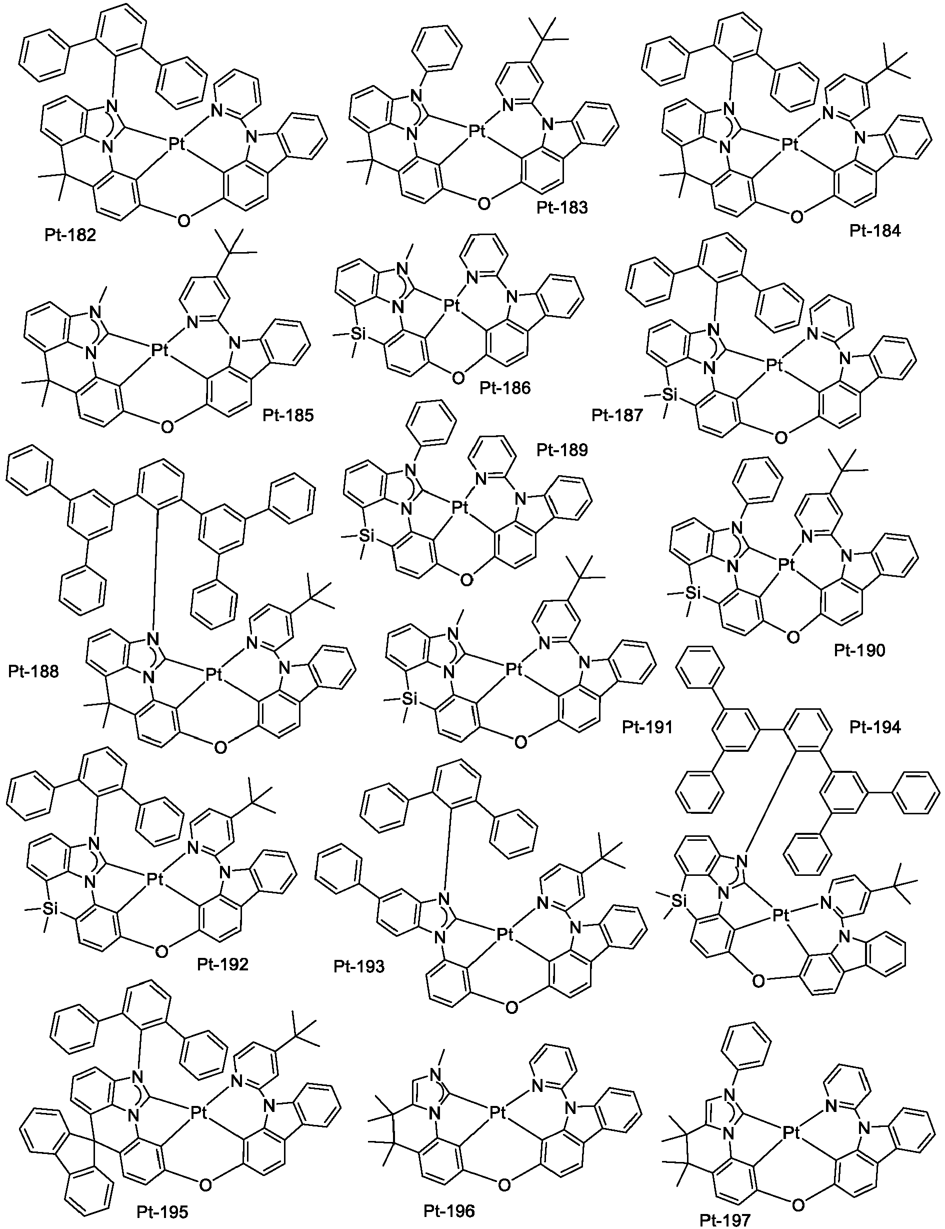 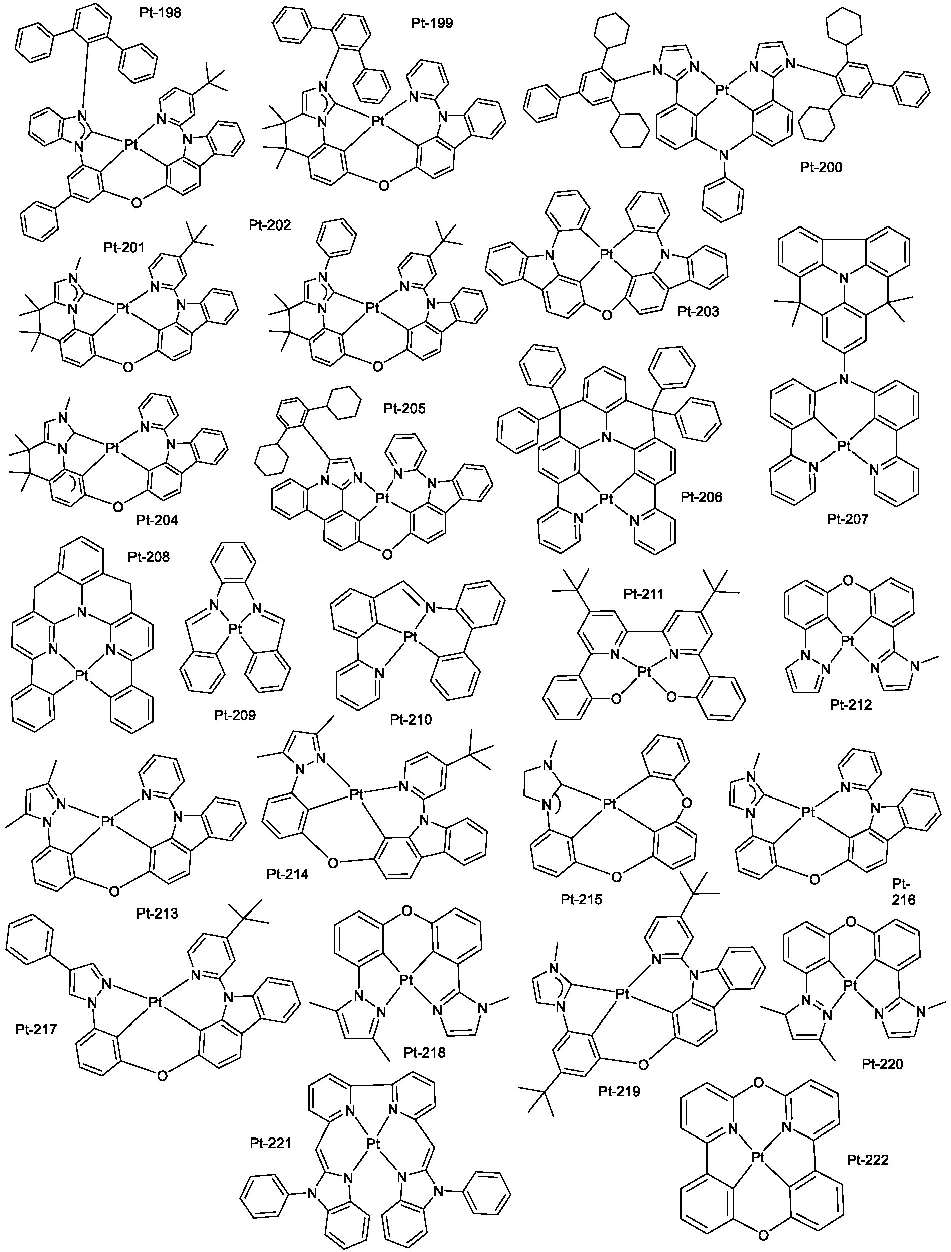 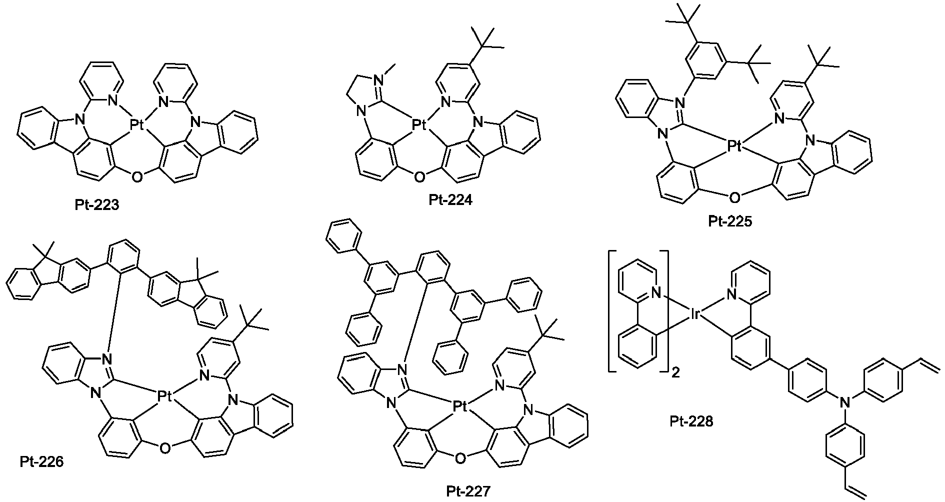 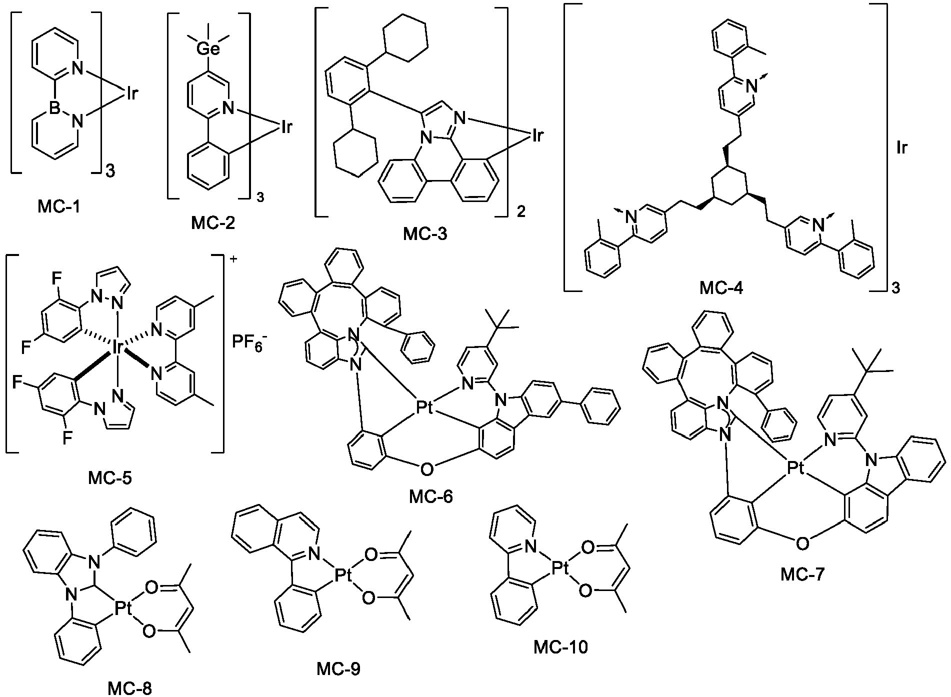 and deuterated analogues thereof.

The examples of the auxiliary TADF dopand can be: 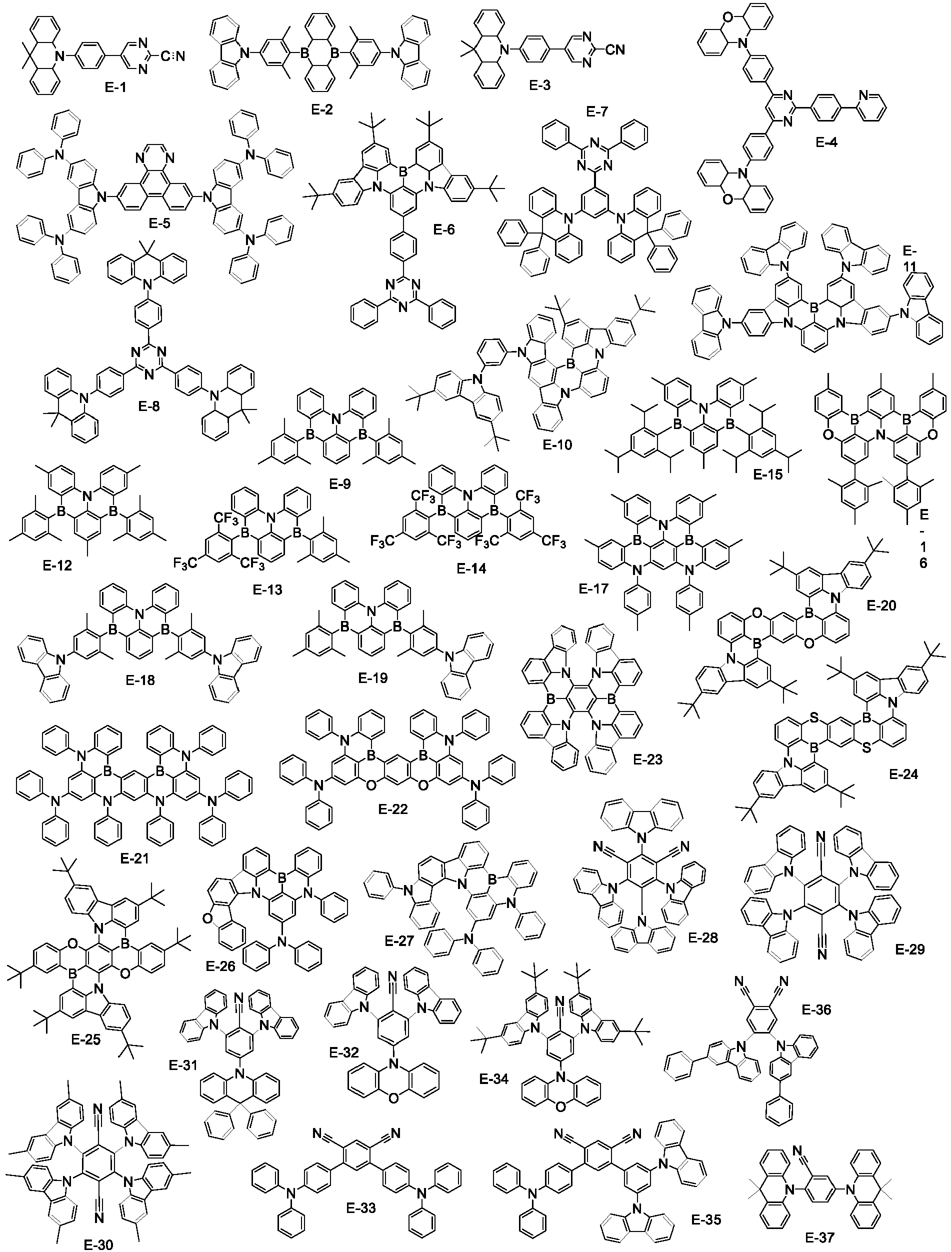 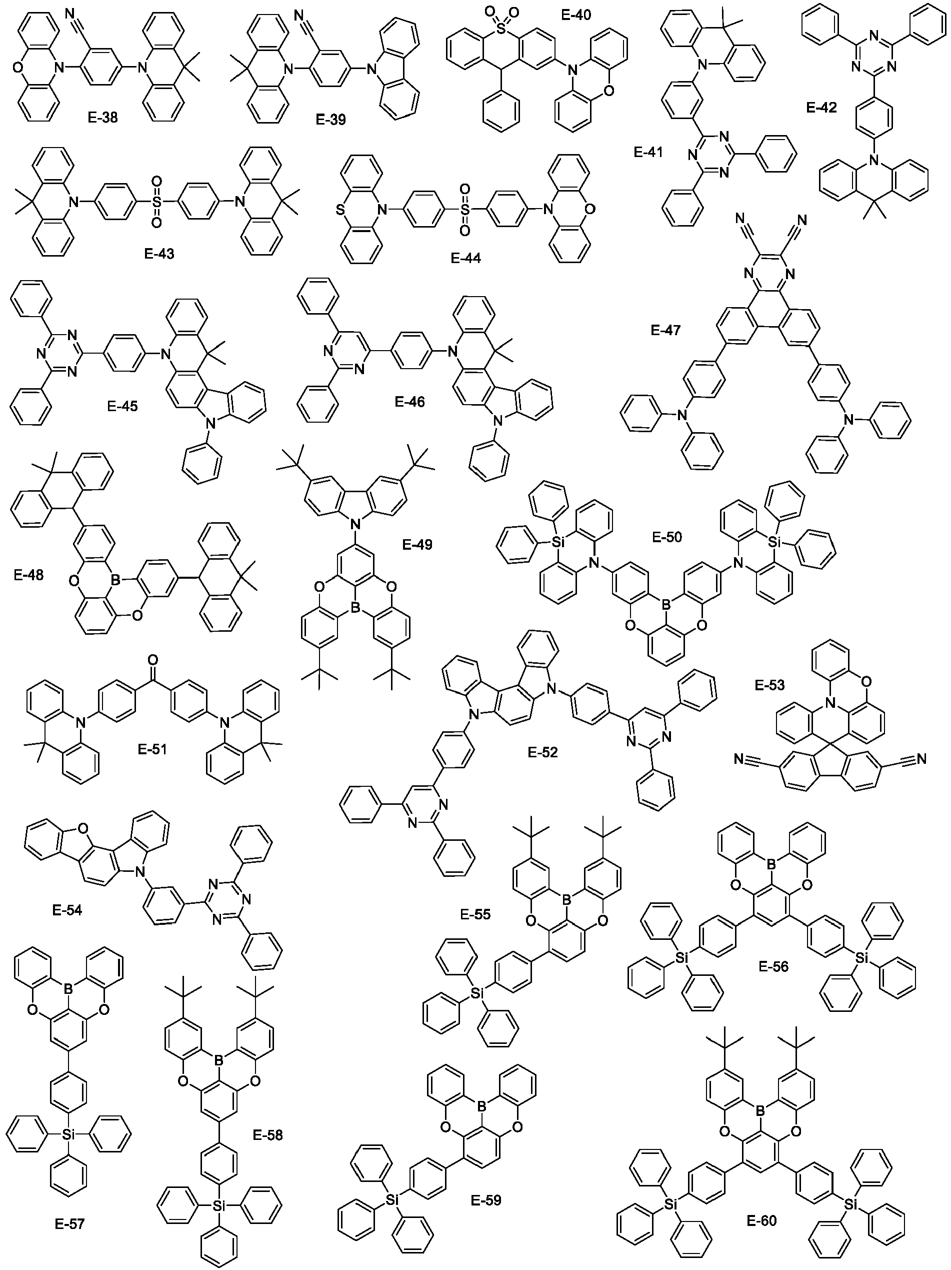 and deuterated analogues thereof.

The processes for obtaining chemical compounds presented in the diode according to the invention such as: organometallic iridium complexes according to Formula II, organometallic platinum complexes according to Formula III, complexes numbered Ir-1-Ir-151, Pt-1-Pt-228, MC-1-MC-10, the auxiliary TADF emissive dopands, hosts, the auxiliary hosts, the fluorescence compounds, the auxiliary fluorescence compounds, the compounds numbered H-1-H-164, E-1-E-60, the compounds of the hole injection layer, hole transport layer, electron transport layer, emission auxiliary layer, electron blocking layer, hole blocking layer, electron injection layer, are well known in the state of the art.

### The example 4: Electroluminescent diodes

The electroluminescent diode can comprise an electrode 1 and electrode 2 (e.g., the electrode can be made of indium tin oxide (ITO) and aluminum (Al), ITO and platinum (Pt), fluorine doped tin oxide (FTO) and silver (Ag), ITO and calcium (Ca), ITO and barium (Ba), ITO and Mg-Al, zinc oxide (ZnO) and Al). For example, the diode may comprise the following layers: ITO as an electrode 1, HATCN, α-NPB, PCZAC, host, sensitizer, and the compound according to Formula I as a TADF emissive dopant, mCBP-CN, BPPB, LiF, and Al as electrode 2. Exemplary current-spectral measurements for exemplary electroluminescent diodes are presented in **Table 1**.

**Table 1. Current-spectral measurements for the diodes according to the invention**

| **No. of diode** | **Host/Sensitizer/Dop and weight ratio** | **EQE (Max/@1,000 cd/m²)** | **Current efficiency @1000 cd/m²)** | **ELₘₐₓ [nm]** | **LT₅₀ at 1000 cd/m² (h)** |
|---|---|---|---|---|---|
| 1 | mCBP-CN/ fac-Ir(dpbic)₃/-90/10/-- | 19.1/17.5% | 19.9 cd/A | 473 | 24.1 |
| 2 | mCBP-CN/ fac-Ir(dpbic)₃/**Comp. 1** 88/10/2 | 20.4/19.1% | 21.1 cd/A | 489 | 30.3 |
| 3 | mCBP-CN/ fac-Ir(dpbic)₃/**Comp. 2** 88/10/2 | 21.7/20.1% | 23.7 cd/A | 483 | 38.6 |
| 4 | mCBP-CN/ fac-Ir(dpbic)₃/**Comp. 3** 88/10/2 | 21.2/19.5% | 24.9 cd/A | 489 | 33.2 |
| 5 | mCBP-CN/ fac-Ir(dpbic)₃/**Comp. 4** 88/10/2 | 23.1/21.0% | 26.6 cd/A | 490 | 54.7 |
| 6 | mCBP-CN/ fac-Ir(dpbic)₃/**Comp. 16** 88/10/2 | 21.0/19.9% | 22.0 cd/A | 492 nm | 47.3 |
| 7 | mCBP-CN/ fac-Ir(dpbic)₃/**Comp. 26** 88/10/2 | 11.7/8.0% | 13.4 cd/A | 494 | 11.8 |
| 8 | SimCP/fac-Ir(dpbic)₃/**Comp. 4** | 25.2/23.1% | 28.0 cd/A | 486 | 56.2 |
| 9 | SiCzCz: SiTrzCz2/PtON-TBBI/**Comp. 4** | 18.6/16.4% | 24.4 cd/A | 483 | 58.9 |
| 10 | mCBP-CN/ fac-Ir(dpbic)₃/**Comp. 70** 88/10/2 | 19.1/17.0% | 18.2 cd/A | 481 | 29.3 |
| 11 | mCBP-CN/ fac-Ir(dpbic)₃/**Comp. 138** 88/10/2 | 19.4/17.8% | 18.7 cd/A | 478 | 31.8 |
| 12 | mCBP-CN/ fac-Ir(dpbic)₃/**Comp. 84** 88/10/2 | 21.6/18.5% | 21.9 cd/A | 486 | 44.0 |
| 13 | mCBP-CN/ fac-Ir(dpbic)₃/**Comp. 105** 88/10/2 | 20.1/18.7% | 19.9 cd/A | 479 | 41.2 |
| 14 | mCBP-CN/ fac-Ir(dpbic)₃/**Comp. 173** 88/10/2 | 18.6/16.7% | 18.8 cd/A | 471 | 39.2 |

| | | | | | |
|---|---|---|---|---|---|
| Abbreviations: EQE - external quantum efficiency; ELₘₐₓ - a maximum wavelength of the diode emission; LT₅₀ - operational lifetime of diode, wherein luminance decreases to 50% of the original; dopand - a TADF emissive dopant. | | | | | |

The organic boron compounds described herein are characterized by high external quantum efficiency of electromagnetic emission, and high luminescence value, such that they can be used in electroluminescent devices, e.g. as emitters in OLED devices/diodes. The diodes can comprise the compounds of Formula I thanks to they can be characterized by a high value of current efficiency.

### Example 5: Electroluminescent diodes

The diodes can comprise an anode, cathode, and organic emissive layer, disposed between an anode and cathode. The exemplary composition of these diodes according to the invention is presented in **Table 2**.

**Table 2. The exemplary composition of diodes the diodes according to the invention**

| **No. of diode** | **PS** | **TADF ED** | **H** | **1A PS** | **2A PS** | **1A TADF ED** | **2A TAD F ED** | **1A H** | **2A H** | **FL** | **1A FL** |
|---|---|---|---|---|---|---|---|---|---|---|---|
| 15 | Ir-3 | 2 | H-1 | Ir-19 | - | 8 | - | - | - | - | - |
| 16 | Ir-21 | 70 | H-2 | Ir-4 | - | 191 | - | H-3 | - | - | - |
| 17 | Ir-21 | 70 | H-2 | Ir-4 | - | - | - | H-3 | - | BA-NPB | - |
| 18 | Pt-10 | 70 | H-2 | Ir-15 | - | - | - | H-3 | - | Alq3 | - |
| 19 | Ir-56 | 206 | H-8 | - | - | E-56 | E-6 | H-2 | - | - | - |
| 20 | Pt-20 | 138 | H-7 | Ir-142 | Ir-26 | - | - | H-8 | - | E-21 | ru bre ne |
| 21 | Pt-72 | 150 | H-65 | Ir-2 | - | E-29 | - | - | - | - | - |
| 22 | Ir-142 | 207 | H-72 | Ir-26 | Ir-74 | E-51 | E-43 | - | - | - | - |
| 23 | Ir-112 | 193 | H-19 | Ir-58 | | | | | | | |
| 24 | IR-68 | 10 | H-2 | PT-147 | MC-2 | 90 | 260 | H-3 | H-56 | - | - |
| 25 | Pt-97 | 99 | H-34 | IR-3 | - | 269 | - | H-63 | - | rubrene | - |

| | | | | | | | | | | | |
|---|---|---|---|---|---|---|---|---|---|---|---|
| Abbreviations: - - a lack of a particular compound; PS - a phosphorescent sensitizer; TADF ED - a TADF emissive dopant; H - a host; 1A PS - the first auxiliary phosphorescent sensitizer; 2A PS - the second auxiliary phosphorescent sensitizer; 1A TADF ED - the first auxiliary TADF emissive dopand; 2A TADF ED - the second auxiliary TADF emissive dopand; 1A H - the first auxiliary host; 2A H - the second auxiliary host; FL - a fluorescence compound; 1A FL - the first auxiliary fluorescence compound; BA-NPB - N10,N10'-diphenyl-N10,N10'-dinaphthalenyl-9,9'-bianthracene-10,10'-diamine, Alq3 - tris(8-hydroxyquinolinato)aluminum. | | | | | | | | | | | |

### Example 6: The use of electroluminescent diodes and a consumer product

A consumer product can comprise the diode according to the invention. The consumer product can be selected from a flat panel display, a computer monitor, a medical monitor, a television, a billboard, a light for interior or exterior illumination/signalling, a heads-up display, a fully or partially transparent display, a flexible display, a laser printer, a telephone, a cell phone, tablet, a phablet, a personal digital assistant, a wearable device, a laptop computer, a watch, a backlight, a digital camera, a camcorder, a 3-D display, a virtual reality or augmented reality display, a vehicle, a video walls comprising multiple displays tiled together, a theatre, stadium screen, and a sign.

Use of the diode according to the invention can be as follows: a display screen or illumination device, an electroluminescent display device, an organic photovoltaic device, or a sensing device.

## Claims

1. An organic boron compound according to Formula I: 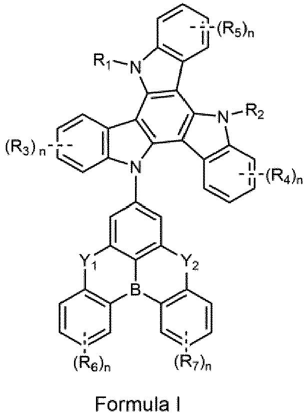 wherein:
R₁ and R₂ are together C₁-C₂₀ alkyl, C₂-C₂₀ alkenyl, C₂-C₂₀ alkynyl groups or their deuterated analogues;
R₃-R₅, together or independently, are hydrogen, deuterium, halogen, cyano, nitro, hydrazine, hydrazone, C₁-C₆₀ alkyl, C₂-C₆₀ alkenyl, C₂-C₆₀ alkynyl, C₁-C₆₀ alkoxy group, C₃-C₆₀ cycloalkyl, C₃-C₆₀ cycloalkenyl, C₁-C₆₀ heterocycloalkyl, C₁-C₆₀ heterocycloalkenyl group, C₃-C₆₀ cycloalkynyl group, C₁-C₆₀ heterocycloalkynyl group, hydroxyl, C₆-C₆₀ aryl, C₁-C₆₀ heteroaryl group, C₅-C₆₀ aryloxy, C₁-C₆₀ heteroaryloxy group, C₂-C₆₀ ether group, C₆-C₆₀ thioaryl, C₁-C₆₀ heterothioaryl, C₁-C₆₀ amino, C₁-C₆₀ alkylamino, C₁-C₆₀ dialkylamino, C₆-C₆₀ arylamino, C₆-C₆₀ diarylamino, C₆-C₆₀ heteroarylamino group, C₆-C₆₀ heterodiarylamino group, C₄-C₆₀ non-aromatic fused polycyclic group, C₁-C₆₀ non-aromatic fused heteropolycyclic group or deuterated analogues thereof;
R₆-R₇, together or independently, are hydrogen, deuterium, halogen, hydroxyl, cyano, nitro, hydrazine, hydrazone, C₁-C₆₀ alkyl, C₂-C₆₀ alkenyl, C₂-C₆₀ alkynyl, C₃-C₆₀ cycloalkyl, C₃-C₆₀ cycloalkenyl, C₁-C₆₀ heterocycloalkyl, C₁-C₆₀ heterocycloalkenyl, C₃-C₆₀ cycloalkynyl group, C₁-C₆₀ heterocycloalkynyl group, C₆-C₆₀ aryl, C₁-C₆₀ heteroaryl group, C₁-C₆₀ alkoxy group, C₅-C₆₀ aryloxy, C₁-C₆₀ heteroaryloxy group, C₂-C₆₀ ether group, C₆-C₆₀ thioaryl, C₁-C₆₀ heterothioaryl, C₁-C₆₀ amino, C₁-C₆₀ alkylamino, C₁-C₆₀ dialkylamino, C₆-C₆₀ arylamino, C₆-C₆₀ diarylamino, C₆-C₆₀ heteroarylamino group, C₆-C₆₀ heterodiarylamino group, C₄-C₆₀ non-aromatic fused polycyclic group, C₁-C₆₀ non-aromatic fused heteropolycyclic group or deuterated analogues thereof;
Y₁ and Y₂, together or independently, are O or N(Rs);
R₈ is hydrogen, deuterium, C₆-C₆₀ aryl group, C₁-C₆₀ heteroaryl group, C₅-C₆₀ aryloxy, C₁-C₆₀ heteroaryloxy group, C₆-C₆₀ arylamino, C₆-C₆₀ heteroarylamino, C₆-C₆₀ diarylamino, C₆-C₆₀ heteroarylamino group, C₆-C₆₀ heterodiarylamino group, C₆-C₆₀ thioaryl group, C₁-C₆₀ heterothioaryl or deuterated analogues thereof;
an index n ranging from 0-4 indicates how many R₃, R₄, R₅, R₆, R₇ may be attached to a particular ring.

2. A compound according to claim 1, wherein the compound according to Formula I is selected from: 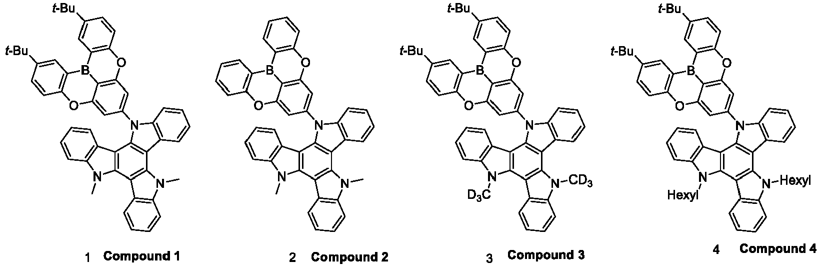 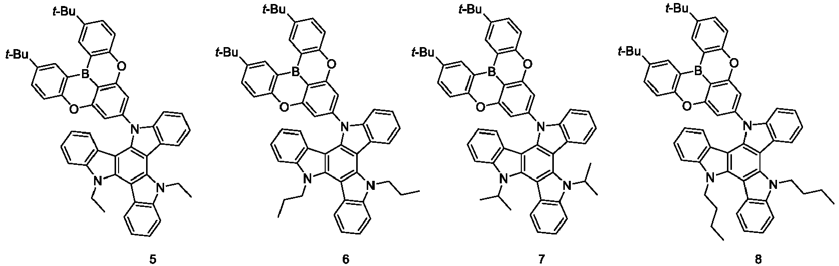 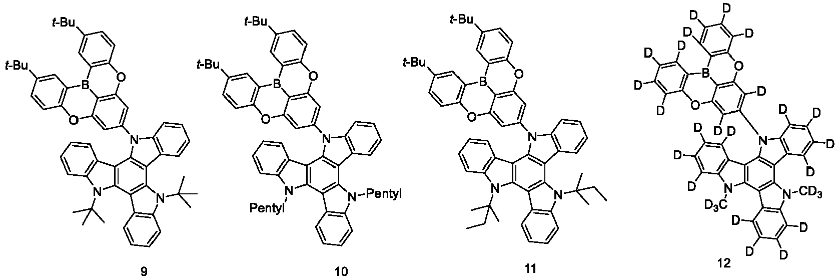 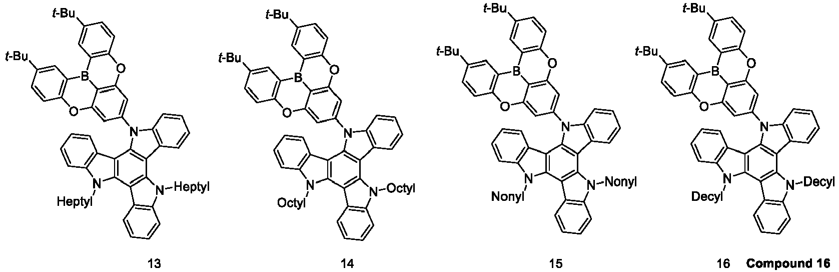 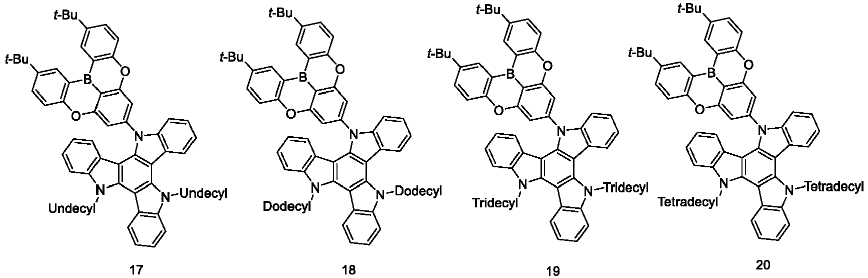 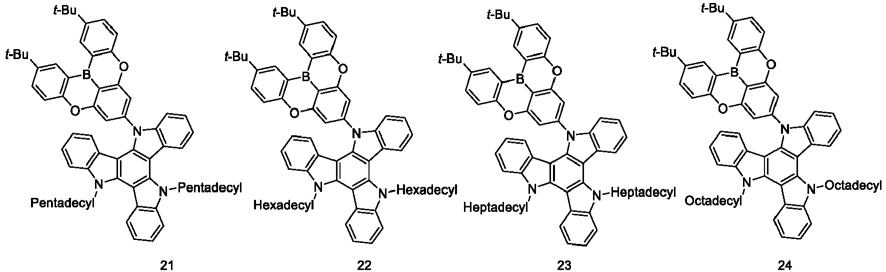 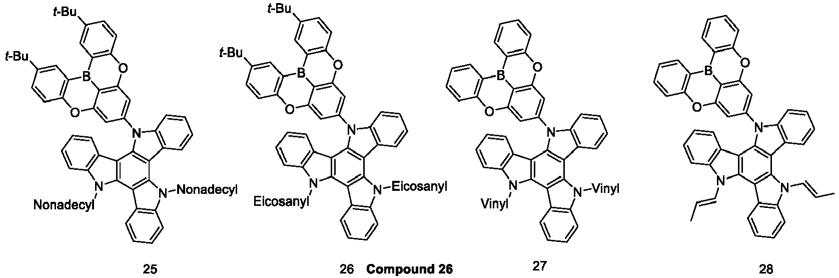 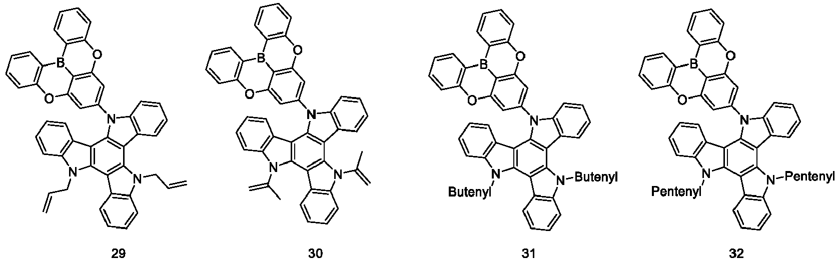 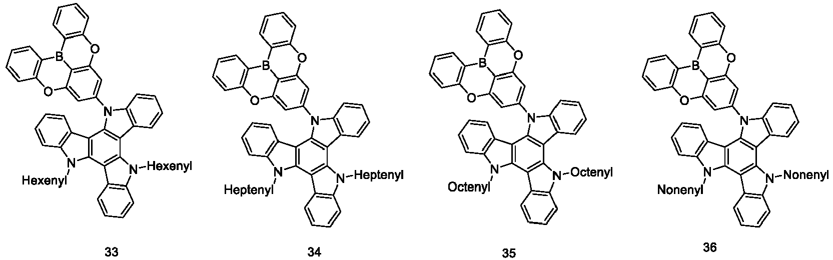 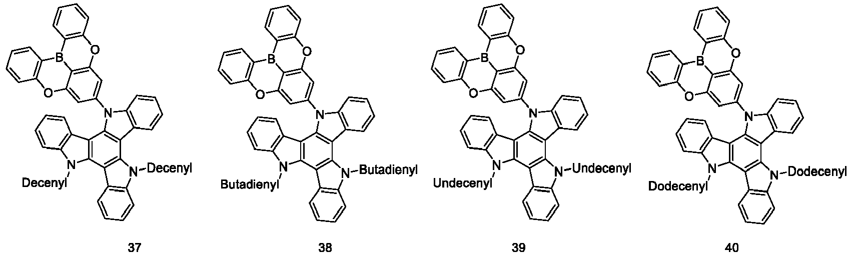 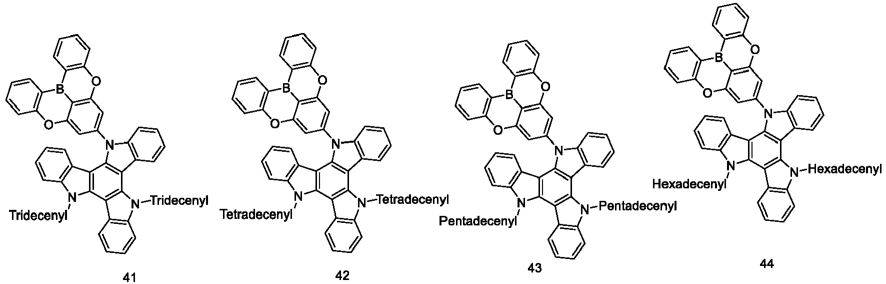 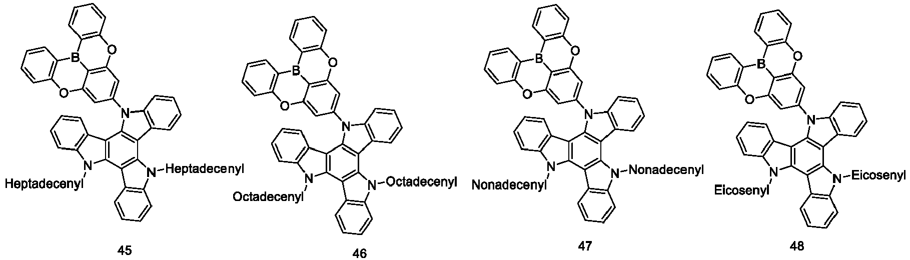 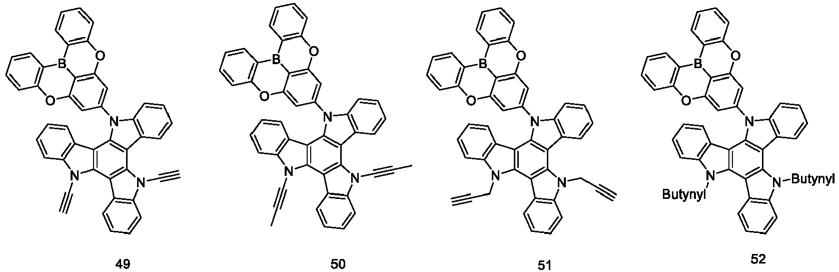 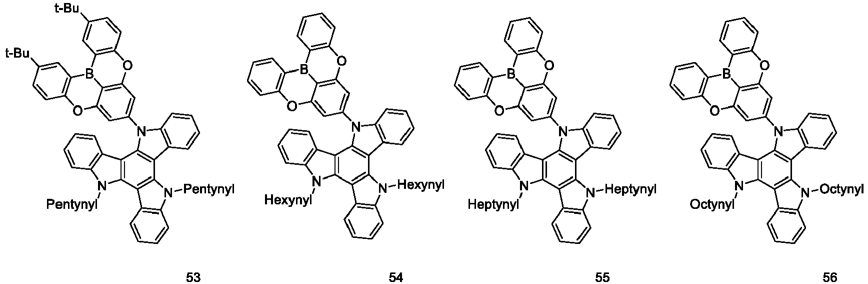 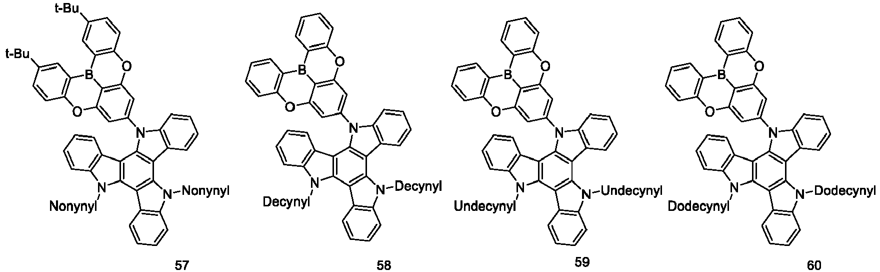 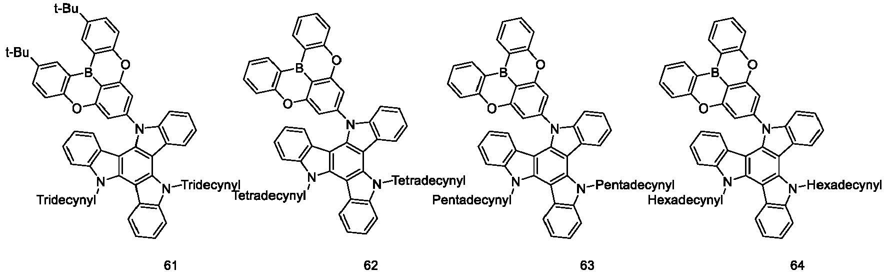 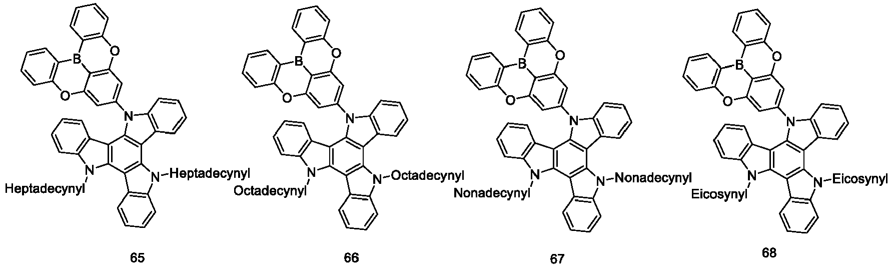 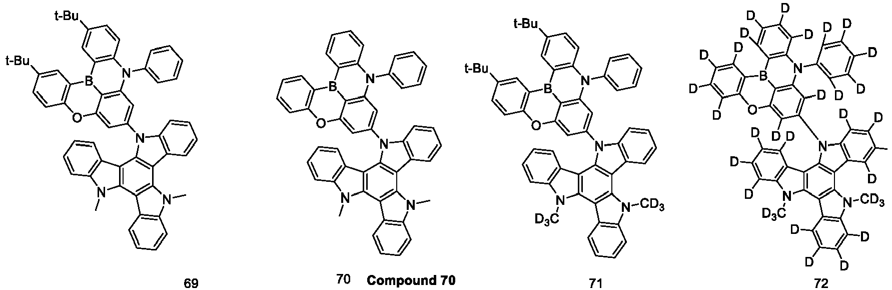 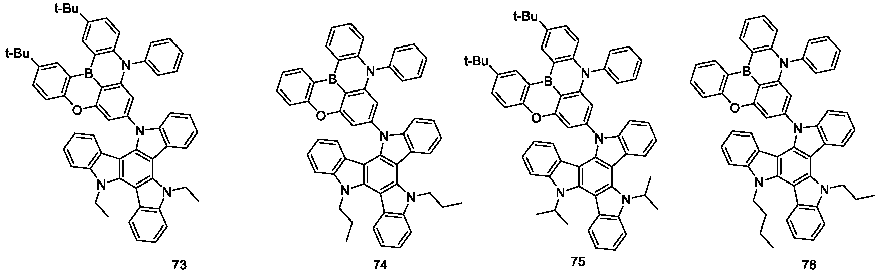 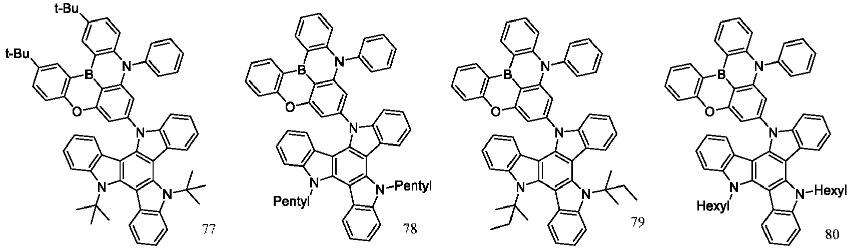 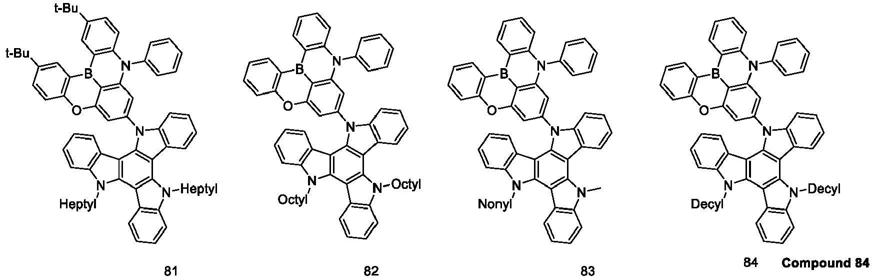 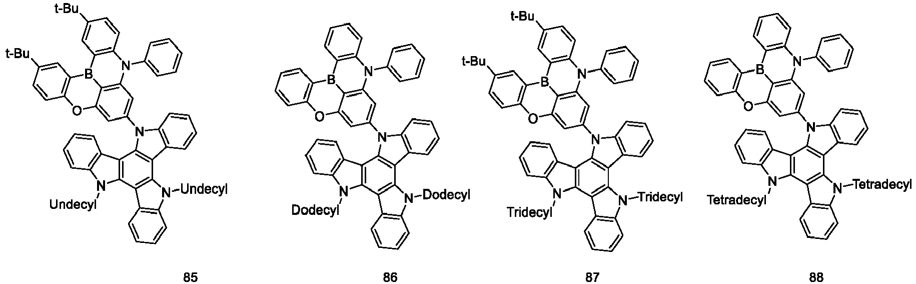 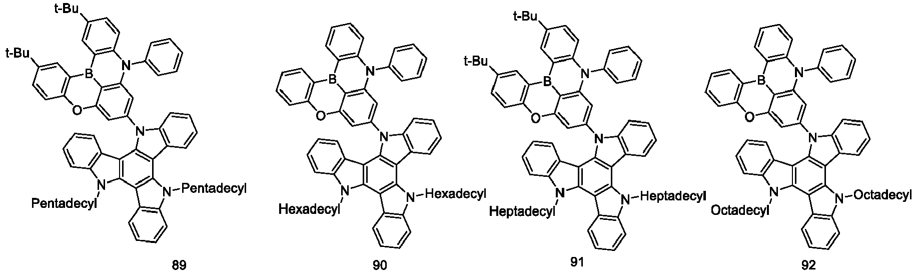 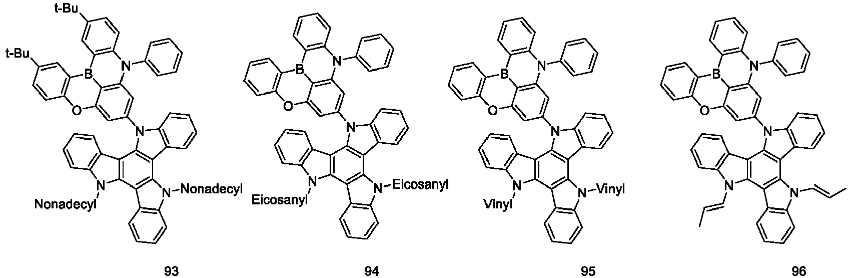 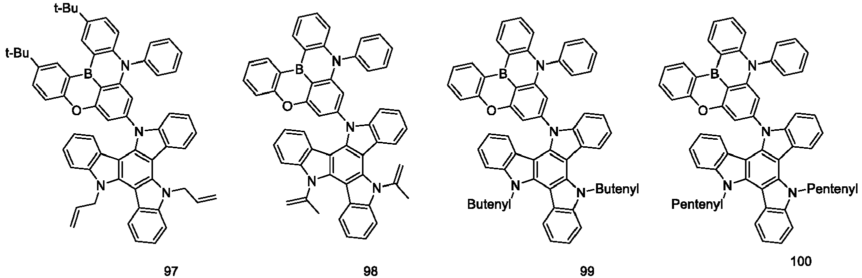 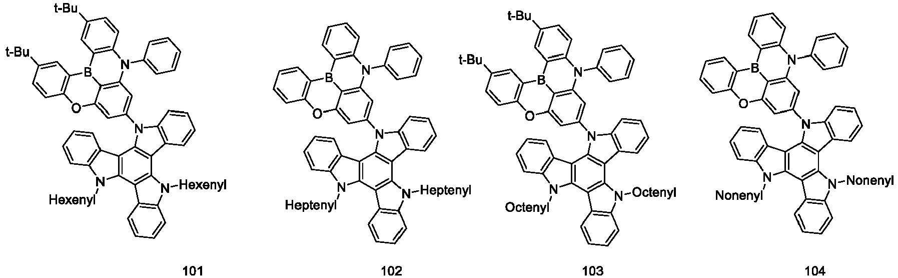 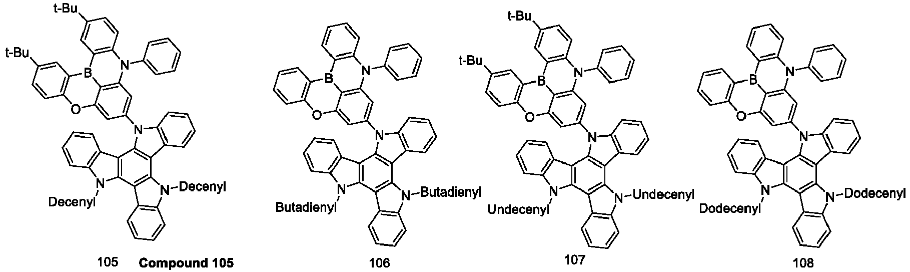 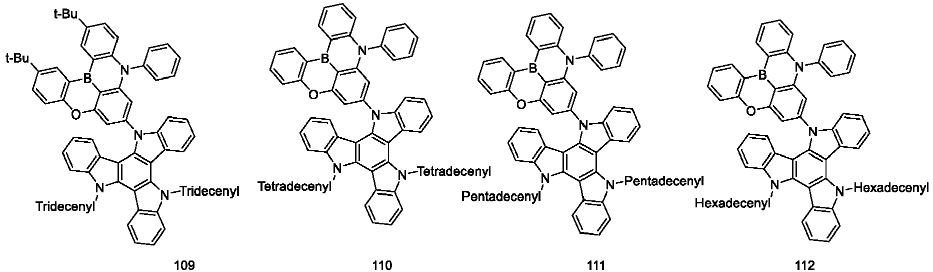 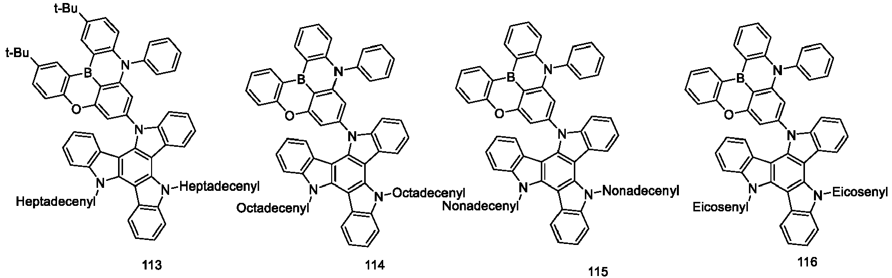 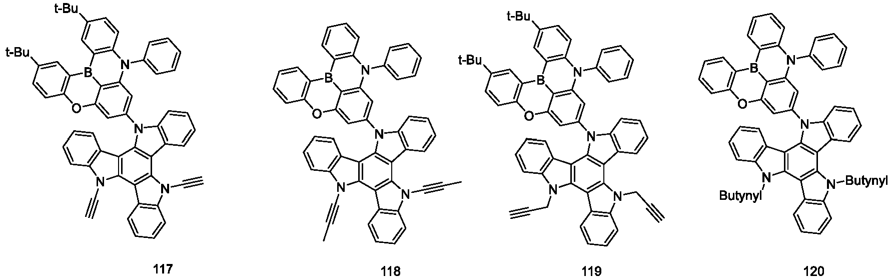 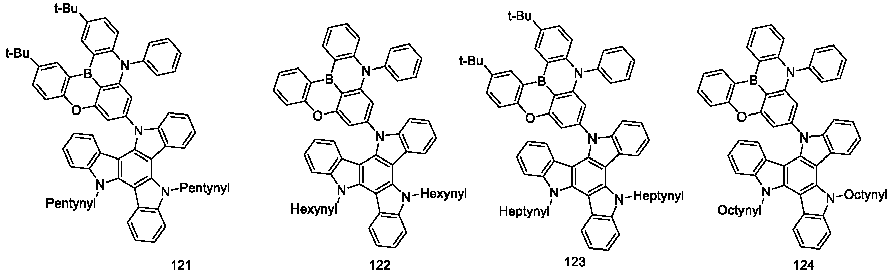 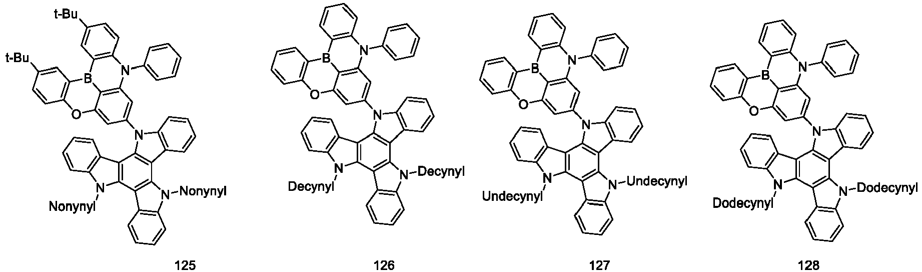 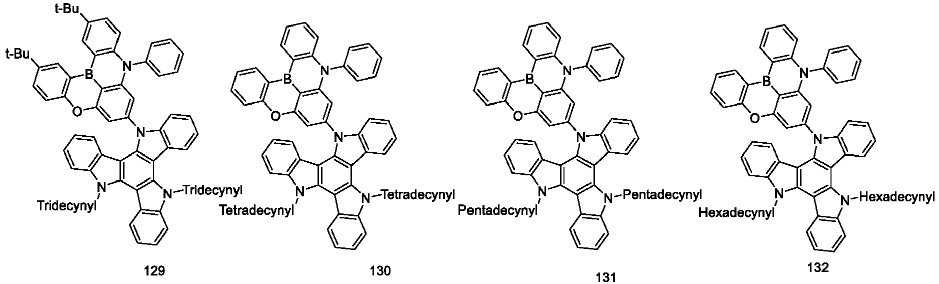 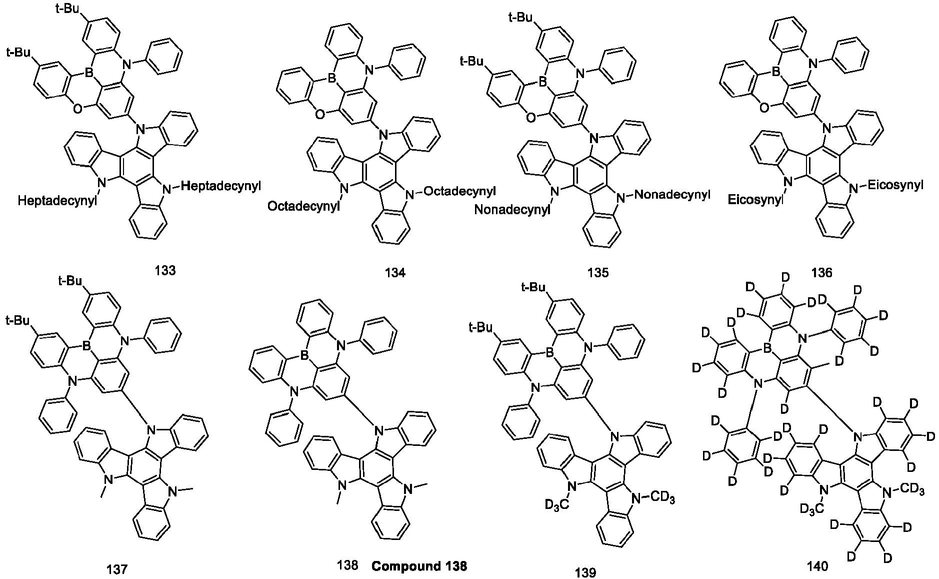 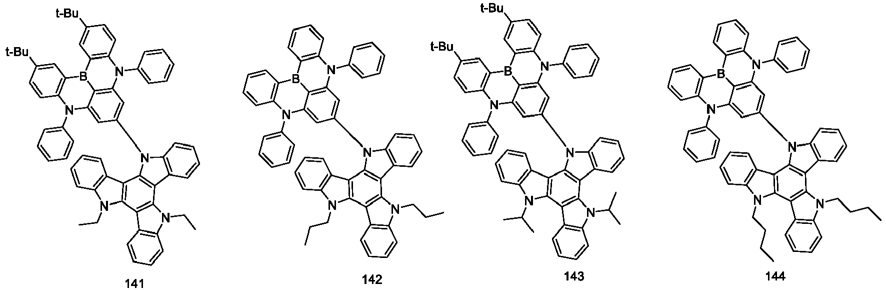 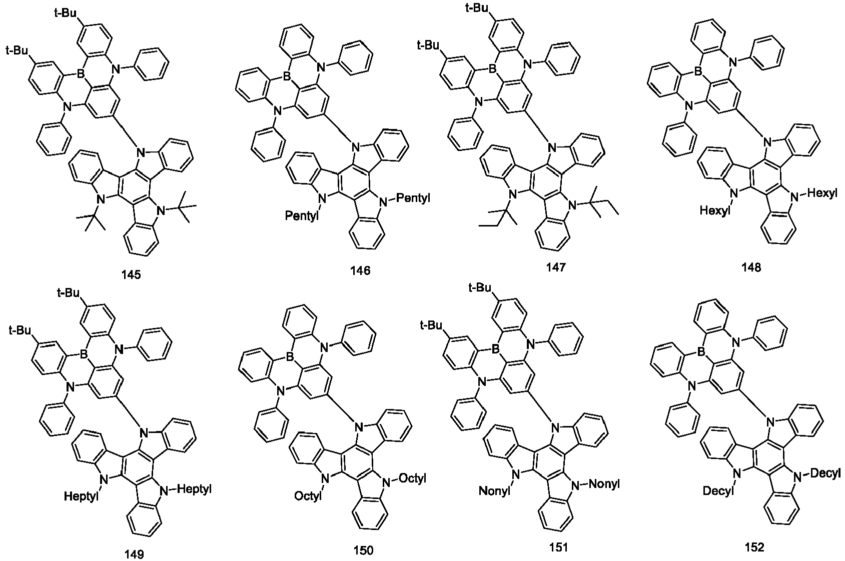 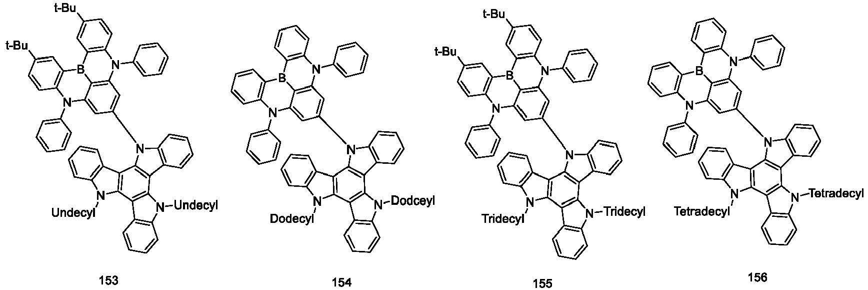 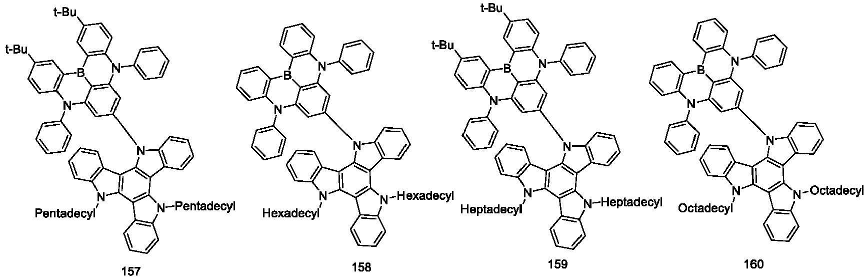 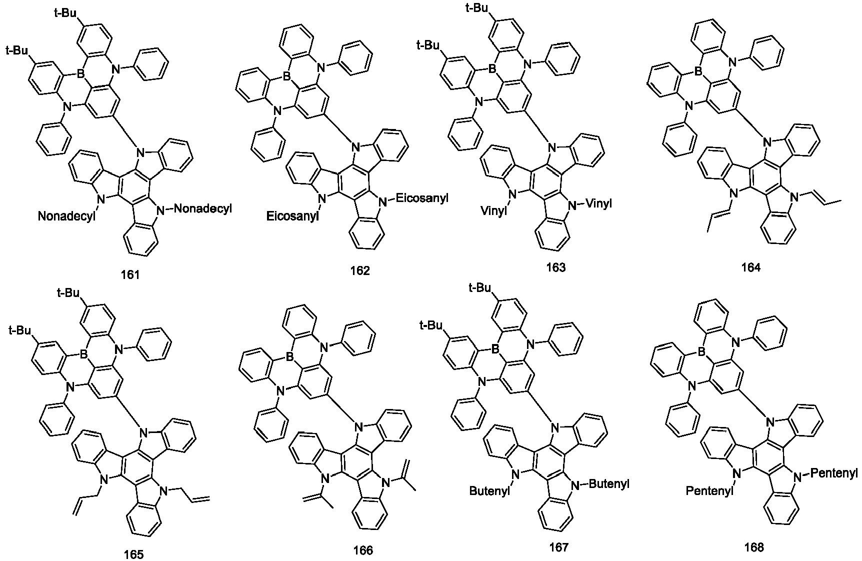 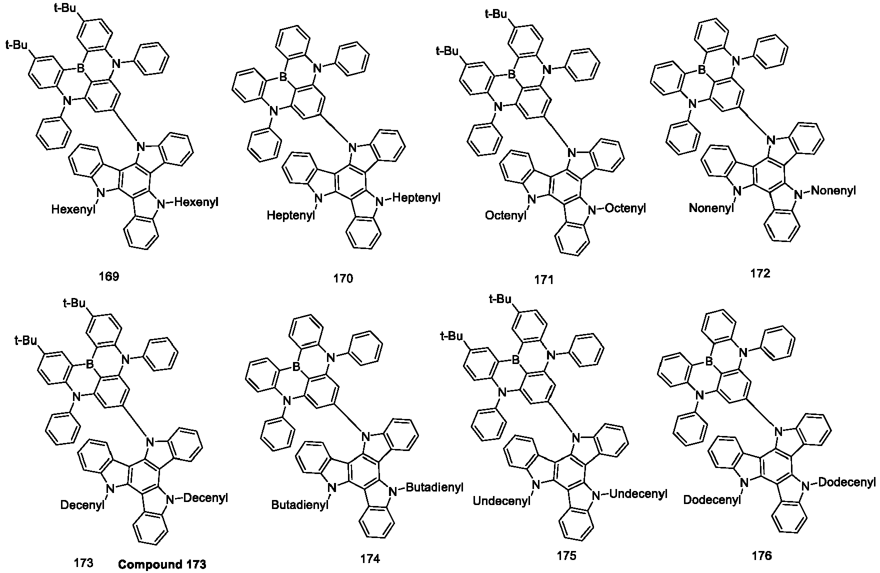 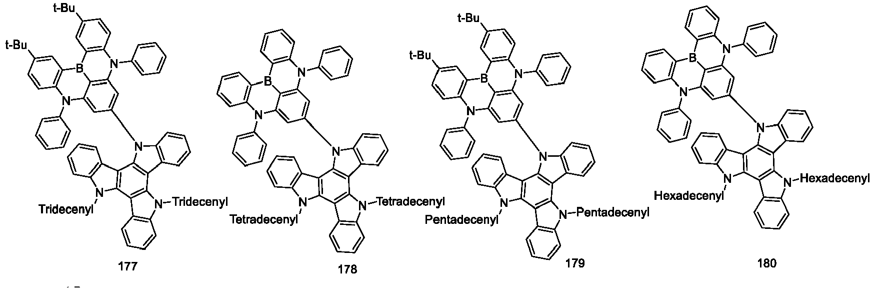 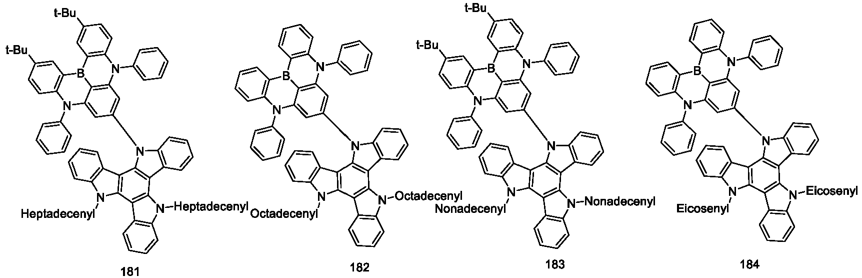 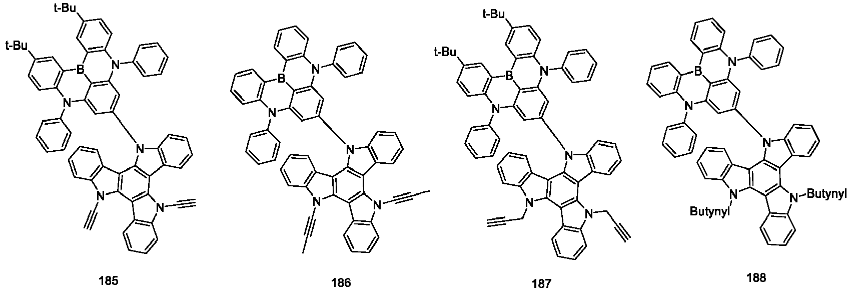 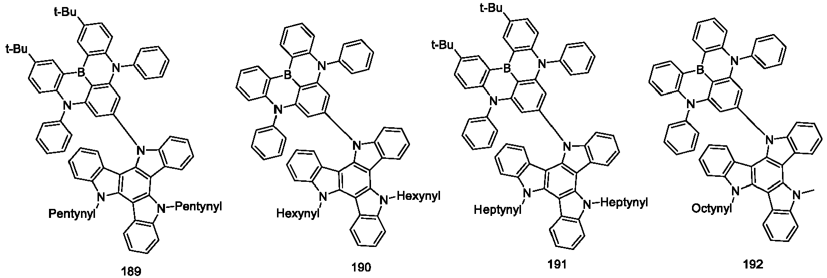 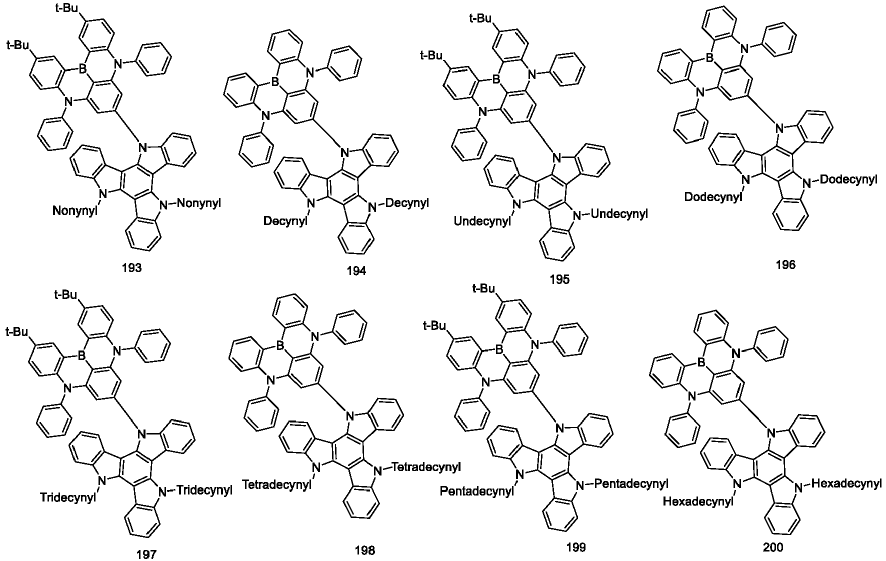 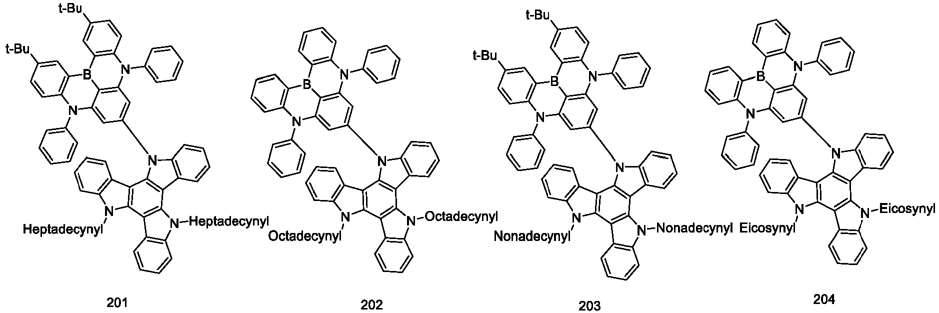 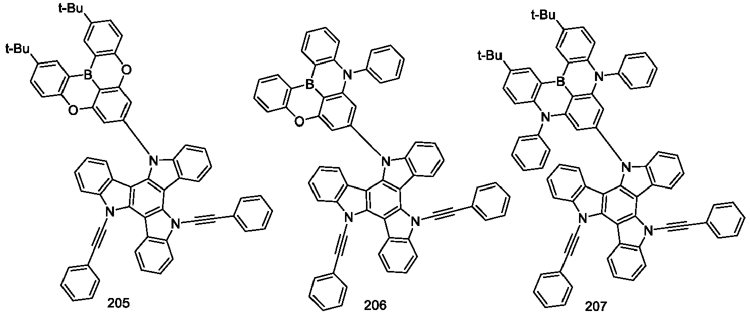 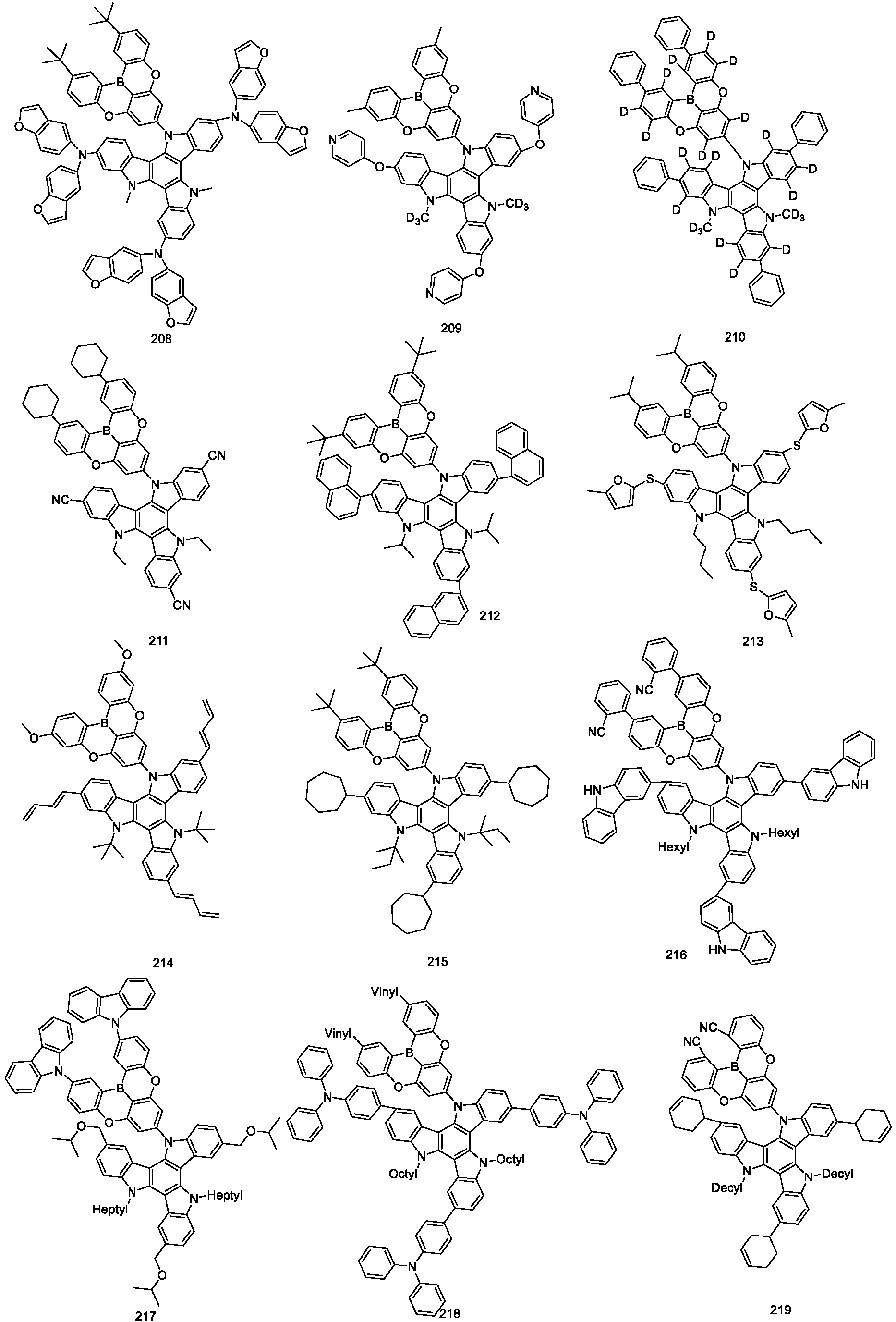 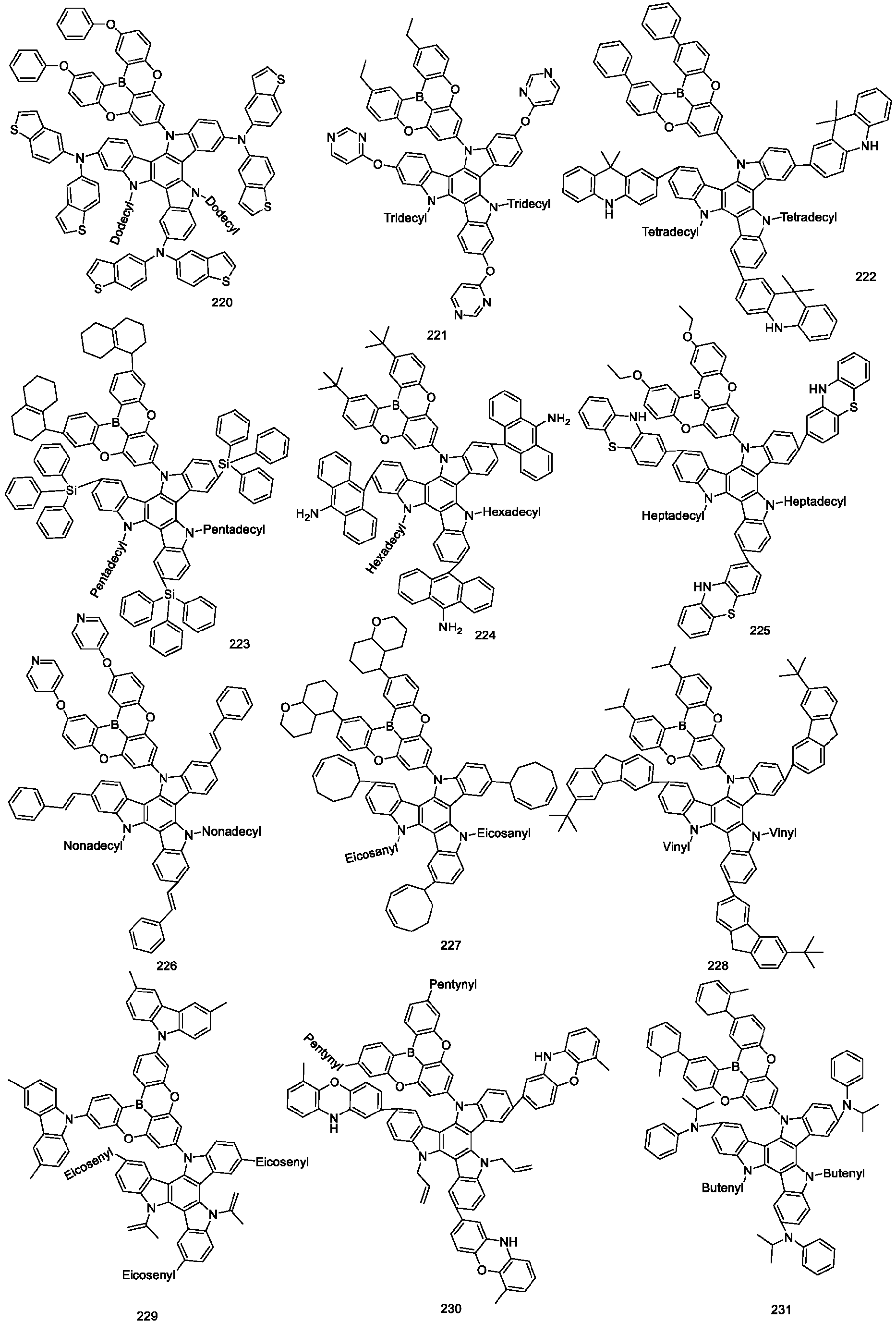 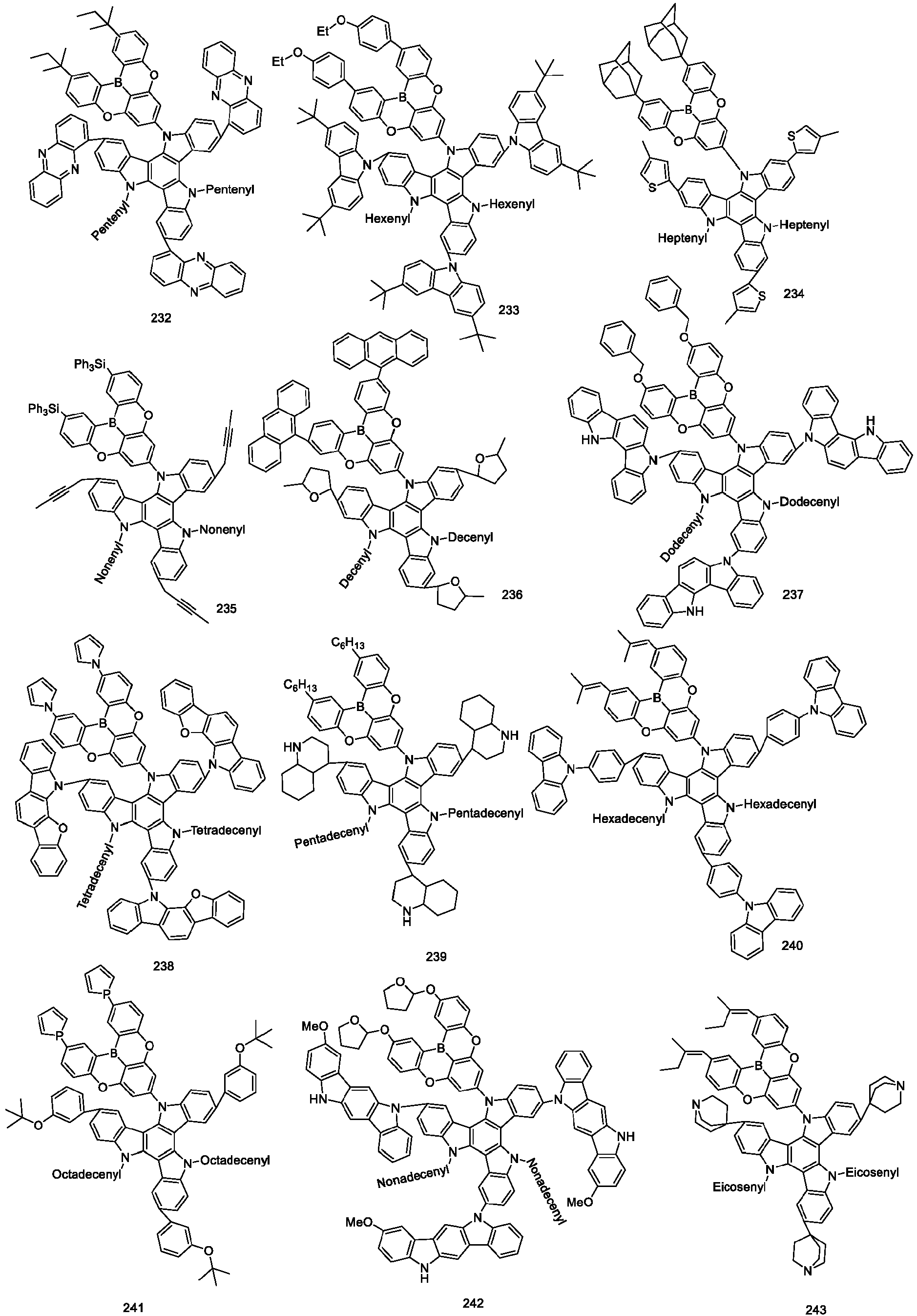 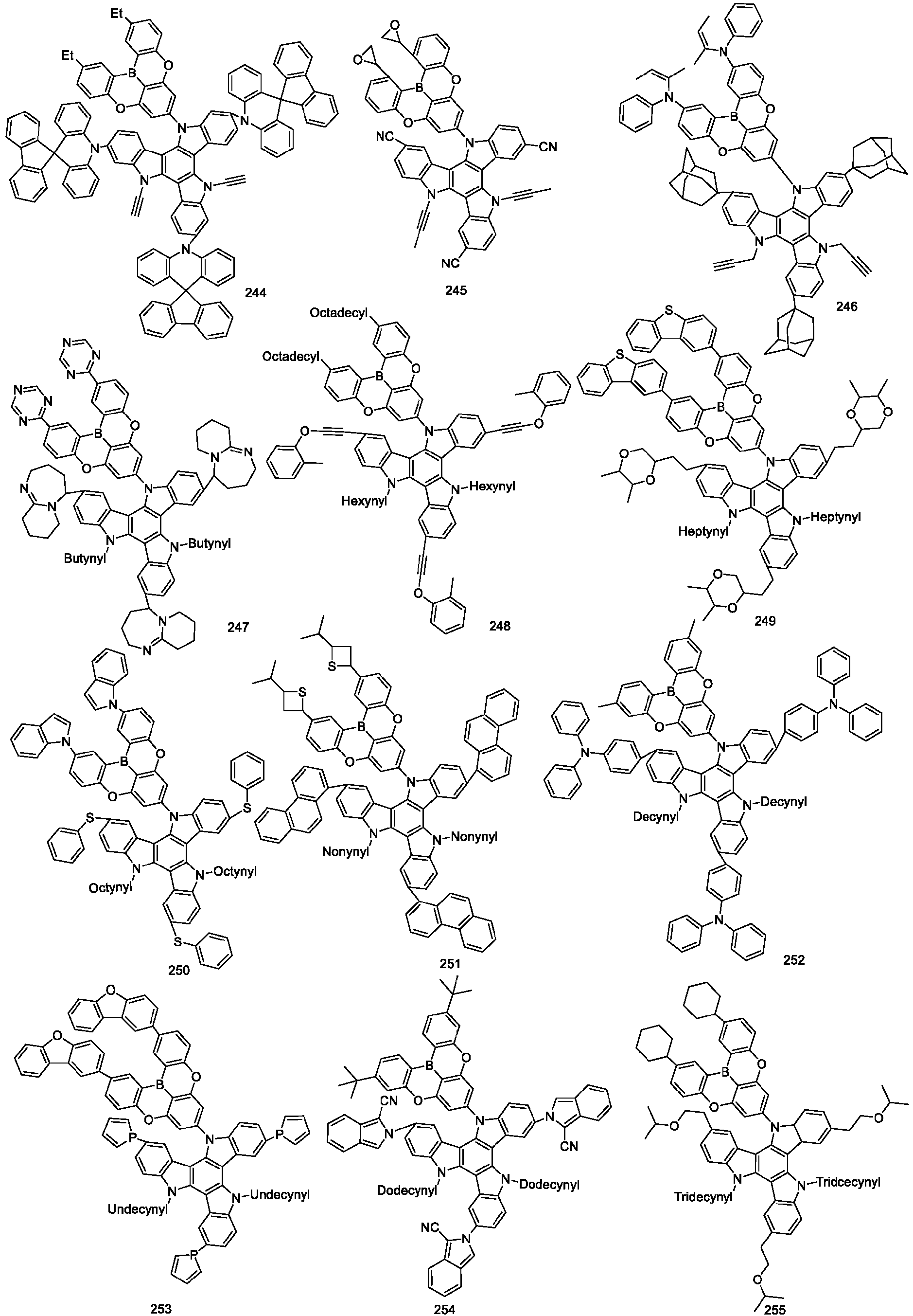 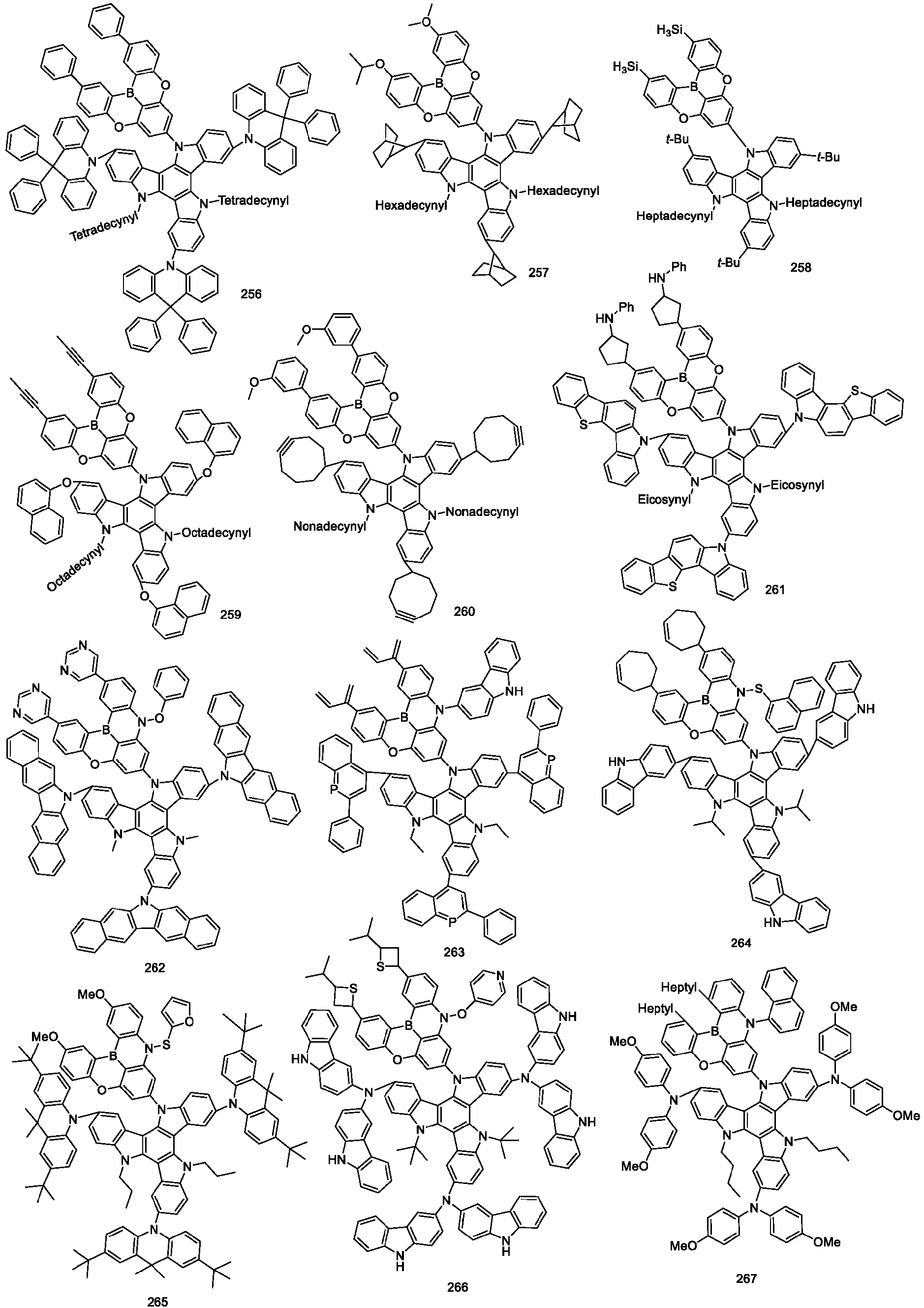 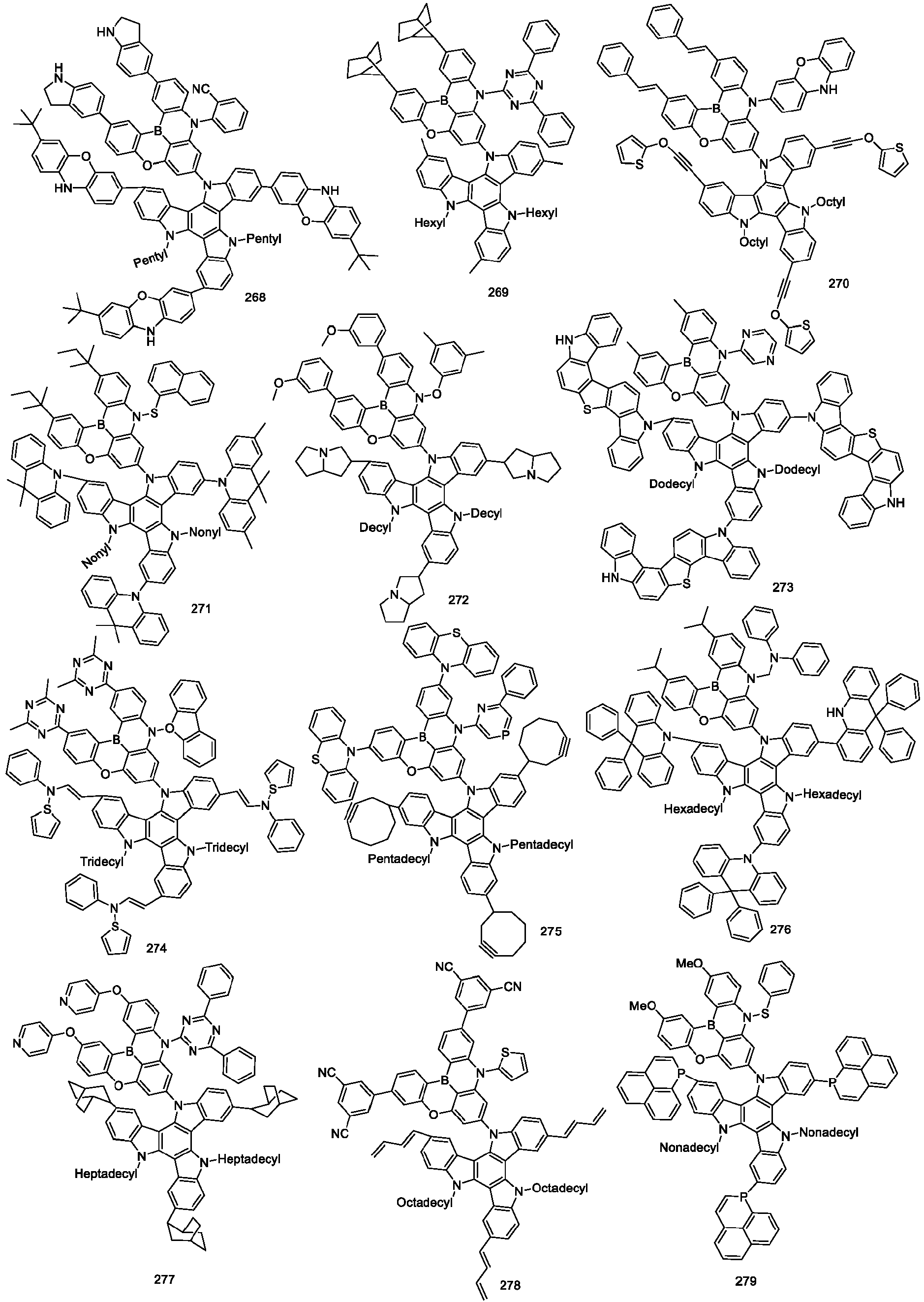 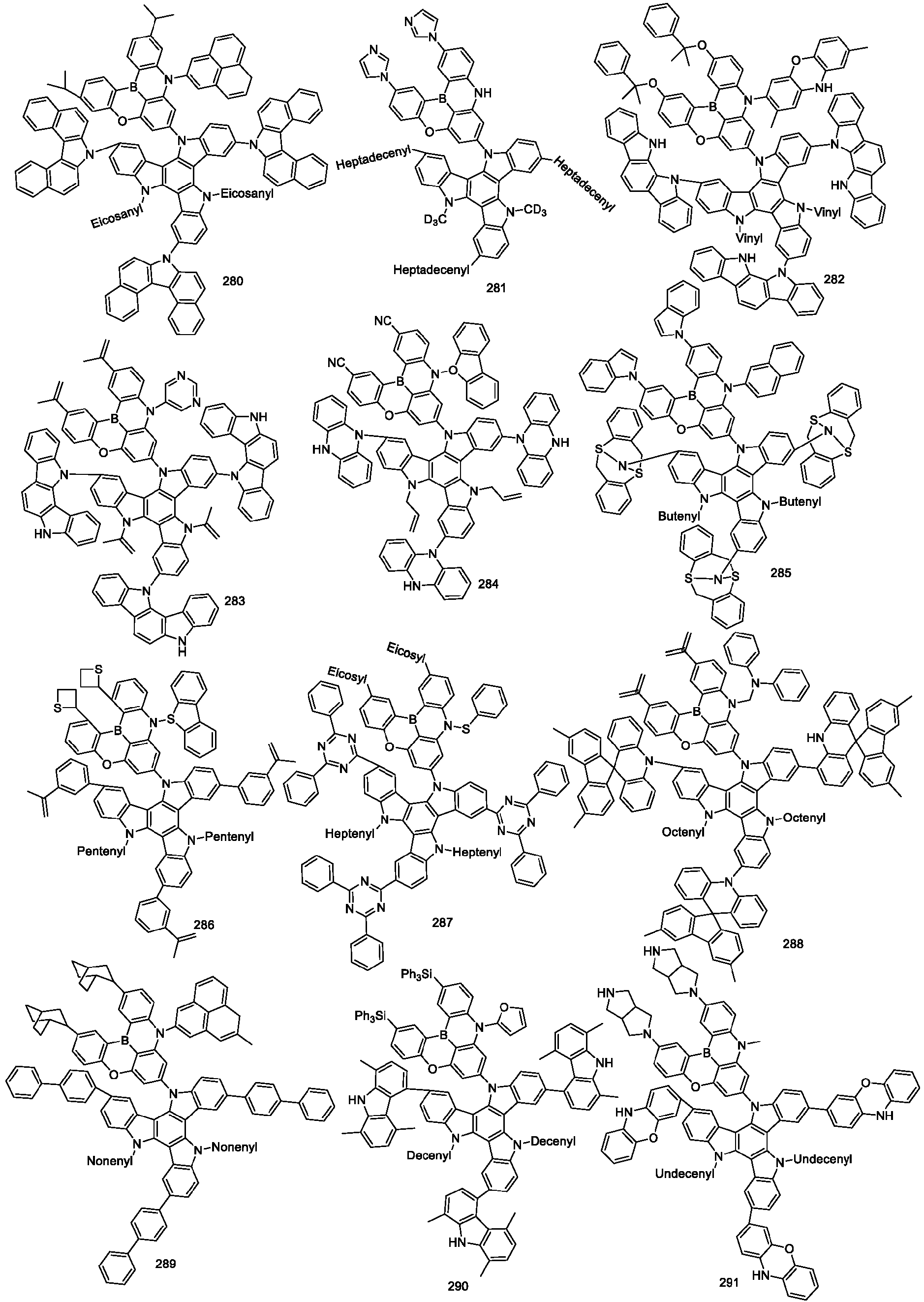 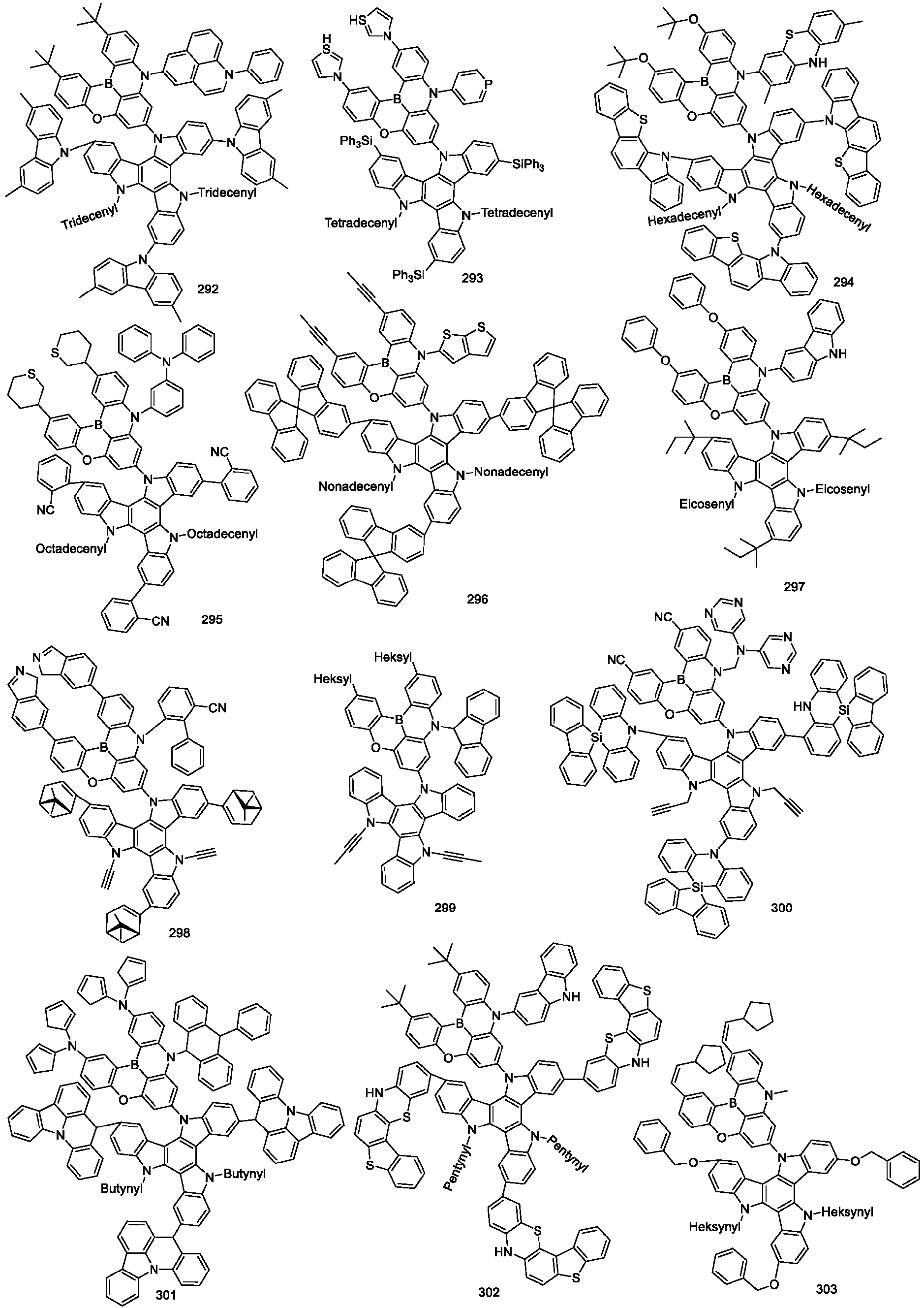 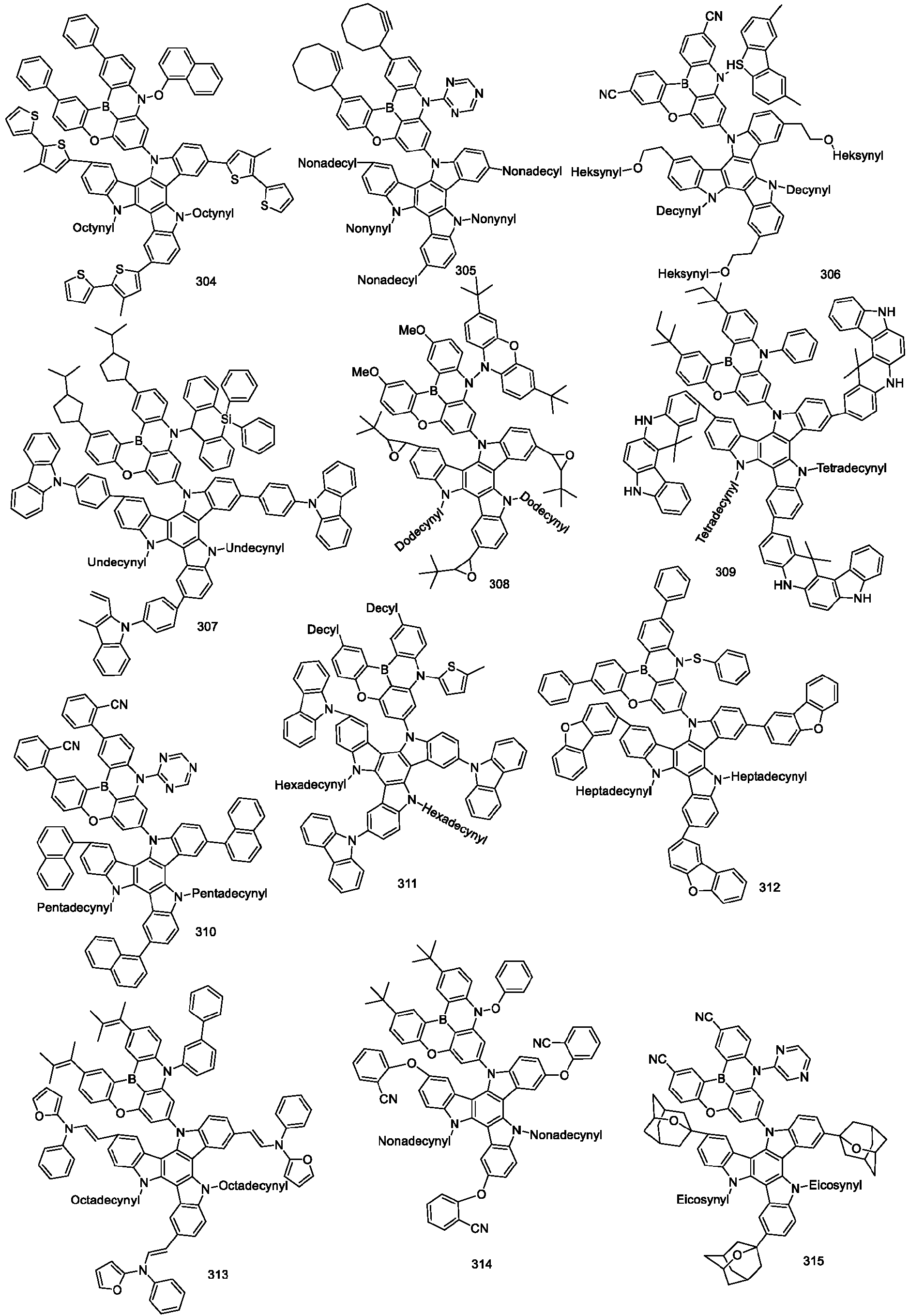 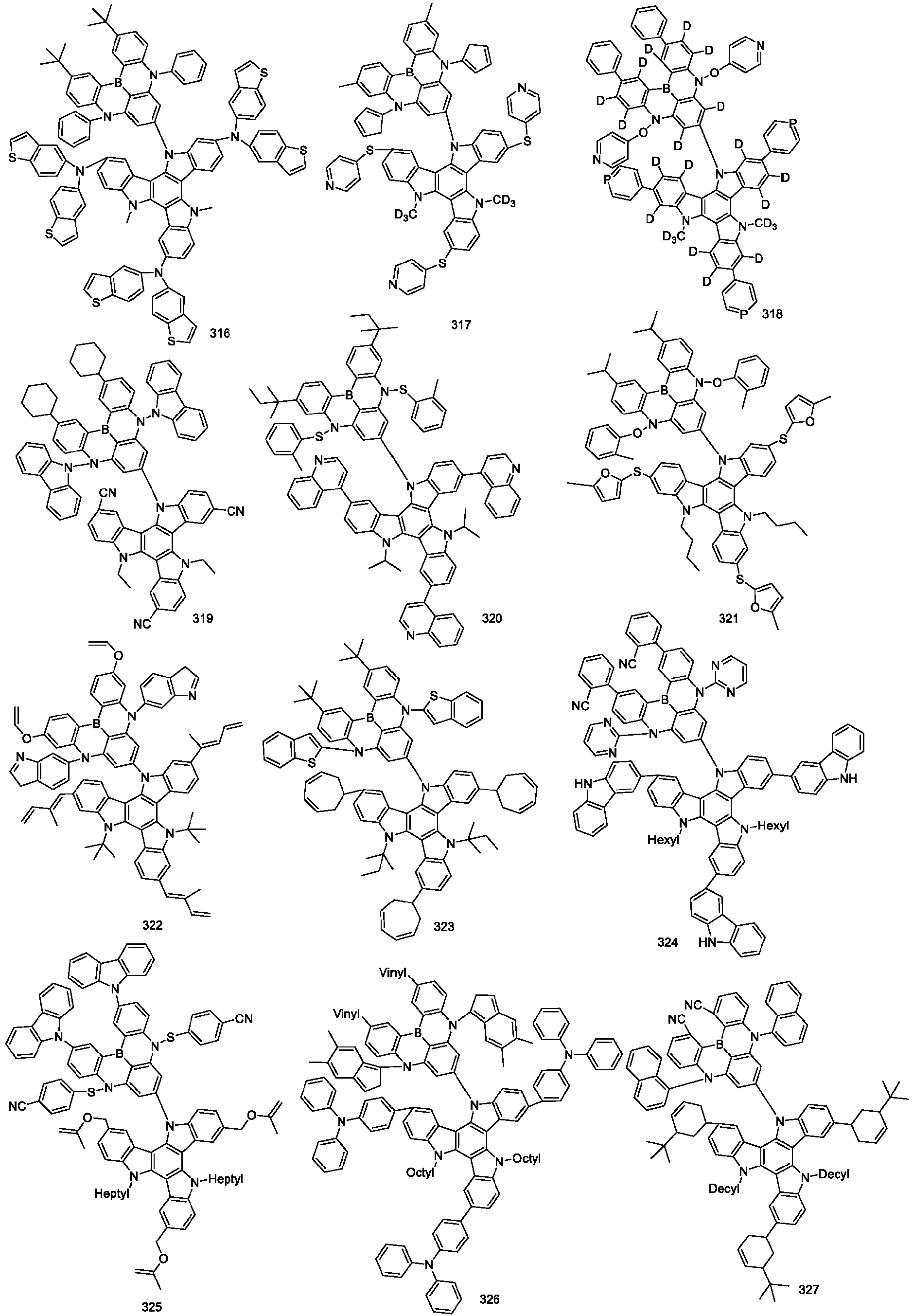 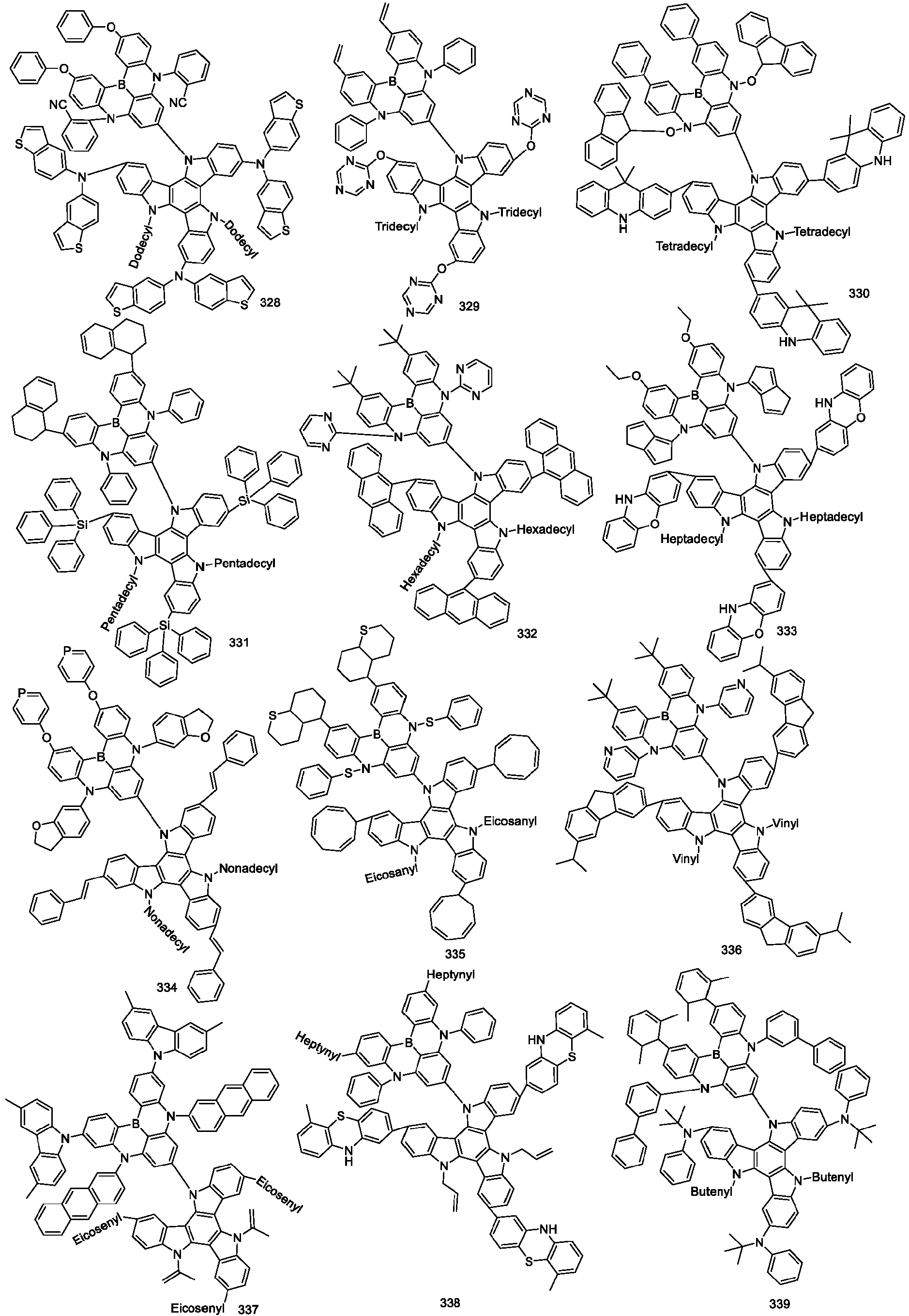 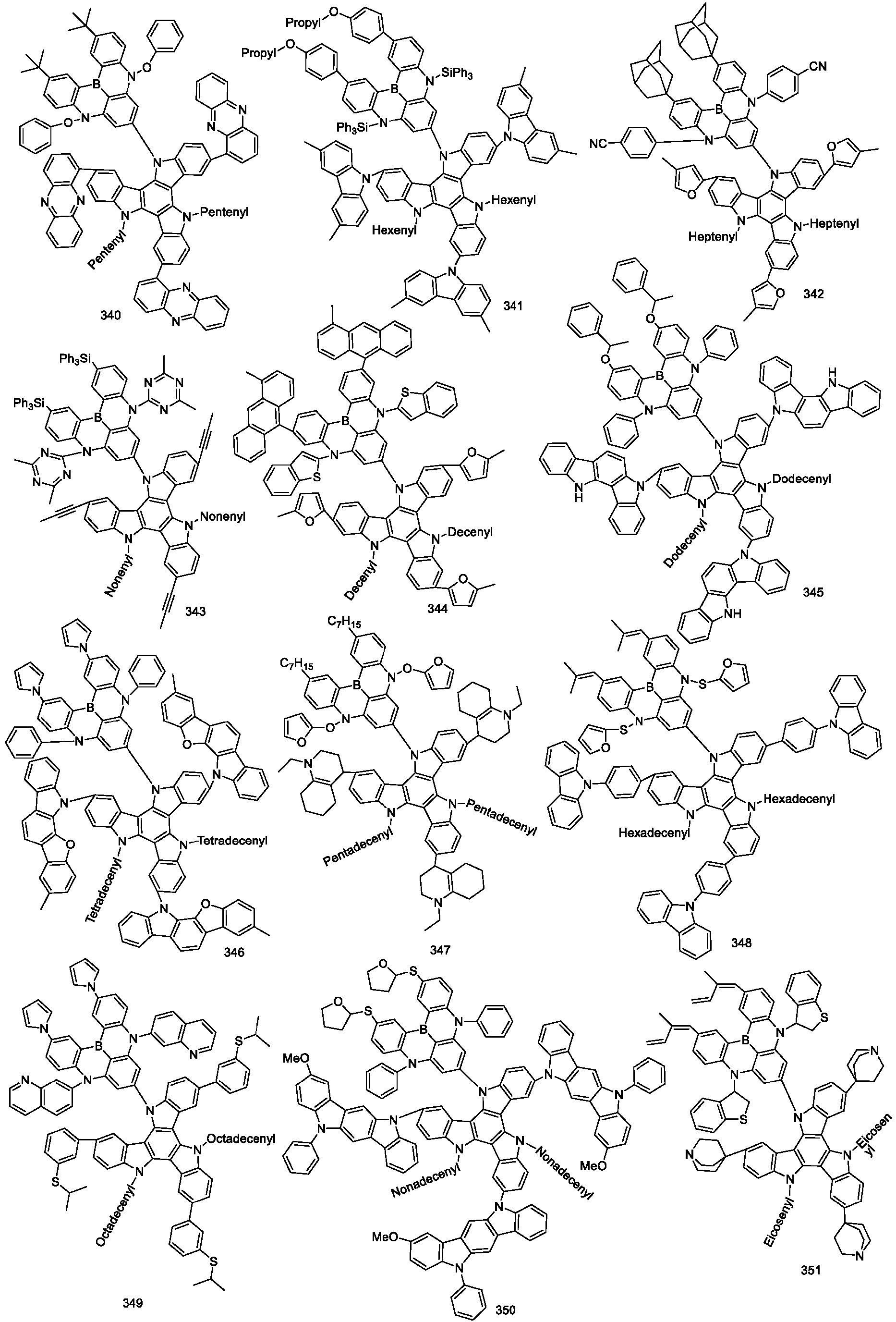 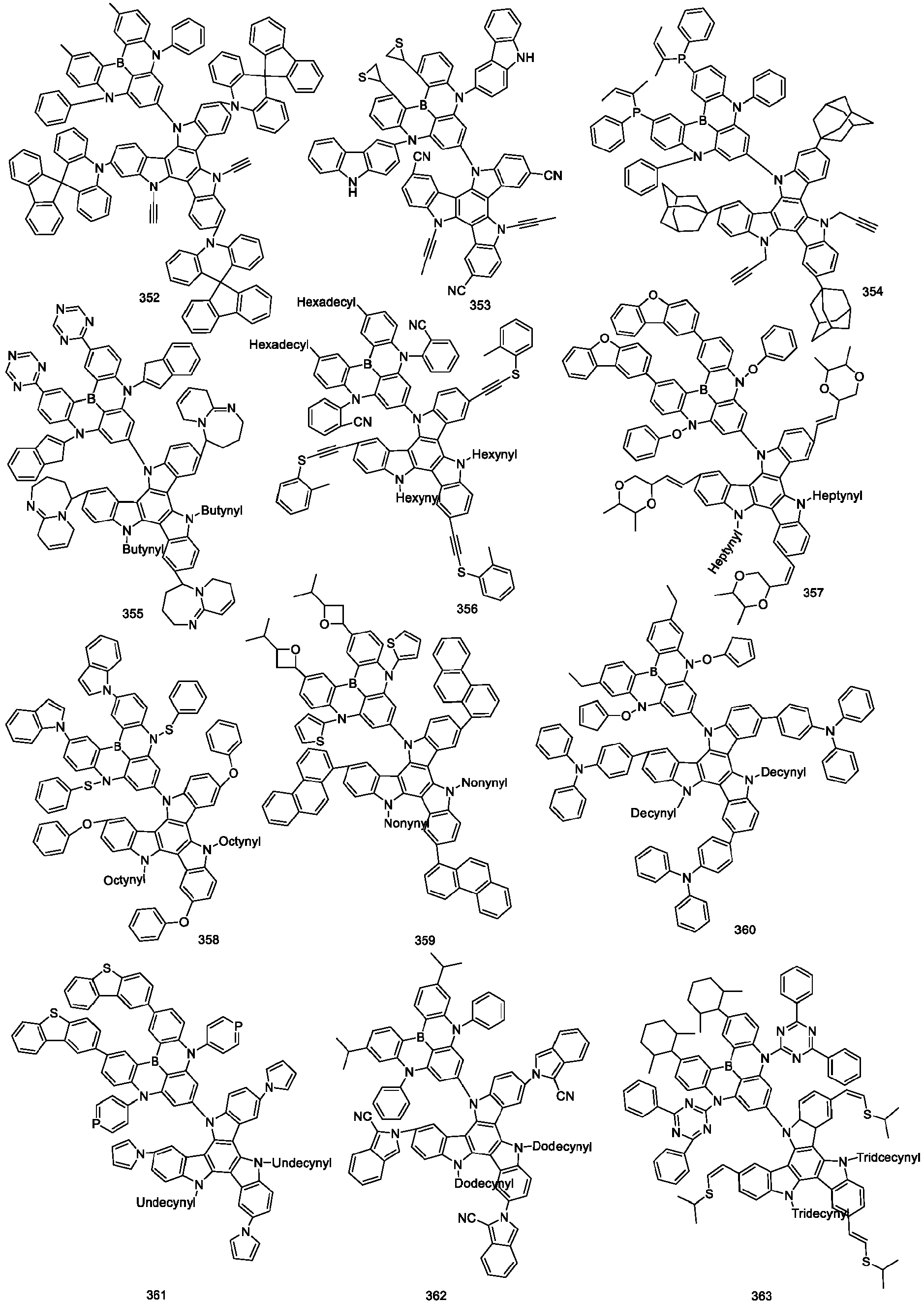 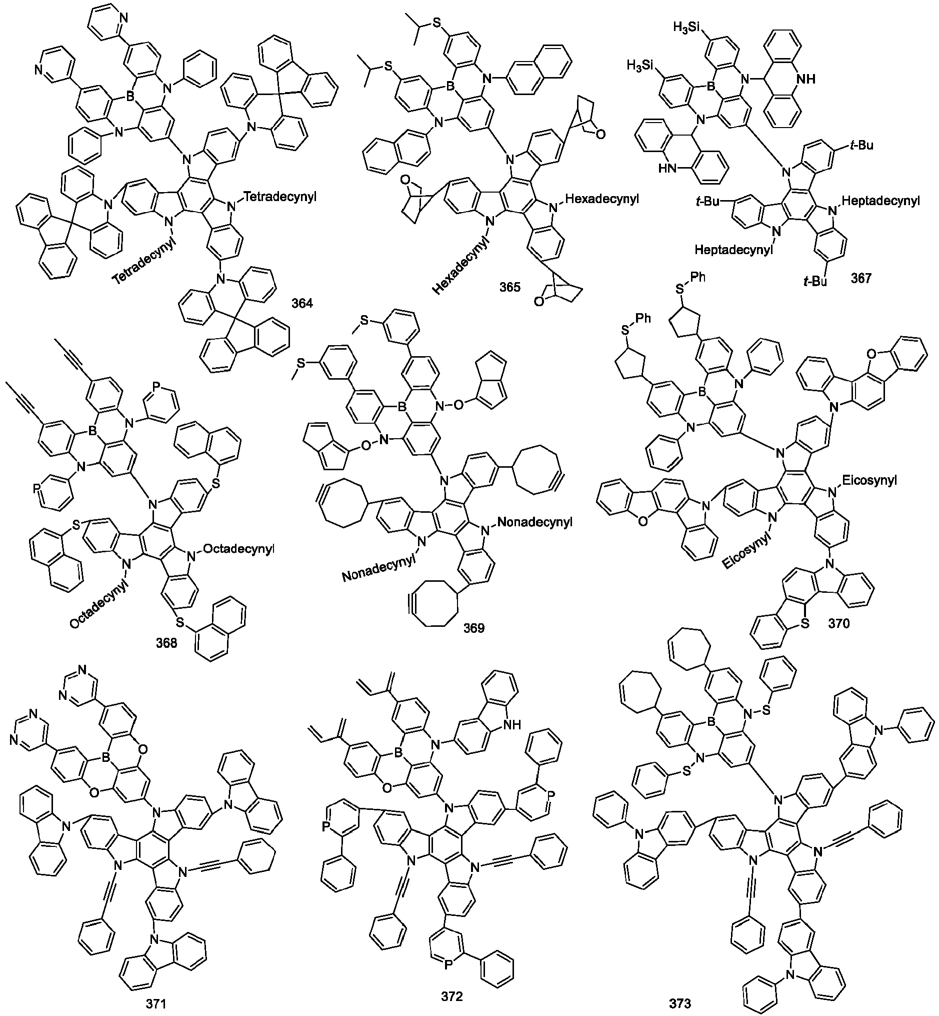 and deuterated analogues thereof.

3. An organic light emitting diode (OLED) comprising an anode, cathode, and organic emissive layer, disposed between the anode and cathode, wherein the organic emissive layer includes a phosphorescent sensitizer doped with a TADF emissive dopant, and a host, wherein the phosphorescent sensitizer is an organometallic iridium or platinum complex and the TADF emissive dopant is a compound according to claim 1 or 2.

4. An organic light emitting diode according to claim 3, wherein the organometallic iridium or platinum complex is a compound according to Formula II or Formula III, or a compound is selected from MC-1 to MC-10; wherein: 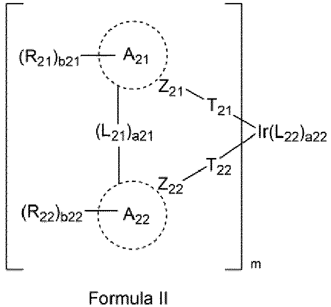 wherein:
m is an integer from 1 to 3;
a21 is an integer from 0 to 3;
a22 is an integer from 0 to 2;
b21, and b22 each independently is an integer from 1 to 8;
L₂₂ each independently is selected from an organic ligand, inorganic ligand, a halogen or deuterated analogues thereof;
T₂₁ and T₂₂ each independently is selected from a single bond, *-O-*', and *—S— * ; * and *' each indicate a binding site to an adjacent atom;
Z₂₁, and Z₂₂ each independently is N or C;
A₂₁ and A₂₂ each independently is selected from a C₆-C₆₀ aryl group, C₁-C₆₀ heteroaryl group and deuterated analogues thereof;
L₂₁ each independently is selected from a single bond, *-O-*', *-S-*', *-C(R₂₅)(R₂₆)-*', *-C(R₂₅)=*', *=C(R₂₅)-*', *-C(R₂₅)=C(R₂₅)-*', *-C(=O)-*', *-C(=S)-*', *-C≡C-*', *-B(R₂₅)-*', *-N(R₂₅)-*', *-P(R₂₅)-*', *-Si(R₂₅)(R₂₆)-*', *-P(R₂₅)(R₂₆)-*', and *-Ge(R₂₅)(R₂₆)-*'; * and *' each indicate as denoted above;
R₂₁ and R₂₂ each independently is selected from hydrogen, deuterium, halogen, a hydroxyl group, a cyano group, a nitro group, an C₁-C₆₀ amidino group, a hydrazino group, a hydrazono group, C₁-C₆₀ alkyl group, C₁-C₆₀ alkoxy group, C₅-C₆₀ aryloxy, C₃-C₆₀ cycloalkyl group, C₁-C₆₀ heterocycloalkyl group, C₃-C₆₀ cycloalkenyl group, C₁-C₆₀ heterocycloalkenyl group, C₃-C₆₀ cycloalkynyl group, C₁-C₆₀ heterocycloalkynyl group, C₆-C₆₀ aryl group, C₆-C₆₀ thioaryl group, C₁-C₆₀ heterothioaryl, C₁-C₆₀ heteroaryl group, a C₄-C₆₀ non-aromatic fused polycyclic group, C₁-C₆₀ non-aromatic fused heteropolycyclic group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂);
Q₂₁ to Q₂₃ and R₂₅ to R₂₆ each independently is selected from hydrogen, deuterium, halogen, a hydroxyl group, a cyano group, a nitro group, an C₁-C₆₀ amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, C₅-C₆₀ aryloxy, a C₃-C₆₀ cycloalkyl group, a C₁-C₆₀ heterocycloalkyl group, a C₃-C₆₀ cycloalkenyl group, a C₁-C₆₀ heterocycloalkenyl group, C₃-C₆₀ cycloalkynyl group, C₁-C₆₀ heterocycloalkynyl group, a C₆-C₆₀ aryl group, a C₆-C₆₀ thioaryl group, a C₁-C₆₀ heteroaryl group, a C₁-C₆₀ heteroaryloxy group, a C₁-C₆₀ heterothioaryl group, a C₄-C₆₀ non-aromatic fused polycyclic group, a C₁-C₆₀ non-aromatic fused heteropolycyclic group, and deuterated analogues thereof; 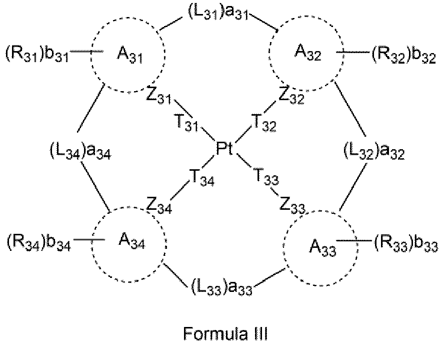
wherein:
a31 to a34 is an integer from 0 to 3;
b31 to b34 is an integer from 1 to 8;
A₃₁ to A₃₄ each independently is selected from a C₆-C₆₀ aryl group, C₁-C₆₀ heteroaryl group, and deuterated analogues thereof;
Z₃₁ to Z₃₄ each independently is N or C,
L₃₁ to L₃₄ each independently is selected from a single bond, *-O-*', *-S-*', *-C(R₃₅)(R₃₆)-*', *-C(R₃₅)=*', *=C(R₃₅)-*', *-C(35)=C(R₃₅)-*', *-C(=O)-*', *-C(=S)-*/, *-C≡C-*', *-B(R₃₅)-*', *-N(R₃₅)-*', *-P(R₃₅)-*', *-Si(R₃₅)(R₃₆)-*', *-P(R₃₅)(R₃₆)-*', and *-Ge(R₃₅)(R₃₆)-*'; * and *' are the same as defined in Formula II;
T₃₁ to T₃₄ each independently is selected from a single bond, *-O-*', and *-S-*', *-C(R₃₅)(R₃₆)-*', *-C(R₃₅)=*', *=C(R₃₅)-*', *-C(R₃₅)=C(R₃₅)-*', *-C(=O)-*', *-C(=S)-*', *-C≡C-*', *-B(R₃₅)-*', *-N(R₃₅)-*', *-P(R₃₅)-*', *-Si(R₃₅)(R₃₆)-*', *-P(R₃₅)(R₃₆)-*', and *-Ge(R₃₅)(R₃₆)-*';
R₃₁ to R₃₆ each independently is selected from hydrogen, deuterium, halogen, a hydroxyl group, a cyano group, a nitro group, an C₁-C₆₀ amidino group, a hydrazino group, a hydrazono group, C₁-C₆₀ alkyl group, C₁-C₆₀ alkoxy group, C₃-C₆₀ cycloalkyl group, C₁-C₆₀ heterocycloalkyl group, C₃-C₆₀ cycloalkenyl group, C₁-C₆₀ heterocycloalkenyl group, C₃-C₆₀ cycloalkynyl group, C₁-C₆₀ heterocycloalkynyl group, C₆-C₆₀ aryl group, C₅-C₆₀ aryloxy group, C₆-C₆₀ thioaryl group, C₁-C₆₀ heterothioaryl, C₁-C₆₀ heteroaryl group, a C₄-C₆₀ non-aromatic fused polycyclic group, C₁-C₆₀ non-aromatic fused heteropolycyclic group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁),-P(=O)(Q₃₁)(Q₃₂), and deuterated analogues thereof;
Q₃₁ to Q₃₃ each independently is selected from hydrogen, deuterium, halogen, a hydroxyl group, a cyano group, a nitro group, an C₁-C₆₀ amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₆₀ cycloalkyl group, a C₁-C₆₀ heterocycloalkyl group, a C₃-C₆₀ cycloalkenyl group, a C₁-C₆₀ heterocycloalkenyl group, C₃-C₆₀ cycloalkynyl group, C₁-C₆₀ heterocycloalkynyl group, a C₆-C₆₀ aryl group, a C₅-C₆₀ aryloxy group, a C₆-C₆₀ thioaryl group, a C₁-C₆₀ heteroaryl group, a C₁-C₆₀, heteroaryloxy group, a C₁-C₆₀ heterothioaryl group, a C₄-C₆₀ non-aromatic fused polycyclic group, a C₁-C₆₀ non-aromatic fused heteropolycyclic group, and deuterated analogues thereof;
the compounds from MC-1 to MC-10 are: 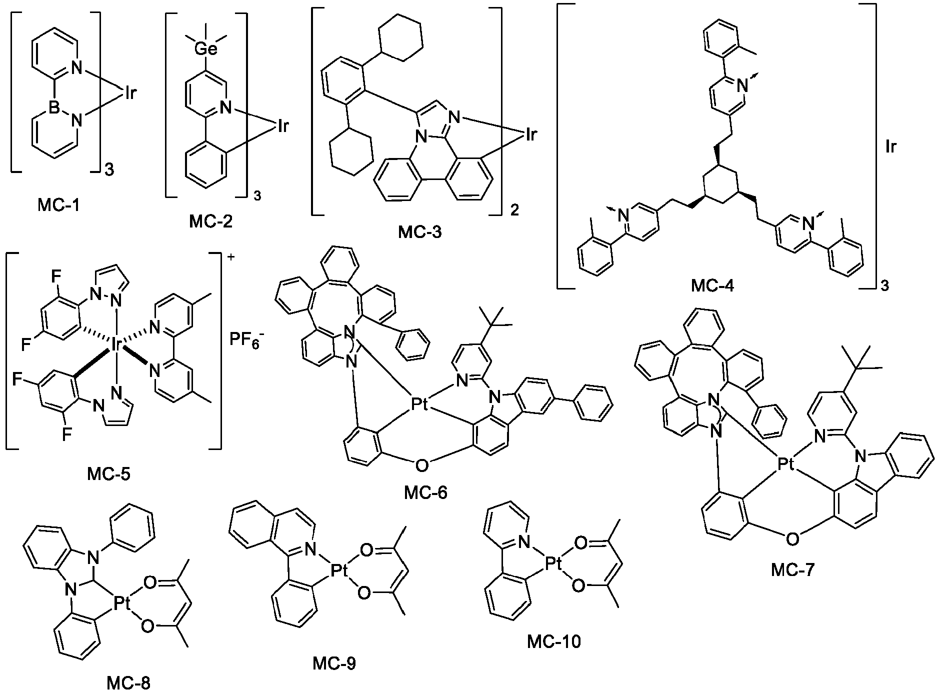 and deuterated analogues thereof.

5. An organic light emitting diode according to claim 4, wherein the organometallic iridium or platinum complex is selected from: 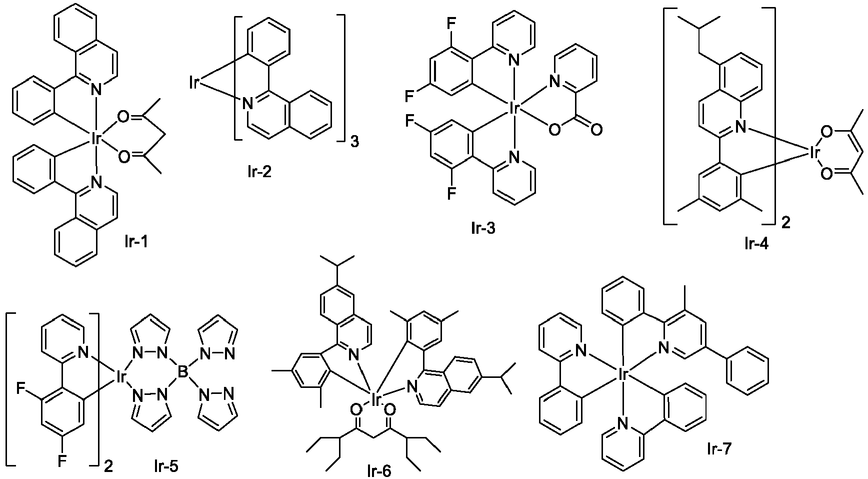 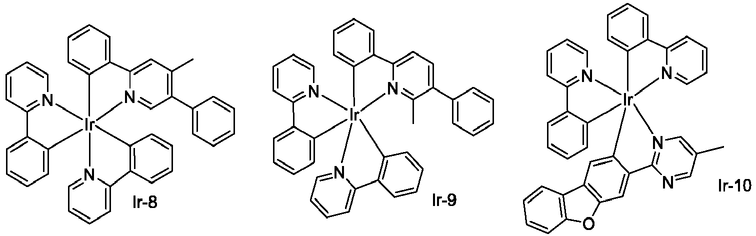 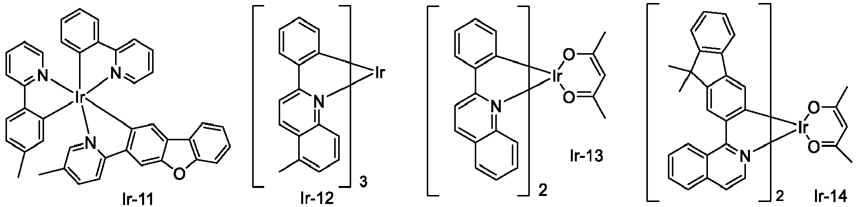 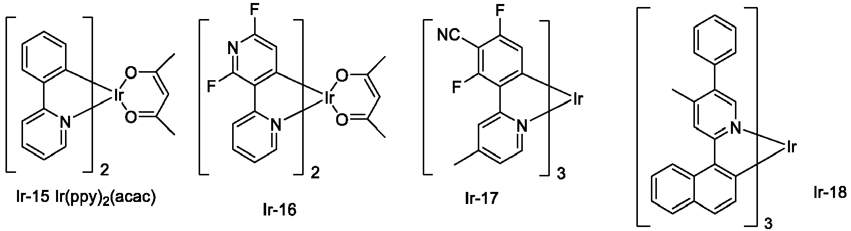 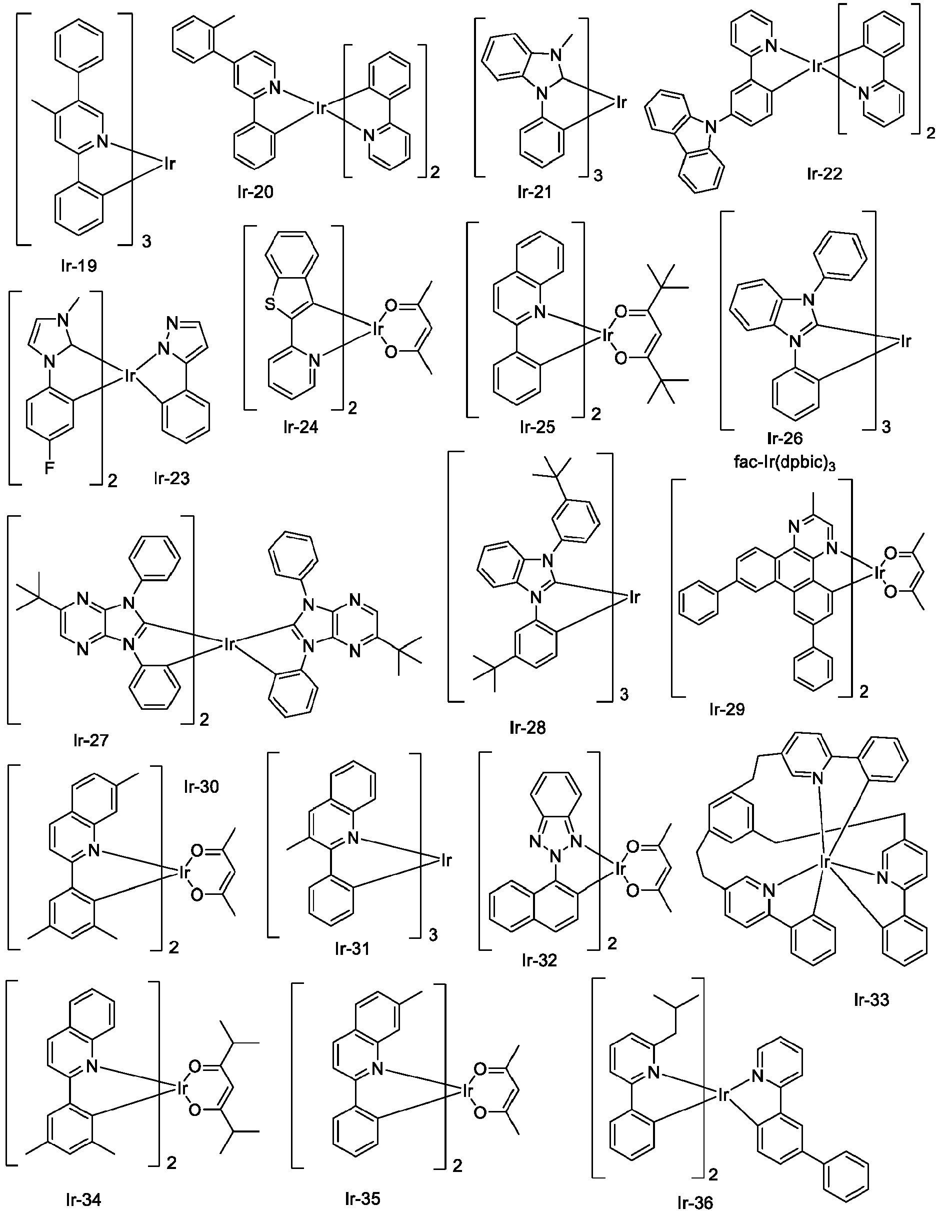 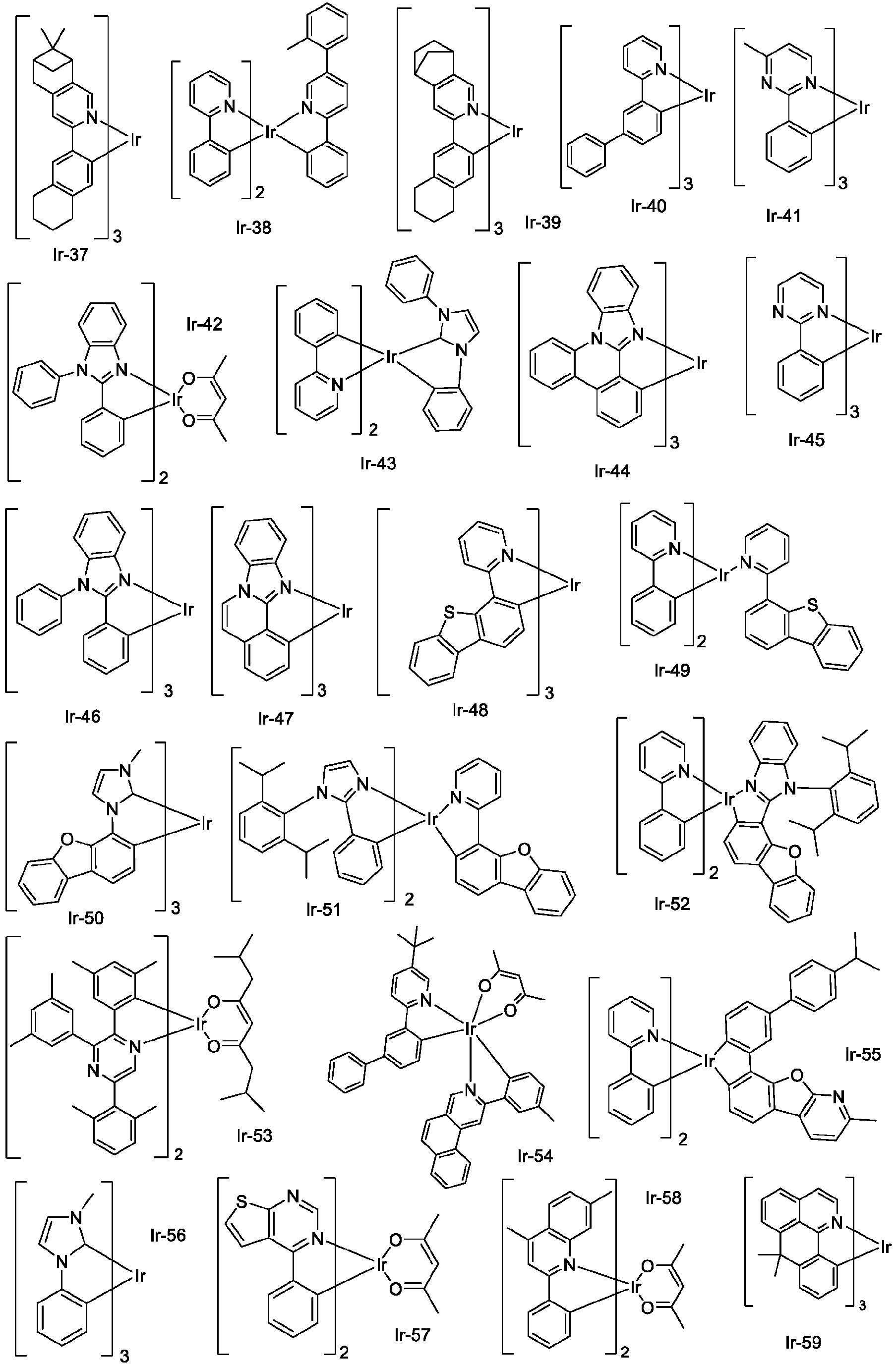 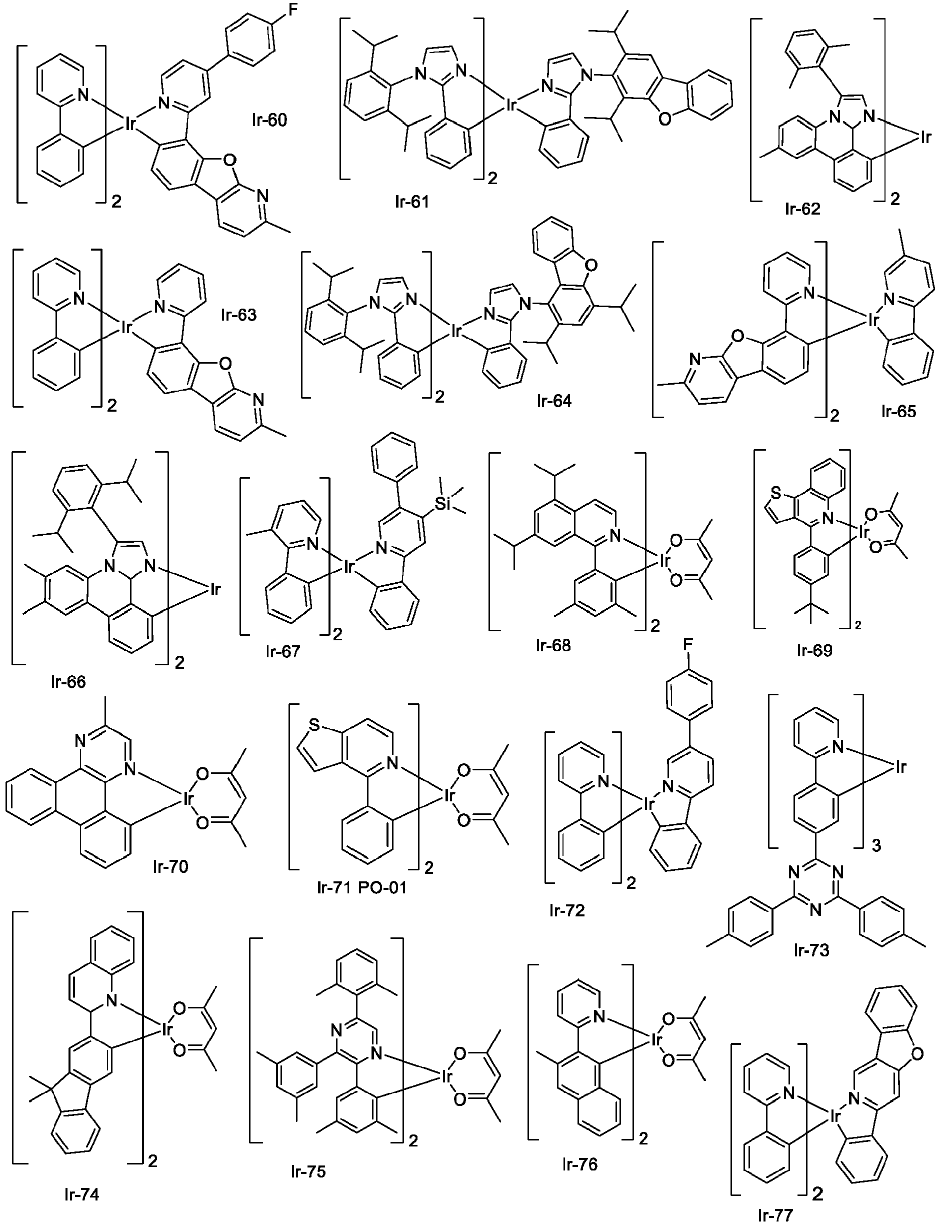 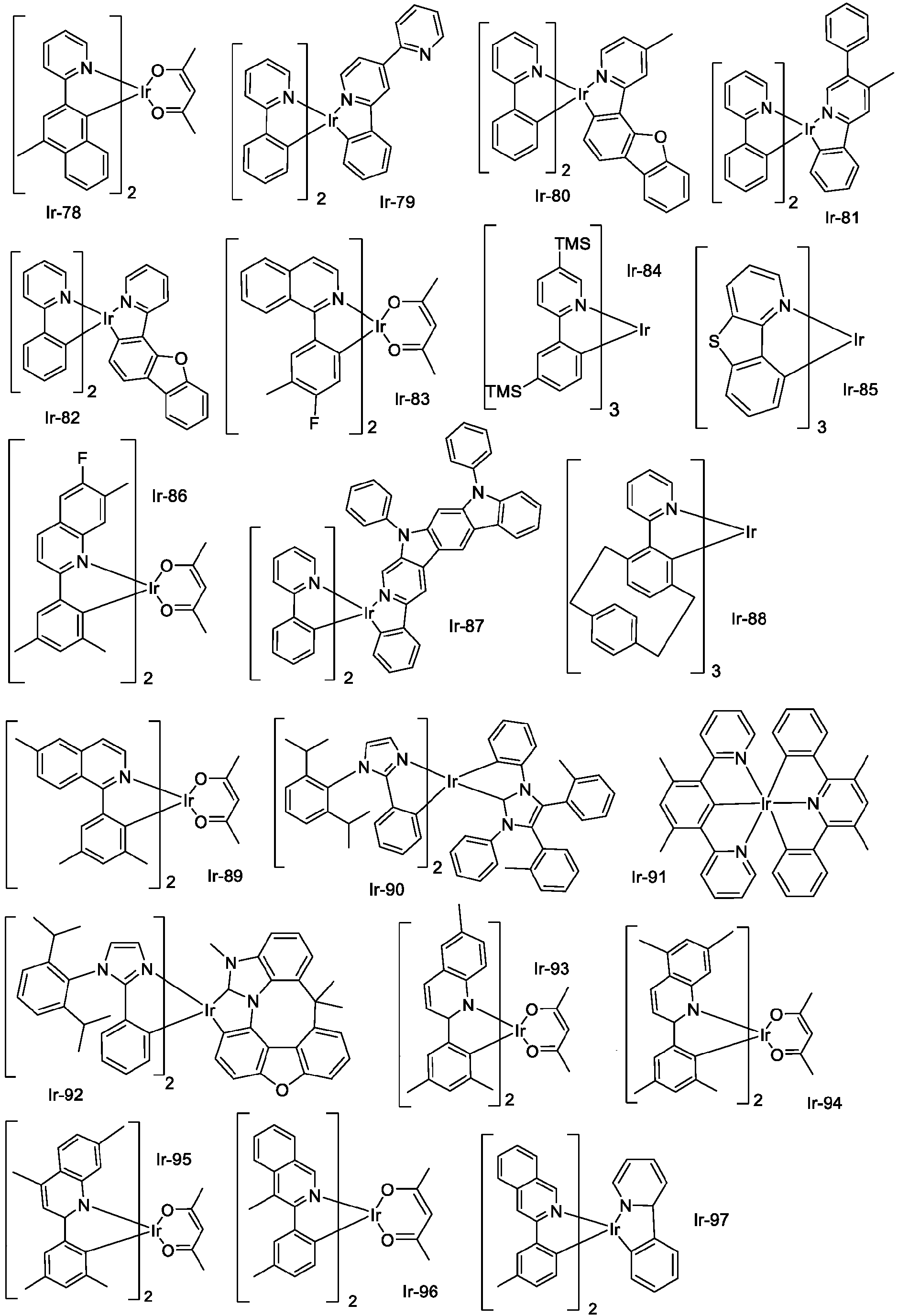 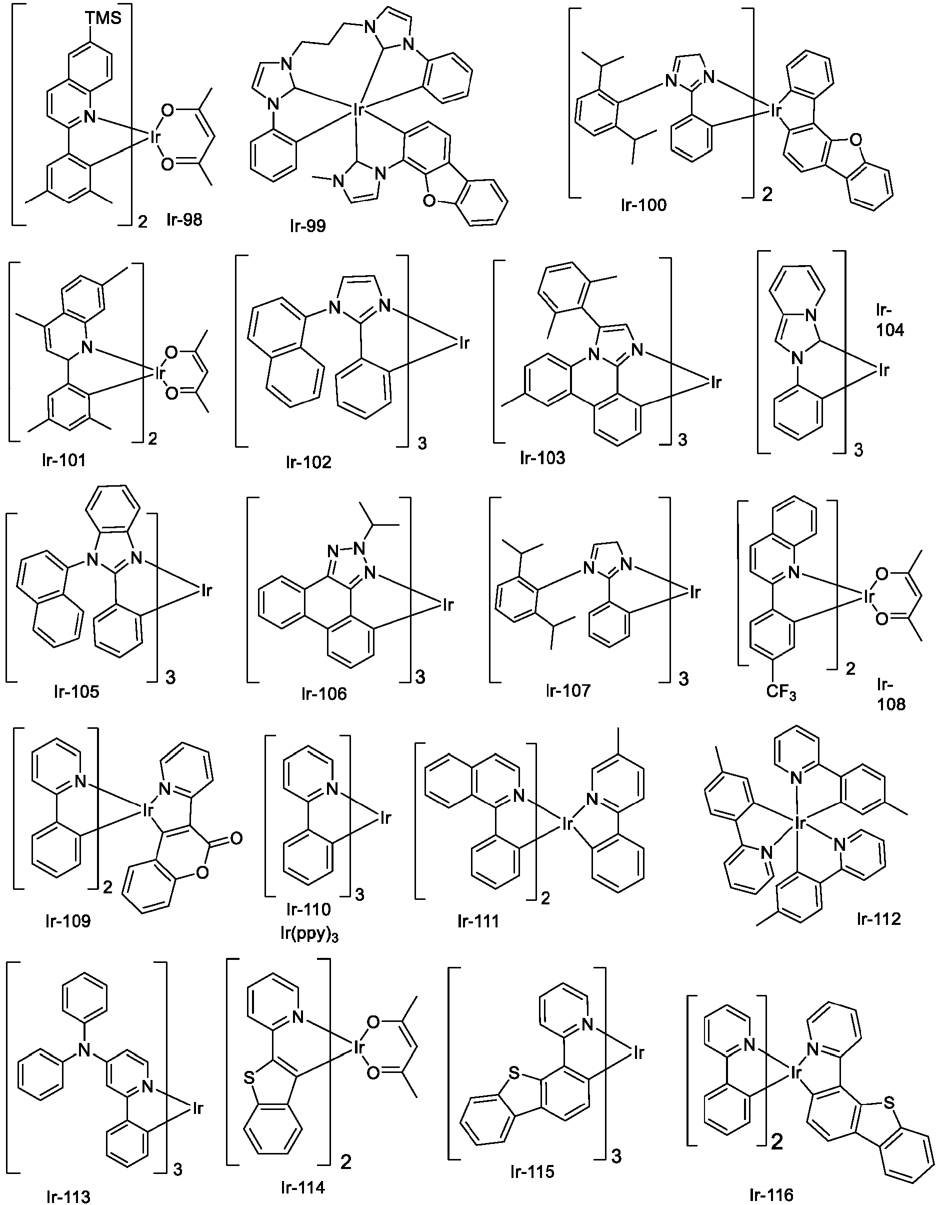 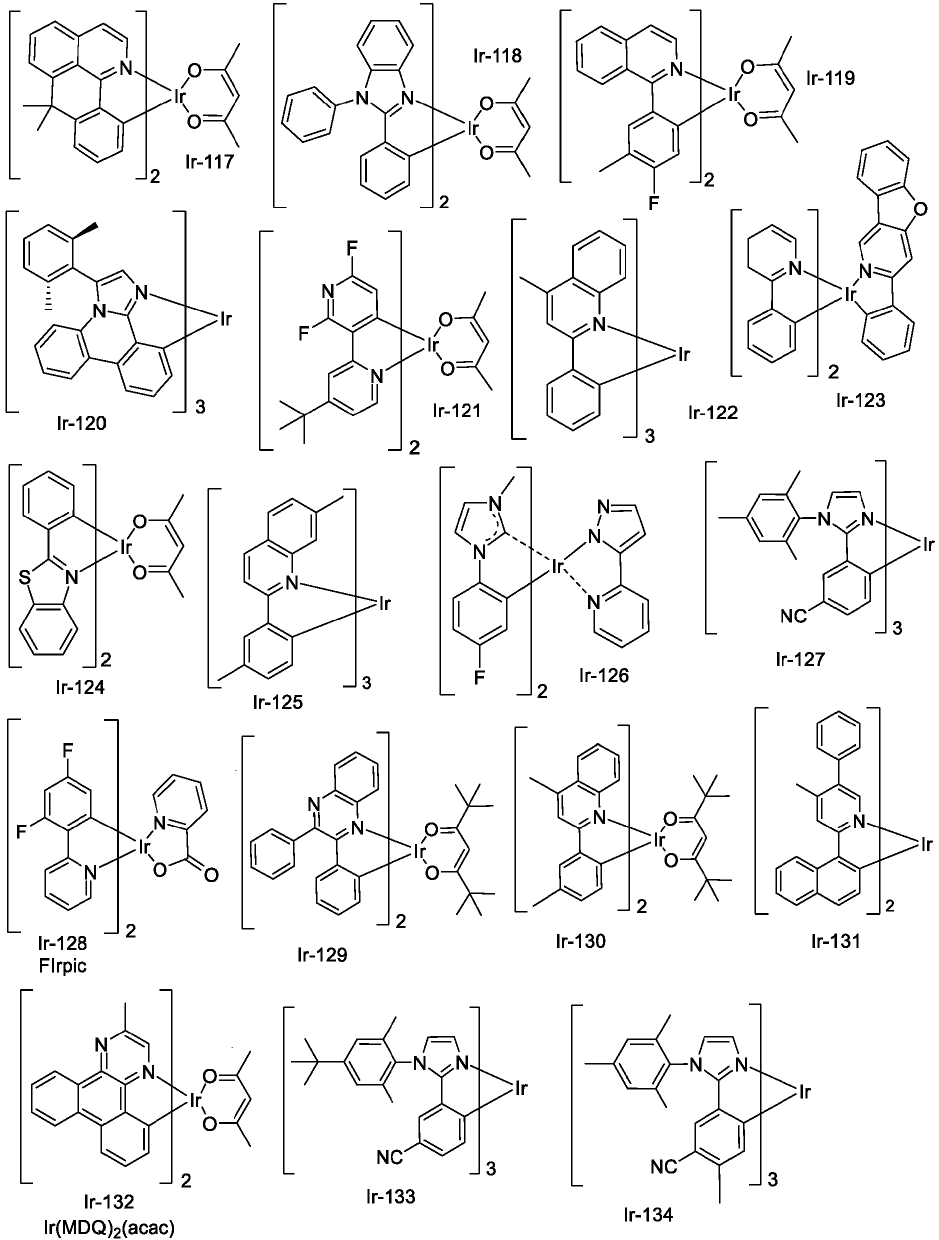 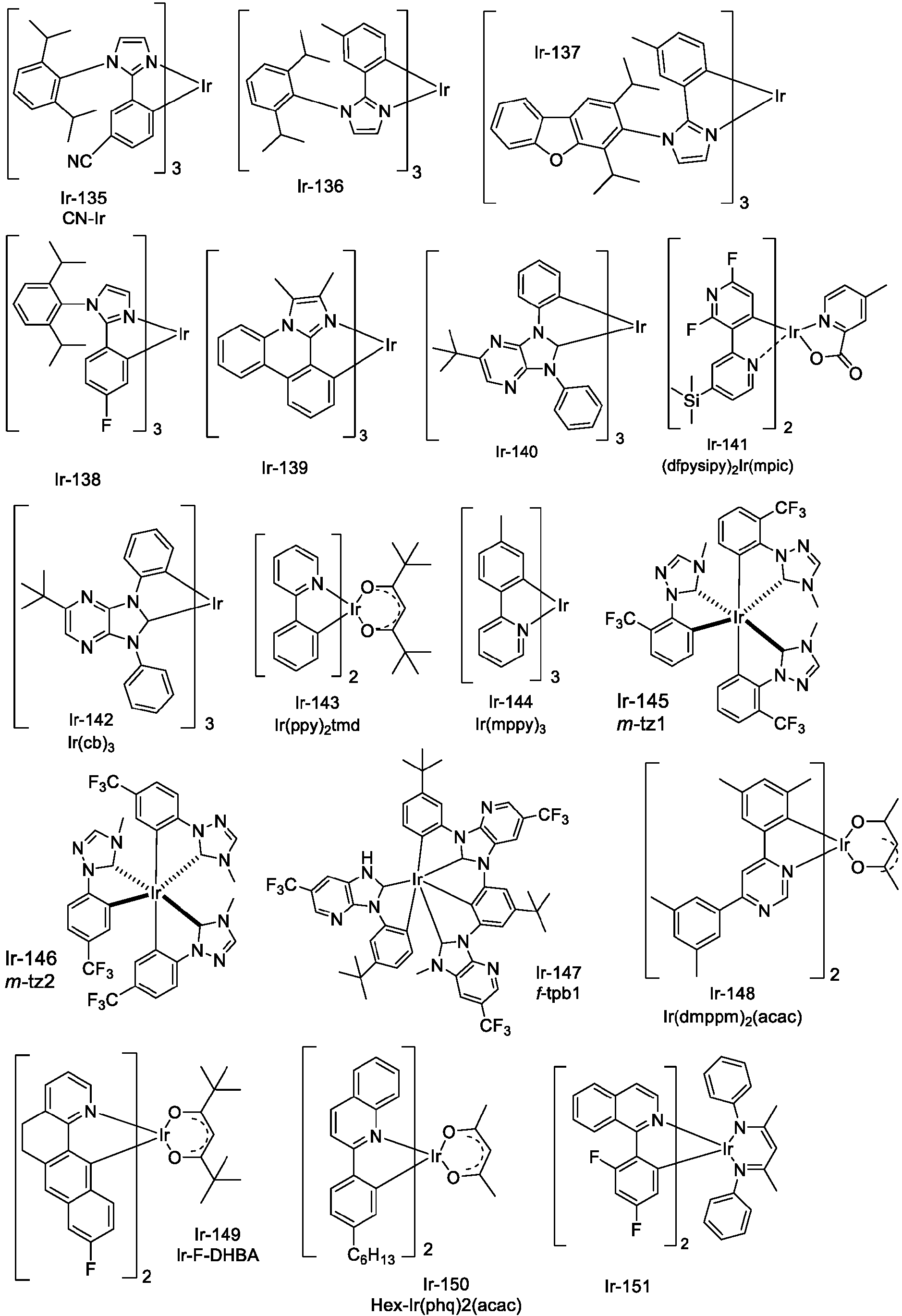 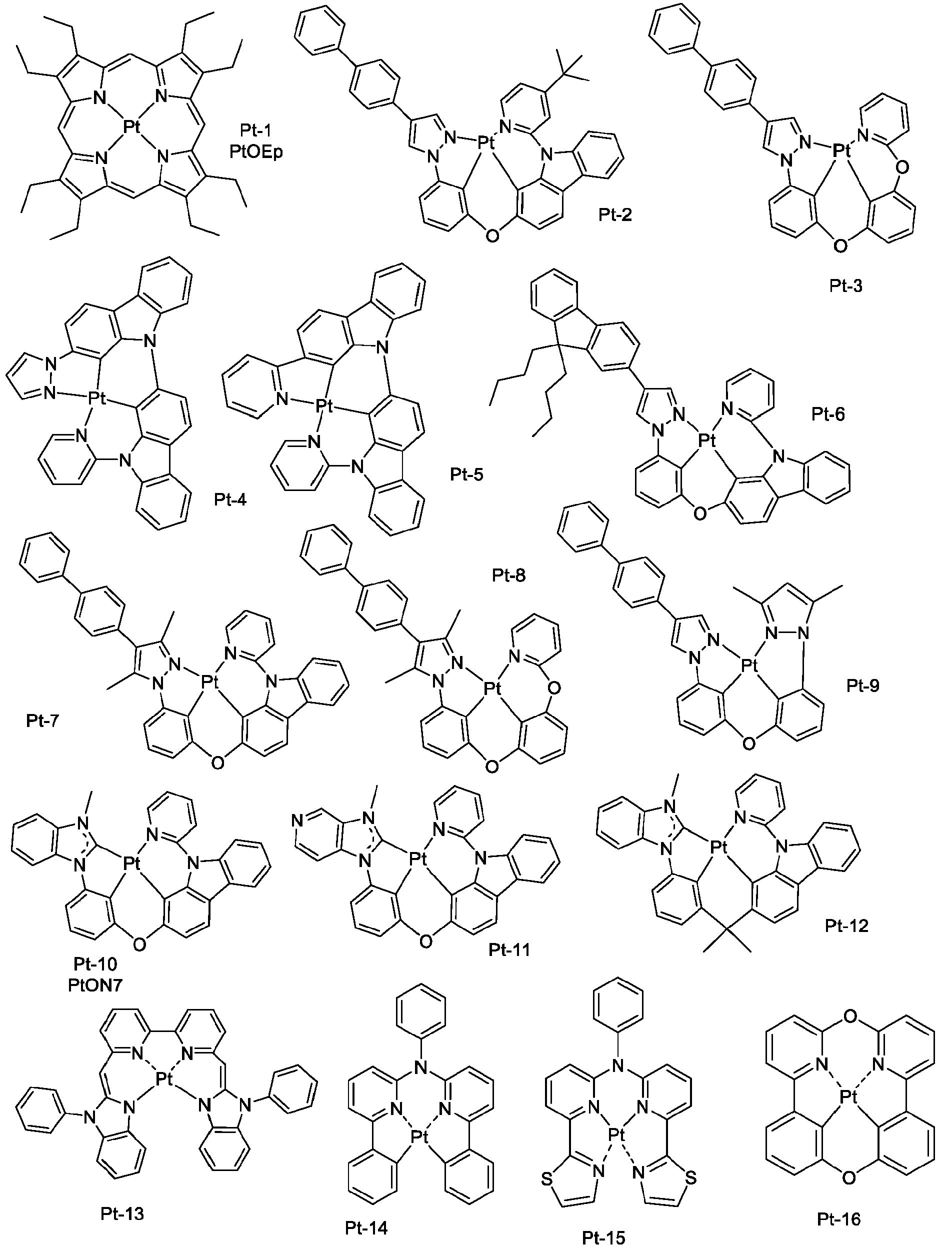 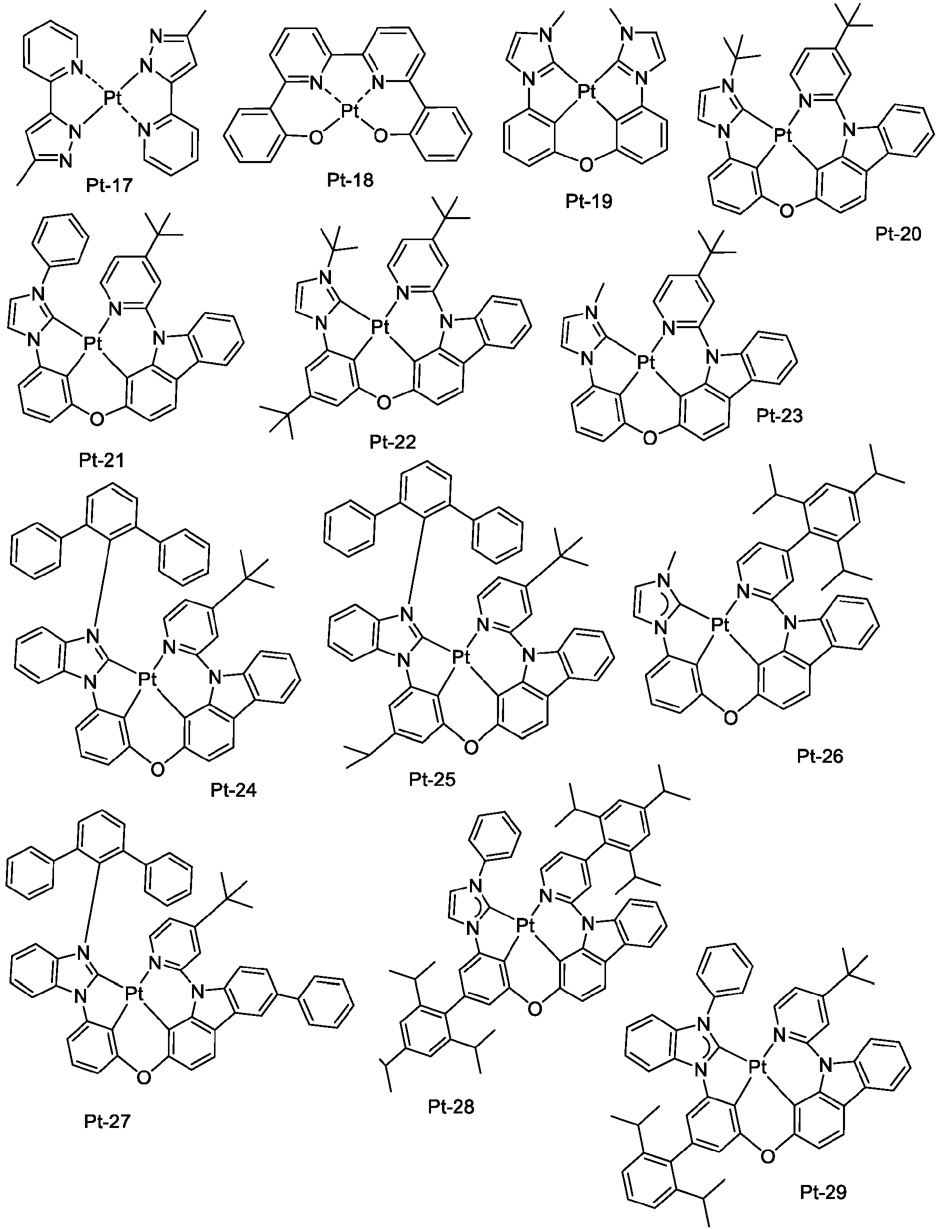 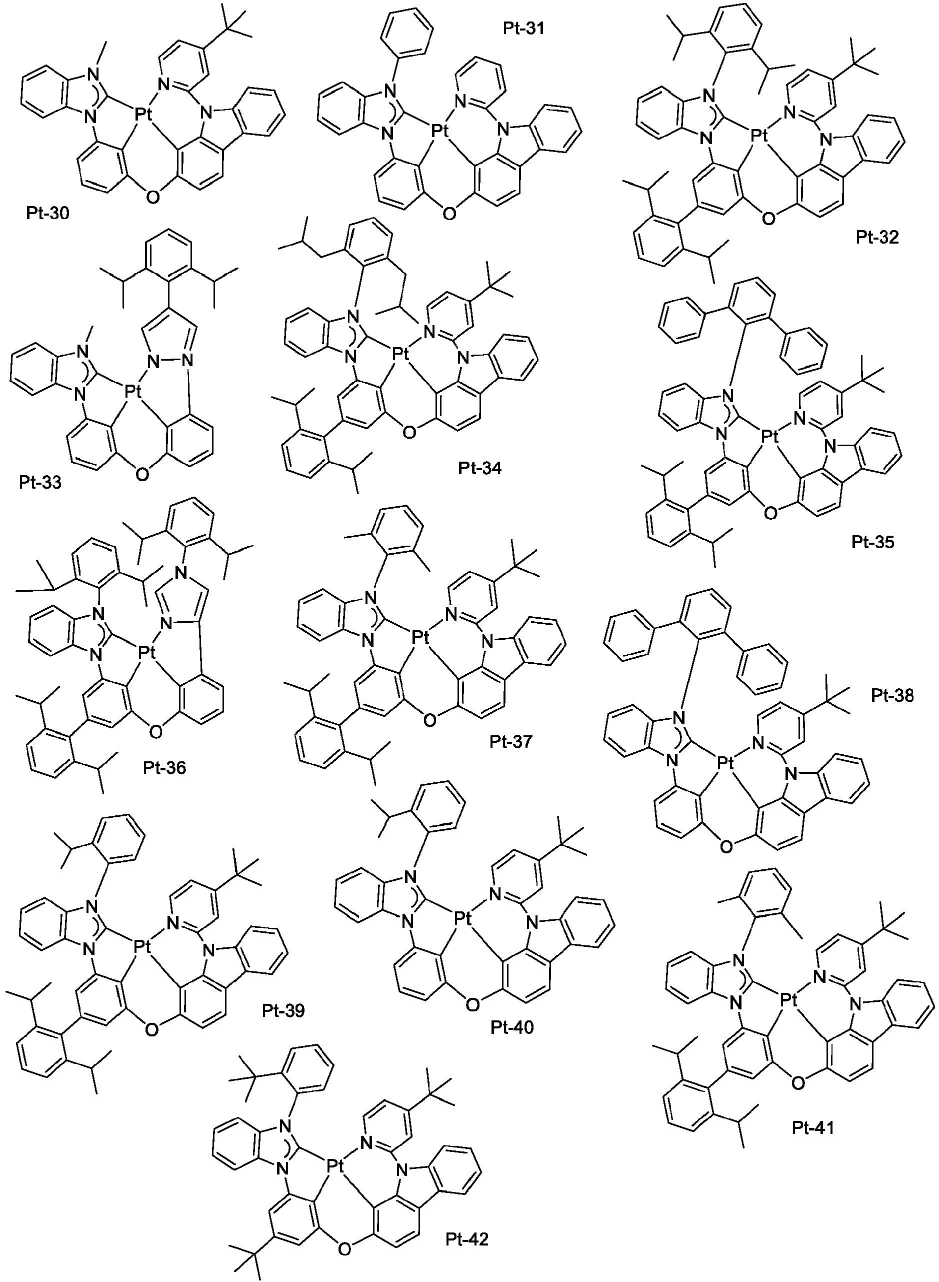 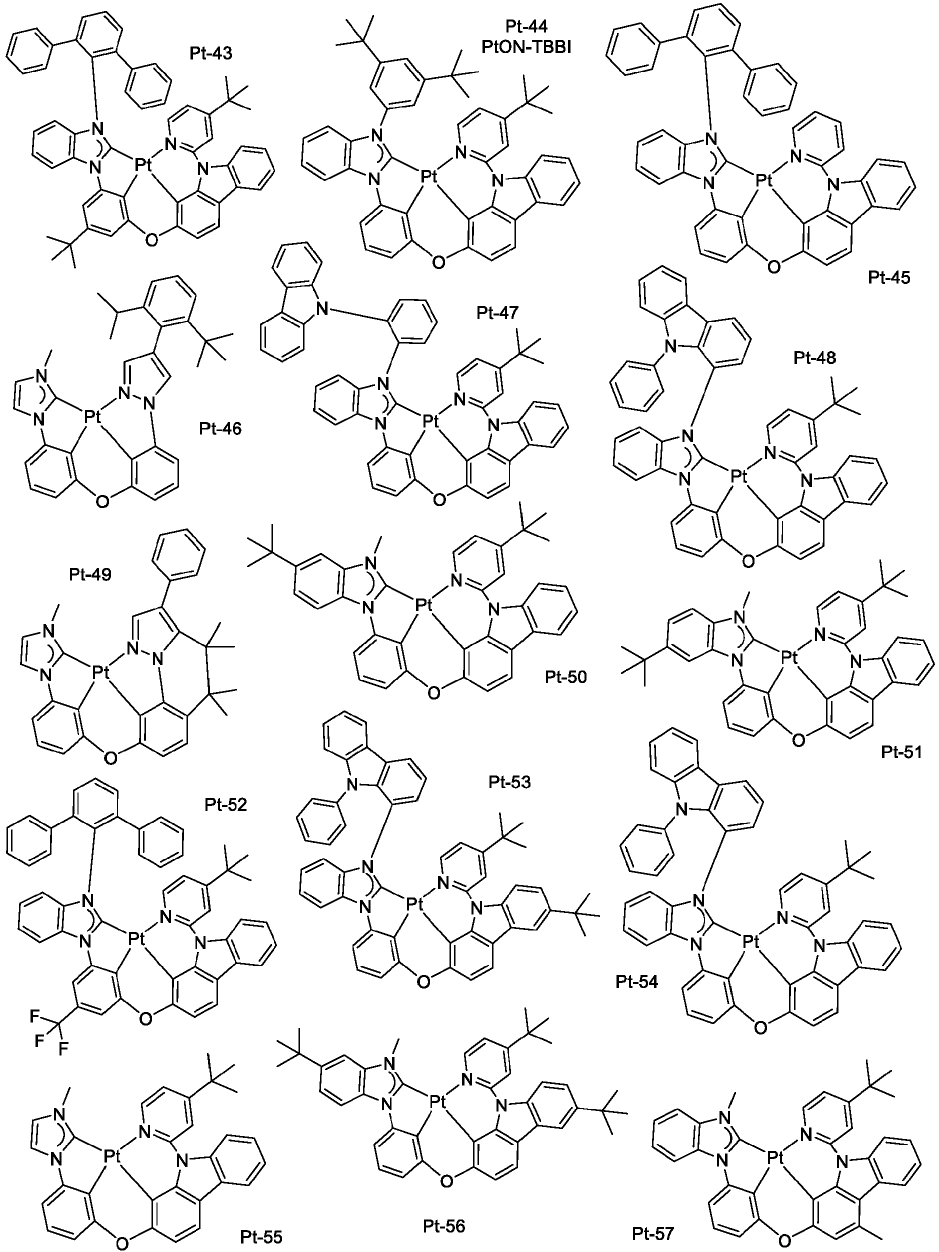 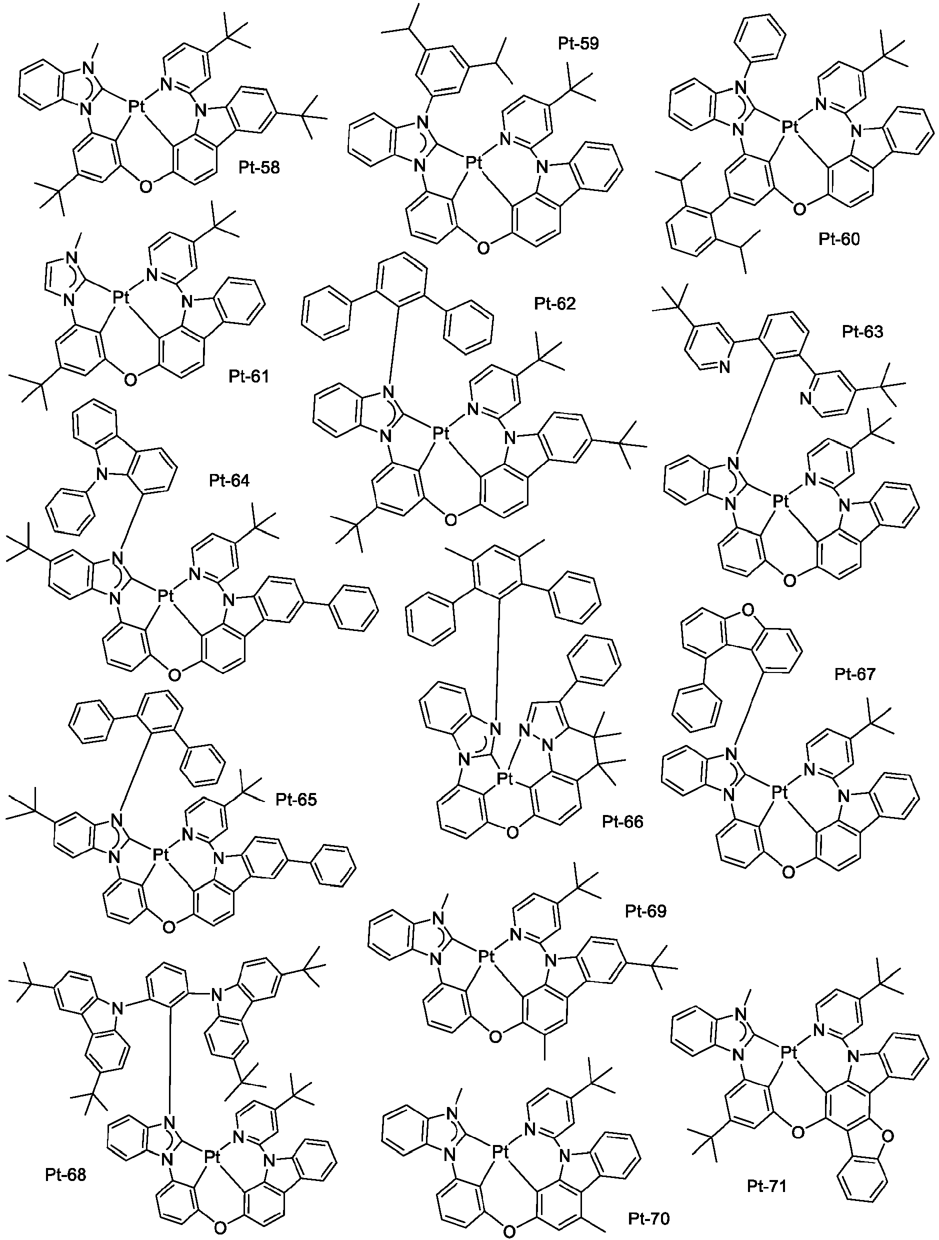 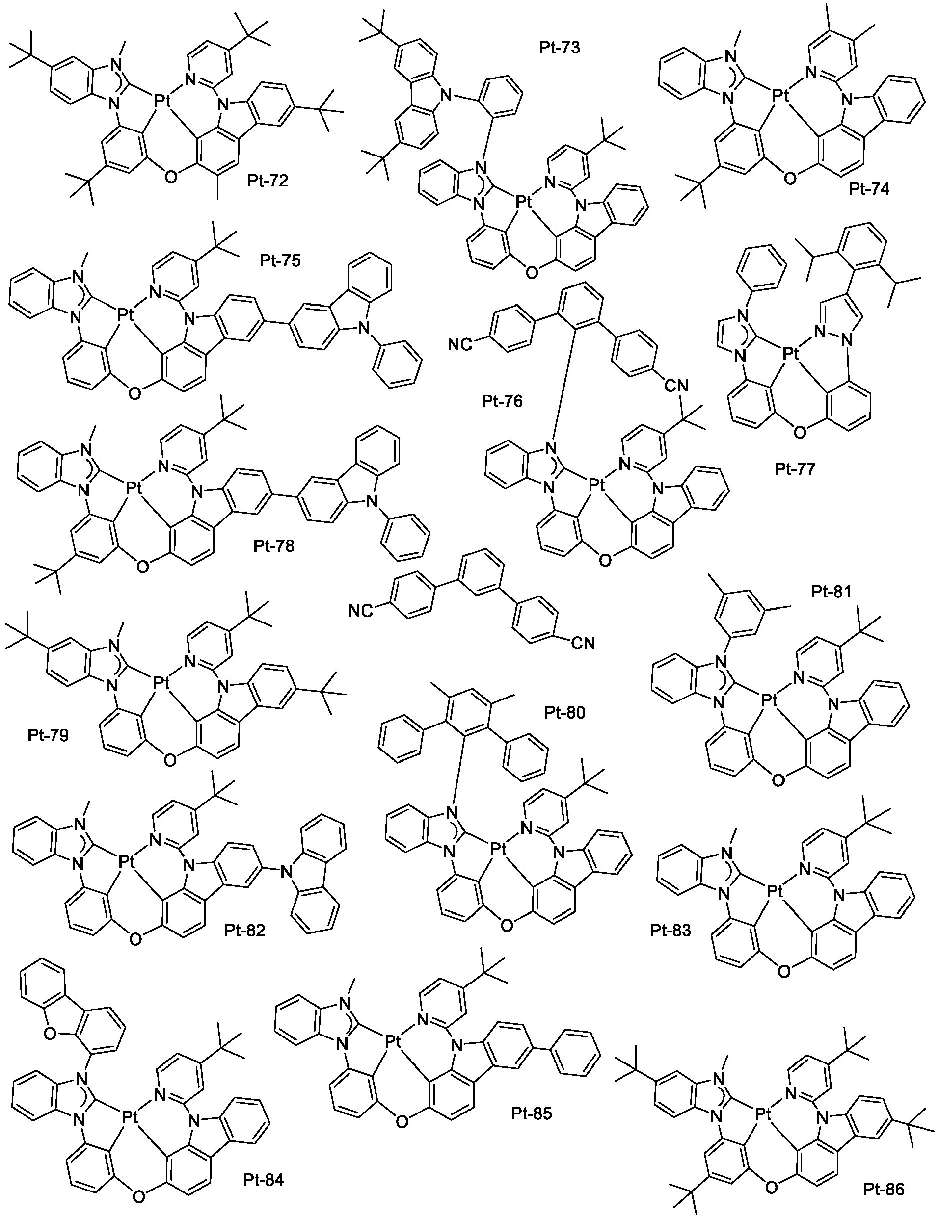 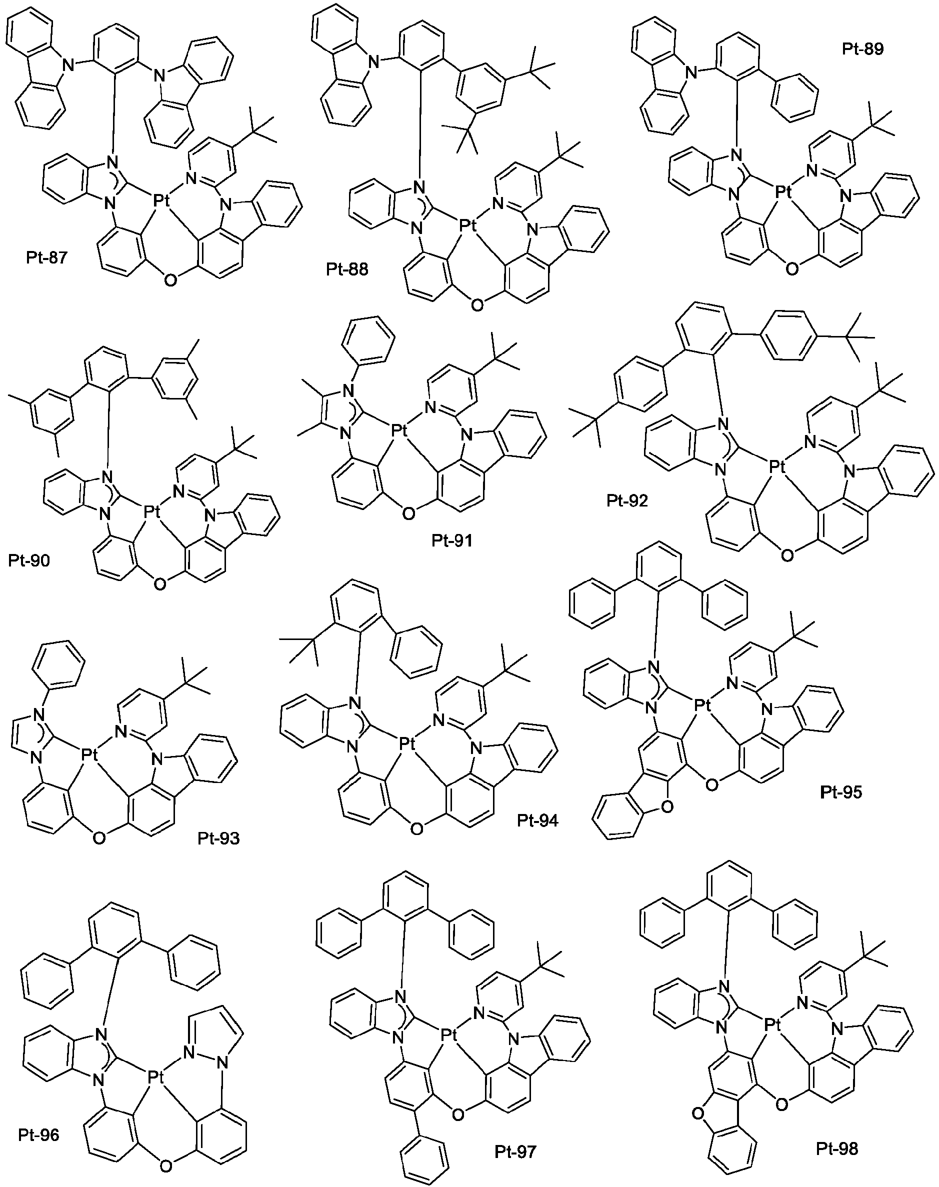 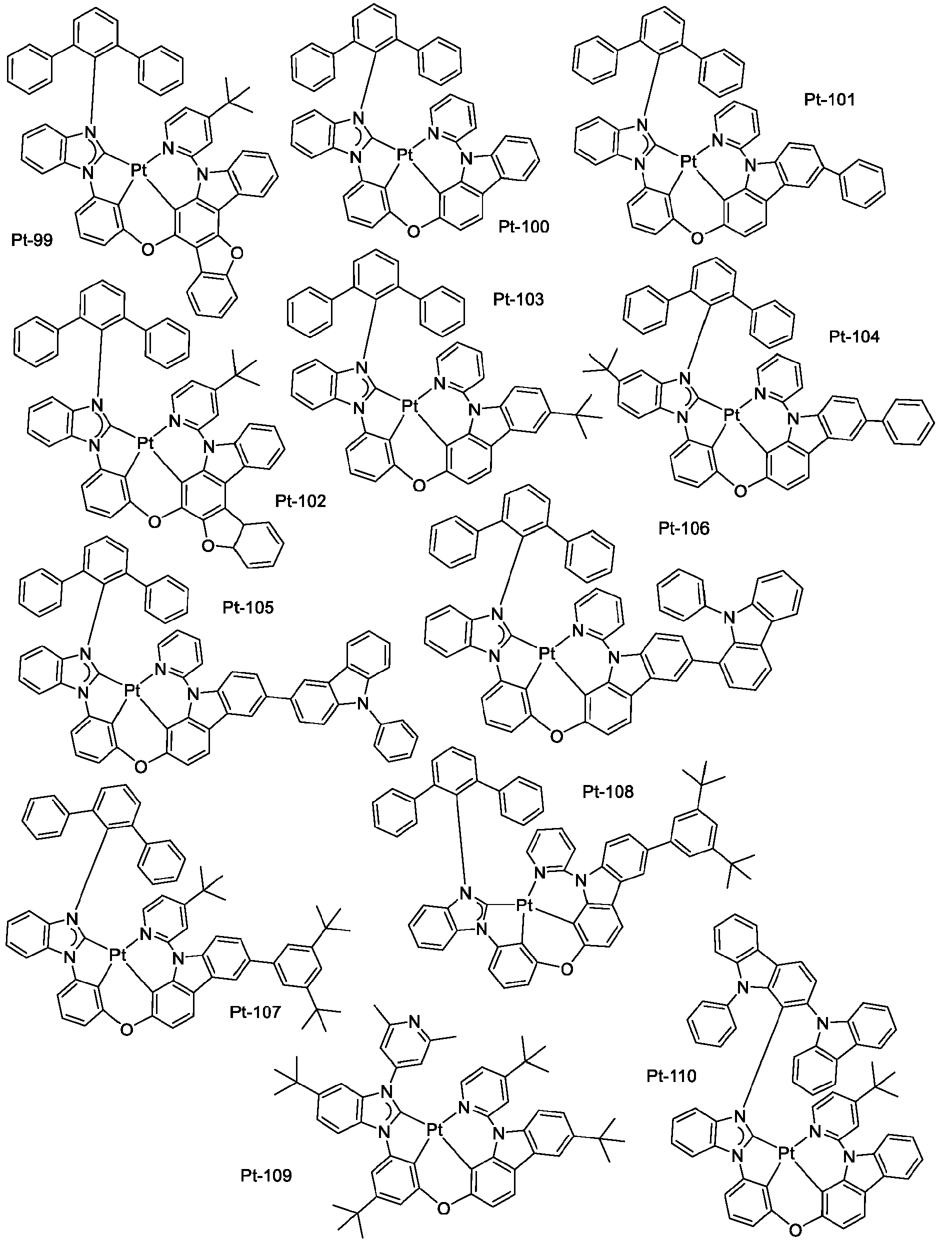 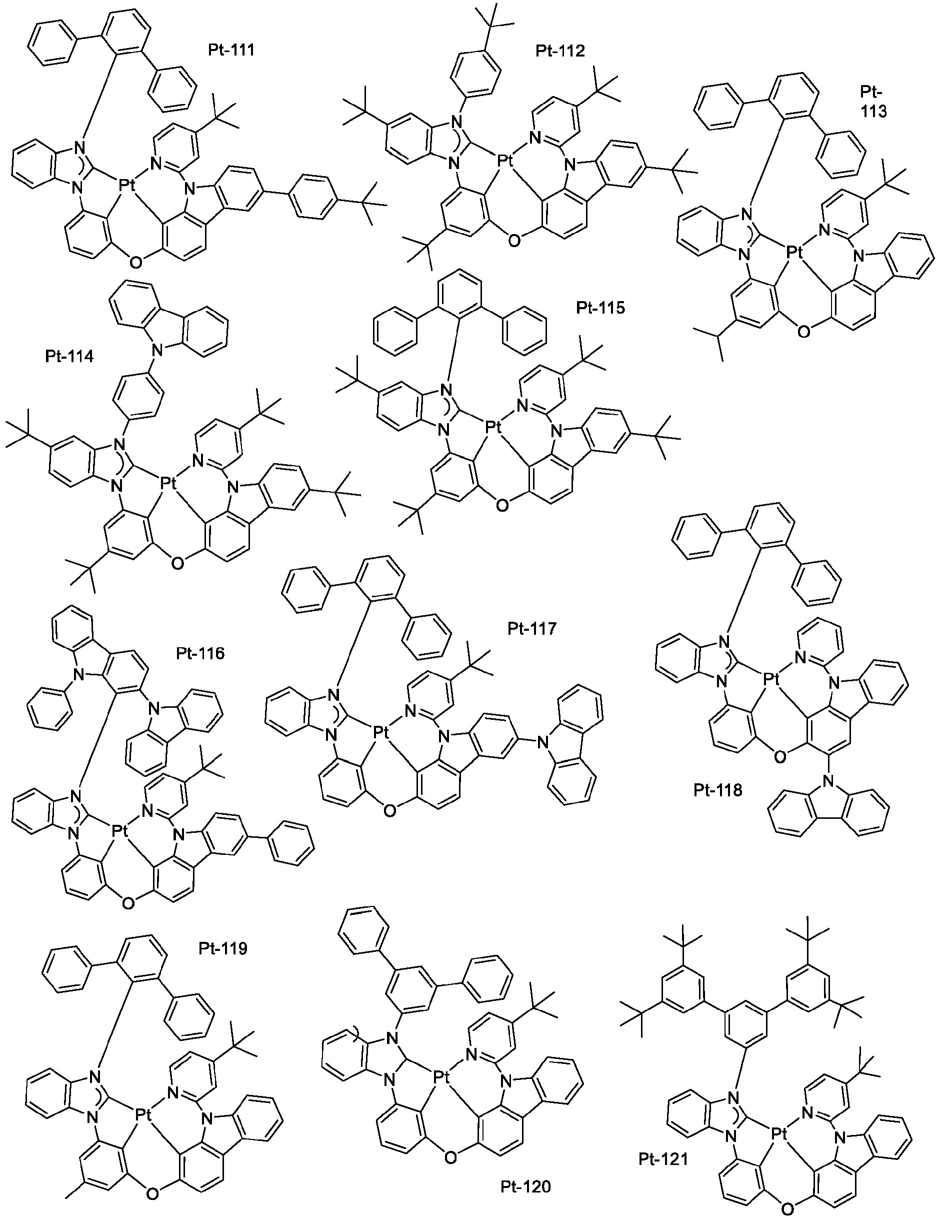 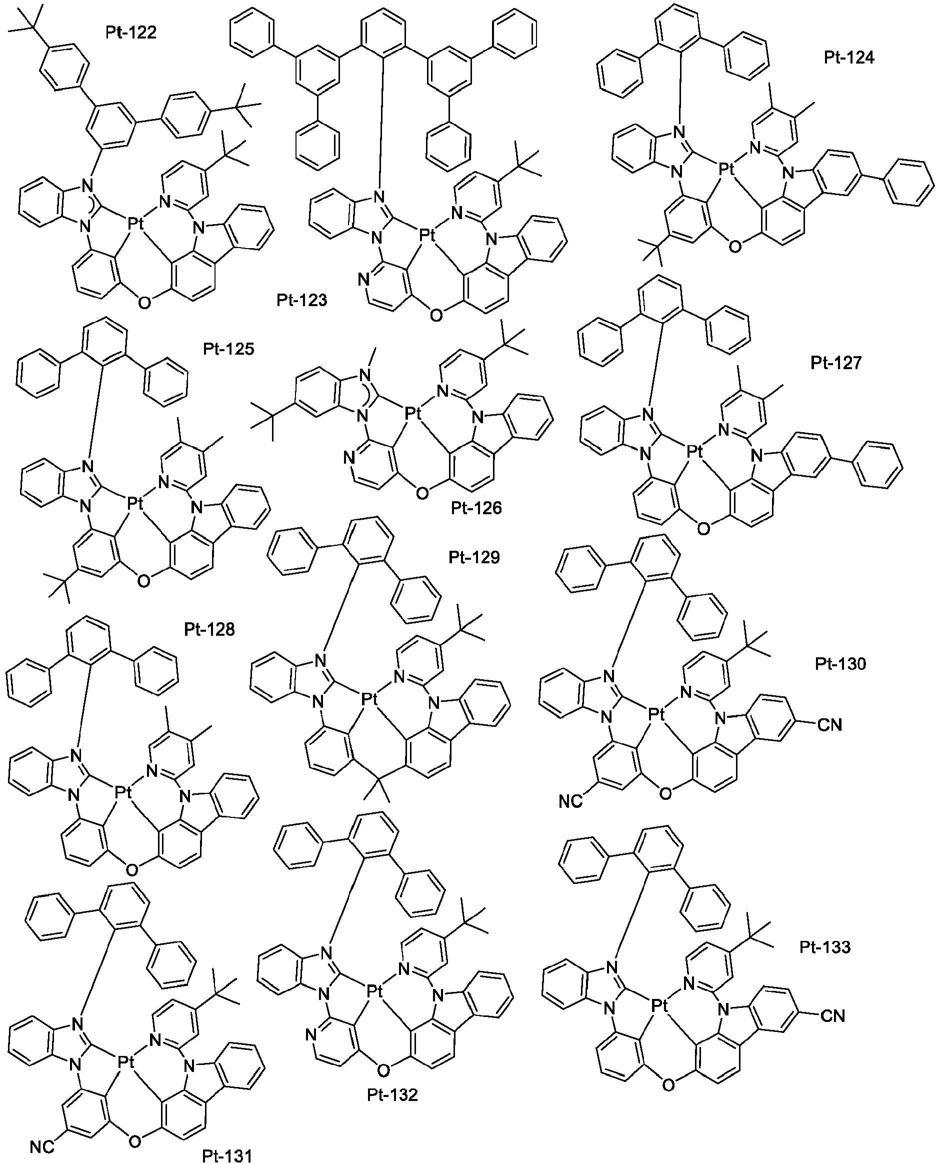 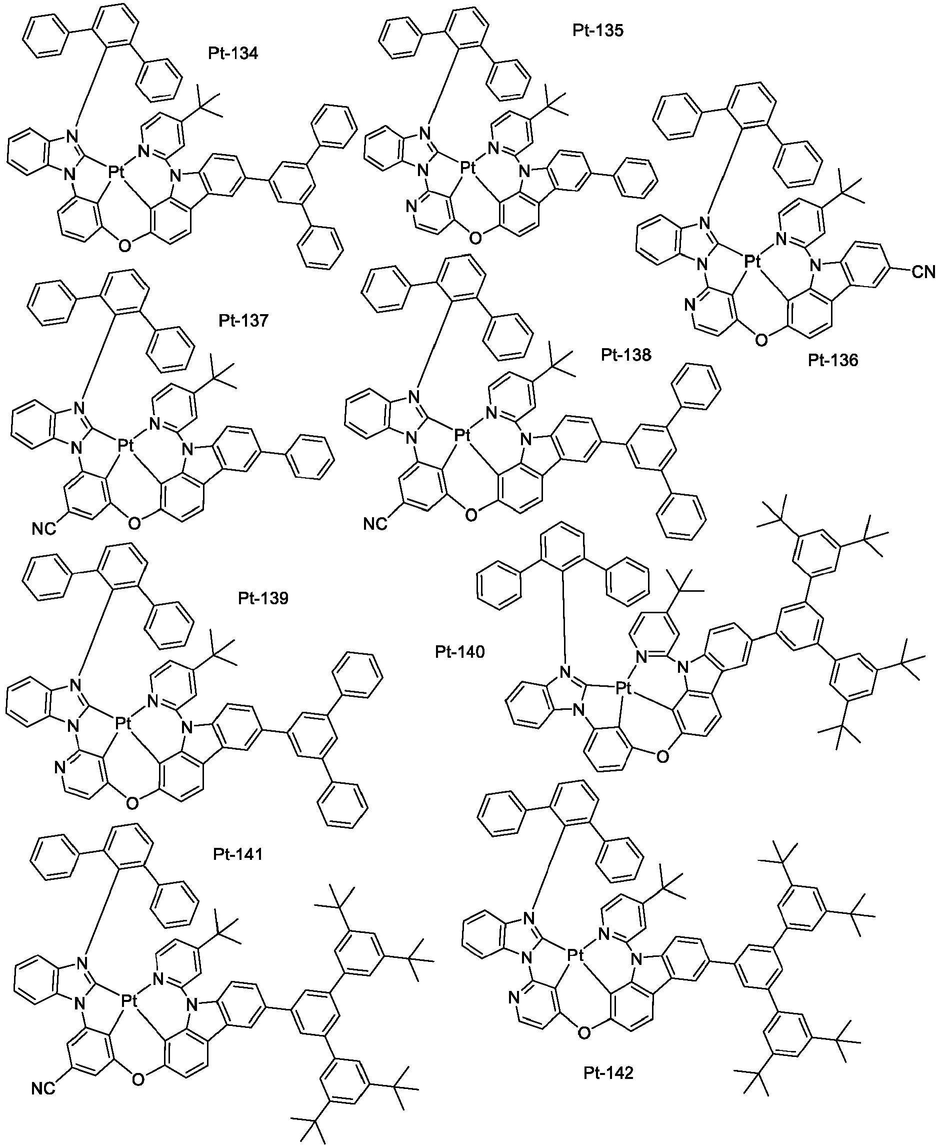 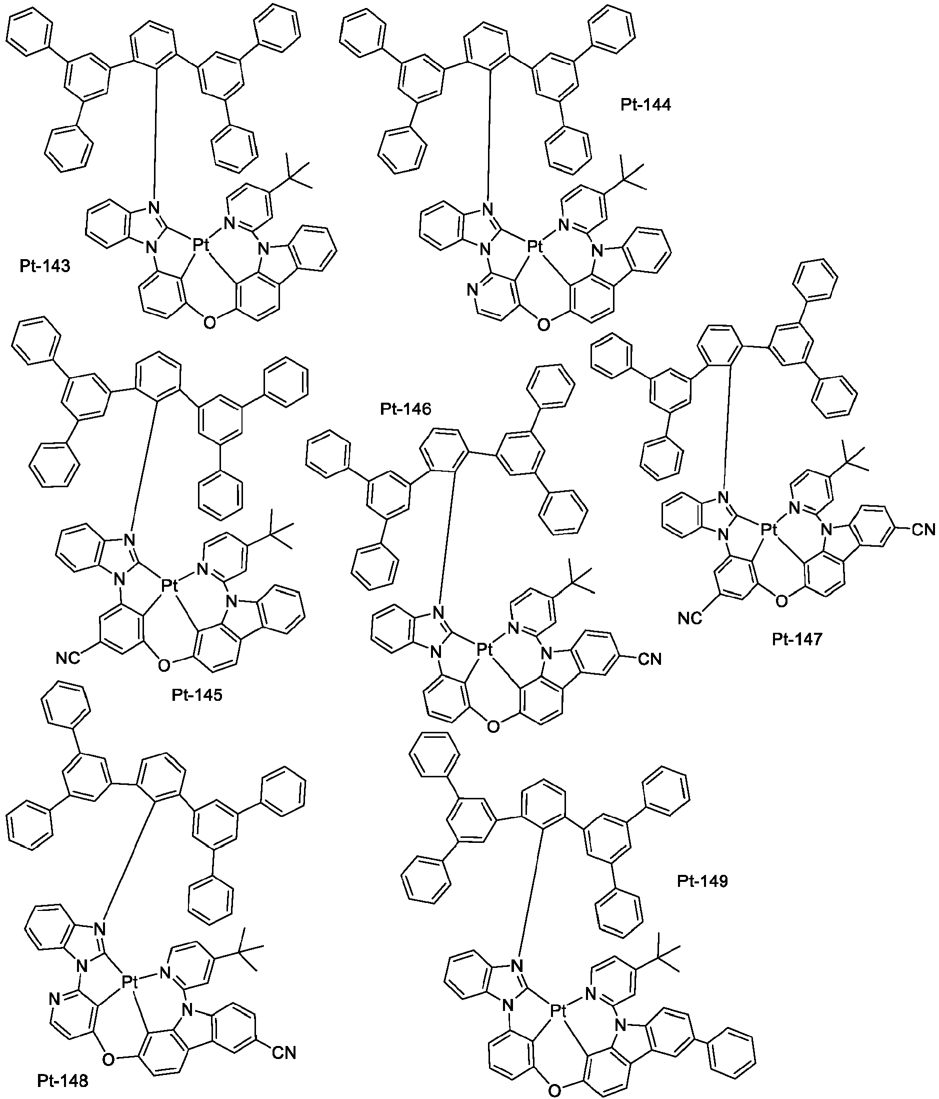 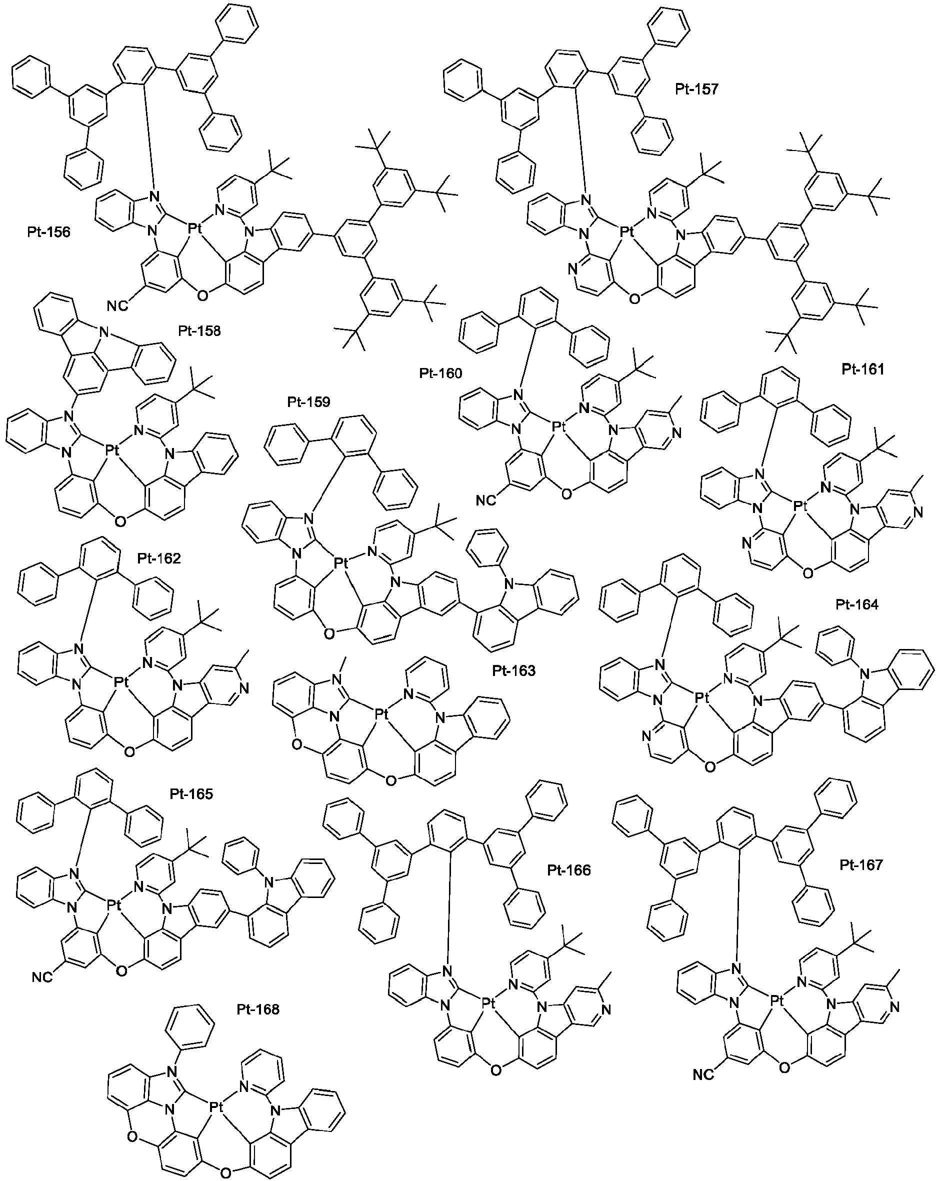 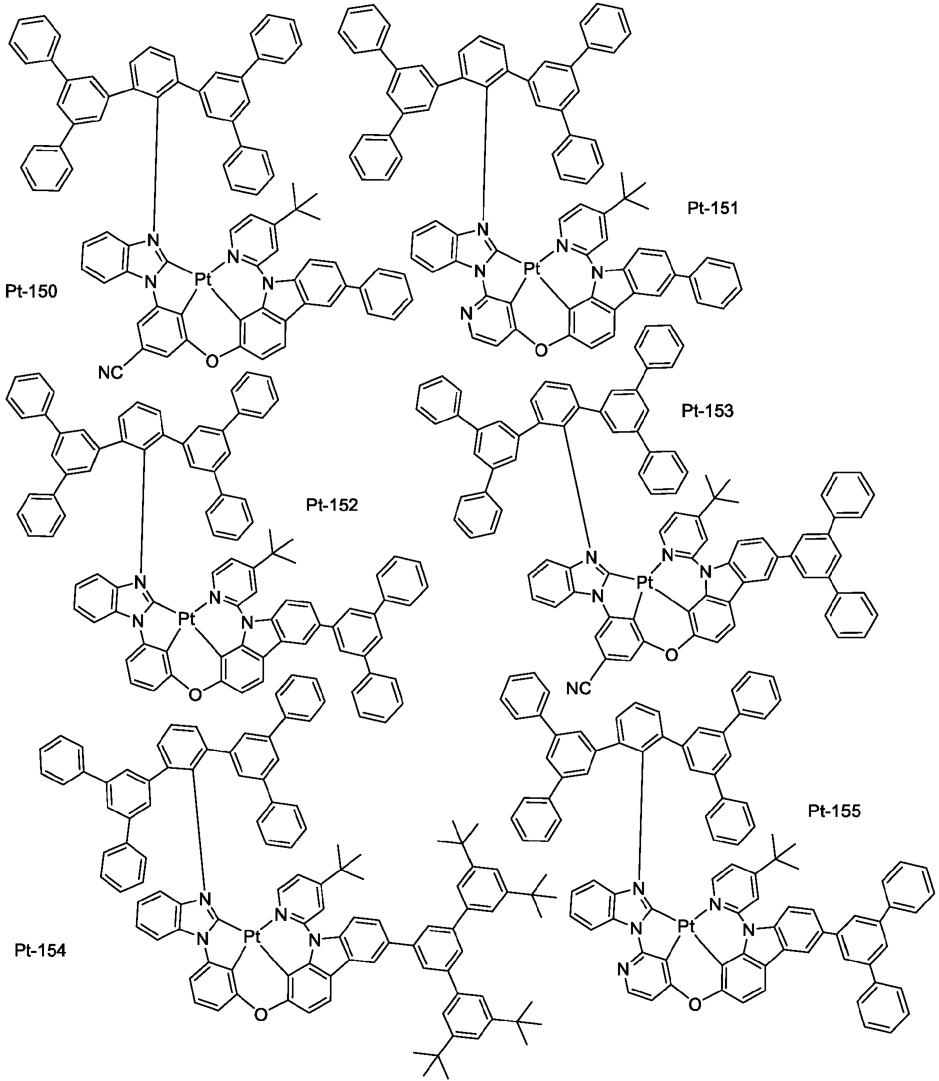 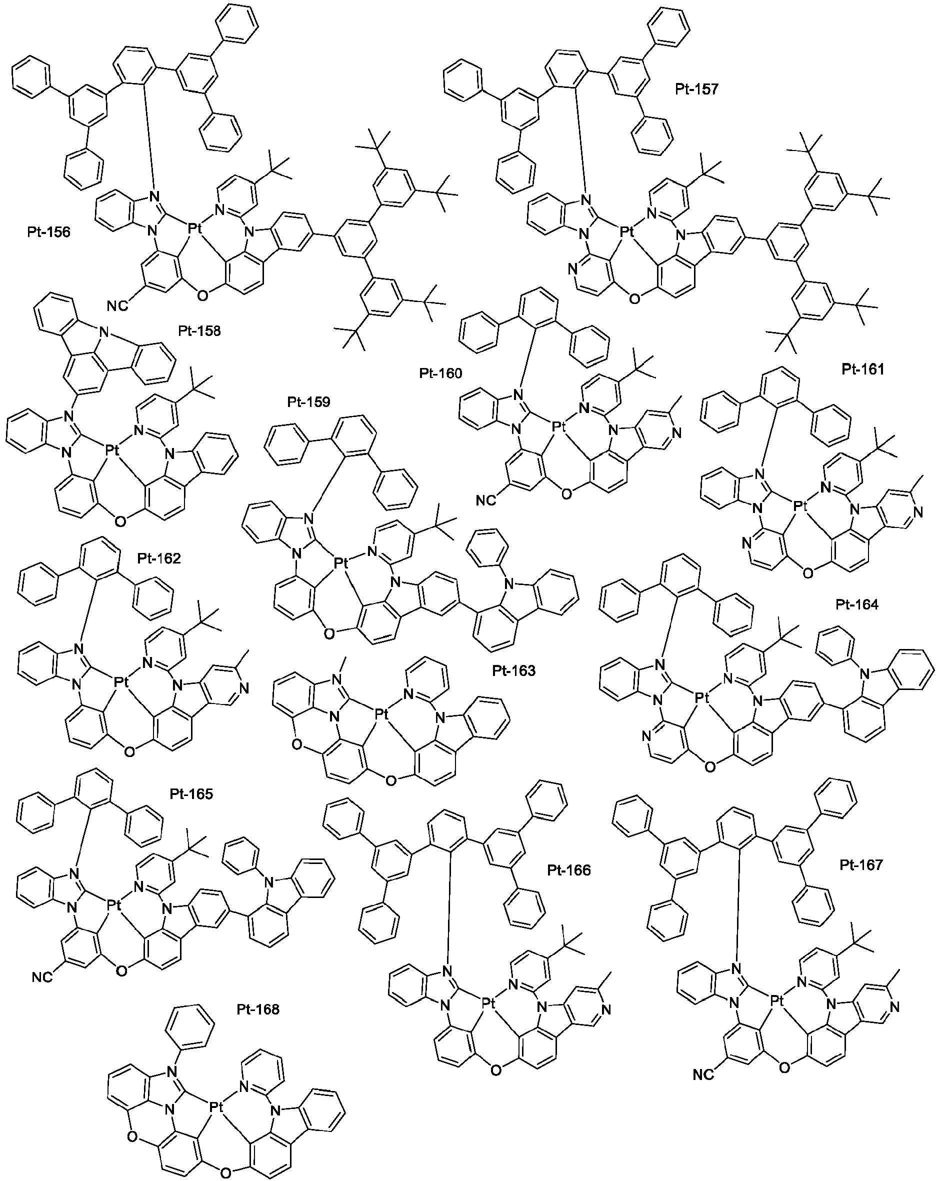 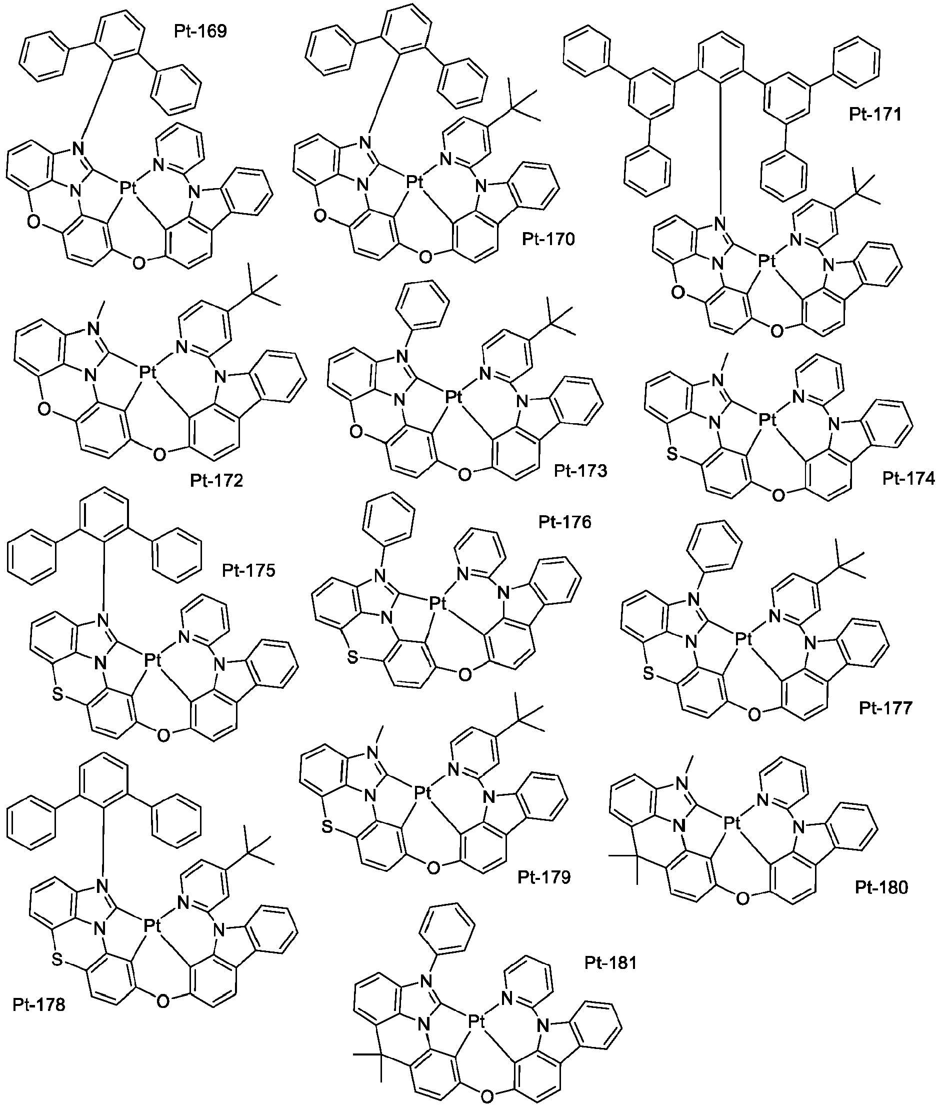 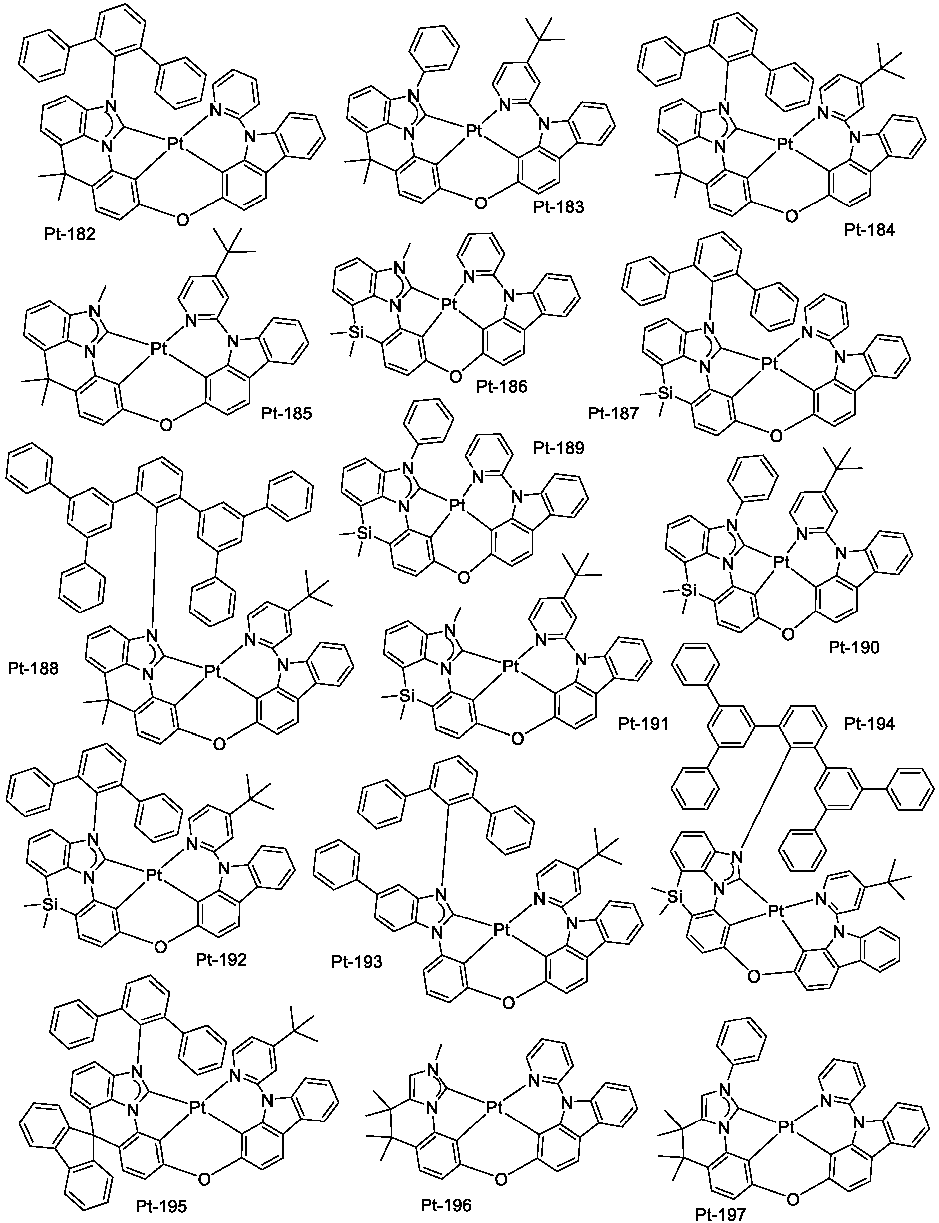 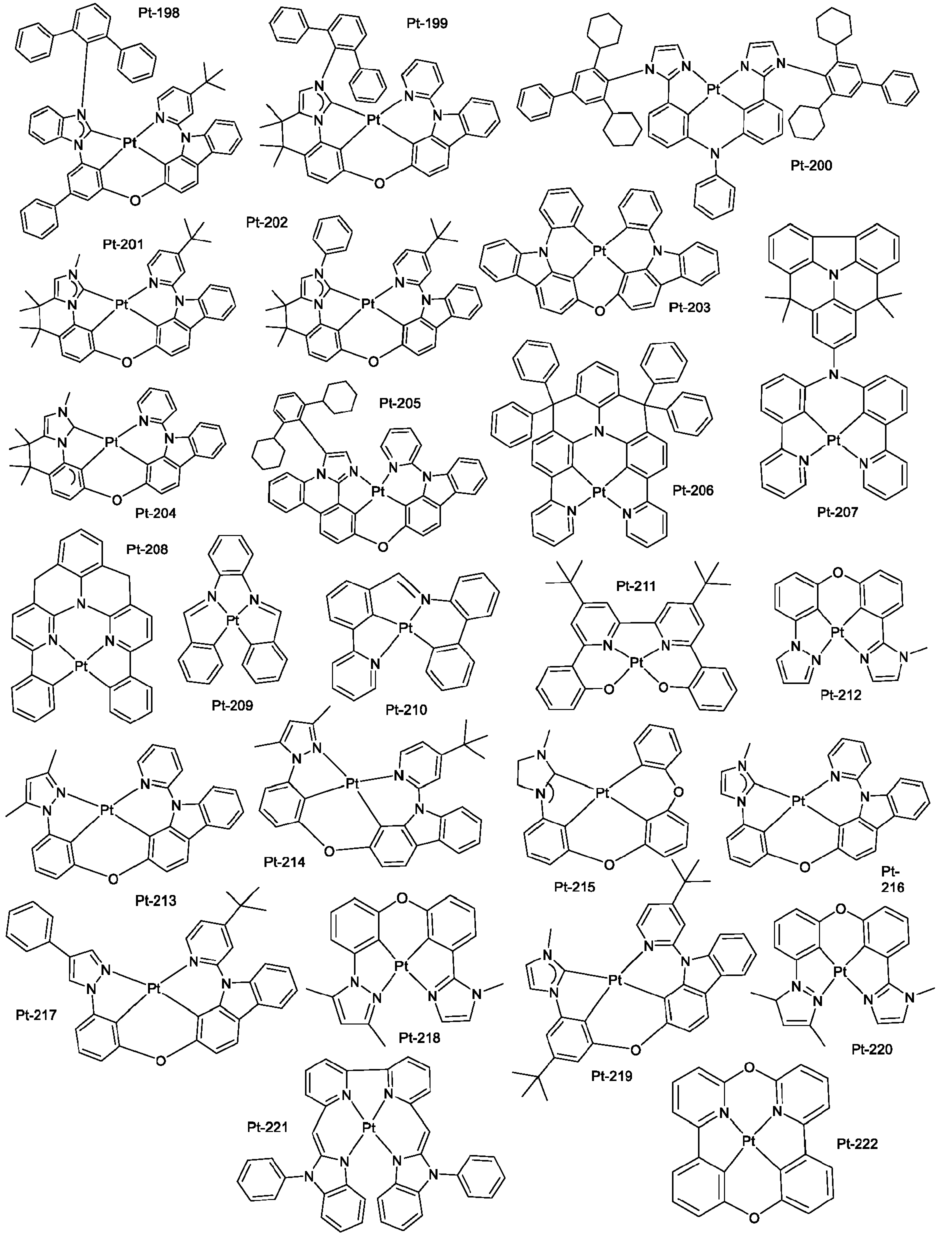 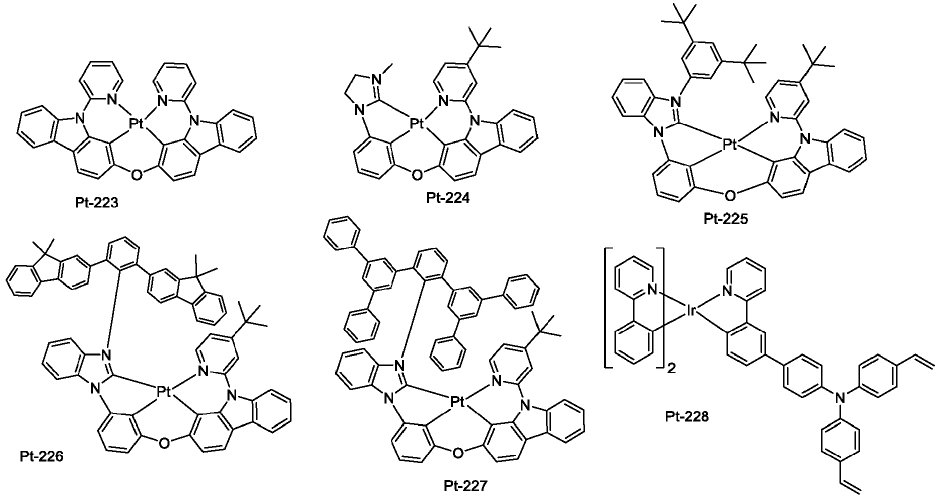 and deuterated analogues thereof.

6. An organic light emitting diode according to any one of claims 3-5, comprising at least one auxiliary phosphorescent sensitizer, preferably the auxiliary phosphorescent sensitizer is selected from a compound according to Formula II, Formula III, or structures Ir-1 to Ir-151, Pt-1 to Pt-228, MC-1 to MC-10, and deuterated analogues thereof.

7. An organic light emitting diode according to any one of claims 3 - 6, wherein the host is selected from: 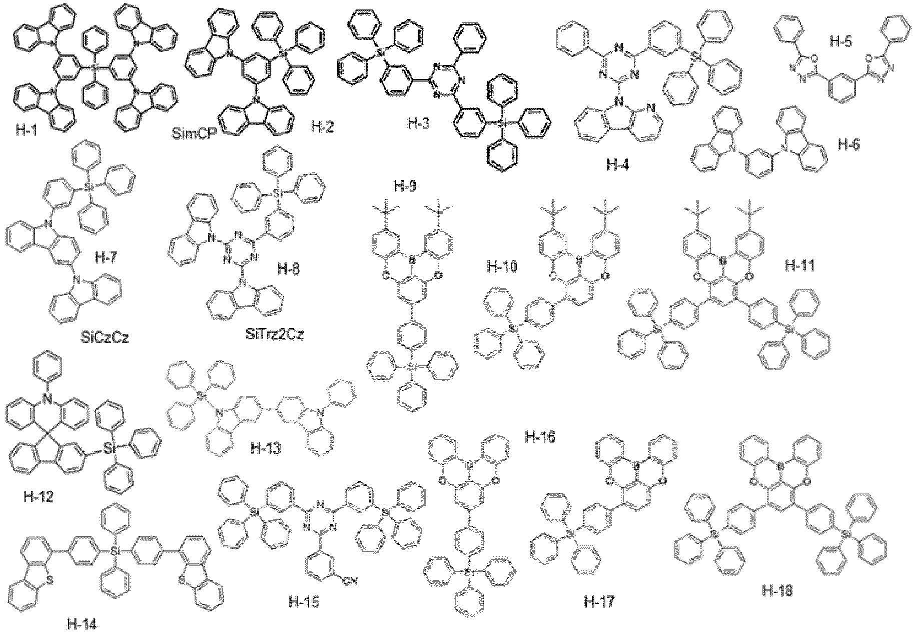 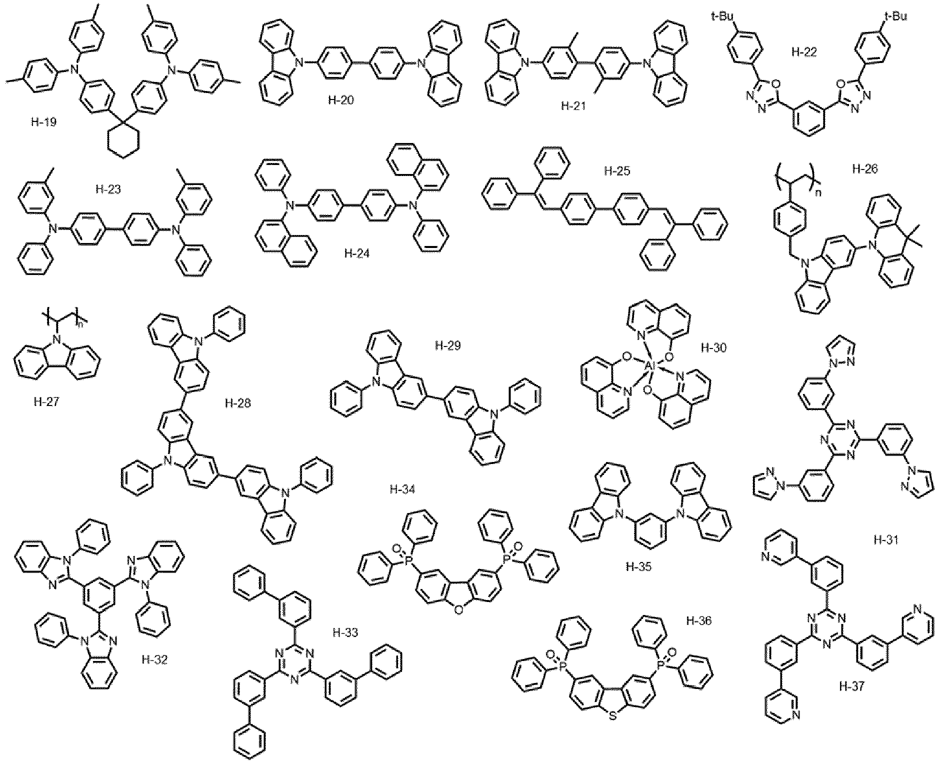 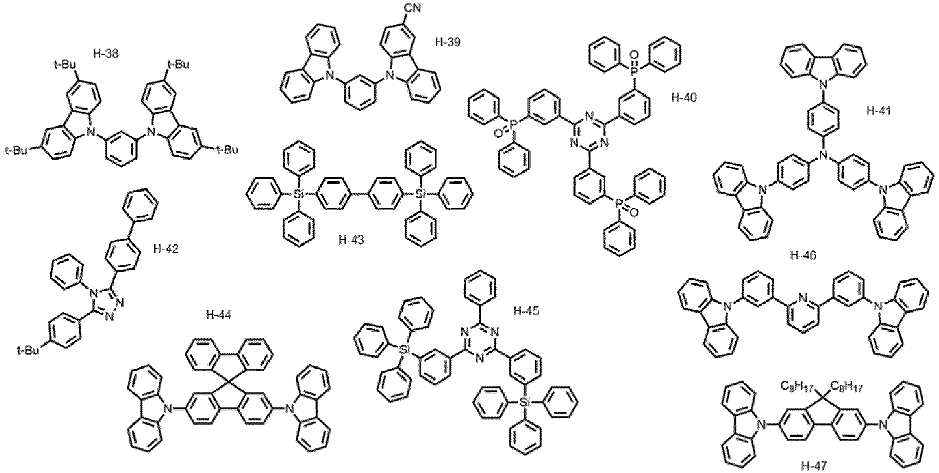 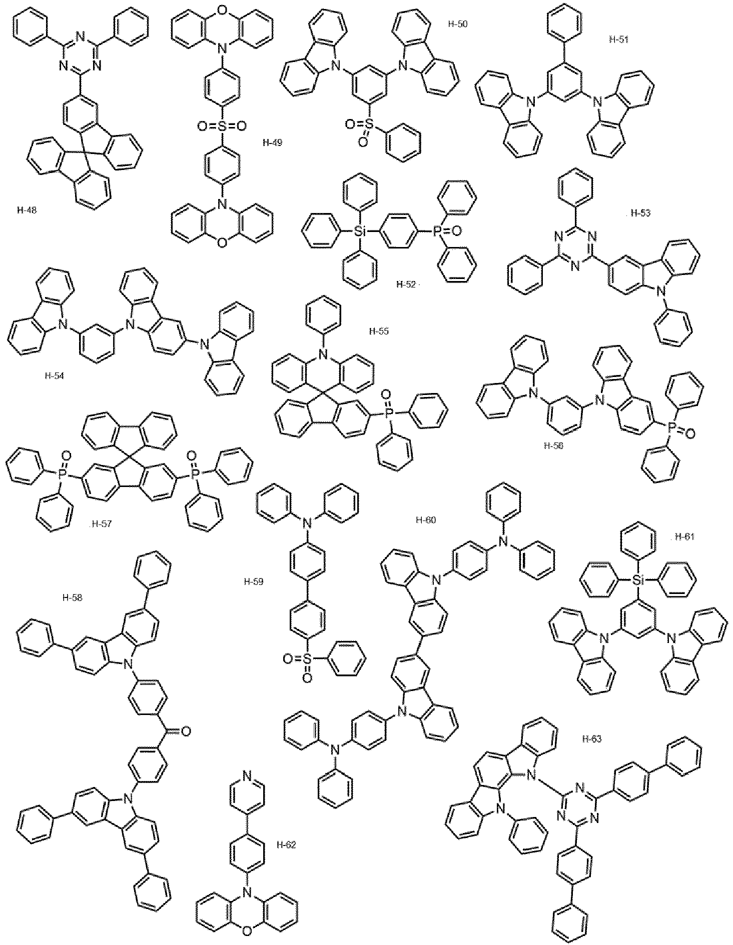 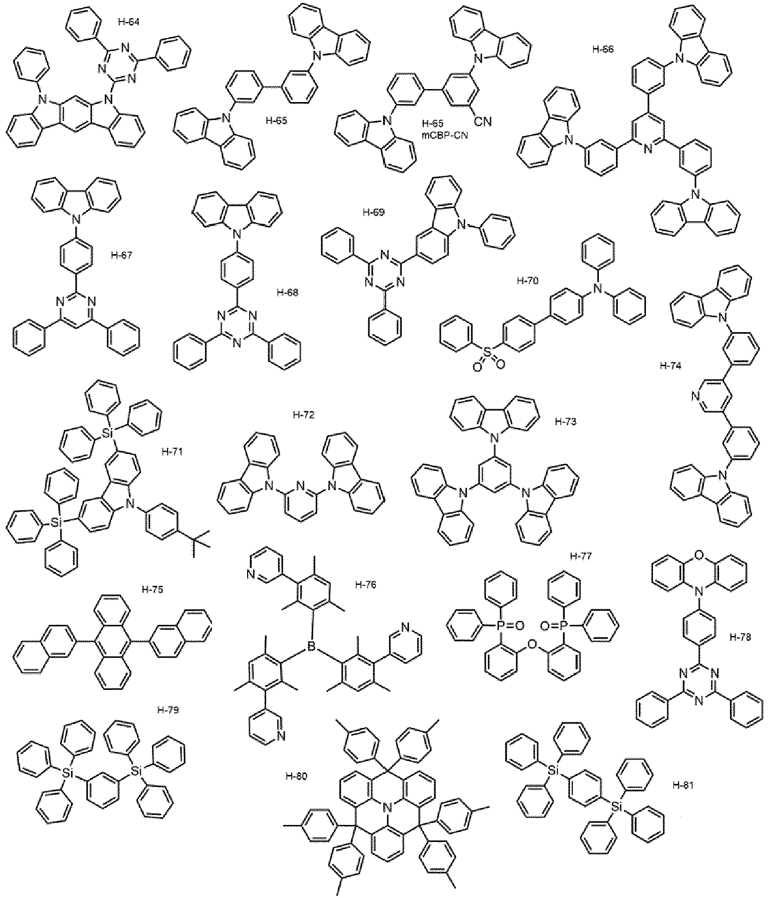 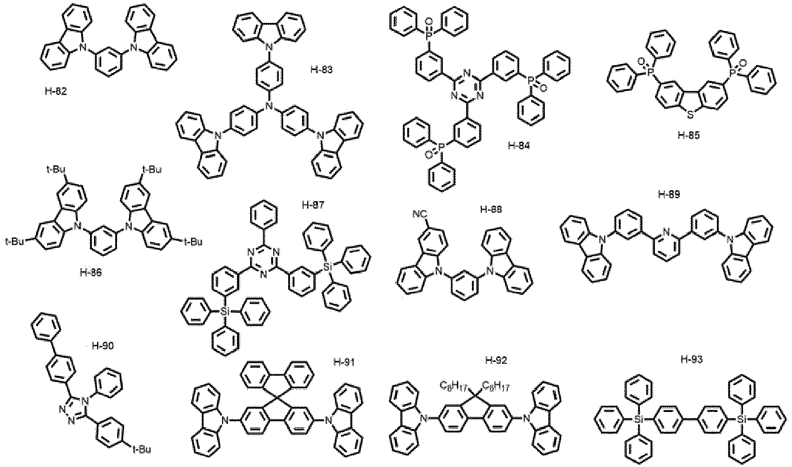 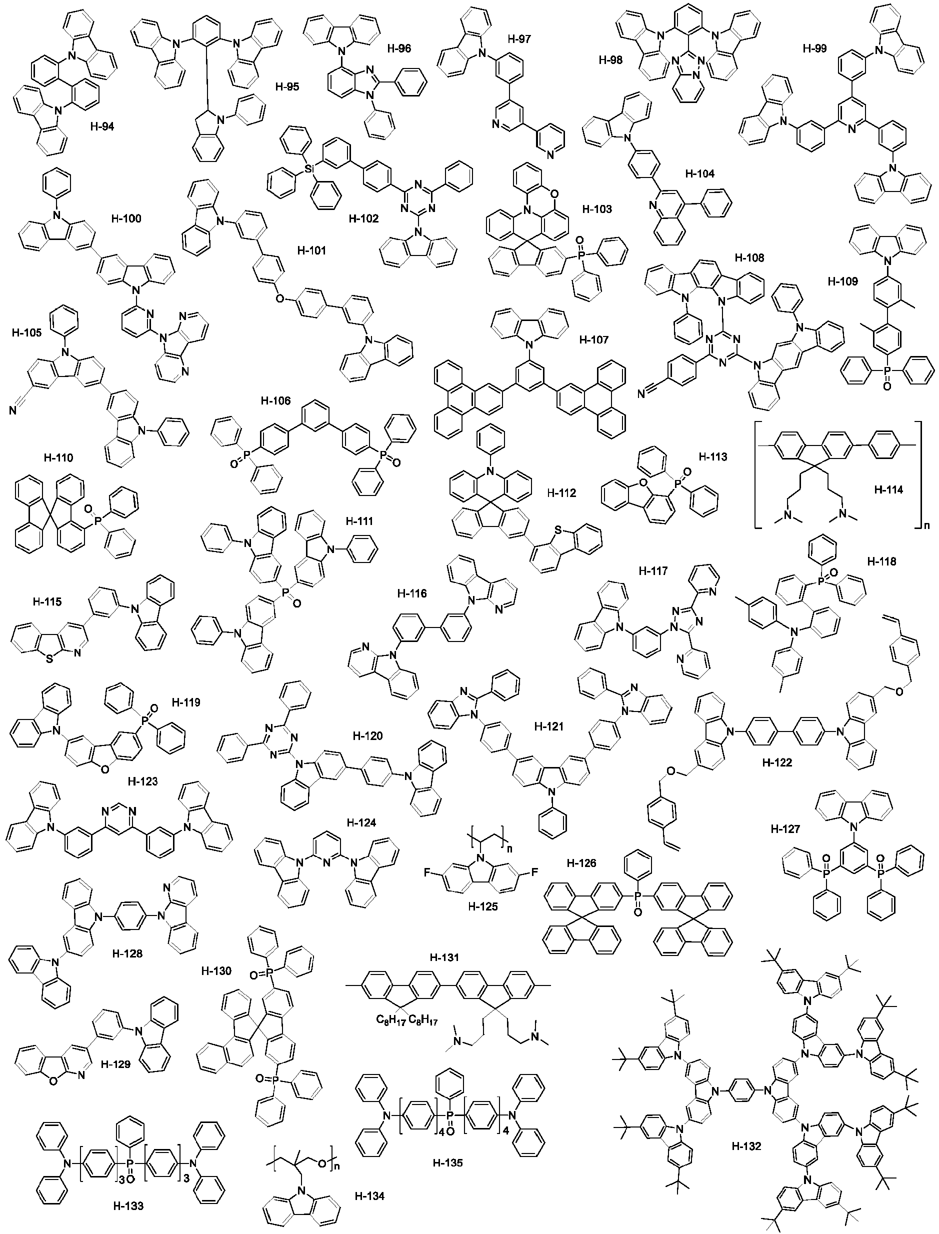 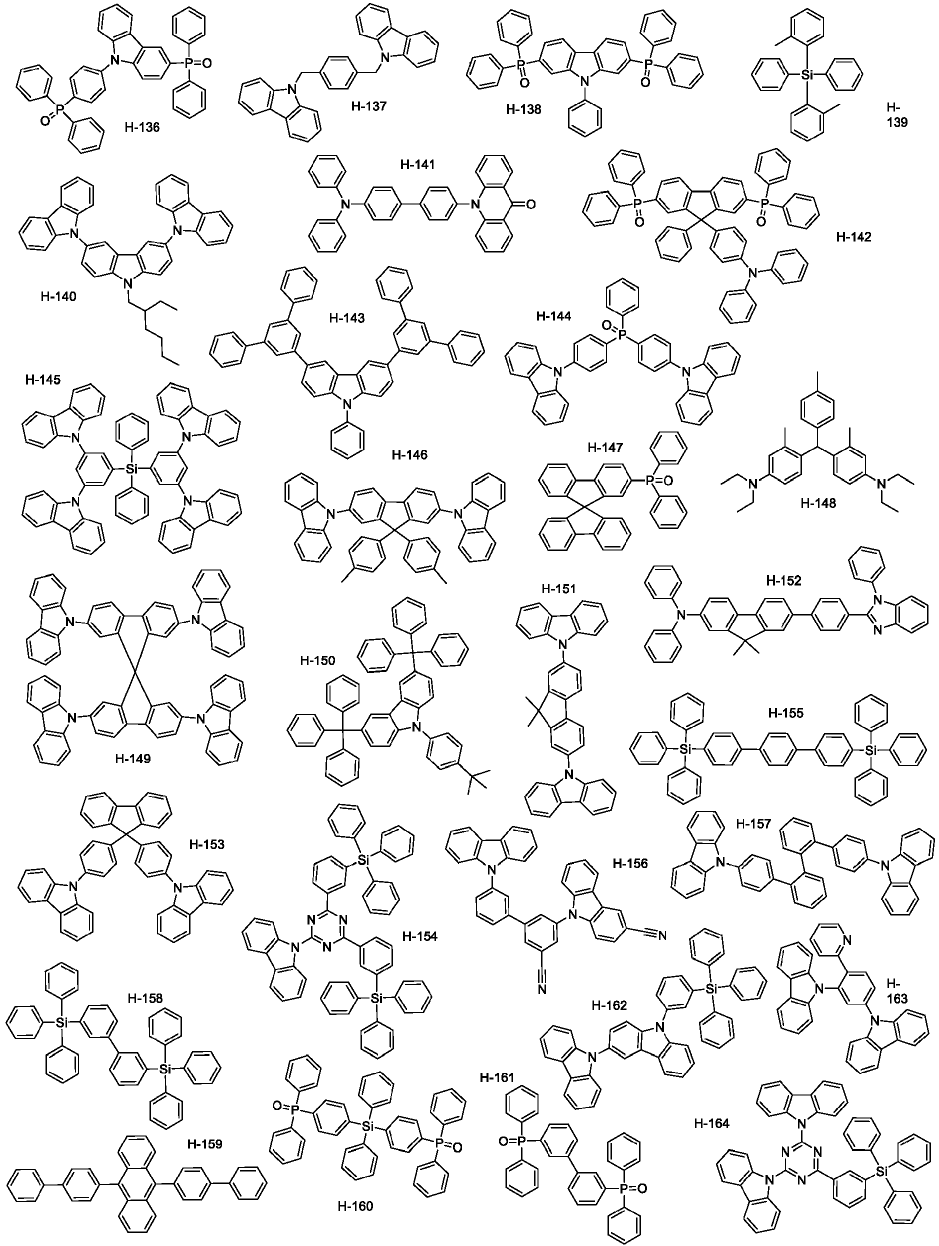 and deuterated analogues thereof.

8. An organic light emitting diode according to any one of claims 3-7, comprising at least one auxiliary host, preferably the auxiliary host is selected from structures H-1 to H-164 and deuterated analogues thereof.

9. An organic light emitting diode according to any one of claims 3-8, comprising at least one auxiliary TADF emissive dopand, preferably the auxiliary TADF emissive dopand is selected from: 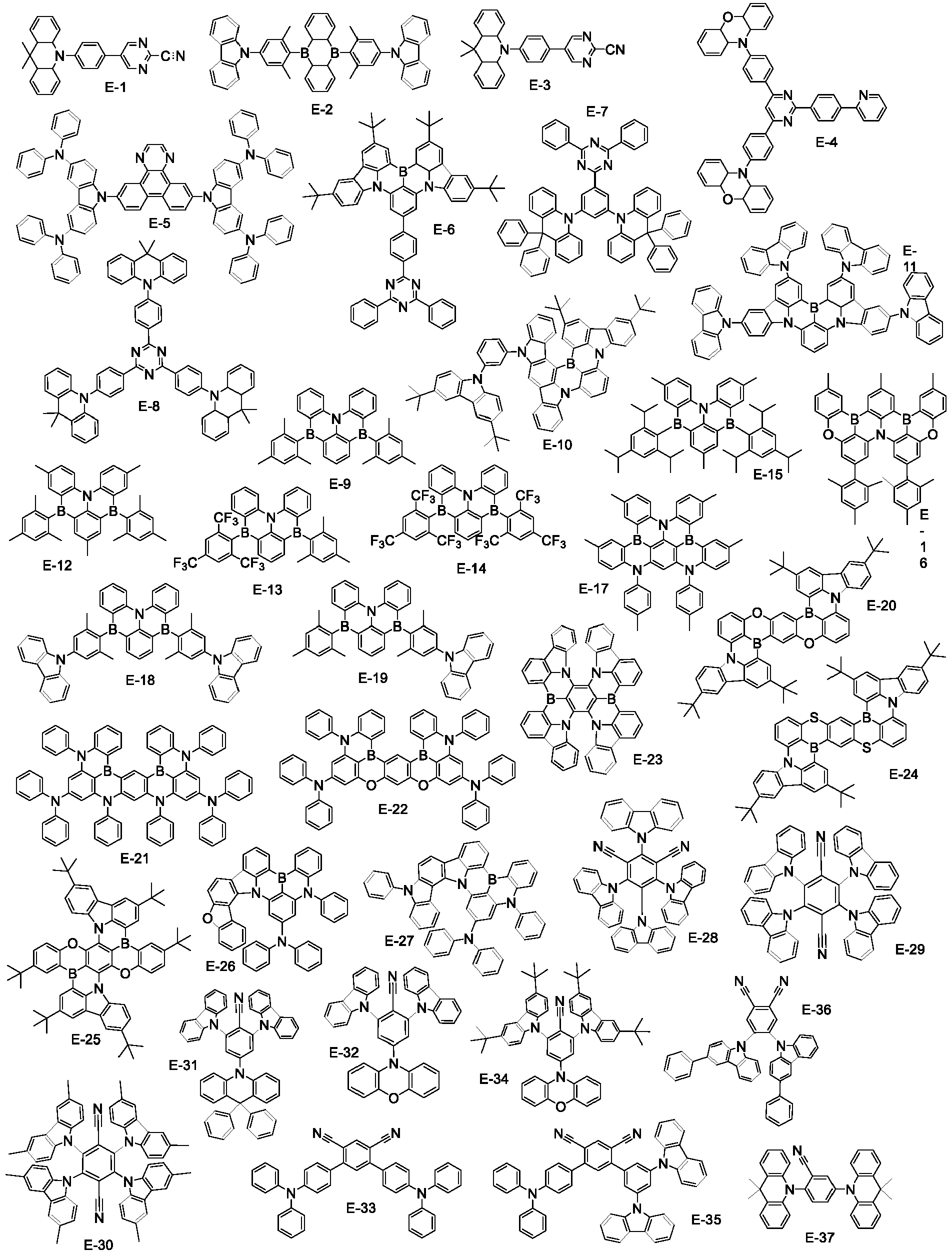 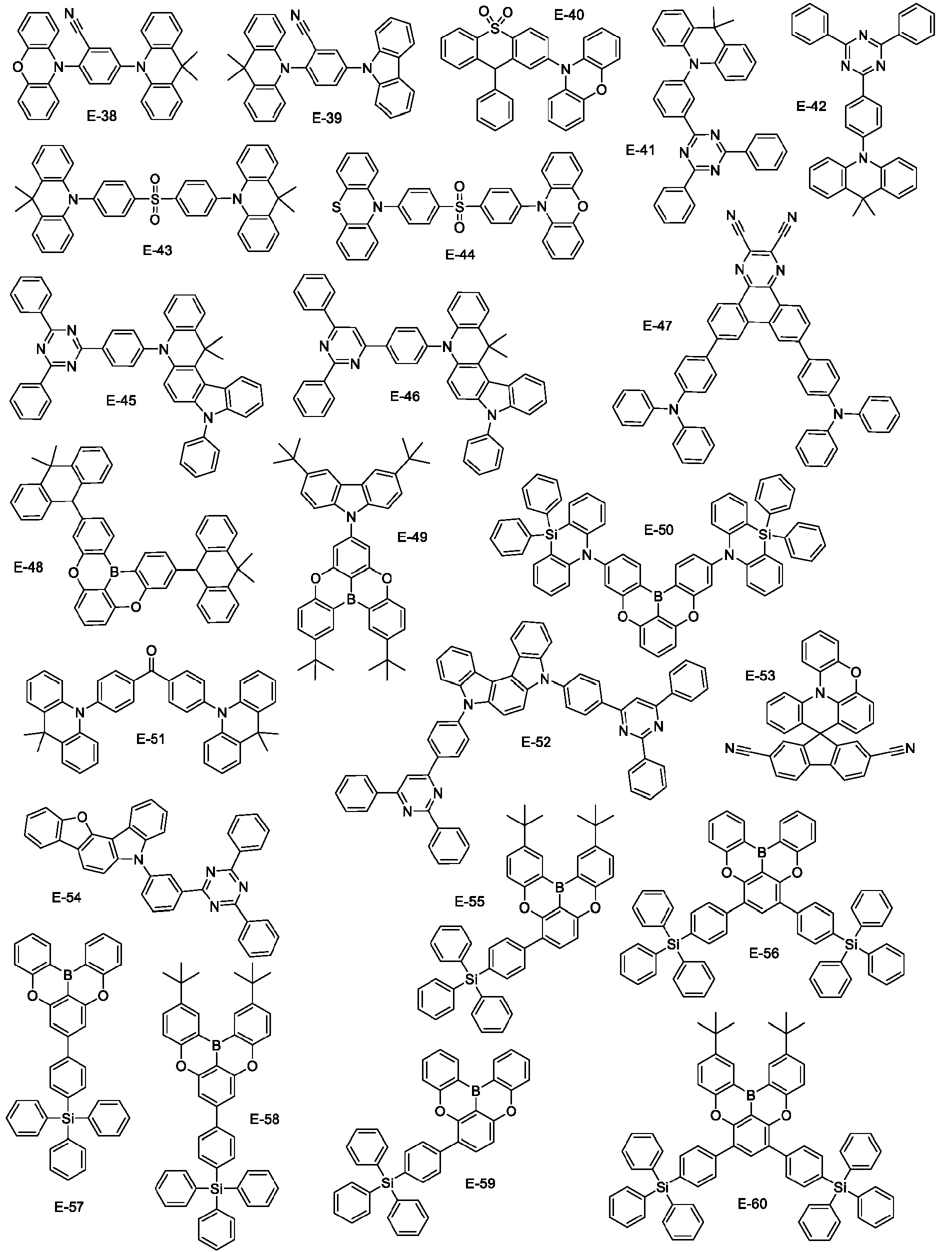 and deuterated analogues thereof.

10. An organic light emitting diode according to any one of claims 3 - 9, wherein comprising at least one fluorescence compound, preferably the fluorescence compound is selected from: tris(8-hydroxyquinolinato)aluminum (Alq3), bis(2-methyl-8-quinolinato)(4-phenylphenoxy)aluminum(BAlq),bis(2-methyl-8-quinolinato)-4-(phenylphenolato)aluminum (BAlq(PPh2Me)), rubrene (5,6,11,12-tetraphenylnaphthacene), mtCzTrz (9,9'-(5-(4-(3-(3-(tert-butyl)-6-isopropyl-9H-carbazol-9-yl)-5-(3,6-diisopropyl-9H-carbazol-9-yl)phenyl)-6-(4-methoxyphenyl)-1,3,5-triazin-2-yl)-1,3-phenylene)bis(3,6-di-tert-butyl-9H-carbazole)), M1 (4-(2-(4-(diphenylamino)phenyl)-4,5-diphenyl-1H-imidazol-1-yl)phenyl acetate), C-A-C (9,10-bis(3,5-bis(3,6-di-tert-butylcarbazol-9-yl)-phenyl) anthracene), m-ACSO2 (10,10'-(sulfonylbis(3,1-phenylene))bis(9,9-dimethyl-9,10-dihydroacridine)), TXO-TPA (2-[4-(diphenylamino) phenyl]-10, 10-dioxide-9H-thioxanthen-9-one), N-BDAVBi-C6 (4,4'-(1E,1'E)-2,2'-(Naphthalene-2,6-diyl)bis(ethene-2,1-diyl)bis(N,N-bis(4-hexylphenyl)aniline)), PXZPDO (1,3-bis(4-(10H-phenoxazin-10-yl)phenyl)-3-hydroxyprop-2-en-1-one), TPA (9,10-bis[phenyl(m-tolyl)-amino]anthracene), TTPA (9,10-bis[N,N-di-(p-tolyl)-amino]anthracene), 3phCN-ICz (5'-(5-phenylindolo[3,2-a]carbazol-12(5H)-yl)-[I, 1 ':3',1 "-terphenyl]-2'-carbonitrile), mCDtCBPy (3,3",6,6"-tetra-tert-butyl-9'-(6-(3-(3,3",6,6"-tetra-tert-butyl-9'H-[9,3':6',9"-tercarbazol]-9'-yl)-phenyl)pyridine-2-yl)-9'H-9,3':6',9"-tercarbazole), DDMACPy (2,6-bis(3-(9,9-dimethylacridin-10(9H)-yl)phenyl)pyridine), BICz (5,5'-(4-(2,12-Di-tert-butyl-5,9-dioxa-13b-boranaphtho[3,2,1-de]anthracen-7-yl)-1,3-phenylene)bis(7,7-dimethyl-5,7-dihydroindeno[2,1-b]carbazole)), BAnF8Pye (1-(7-(9,9'-bianthracen-10-yl)-9,9-dioctyl-9H-fluoren-2-yl)pyrene), BDAF (2-[9,9-di(4-methylphenyl)-fluoren-2-yl]-9,9-di(4-methylphenyl)fluorene), TDAF (2,7-bis[9,9-di(4-methylphenyl)-fluoren-2-yl]-9,9-di(4-methylphenyl)fluorene), 9,10-diphenylanthracene, 3P-T2T (2,4,6-tris[3-(1H-pyrazol-1-yl)phenyl]-1,3,5-triazine), mCBP-CN (3,3'-di(carbazol-9-yl)-5-cyano-1,1'-biphenyl), 9,9'-(((1E,1'E)-(2,5-dimethyl-1,4-phenylene)bis(ethene-2,1-diyl))bis(4,1-phenylene))bis(9H-carbazole), 9,9'-(((1E,1'E)-(2,5-dimethoxy-1,4-phenylene)bis(ethene-2,1-diyl))bis(4,1-phenylene))bis(9H-carbazole), 9,9'-(((1E,1'E)-(9,9-dimethyl-9H-fluorene-2,7-diyl)bis(ethene-2,1-diyl))bis(4,1-phenylene))bis(9H-carbazole), 10-(3-(9H-carbazol-9-yl)phenyl)-9,9-dimethyl-9,10-dihydroacridine, 2FPPICz (2-(4-(9H-carbazol-9-yl)phenyl)-1-(3,5-difluorophenyl)-1H-phenanthro[9,10-d]imidazole), CzPVSBF (2,7-bis((E)-4-(9H-carbazol-9-yl)styryl)-9,9'-spirobi[fluorene]), CN-TPB-TPA (4"'-(diphenylamino)-2',5'-diphenyl-[1,1':4',1":4",1'"-quaterphenyl]-4-carbonitrile), BCzTPM (9,9'-bis(4-tritylphenyl)-9H,9'H-3,3'-bicarbazole), PIM-TRZ (2-(3-(4,6-Diphenyl-1,3,5-triazin-2-yl)phenyl)-1-phenyl-1H-benzo[d]imidazole), mCP-t-Bu (1,3-bis(3,6-di-tert-butyl-9H-carbazol-9-yl)benzene), SiCblTrz (9-(4-phenyl-6-(3-(triphenylsilyl)phenyl)-1,3,5-triazin-2-yl)-9H-pyrido[2,3-b]indole), m-BPDBT (3,3'-bis(dibenzo[b,d]thiophen-4-yl)-1,1'-biphenyl), DBTSiDBT (bis(4-(dibenzo[b,d]thiophen-4-yl)phenyl)diphenylsilane), DBFSiDBF (bis(4-(dibenzo[b,d]furan-4-yl)phenyl)diphenylsilane), DBTSF4 (4-(9,9'-spirobi[fluoren]-4-yl)dibenzo[b,d]thiophene), CCP (9-phenyl-3,9'-bi-9H-carbazole), PIAnCN (4-(10-(4-(1-phenyl-1H-phenanthro[9,10-d]imidazol-2-yl)phenyl) anthracen-9-yl)benzonitrile), PIAnTAZ (2-(4-(10-(4-(4,6-diphenyl-1,3,5 -triazin-2-yl)phenyl)anthracen-9-yl)phenyl)-1-phenyl-1H-phenanthro[9,10-d]imidazole), MAD-1N (2-methyl-9,10-di(naphthalen-1-yl)anthracene), SSTF (10-phenyl-2'-(triphenylsilyl)-10H-spiro[acridine-9,9'-fluorene]), BUBH-3 (4,4'-di[10-(naphthalen-1-yl)anthracen-9-yl]biphenyl), 4P-NPB (N,N'-di-(1-naphthalenyl)-N,N' -diphenyl-[1,1':4',1":4", 1"'-quaterphenyl]-4,4"'-diamine), BANE (10,10'-di(biphenyl-4-yl)-9,9'-bianthracene), TPyPA (tris[4-(pyrenyl)-phenyl]amine), m-Bpye (1,3-di(pyren-1-yl)benzene), BSBF (2-(9,9-spirobifluoren-2-yl)-9,9-spirobifluorene), BH-9PA (9-(10-phenylanthracen-9-yl)spiro-[benzo[c]fluorene-7,9'-fluorene]), 9-(naphthalen-1-yl)-10-(naphthalen-2-yl)anthracene, pDPFB (1,4-bis(9-phenyl-9H-fluoren-9-yl)benzene), SF34 (3-(9,9'-spirofluorenyl-4-yl)-9,9'-spirofluorene), TCPZ (2,4,6-tris(3-(9H-carbazol-9-yl)phenyl)-1,3,5-triazine), POPH ((5-terphenyl-1,3-phenylene)bis(diphenylphosphine oxide)), DPTPCz (3-(4,6-Diphenyl-1,3,5-triazin-2-yl)-9-phenyl-9H-carbazole), BCz-Si (9-phenyl-9'-(triphenylsilyl)-9H,9'H-3,3'-bicarbazole), 3CzPFP (3-[3-(9H-carbazol-9-yl)phenyl]furo[2,3-b:5,4-b']dipyridine), 4ICDPy (5,12-dihydro-6,7-dimethyl-5,12-di-4-pyridinyl-indolo[3,2-a]carbazole), POSTF (2'-(diphenylphosphoryl)-10-phenyl-10H-spiro[acridine-9,9'-fluorene]), SF3PO (bis(9,9-spirobifluorene-3-yl)-phenylphosphane oxide), CPPyC (9-(5-(3-(9H-carbazol-9-yl)phenyl)pyridin-3-yl)-9H-carbazole), Znq2 (bis(8-hydroxyquinoline) zinc), DBP (dibenzo{[f,f']-4,4',7,7'-tetraphenyl}diindeno[1,2,3-cd:1',2',3'-lm]perylene), DMPPP (1,1'-(2,5-dimethyl-1,4-phenylene)dipyrene), DBPenta (6,13-di-biphenyl-4-yl-pentacene), Spiro-Pye (2,7-dipyrenyl-9,9-spirobifluorene), TPBA (9,9',10,10'-Tetraphenyl-2,2'-bianthracene), BPPF (9,9-bis[4-(pyrenyl)phenyl]-9H-fluorene), TPB3 (1,3,5-tri(pyren-1-yl)benzene), 2,2'-Spiro-Pye (2,2'-dipyrenyl-9,9-spirobifluorene), TSBF (2,7-bis(9,9-spirobifluoren-2-yl)-9,9-spirobifluorene), MADN (2-methyl-9,10-bis(naphthalen-2-yl)anthracene), p-DMDPVBi (1-[2,2-Bis(4-methylphenyl)ethenyl]-4-[4-[2,2-bis(4-methylphenyl)ethenyl]phenyl]benzene), DPVBi (4,4'-bis(2,2-diphenylethenyl)-1,1'-biphenyl), TBADN (2-tert-butyl-9,10-di(naphth-2-yl)anthracene), DCM ((E)-2-(2-(4-(dimethylamino)styryl)-6-methyl-4H-pyran-4-ylidene)malononitrile), DCM2 (4-(dicyanomethylene)-2-methyl-6-julolidyl-9-enyl-4H-pyran), DCMB ((E)-2-(2-(4-(dimethylamino)styryl)-6-tertbutyl-4H-pyran-4-ylidene)malononitrile), BA-NPB (N10,N10'-diphenyl-N10,N10'-dinaphthalenyl-9,9'-bianthracene-10,10'-diamine).

11. An organic light emitting diode according to any one of claims 3 - 10, comprising at least one of layer between the anode and cathode selected from a hole injection layer; hole transport layer; electron transport layer; emission auxiliary layer; electron blocking layer; hole blocking layer; electron injection layer; or a combination thereof.

12. An organic light emitting diode according to any one of claims 3 - 11, comprising a matrix, preferably the matrix is passive or active.

13. An organic light emitting diode according to any one of claims 3 - 12, wherein the diode emits light with a maximum wavelength of 350 nm to 2 500 nm, more preferably with a maximum wavelength of 400 nm to 750 nm.

14. Use of the diode according to any one of claims 3 - 13 as a display screen or illumination device, an electroluminescent display device, an organic photovoltaic device, or a sensing device.

15. A consumer product comprises the diode according to any one of claims 3 - 13, wherein the product is selected from a flat panel display, a computer monitor, a medical monitor, a television, a billboard, a light for interior or exterior illumination/signalling, a heads-up display, a fully or partially transparent display, a flexible display, a laser printer, a telephone, a cell phone, tablet, a phablet, a personal digital assistant, a wearable device, a laptop computer, a watch, a backlight, a digital camera, a camcorder, a 3-D display, a virtual reality or augmented reality display, a vehicle, a video walls comprising multiple displays tiled together, a theatre, stadium screen, and a sign.
